(19) Europäisches Patentamt
European Patent Office
Office européen des brevets

(11) EP 4 672 934 A1

# (12) EUROPEAN PATENT APPLICATION

(43) Date of publication:
**31.12.2025 Bulletin 2026/01**

(21) Application number: **25184686.1**

(22) Date of filing: **23.06.2025**

(51) International Patent Classification (IPC):
***H10K 50/12*** *(2023.01)* ***H10K 85/30*** *(2023.01)*
*H10K 101/40* *(2023.01)*

(52) Cooperative Patent Classification (CPC):
**H10K 85/346; H10K 50/12;** H10K 2101/40

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **27.06.2024 KR 20240084818**

(71) Applicant: **Samsung Display Co., Ltd.**
**Yongin-si, Gyeonggi-do 17113 (KR)**

(72) Inventors:
- **AHN, Seihwan**
  **17113 Yongin-si (KR)**
- **KANG, Iljoon**
  **17113 Yongin-si (KR)**
- **KO, Soobyung**
  **17113 Yongin-si (KR)**
- **KIM, Sungbum**
  **17113 Yongin-si (KR)**
- **OH, Chanseok**
  **17113 Yongin-si (KR)**
- **LEE, Eunyoung**
  **17113 Yongin-si (KR)**

(74) Representative: **Marks & Clerk LLP**
**15 Fetter Lane**
**London EC4A 1BW (GB)**

## (54) LIGHT-EMITTING DEVICE INCLUDING ORGANOMETALLIC COMPOUND, ELECTRONIC APPARATUS INCLUDING THE LIGHT-EMITTING DEVICE, AND THE ORGANOMETALLIC COMPOUND

(57) A light-emitting device including an organometallic compound represented by Formula 1, and an electronic apparatus including the light-emitting device are provided. Also provided is the organometallic compound represented by Formula 1. A detailed description (e.g., of Formula 1) is in the specification.

EP 4 672 934 A1

**Formula 1**

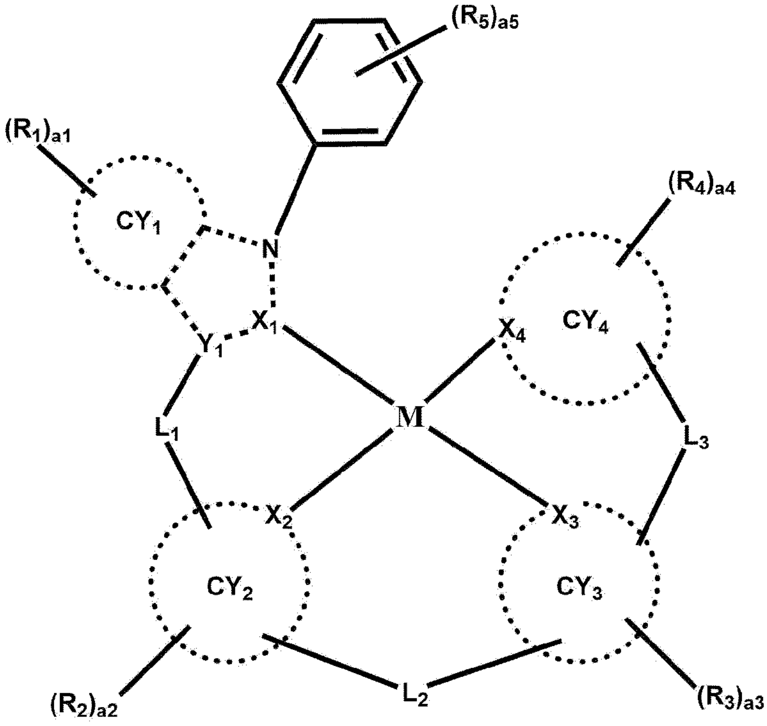

FIG. 1

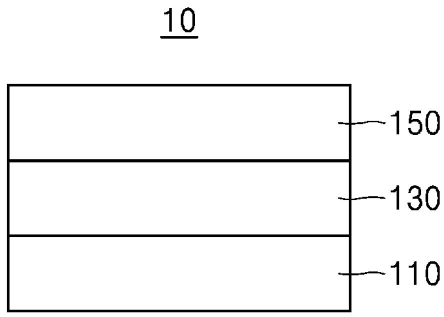

## Description

## BACKGROUND

### 1. Field

One or more aspects of embodiments of the present disclosure relate to a light-emitting device including an organometallic compound, an electronic apparatus including the light-emitting device, and the organometallic compound.

### 2. Description of the Related Art

Among light-emitting devices, "self-emissive" devices are distinguished by their relatively wide (broad) viewing angles, high contrast ratios, short (fast or rapid) response times, and/or superior or suitable characteristics in terms of luminance, driving voltage, and/or response speed, particularly when compared to non-self-emissive or comparable devices in the related art.

In a light-emitting device, a first electrode is arranged on a substrate, followed by a sequential arrangement of a hole transport region, an emission layer, an electron transport region, and a second electrode (e.g., sequentially arranged on the first electrode). Holes provided from the first electrode travel (move) through the hole transport region to the emission layer, while electrons provided from the second electrode travel (move) through the electron transport region to the emission layer. In the emission layer, these carriers, (e.g., the holes and electrons), recombine to produce excitons that may then transition (e.g., relax) from an excited state to a ground state, thereby emitting (e.g., generating) light to, e.g., display an image.

## SUMMARY

One or more aspects of embodiments of the present disclosure are directed toward a light-emitting device including an organometallic compound, an electronic apparatus including the light-emitting device, and the organometallic compound.

Additional aspects will be set forth in part in the description which follows and, in part, will be apparent from the description, or may be learned by practice of the presented embodiments of the disclosure.

According to one or more embodiments, a light-emitting device includes

a first electrode,
a second electrode opposite to (e.g., facing) the first electrode, and
an interlayer arranged between the first electrode and the second electrode and including an emission layer, and
wherein the light-emitting device includes an organometallic compound represented by Formula 1:

## Formula 1

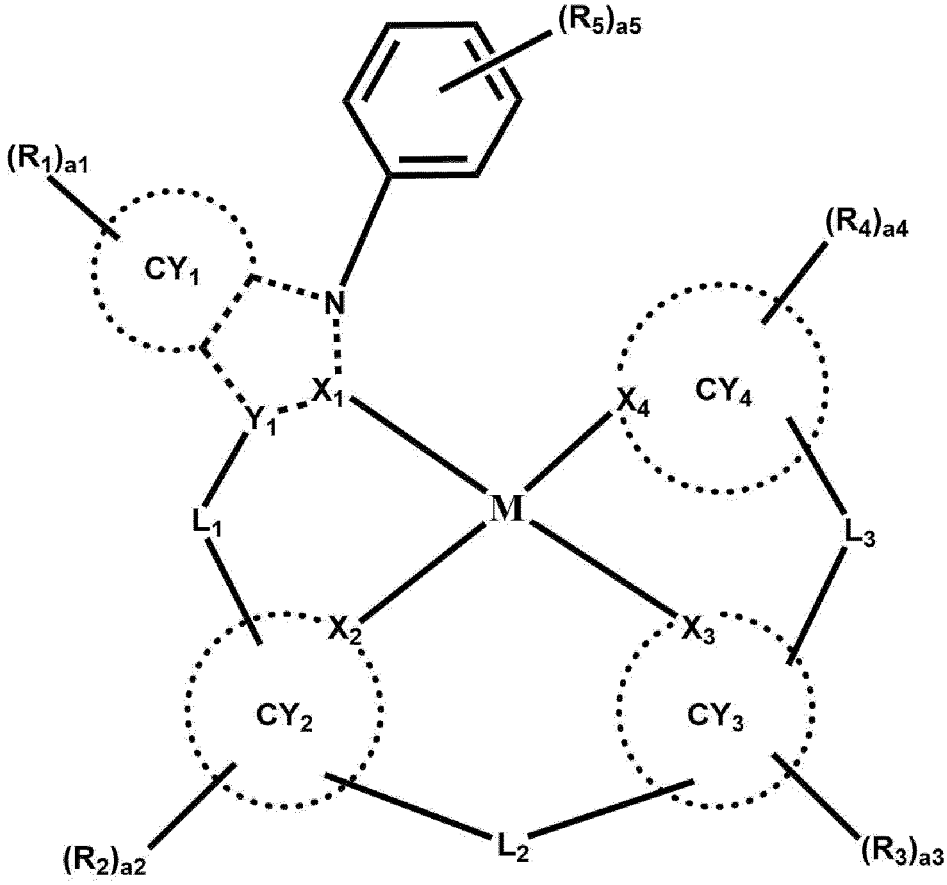

,

wherein, in Formula 1,

M is platinum (Pt), palladium (Pd), cobalt (Co), gold (Au), iridium (Ir), rhenium (Re), nickel (Ni), silver (Ag), or copper (Cu),
$X_1$ to $X_4$ and $Y_1$ are each independently C or N (e.g., a C atom or a N atom),
$L_1$ to $L_3$ are each independently a single bond, *-O-*', *-S-*', *-C($R_6$)($R_7$)-*', *-Si($R_6$)($R_7$)-*', *-B($R_6$)-*', *-N($R_6$)-*', or *-P($R_6$)-*',
$CY_1$ to $CY_4$ are each independently a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,
a1 to a4 are each independently an integer from 0 to 10,
a5 is an integer from 1 to 5,
$R_1$ to $R_7$ are each independently hydrogen, deuterium, -F, -Cl, -Br, -I, a hydroxyl group, a cyano group, a nitro group, a $C_1$-$C_{60}$ alkyl group unsubstituted or substituted with at least one $R_{10a}$, a $C_2$-$C_{60}$ alkenyl group unsubstituted or substituted with at least one $R_{10a}$, a $C_2$-$C_{60}$ alkynyl group unsubstituted or substituted with at least one $R_{10a}$, a $C_1$-$C_{60}$ alkoxy group unsubstituted or substituted with at least one $R_{10a}$, a $C_3$-$C_{60}$ carbocyclic group unsubstituted or substituted with at least one $R_{10a}$, a $C_1$-$C_{60}$ heterocyclic group unsubstituted or substituted with at least one $R_{10a}$, -C($Q_1$)($Q_2$)($Q_3$), - Si($Q_1$)($Q_2$)($Q_3$), -N($Q_1$)($Q_2$), -B($Q_1$)($Q_2$), -C(=O)($Q_1$), -S(=O)$_2$($Q_1$), or **-P(=O)($Q_1$)($Q_2$),**
$R_{10a}$ is
deuterium, -F, -Cl, -Br, -I, a hydroxyl group, a cyano group, or a nitro group,
a $C_1$-$C_{60}$ alkyl group, a $C_2$-$C_{60}$ alkenyl group, a $C_2$-$C_{60}$ alkynyl group, or a $C_1$-$C_{60}$ alkoxy group, each unsubstituted or substituted with deuterium, -F, -Cl, -Br, -I, a hydroxyl group, a cyano group, a nitro group, a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_7$-$C_{60}$ arylalkyl group, a $C_2$-$C_{60}$ heteroarylalkyl group, -Si($Q_{11}$)($Q_{12}$)($Q_{13}$), -N($Q_{11}$)($Q_{12}$), -B($Q_{11}$)($Q_{12}$), - C(=O)($Q_{11}$), -S(=O)$_2$($Q_{11}$), -P(=O)($Q_{11}$)($Q_{12}$), or any combination thereof,
a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_7$-$C_{60}$ arylalkyl group, or a $C_2$-$C_{60}$ heteroarylalkyl group, each unsubstituted or substituted with deuterium, -F,

-Cl, -Br, -I, a hydroxyl group, a cyano group, a nitro group, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_7$-$C_{60}$ arylalkyl group, a $C_2$-$C_{60}$ heteroarylalkyl group, -Si($Q_{21}$)($Q_{22}$)($Q_{23}$), -N($Q_{21}$)($Q_{22}$), -B($Q_{21}$)($Q_{22}$), - C(=O)($Q_{21}$), -S(=O)$_2$($Q_{21}$), -P(=O)($Q_{21}$)($Q_{22}$), or any combination thereof, or -Si($Q_{31}$)($Q_{32}$)($Q_{33}$), -N($Q_{31}$)($Q_{32}$), -B($Q_{31}$)($Q_{32}$), -C(=O)($Q_{31}$), -S(=O)$_2$($Q_{31}$), or - P(=O)($Q_{31}$)($Q_{32}$),

$Q_1$ to $Q_3$, $Q_{11}$ to $Q_{13}$, $Q_{21}$ to $Q_{23}$, and $Q_{31}$ to $Q_{33}$ are each independently hydrogen, deuterium, -F, -Cl, -Br, -I, a hydroxyl group, a cyano group, a nitro group, or a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{60}$ carbocyclic group, or a $C_1$-$C_{60}$ heterocyclic group, each unsubstituted or substituted with deuterium, -F, a cyano group, a $C_1$-$C_{60}$ alkyl group, a $C_1$-$C_{60}$ alkoxy group, a phenyl group, a biphenyl group, or any combination thereof, and

the organometallic compound satisfies Condition 1 and Condition 2.

## Condition 1

$$\Delta G(T_1) - \Delta G(BDE)$$

is greater than (>) 0 kilocalorie per mole (kcal/mol).

**Condition 2**

A percent buried volume of the organometallic compound is at most 25% (e.g., or less),

wherein $\Delta G(T_1)$ is a triplet excited state energy of the organometallic compound, and $\Delta G(BDE)$ is a binding energy of N* and C* (e.g., in) at

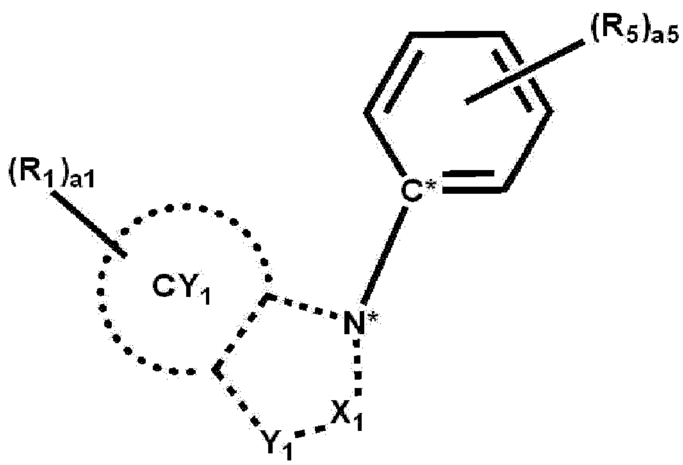

(e.g., of) in Formula 1, and

the percent buried volume of the organometallic compound is a percentage of a ratio of a volume of the organometallic compound to a volume of a sphere around (e.g., surrounding) a molecule of the organometallic compound.

According to one or more embodiments, an electronic apparatus and electronic equipment each include the light-emitting device.

Another one or more embodiments of the disclosure provide the organometallic compound represented by Formula 1.

At least some of the above and other features of the invention are set out in the claims.

### BRIEF DESCRIPTION OF THE DRAWINGS

The accompanying drawings are included to provide a further understanding of the preceding and other aspects, features, and advantages of certain embodiments of the disclosure are incorporated in and constitute a part of this specification. The drawings illustrate example embodiments and, together with the following description taken in conjunction with the accompanying drawings. In the drawings:

FIG. 1 is a schematic view of a structure of a light-emitting device according to one or more embodiments;
FIG. 2 is a schematic view of the structure of an electronic apparatus according to one or more embodiments;
FIG. 3 is a schematic view of the structure of an electronic apparatus according to one or more embodiments;
FIG. 4 is a schematic view of electronic equipment according to one or more embodiments;
FIG. 5 is a diagram schematically illustrating the exterior of a vehicle as electronic equipment including a light-emitting device according to one or more embodiments; and
FIGS. 6A-6C are each a diagram schematically illustrating the interior of a vehicle according to one or more embodiments.

## DETAILED DESCRIPTION

Reference will now be made in more detail to one or more embodiments, examples of which are illustrated in the accompanying drawings, wherein like reference numerals refer to like elements throughout the specification, and duplicative descriptions thereof may not be provided. In this regard, the present embodiments may have different forms and should not be construed as being limited to the descriptions set forth herein. Accordingly, one or more embodiments are merely described in more detail, by referring to the drawings, to explain aspects of the present description.

As used herein, the term "and/or" includes any and all combinations of one or more of the associated listed items. Expressions such as "at least one of," "one of," "selected from," and "selected from among," when preceding a list of elements, modify the entire list of elements and do not modify the individual elements of the list. For example, throughout the disclosure, the expression "at least one of a, b or c" indicates only a, only b, only c, both (e.g., simultaneously) a and b, both (e.g., simultaneously) a and c, both (e.g., simultaneously) b and c, all of a, b, and c, or variations thereof.

Because the disclosure may have diverse modified embodiments, the embodiments are illustrated in the drawings and are described in the detailed description. An aspect and a characteristic of the disclosure, and a method of accomplishing these will be apparent if (e.g., when) referring to one or more embodiments described with reference to the drawings. The disclosure may, however, be embodied in many different forms and should not be construed as limited to the embodiments set forth herein.

Unless otherwise defined, all chemical names, technical and scientific terms, and terms defined in common dictionaries should be interpreted as having meanings consistent with the context of the related art, and should not be interpreted in an ideal or overly formal sense. It will be understood that although the terms "first," "second," and/or the like may be utilized herein to describe one or more suitable components, these components should not be limited by these terms. These terms are only utilized to distinguish one component from another. Thus, a first element could be termed a second element without departing from the teachings of the present disclosure. Similarly, a second element could be termed a first element. An expression utilized in the singular forms such as "a," "an," and "the" are intended to encompass the expression of the plural forms as well, unless it has a clearly different meaning in the context.

It will be further understood that the terms "comprises," "comprising," "comprise," "has," "have," "having," "include," "includes," and/or " including," as utilized herein specify the presence of stated features or elements, but do not preclude the presence or addition of one or more other features or elements.

The term "may" will be understood to refer to "one or more embodiments of the present disclosure," some of which include the described element and some of which exclude that element and/or include an alternate element. Similarly, alternative language such as "or" refers to "one or more embodiments of the present disclosure," each including a corresponding listed item.

In the following embodiments, if (e.g., when) one or more components such as layers, films, regions, plates, and/or the like are said to be "connected to," or "on" another component, this may include not only a case in which other components are "immediately on" the layers, films, regions, or plates, but also a case in which other components may be placed therebetween. Sizes of elements in the drawings may be exaggerated for convenience of explanation. In other words, because sizes and thicknesses of components in the drawings are arbitrarily illustrated for convenience of explanation, the following embodiments are not limited thereto.

Spatially relative terms, such as "beneath," "below," "lower," "above," "upper," "bottom," "top," and the like, may be used herein for ease of description to describe one element or feature's relationship to another element(s) or feature(s) as illustrated in the drawings. It will be understood that the spatially relative terms are intended to encompass different orientations of the device in use or operation in addition to the orientation depicted in the drawings. For example, if the device in the drawings is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

In this context, "consisting essentially of" indicates that any additional components will not materially affect the chemical, physical, optical or electrical properties of the semiconductor film.

Further, in this specification, the phrase "on a plane," or "plan view," indicates viewing a target portion from the

top, and the phrase "on a cross-section" indicates viewing a cross-section formed by vertically cutting a target portion from the side.

**Light-emitting device**

An embodiment of the disclosure provides a light-emitting device including: a first electrode; a second electrode opposite to (e.g., facing) the first electrode; an interlayer arranged between the first electrode and the second electrode and including an emission layer, wherein the light-emitting device includes an organometallic compound represented by Formula 1:

**Formula 1**

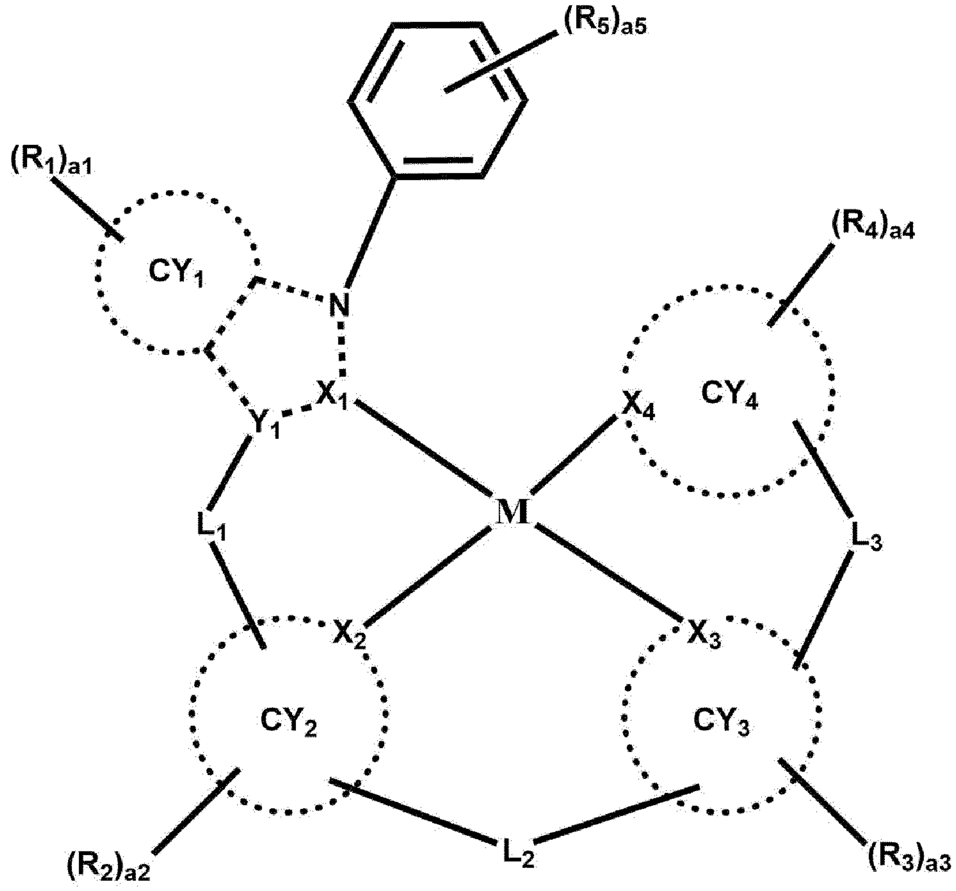

wherein, in Formula 1,

M is platinum (Pt), palladium (Pd), cobalt (Co), gold (Au), iridium (Ir), rhenium (Re), nickel (Ni), silver (Ag), or copper (Cu),
$X_1$ to $X_4$ and $Y_1$ are each independently C or N (e.g., a C atom or a N atom),
$L_1$ to $L_3$ are each independently a single bond, *-O-*', *-S-*', *-C($R_6$)($R_7$)-*', *-Si($R_6$)($R_7$)-*', *-B($R_6$)-*', *-N($R_6$)-*', or *-P($R_6$)-*',
$CY_1$ to $CY_4$ are each independently a $C_3$-$C_{60}$ (e.g. $C_3$-$C_{32}$) carbocyclic group unsubstituted or substituted with at least one $R_{10a}$ or a $C_1$-$C_{60}$ (e.g. $C_1$-$C_{20}$) heterocyclic group unsubstituted or substituted with at least one $R_{10a}$,
a1 to a4 are each independently an integer from 0 to 10,
a5 is an integer from 1 to 5,
$R_1$ to $R_7$ are each independently hydrogen, deuterium, -F, -Cl, -Br, -I, a hydroxyl group, a cyano group, a nitro group, a $C_1$-$C_{60}$ (e.g. $C_1$-$C_{20}$) alkyl group unsubstituted or substituted with at least one $R_{10a}$, a $C_2$-$C_{60}$ (e.g. $C_2$-$C_{20}$) alkenyl group unsubstituted or substituted with at least one $R_{10a}$, a $C_2$-$C_{60}$ (e.g. $C_2$-$C_{20}$) alkynyl group unsubstituted or substituted with at least one $R_{10a}$, a $C_1$-$C_{60}$ (e.g. $C_1$-$C_{20}$) alkoxy group unsubstituted or substituted with at least one $R_{10a}$, a $C_3$-$C_{60}$ (e.g. $C_3$-$C_{30}$) carbocyclic group unsubstituted or substituted with at least one $R_{10a}$, a $C_1$-$C_{60}$ (e.g. $C_1$-$C_{20}$) heterocyclic group unsubstituted or substituted with at least one $R_{10a}$, -C($Q_1$)($Q_2$)($Q_3$), - Si($Q_1$)($Q_2$)($Q_3$),

-N($Q_1$)($Q_2$), -B($Q_1$)($Q_2$), -C(=O)($Q_1$), -S(=O)$_2$($Q_1$), or -P(=O)($Q_1$)($Q_2$),

$R_{10a}$ is:

deuterium, -F, -Cl, -Br, -I, a hydroxyl group, a cyano group, or a nitro group;

a $C_1$-$C_{60}$ (e.g. $C_1$-$C_{20}$) alkyl group, a $C_2$-$C_{60}$ (e.g. $C_2$-$C_{20}$) alkenyl group, a $C_2$-$C_{60}$ (e.g. $C_2$-$C_{20}$) alkynyl group, or a $C_1$-$C_{60}$ (e.g. $C_1$-$C_{20}$) alkoxy group, each unsubstituted or substituted with deuterium, -F, -Cl, -Br, -I, a hydroxyl group, a cyano group, a nitro group, a $C_3$-$C_{60}$ (e.g. $C_3$-$C_{30}$) carbocyclic group, a $C_1$-$C_{60}$ (e.g. $C_1$-$C_{20}$) heterocyclic group, a $C_6$-$C_{60}$ (e.g. $C_6$-$C_{30}$) aryloxy group, a $C_6$-$C_{60}$ (e.g. $C_6$-$C_{30}$) arylthio group, a $C_7$-$C_{60}$ (e.g. $C_7$-$C_{30}$) arylalkyl group, a $C_2$-$C_{60}$ (e.g. $C_2$-$C_{20}$) heteroarylalkyl group, -Si($Q_{11}$)($Q_{12}$)($Q_{13}$), -N($Q_{11}$)($Q_{12}$), -B($Q_{11}$)($Q_{12}$), -C(=O)($Q_{11}$), -S(=O)$_2$($Q_{11}$), - P(=O)($Q_{11}$)($Q_{12}$), or any combination thereof;

a $C_3$-$C_{60}$ (e.g. $C_3$-$C_{30}$) carbocyclic group, a $C_1$-$C_{60}$ (e.g. $C_1$-$C_{20}$) heterocyclic group, a $C_6$-$C_{60}$ (e.g. $C_6$-$C_{30}$) aryloxy group, a $C_6$-$C_{60}$ (e.g. $C_6$-$C_{30}$) arylthio group, a $C_7$-$C_{60}$ (e.g. $C_7$-$C_{30}$) arylalkyl group, or a $C_2$-$C_{60}$ (e.g. $C_2$-$C_{20}$) heteroarylalkyl group, each unsubstituted or substituted with deuterium, -F, -Cl, -Br, -I, a hydroxyl group, a cyano group, a nitro group, a $C_1$-$C_{60}$ (e.g. $C_1$-$C_{20}$) alkyl group, a $C_2$-$C_{60}$ (e.g. $C_2$-$C_{20}$) alkenyl group, a $C_2$-$C_{60}$ (e.g. $C_2$-$C_{20}$) alkynyl group, a $C_1$-$C_{60}$ (e.g. $C_1$-$C_{20}$) alkoxy group, a $C_3$-$C_{60}$ (e.g. $C_3$-$C_{30}$) carbocyclic group, a $C_1$-$C_{60}$ (e.g. $C_1$-$C_{20}$) heterocyclic group, a $C_6$-$C_{60}$ (e.g. $C_6$-$C_{30}$) aryloxy group, a $C_6$-$C_{60}$ (e.g. $C_6$-$C_{30}$) arylthio group, a $C_7$-$C_{60}$ (e.g. $C_7$-$C_{30}$) arylalkyl group, a $C_2$-$C_{60}$ (e.g. $C_2$-$C_{20}$) heteroarylalkyl group, -Si($Q_{21}$)($Q_{22}$)($Q_{23}$), - N($Q_{21}$)($Q_{22}$), -B($Q_{21}$)($Q_{22}$), -C(=O)($Q_{21}$), -S(=O)$_2$($Q_{21}$), -P(=O)($Q_{21}$)($Q_{22}$), or any combination thereof; or

-Si($Q_{31}$)($Q_{32}$)($Q_{33}$), -N($Q_{31}$)($Q_{32}$), -B($Q_{31}$)($Q_{32}$), -C(=O)($Q_{31}$), -S(=O)$_2$($Q_{31}$), or - P(=O)($Q_{31}$)($Q_{32}$),

$Q_1$ to $Q_3$, $Q_{11}$ to $Q_{13}$, $Q_{21}$ to $Q_{23}$, and $Q_{31}$ to $Q_{33}$ are each independently: hydrogen; deuterium; -F; -Cl; -Br; -I; a hydroxyl group; a cyano group; a nitro group; or a $C_1$-$C_{60}$ (e.g. $C_1$-$C_{20}$) alkyl group, a $C_2$-$C_{60}$ (e.g. $C_2$-$C_{20}$) alkenyl group, a $C_2$-$C_{60}$ (e.g. $C_2$-$C_{20}$) alkynyl group, a $C_1$-$C_{60}$ (e.g. $C_1$-$C_{20}$) alkoxy group, a $C_3$-$C_{60}$ (e.g. $C_3$-$C_{30}$) carbocyclic group, or a $C_1$-$C_{60}$ (e.g. $C_1$-$C_{20}$) heterocyclic group, each unsubstituted or substituted with deuterium, -F, a cyano group, a $C_1$-$C_{60}$ (e.g. $C_1$-$C_{20}$) alkyl group, a $C_1$-$C_{60}$ (e.g. $C_1$-$C_{20}$) alkoxy group, a phenyl group, a biphenyl group, or any combination thereof, and

the organometallic compound satisfies Condition 1 and Condition 2.

## Condition 1

$$\Delta G(T_1) - \Delta G(BDE)$$

is greater than (>) 0 kilocalorie per mole (kcal/mol)

**Condition 2**

A percent buried volume of the organometallic compound is at most 25% (e.g., or less),

wherein $\Delta G(T_1)$ is a triplet excited state energy of the organometallic compound, and $\Delta G(BDE)$ is a binding energy of N* and C* (e.g., in) at

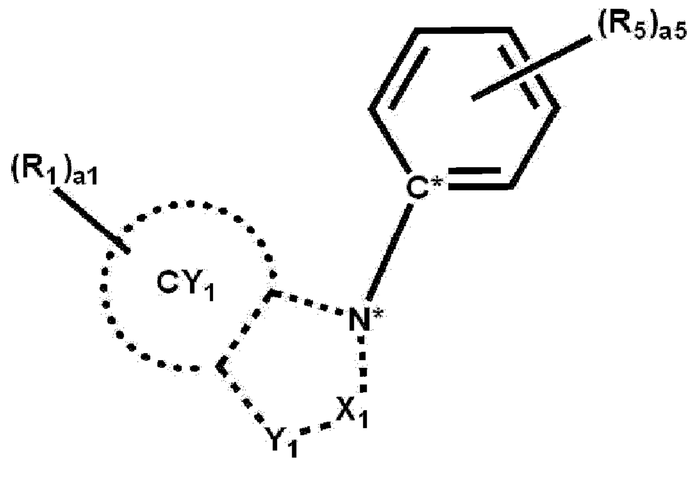

(e.g., of) in Formula 1, and

the percent buried volume of the organometallic compound is a percentage of a ratio of a volume of the organometallic compound to a volume of a sphere around (e.g., surrounding) a molecule of the organometallic compound.

According to one or more embodiments, the organometallic compound may satisfy $\Delta G(T_1)$ - $\Delta G(BDE)$ is greater

than (>) 0.9 kcal/mol.

According to one or more embodiments, M may be platinum (Pt).

According to one or more embodiments, $L_1$ to $L_3$ may each independently be a single bond, *-N($R_5$)-*', *-C($R_5$)($R_6$)-*', *-Si($R_5$)($R_6$)-*' or *-O-*'.

According to one or more embodiments, $L_2$ may be O.

According to one or more embodiments, the organometallic compound may include at least one of deuterium, a tert-butyl group, and/or a (e.g., any suitable) combination thereof.

According to one or more embodiments, a bond between $X_1$ and M and a bond between $X_4$ and M may each be a coordinate bond, and a bond between $X_2$ and M and a bond between and $X_3$ and M may each be a covalent bond.

According to one or more embodiments, $X_1$ to $X_3$ may each be C (e.g., a C atom), and $X_4$ may be N (e.g., a N atom).

According to one or more embodiments, $X_1$ may be the C atom including a carbene.

According to one or more embodiments, $CY_1$ to $CY_4$ may each independently be a cyclopentadiene group, an adamantane group, a norbornane group, a benzene group, a pentalene group, a naphthalene group, an azulene group, an indacene group, an acenaphthylene group, a phenylene group, a phenanthrene group, an anthracene group, a fluoranthene group, a triphenylene group, a pyrene group, a chrysene group, a perylene group, a pentaphene group, a heptalene group, a naphthacene group, a picene group, a hexacene group, a pentacene group, a rubicene group, a coronene group, an ovalene group, an indene group, a fluorene group, a spiro-bifluorene group, a benzofluorene group, an indenophenanthrene group, an indenoanthracene group, a pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, or an azadibenzofuran group, each unsubstituted or substituted with at least one $R_{10a}$.

According to one or more embodiments, $CY_1$ to $CY_4$ may each independently be a benzene group, a pentalene group, a naphthalene group, an azulene group, an indacene group, acenaphthylene group, a phenalene group, a phenanthrene group, an anthracene group, a pyrrole group, a thiophene group, a furan group, an indole group, a benzoindole group, a naphtho-indole group, an iso-indole group, a benzoiso-indole group, a naphthoiso-indole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, pyrazole group, imidazole group, a triazole group, oxazole group, an isoxazole group, an oxadiazole group, thiazole group, an isothiazole group, a thiadiazole group, a benzopyrazole group, a benzimidazole group, a benzoxazole group, a benzoisoxazole group, a benzothiazole group, a benzoisothiazole group, pyridine group, a pyrimidine group, pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, or azadibenzofuran group, each unsubstituted or substituted with at least one $R_{10a}$.

According to one or more embodiments,

i) $R_1$ may be hydrogen, or

ii) each of a1 and a5 may not be 0, and at least one $R_1$ (e.g., in the number of a1) is bonded to at least one $R_5$ (e.g., in the number of a5) to form a $C_3$-$C_{60}$ (e.g. $C_3$-$C_{30}$) carbocyclic group or a $C_1$-$C_{60}$ (e.g. $C_1$-$C_{20}$) heterocyclic group (e.g., the at least one $R_1$ and at least one of $R_5$ are bonded together), or

iii) each of a4 and a5 may not be 0, and at least one $R_4$ (e.g., in the number of a4) is bonded to at least one $R_5$ (e.g., in the number of a5) to form a cyclometallated group including M, $X_1$, and $X_4$, (e.g., the at least one $R_4$ and at least one of $R_5$ are bonded together), and the cyclometallated group may be a 9 or more-membered ring (e.g., may include at least 9 ring forming atoms). For example, according to one or more embodiments: i) $R_1$ may be hydrogen; ii) both a1 and a5 are non-zero (0), and at least one $R_1$ (in the number of a1) bonds with at least one $R_5$ (in the number of a5) to form a $C_3$-$C_{60}$ (e.g. $C_3$-$C_{30}$) carbocyclic or a $C_1$-$C_{60}$ (e.g. $C_1$-$C_{20}$) heterocyclic group; or iii) both a4 and a5 are non-zero, and at least one $R_4$ (in the number of a4) bonds with at least one $R_5$ (in the number of a5) to form a cyclometallated group including M, $X_1$, and $X_4$, which may be a ring with nine or more atoms.

According to one or more embodiments, the organometallic compound represented by Formula 1 may be represented by any one of Formulae 1-1 to 1-3:

## Formula 1-1

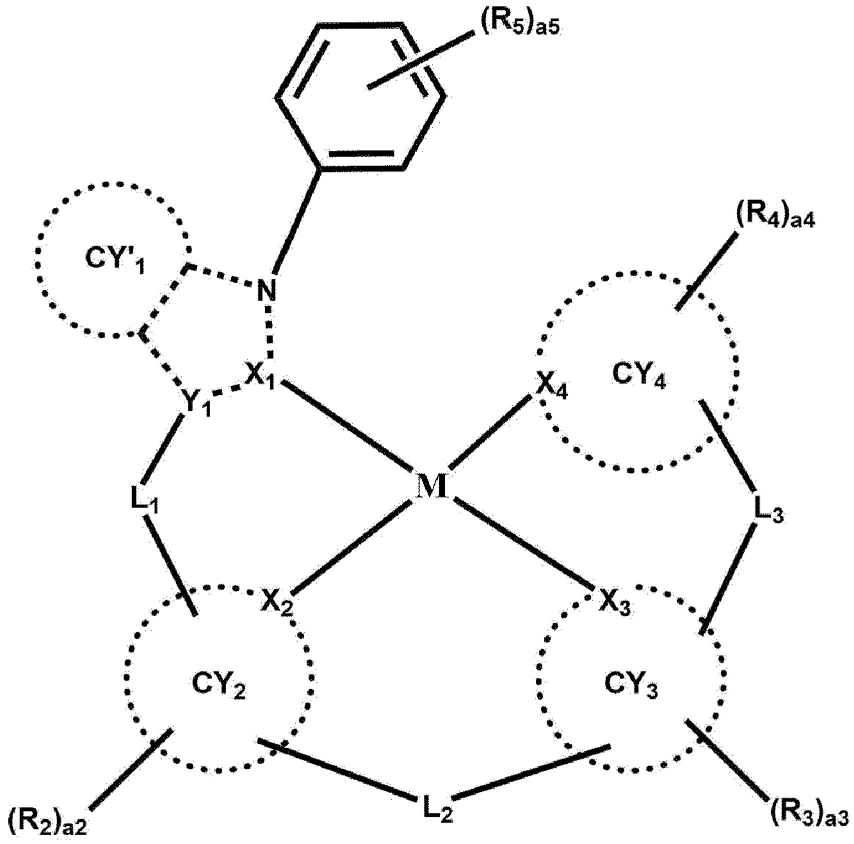

Formula 1-2

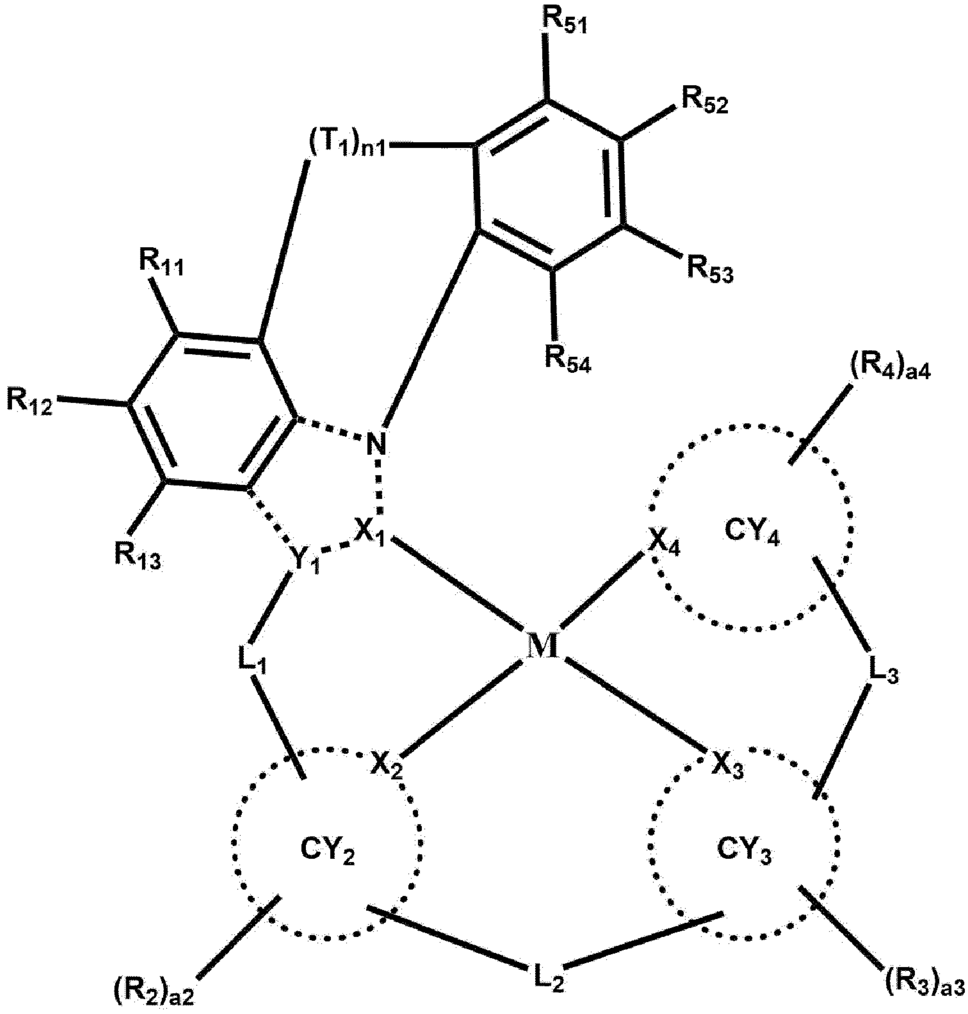

**Formula 1-3**

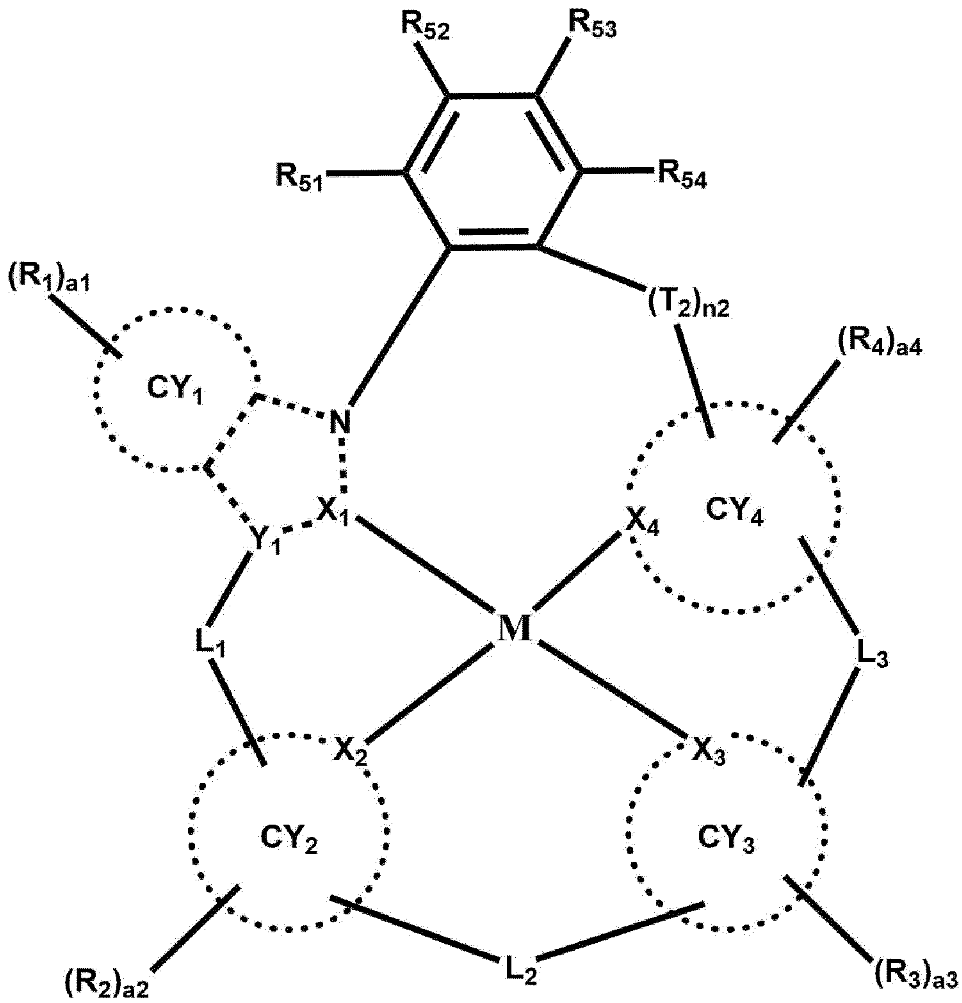

wherein, in Formulae 1-1 to 1-3,

M, $CY_1$ to $CY_4$, $X_1$ to $X_4$, $Y_1$, $L_1$ to $L_3$, a1 to a5, $R_1$ to $R_5$ are each as described herein,
$CY'_1$ is an unsubstituted $C_3$-$C_{60}$ (e.g. $C_3$-$C_{32}$) carbocyclic group or an unsubstituted $C_1$-$C_{60}$ (e.g. $C_1$-$C_{20}$) heterocyclic group,
$T_1$ and $T_2$ are each independently *-O-*', *-S-*', *-C(=O)-*', *-N($R_8$)-*', *-C($R_8$)($R_9$)-*', *-C($R_8$)=C($R_9$)-*', *-C($R_8$)=*', *=C=*', a $C_3$-$C_{60}$ (e.g. $C_3$-$C_{30}$) carbocyclic group unsubstituted or substituted with at least one $R_{10a}$, or a $C_1$-$C_{60}$ (e.g. $C_1$-$C_{20}$) heterocyclic group unsubstituted or substituted with at least one $R_{10a}$,
n1 and n2 are each independently an integer from 1 to 5,
$R_{11}$ to $R_{13}$ are each independently defined according to the definition of $R_1$ described herein, and
$R_{51}$ to $R_{54}$ are each independently defined according to the definition of $R_5$ described herein.

According to one or more embodiments, the cyclometallated group including M, $X_1$, N, $(T_2)_{n2}$ and $X_4$ may have a ring structure of 9 or more members (e.g., ring-forming atoms).

According to one or more embodiments, the organometallic compound represented by Formula 1 may be represented by any one of Formulae 1-a to 1-c:

## Formula 1-a

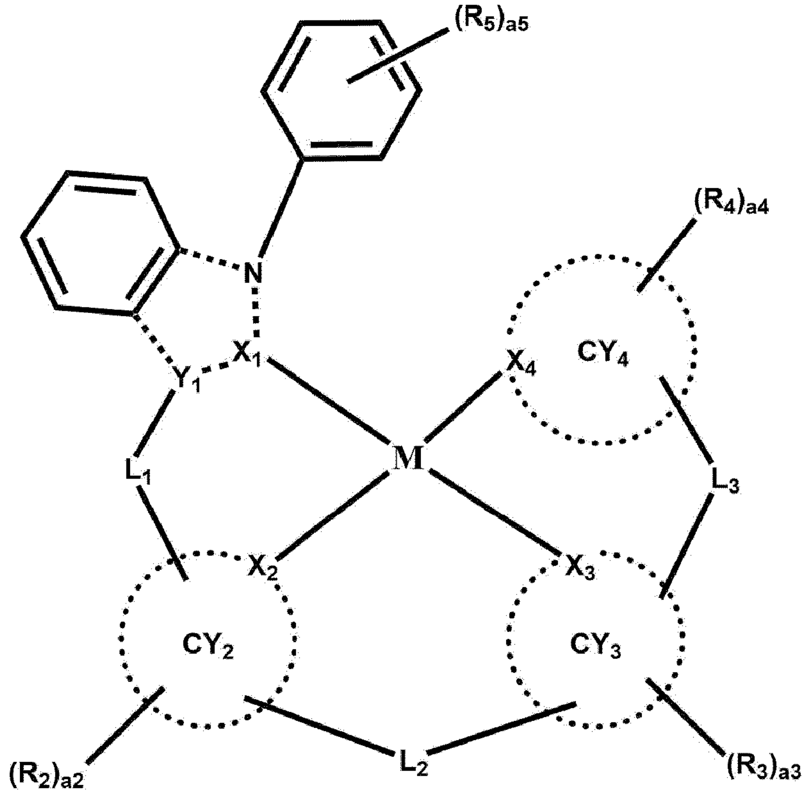

**Formula 1-b**

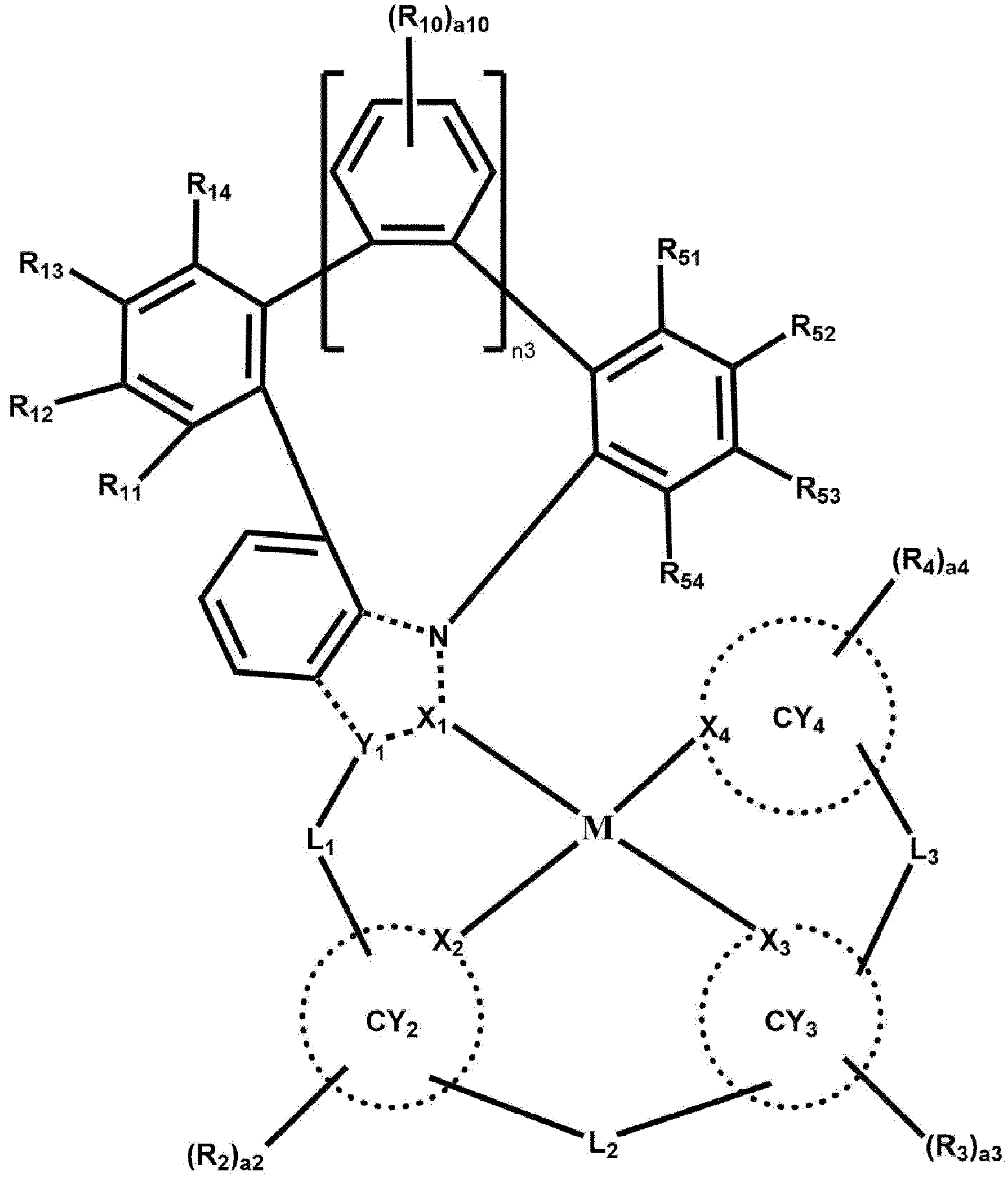

**Formula 1-c**

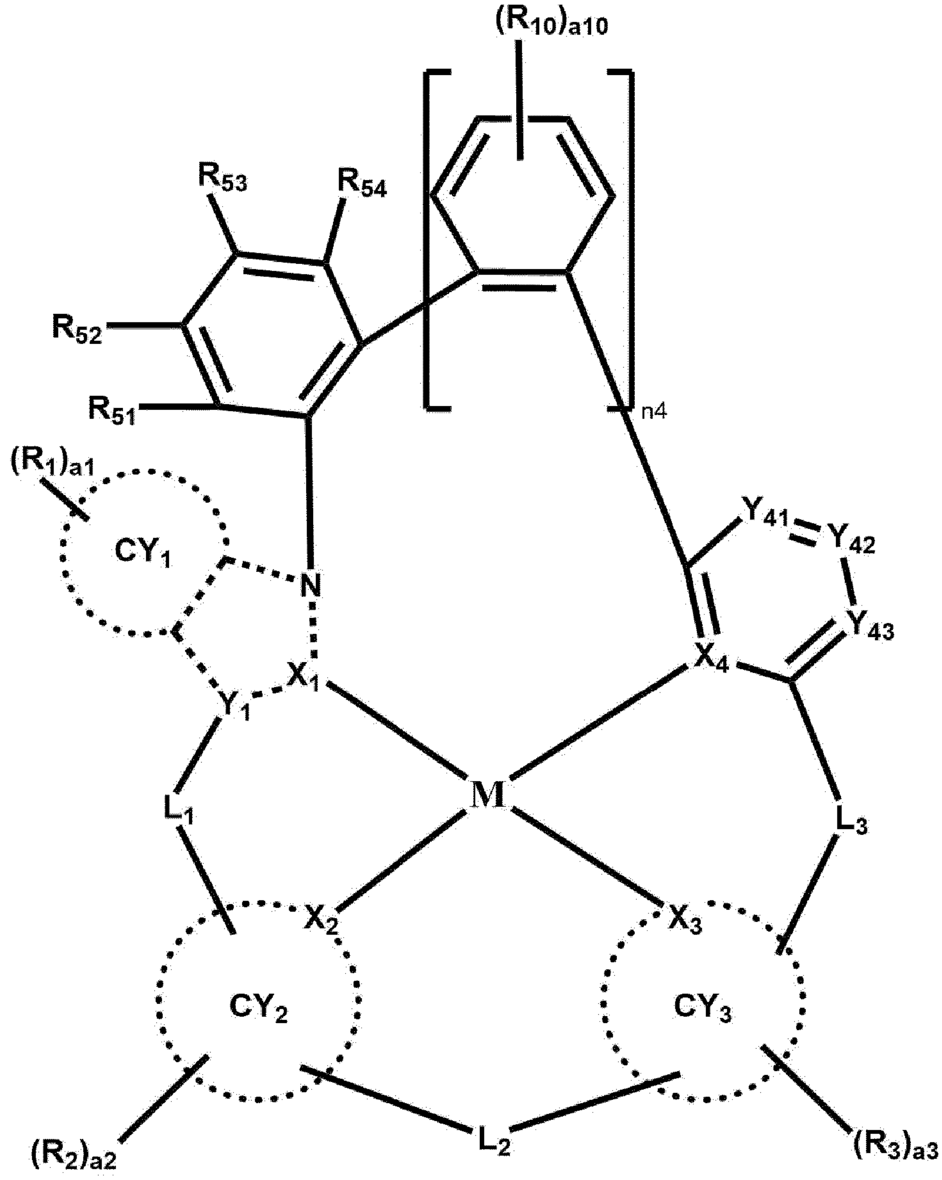

wherein, in Formulae 1-a to 1-c,

M, $CY_1$ to $CY_4$, $X_1$ to $X_4$, $Y_1$, $L_1$ to $L_3$, a1 to a5, $R_1$ to $R_5$ are each as described herein,
n3 and n4 are each independently an integer from 1 to 5,
a10 is an integer from 0 to 4,
$Y_{41}$ is $C(R_{41})$ or N, $Y_{42}$ is $C(R_{42})$ or N, $Y_{43}$ is $C(R_{43})$ or N,
$R_{10}$ to $R_{14}$ are each independently defined according to the definition of $R_1$ described herein, and
$R_{41}$ to $R_{43}$ are each independently defined according to the definition of $R_1$ described herein, and
$R_{51}$ to $R_{54}$ are each independently defined according to the definition of $R_5$ described herein.

According to one or more embodiments, $R_1$ to $R_7$ may each independently be hydrogen, deuterium, -F, a cyano group, a $C_1$-$C_{20}$ (e.g. $C_1$-$C_{10}$) alkyl group unsubstituted or substituted with at least one $R_{10a}$, a $C_3$-$C_{60}$ (e.g. $C_3$-$C_{30}$) carbocyclic group unsubstituted or substituted with at least one $R_{10a}$, a $C_1$-$C_{60}$ (e.g. $C_1$-$C_{20}$) heterocyclic group unsubstituted or substituted with at least one $R_{10a}$.

According to one or more embodiments, $R_1$ to $R_7$ may each independently be hydrogen, deuterium, -F, or a cyano group;

a $C_1$-$C_{20}$ (e.g. $C_1$-$C_{10}$) alkyl group unsubstituted or substituted with hydrogen, deuterium, -F, a cyano group, or any

combination thereof; or

a benzene group, a naphthalene group, a terphenyl group, a pyridine group, a dibenzofuran group, a dibenzothiophene group, a carbazole group, an azadibenzofuran group, an azadibenzothiophene group, or an azacarbazole group, each unsubstituted or substituted with hydrogen, deuterium, -F, a cyano group, a $C_1$-$C_{20}$ (e.g. $C_1$-$C_{10}$) alkyl group, a deuterated $C_1$-$C_{20}$ (e.g. $C_1$-$C_{10}$) alkyl group, a fluorinated $C_1$-$C_{20}$ (e.g. $C_1$-$C_{10}$) alkyl group, a phenyl group, a deuterated phenyl group, a fluorinated phenyl group, a ($C_1$-$C_{20}$ alkyl)phenyl group, a biphenyl group, a dibenzofuranyl group, a dibenzothiophenyl group, a carbazolyl group, a fluorenyl group, a dibenzosilolyl group, or any combination thereof.

According to one or more embodiments, $R_1$ to $R_7$ may each independently be hydrogen, deuterium, -F, a cyano group;

a methyl group, an ethyl group, an n-propyl group, an isopropyl group, an n-butyl group, an isobutyl group, a sec-butyl group, a tert-butyl group, an n-pentyl group, an isopentyl group, a sec-pentyl group, a tert-pentyl group, a 2-methylbutyl group, a 2,2-dimethylpropyl group, a 1-ethylpropyl group, or a 1,2-dimethylpropyl group, each unsubstituted or substituted with deuterium, -F, -Cl, -Br, -I, a hydroxyl group, a cyano group, or a nitro group; or

a benzene group, a naphthalene group, a biphenyl group, a terphenyl group, a pyridine group, a dibenzofuran group, a dibenzothiophene group, a carbazole group, an azadibenzofuran group, an azadibenzothiophene group, or an azacarbazole group, each unsubstituted or substituted with deuterium, -F, -Cl, -Br, -I, a hydroxyl group, a cyano group, a nitro group, a methyl group, an ethyl group, an n-propyl group, an iso-propyl group, an n-butyl group, an isobutyl group, a sec-butyl group, a tert-butyl group, an n-pentyl group, an isopentyl group, a sec-pentyl group, a tert-pentyl group, a 2-methylbutyl group, a 2,2-dimethylpropyl group, a 1-ethylpropyl, 1,2-dimethylpropyl group, or a phenyl group.

According to one or more embodiments, $R_1$ to $R_7$ may each independently be:

hydrogen, deuterium, -F, -Cl, -Br, -I, a cyano group, a $C_1$-$C_{20}$ (e.g. $C_1$-$C_{10}$) alkyl group;

a $C_1$-$C_{20}$ (e.g. $C_1$-$C_{10}$) alkyl group substituted with at least one of deuterium, - F, -Cl, -Br, -I, $-CD_3$, $-CD_2H$, $-CDH_2$, $-CF_3$, $-CF_2H$, $-CFH_2$, a cyano group, a nitro group, a $C_1$-$C_{10}$ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a naphthyl group, a pyridinyl group, and a pyrimidinyl group;

a phenyl group, a biphenyl group, a terphenyl group, a pyridine group, a dibenzofuranyl group, a dibenzothiophenyl group, a carbazolyl group, an azadibenzofuranyl group, an azadibenzothiophenyl group, or an azacarbazolyl group, each unsubstituted or substituted with at least one of deuterium, -F, -Cl, -Br, -I, $-CD_3$, - $CD_2H$, $-CDH_2$, $-CF_3$, $-CF_2H$, $-CFH_2$, a cyano group, a $C_1$-$C_{20}$ (e.g. $C_1$-$C_{10}$) alkyl group, a phenyl group, a biphenyl group, a ($C_1$-$C_{10}$ alkyl)phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, **$-Si(Q_{31})(Q_{32})(Q_{33})$, $-N(Q_{31})(Q_{32})$,** and **$-B(Q_{31})(Q_{32})$; or**

**$-Si(Q_1)(Q_2)(Q_3)$,** $-N(Q_1)(Q_2)$, or $-B(Q_1)(Q_2)$, and

$Q_1$ to $Q_3$ and $Q_{31}$ to $Q_{33}$ may each independently be:

$-CH_3$, $-CD_3$, $-CD_2H$, $-CDH_2$, $-CH_2CH_3$, $-CH_2CD_3$, $-CH_2CD_2H$, $-CH_2CDH_2$, - $CHDCH_3$, $-CHDCD_2H$, $-CHDCDH_2$, $-CHDCD_3$, $-CD_2CD_3$, $-CD_2CD_2H$, or $-CD_2CDH_2$; or

an n-propyl group, an iso-propyl group, an n-butyl group, an isobutyl group, a sec-butyl group, a tert-butyl group, an n-pentyl group, an isopentyl group, a sec-pentyl group, a tert-pentyl group, a phenyl group, a naphthyl group, a pyridinyl group, a pyrimidinyl group, a pyridazinyl group, a pyrazinyl group, or a triazinyl group, each unsubstituted or substituted with at least one of deuterium, a $C_1$-$C_{10}$ alkyl group, a phenyl group, a biphenyl group, a pyridinyl group, a pyrimidinyl group, a pyridazinyl group, a pyrazinyl group, or a triazinyl group.

According to one or more embodiments, $R_1$ to $R_7$ may each independently be: hydrogen, deuterium, -F, -Cl, -Br, -I, a cyano group, a $C_1$-$C_{20}$ (e.g. $C_1$-$C_{10}$) alkyl group;

a $C_1$-$C_{20}$ (e.g. $C_1$-$C_{10}$) alkyl group substituted with at least one of deuterium, - F, -Cl, -Br, -I, $-CD_3$, $-CD_2H$, $-CDH_2$, $-CF_3$, $-CF_2H$, $-CFH_2$, a cyano group, a nitro group, a $C_1$-$C_{10}$ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a naphthyl group, a pyridinyl group, and a pyrimidinyl group;

a phenyl group, a pyridine group, a dibenzofuranyl group, a dibenzothiophenyl group, a carbazolyl group, an azadibenzofuranyl group, an azadibenzothiophenyl group, or an azacarbazolyl group, each unsubstituted or substituted with at least one of deuterium, -F, -Cl, -Br, -I, $-CD_3$, $-CD_2H$, $-CDH_2$, $-CF_3$, $- CF_2H$, $-CFH_2$, a cyano group, a $C_1$-$C_{20}$ alkyl group, a phenyl group, a biphenyl group, a ($C_1$-$C_{10}$ alkyl)phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, $-Si(Q_{31})(Q_{32})(Q_{33})$, $- N(Q_{31})(Q_{32})$, and $-B(Q_{31})(Q_{32})$; or

$-Si(Q_1)(Q_2)(Q_3)$, $-N(Q_1)(Q_2)$, or $-B(Q_1)(Q_2)$, and

$Q_1$ to $Q_3$ and $Q_{31}$ to $Q_{33}$ may each independently be:

$-CH_3$, $-CD_3$, $-CD_2H$, $-CDH_2$, $-CH_2CH_3$, $-CH_2CD_3$, $-CH_2CD_2H$, $-CH_2CDH_2$, $- CHDCH_3$, $-CHDCD_2H$, $-CHDCDH_2$, $-CHDCD_3$, $-CD_2CD_3$, $-CD_2CD_2H$, or $-CD_2CDH_2$; or

an n-propyl group, an iso-propyl group, an n-butyl group, an isobutyl group, a sec-butyl group, a tert-butyl group, an n-pentyl group, an isopentyl group, a sec-pentyl group, a tert-pentyl group, a phenyl group, a naphthyl group, a pyridinyl group, a pyrimidinyl group, a pyridazinyl group, a pyrazinyl group, or a triazinyl group, each unsubstituted or substituted with at least one of deuterium, a $C_1$-$C_{10}$ alkyl group, a phenyl group, a biphenyl group, a pyridinyl group, a pyrimidinyl group, a pyridazinyl group, a pyrazinyl group, or a triazinyl group.

According to one or more embodiments, $R_1$ to $R_7$ may each independently be:

hydrogen, deuterium, -F, a cyano group;

a methyl group, an ethyl group, an n-propyl group, an isopropyl group, an n-butyl group, an isobutyl group, a sec-butyl group, a tert-butyl group, an n-pentyl group, an isopentyl group, a sec-pentyl group, a tert-pentyl group, a 2-methylbutyl group, a 2,2-dimethylpropyl group, a 1-ethylpropyl group, or a 1,2-dimethylpropyl group, each unsubstituted or substituted with deuterium, -F, -Cl, -Br, -I, a hydroxyl group, a cyano group, or a nitro group; or

a benzene group, a naphthalene group, a biphenyl group, a terphenyl group, a pyridine group, a dibenzofuran group, a dibenzothiophene group, a carbazole group, an azadibenzofuran group, an azadibenzothiophene group, or an azacarbazole group, each unsubstituted or substituted with deuterium, -F, -Cl, -Br, -I, a hydroxyl group, a cyano group, a nitro group, a methyl group, an ethyl group, an n-propyl group, an iso-propyl group, an n-butyl group, an isobutyl group, a sec-butyl group, a tert-butyl group, an n-pentyl group, an isopentyl group, a sec-pentyl group, a tert-pentyl group, a 2-methylbutyl group, a 2,2-dimethylpropyl group, a 1-ethylpropyl, 1,2-dimethylpropyl group, a phenyl group, and/or a (e.g., any suitable) combination thereof.

According to one or more embodiments, the organometallic compound may be any one selected from among Compounds BD1 to BD8.

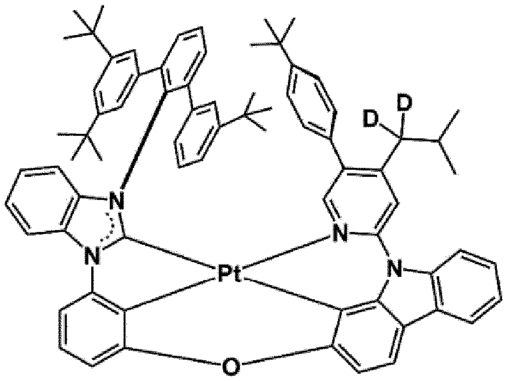

BD1

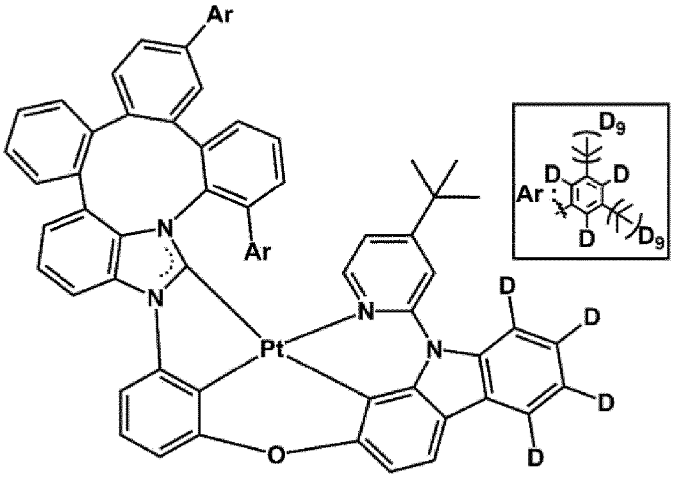

BD2

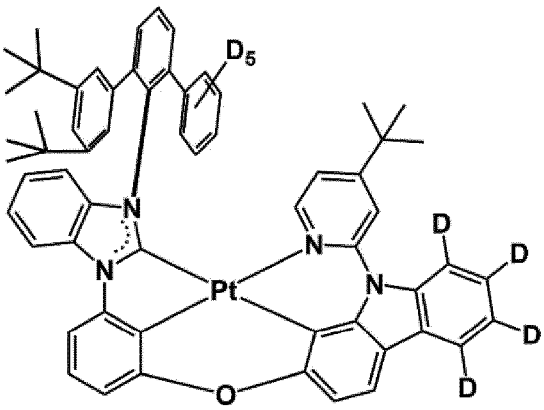

BD3

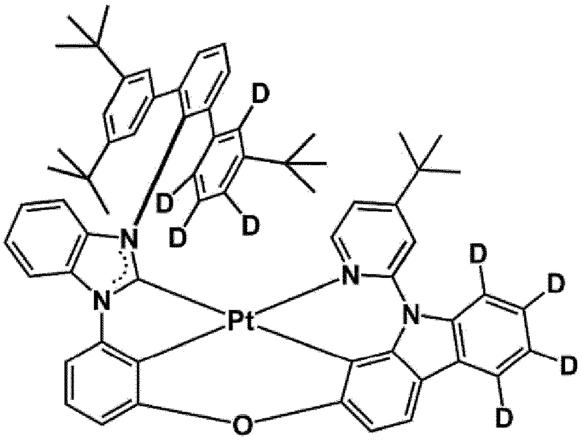

BD4

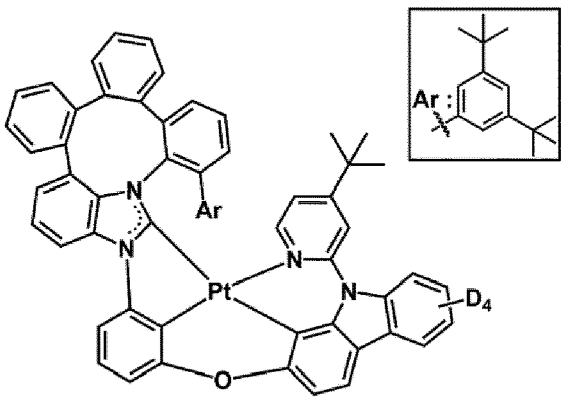

BD5

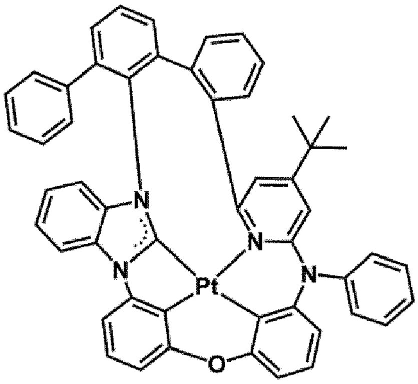

BD6

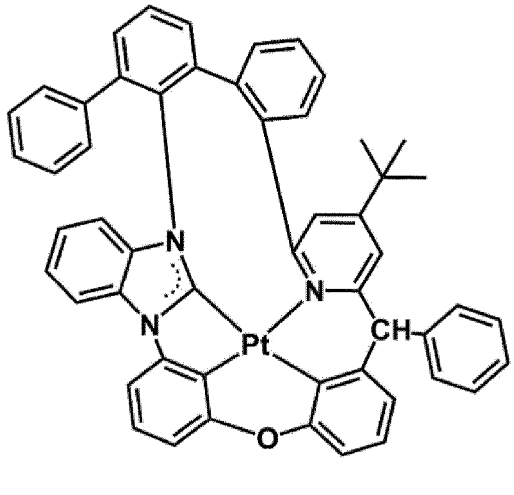

BD7

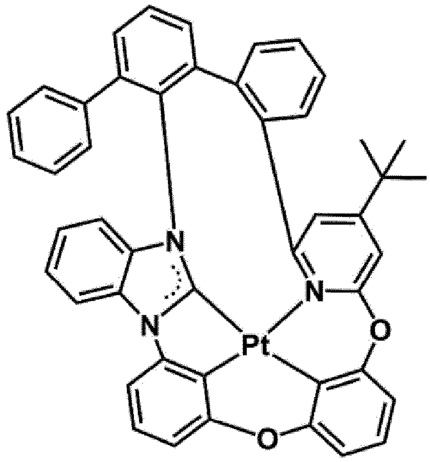

BD8 .

The organometallic compound satisfies Condition 1 and Condition 2:

**Condition 1**

$$\Delta G(T_1) - \Delta G(BDE)$$

is greater than (>) 0 kcal/mol,

**Condition 2**

The percent buried volume of the organometallic compound is at most 25% (e.g., or less),

wherein, in Condition 1 and Condition 2,
$\Delta G(T_1)$ is the triplet excited state energy of the organometallic compound, and $\Delta G(BDE)$ is the binding energy of N* and C* at (e.g., in)

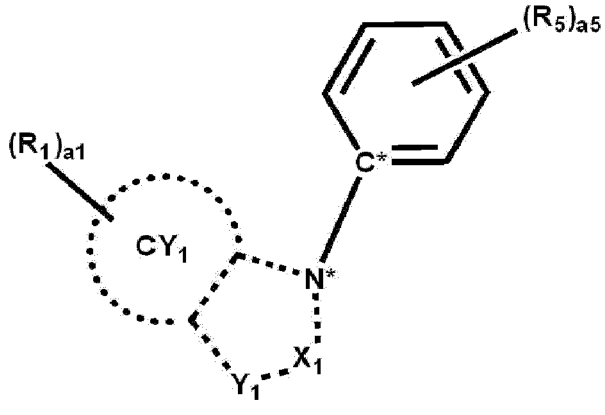

in Formula 1, and
the percent buried volume of the organometallic compound is the percentage of the ratio of the volume of the organometallic compound to the volume of a sphere around (e.g., surrounding) the molecule of the organometallic compound.

Accordingly, the organometallic compound may improve color purity and a driving voltage of the light-emitting device. Moreover, in a light-emitting device including the organometallic compound, energy may be easily transferred

within the light-emitting device, thereby improving lifespan characteristics.

Synthesis methods of the organometallic compound represented by Formula 1 may be recognizable by one of ordinary skill in the art by referring to the Synthesis Examples and/or Examples provided herein.

At least one organometallic compound represented by Formula 1 may be used in a light-emitting device (e.g., an organic light-emitting device). Accordingly, provided is a light-emitting device including: a first electrode; a second electrode opposite to (e.g., facing) the first electrode; an interlayer arranged between the first electrode and the second electrode and including an emission layer wherein the light-emitting device includes the organometallic compound represented by Formula 1.

According to one or more embodiments,

the first electrode of the light-emitting device may be an anode,
the second electrode of the light-emitting device may be a cathode,
the interlayer may further include a hole transport region between the first electrode and the emission layer and an electron transport region between the emission layer and the second electrode,
the hole transport region may include a hole injection layer, a hole transport layer, an emission auxiliary layer, an electron-blocking layer, or any combination thereof, and
the electron transport region may include a hole-blocking layer, an electron transport layer, an electron injection layer, an electron control layer, or any combination thereof.

In one or more embodiments, the organometallic compound represented by Formula 1 may be included in the interlayer.

In one or more embodiments, the organometallic compound represented by Formula 1 may be included in the emission layer.

In one or more embodiments, the emission layer may include a host and a dopant, and the dopant may include the organometallic compound represented by Formula 1.

In one or more embodiments, the emission layer may be to emit blue light.

In one or more embodiments, the dopant may be a phosphorescent dopant or a delayed fluorescence dopant.

In one or more embodiments, the host may include a first host including at least one electron donating group and a second host including at least one electron withdrawing group.

In one or more embodiments, the emission layer may further include a sensitizer.

In one or more embodiments, the emission layer may include a delayed fluorescence material.

In one or more embodiments, the emission layer may be to emit blue light.

According to one or more embodiments, the emission layer may further include a first host and a second host, wherein the first host may be a hole-transporting compound including at least one electron-donating group, and the second host may be an electron-transporting host including at least one electron-withdrawing group.

According to one or more embodiments, the emission layer may further include a third compound, and the third compound may be a metal-containing compound.

According to one or more embodiments, the third compound may serve as a sensitizer such as a phosphorescent sensitizer.

According to one or more embodiments, the third compound may not emit light.

In some embodiments, the emission layer may further include at least one of an auxiliary dopant and a sensitizer.

In one or more embodiments, the auxiliary dopant and the sensitizer may each independently be an organometallic compound including Pt and a tetradentate ligand bonded to Pt, wherein the tetradentate ligand may include a carbene moiety chemically bonded to the Pt. For example, the auxiliary dopant and/or the sensitizer may include the third compound.

According to one or more embodiments, the first host and the second host may serve as an exciplex host.

The term "electron-donating group" refers to any moiety having ability to donate electrons, and for example, may be a $\pi$ electron-rich $C_3$-$C_{60}$ cyclic group or an amine group, but the present disclosure is not limited thereto. The electron-donating group may refer to a cyclic group other than an $\pi$ electron-deficient nitrogen-containing $C_1$-$C_{60}$ cyclic group.

The term "electron-withdrawing group" refers to any moiety having ability to withdraw electrons, and for example, may be -F, $-CFH_2$, $-CF_2H$, $-CF_3$, -CN, $-NO_2$, a $\pi$ electron-deficient nitrogen-containing $C_1$-$C_{60}$ cyclic group, or any combination thereof. However, embodiments are not limited thereto.

Regarding a luminescence pathway in the light-emitting device according to one or more embodiments, the first host and the second host may form an exciton (1st step), the energy of the exciton may be transferred to the third compound (2nd step), and the energy may be transferred from the third compound to the organometallic compound (3rd step).

According to one or more embodiments, the amount of the third compound may be more than 0 parts by weight and less than 50 parts by weight based on the total weight of 100 parts by weight of the emission layer.

According to one or more embodiments, the first host may include at least one carbazole moiety, and the second host may include at least one azine moiety.

According to one or more embodiments, the first host may be any one represented by Formula 301-1 A or 301-2A:

**Formula 301-1A**

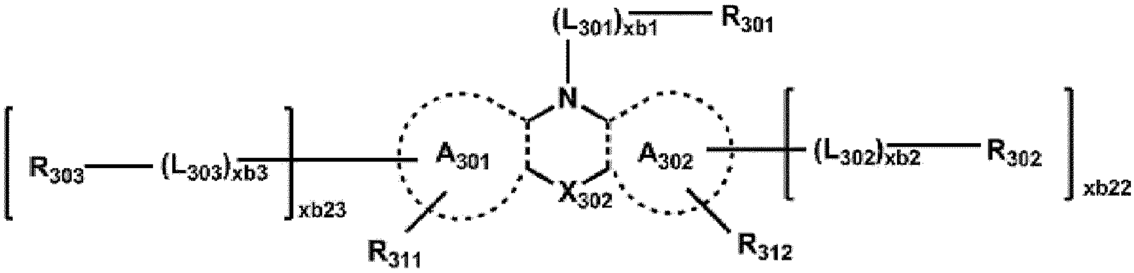

**Formula 301-2A**

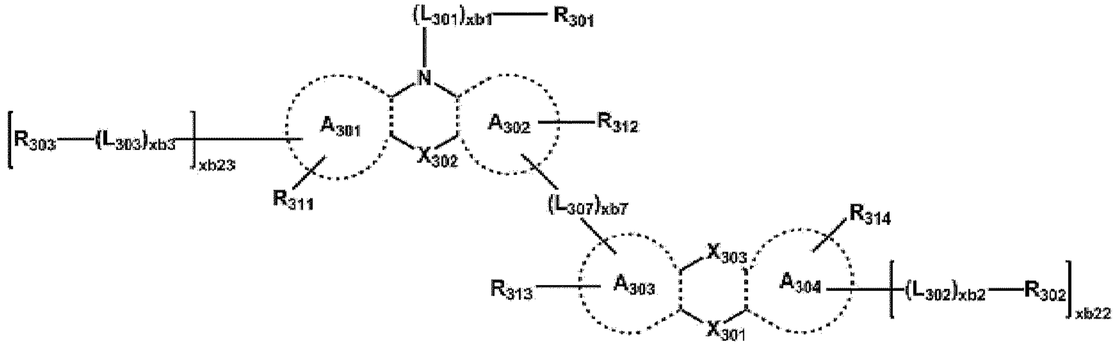

wherein, in Formulae 301-1A and 301-2A,

ring $A_{301}$ to ring $A_{304}$ may each independently be a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,
$X_{301}$ may be O, S, N-[$(L_{304})_{xb4}$-$R_{304}$], C($R_{304a}$)($R_{304a}$), or Si($R_{304a}$)($R_{305}$),
$X_{302}$ may be a single bond, O, S, N-[$(L_{305})_{xb5}$-$R_{305a}$], C(R1111111$_{305a}$)($R_{305b}$), or Si($R_{305a}$)($R_{305b}$),
$X_{303}$ may be a single bond, O, S, N-[$(L_{306})_{xb6}$-$R_{306a}$], C($R_{306a}$)($R_{306b}$), or Si(R306$_a$)(R306$_b$),
xb22 and xb23 may each independently be an integer from 0 to 10,
$L_{301}$ to $L_{307}$ may each independently be a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,
xb1 to xb7 may each independently be an integer from 0 to 5,
$R_{301}$ to $R_{303}$, $R_{304a}$ to $R_{306a}$, $R_{304b}$ to $R_{306b}$, and $R_{311}$ to $R_{314}$ may each independently be hydrogen, deuterium, -F, -Cl, -Br, -I, a hydroxyl group, a cyano group, a nitro group, a $C_1$-$C_{60}$ alkyl group unsubstituted or substituted with at least one $R_{10a}$, a $C_2$-$C_{60}$ alkenyl group unsubstituted or substituted with at least one $R_{10a}$, a $C_2$-$C_{60}$ alkynyl group unsubstituted or substituted with at least one $R_{10a}$, a $C_1$-$C_{60}$ alkoxy group unsubstituted or substituted with at least one $R_{10a}$, a $C_3$-$C_{60}$ carbocyclic group unsubstituted or substituted with at least one $R_{10a}$, a $C_1$-$C_{60}$ heterocyclic group unsubstituted or substituted with at least one $R_{10a}$, -Si($Q_{301}$)($Q_{302}$)($Q_{303}$), -N($Q_{301}$)($Q_{302}$), -B($Q_{301}$)($Q_{302}$), -C(=O)($Q_{301}$), -S(=O)$_2$($Q_{301}$), or -P(=O)($Q_{301}$)($Q_{302}$), and
$Q_{301}$ to $Q_{303}$ are each as described in connection with $Q_1$.

According to one or more embodiments, the first host may be one of (e.g., any one selected from among) Compounds HTH1 to HTH56, but embodiments are not limited thereto:

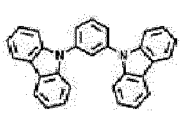

HTH1

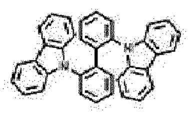

HTH2

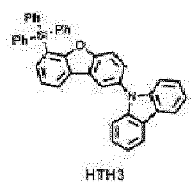

HTH3

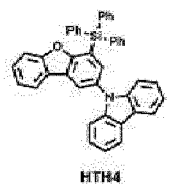

HTH4

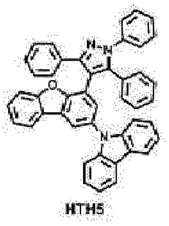
HTH5

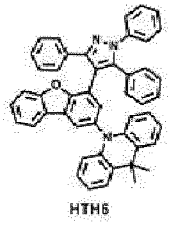
HTH6

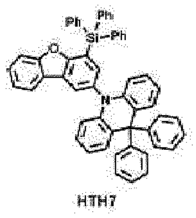
HTH7

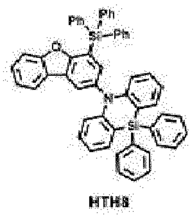
HTH8

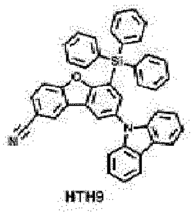
HTH9

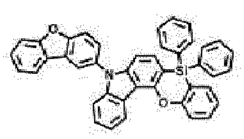
HTH10

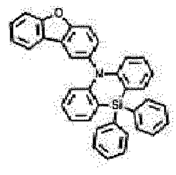
HTH11

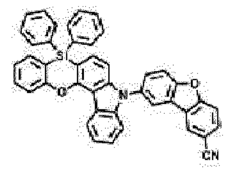
HTH12

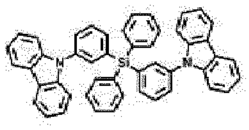
HTH13

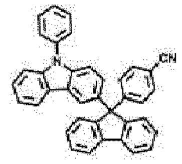
HTH14

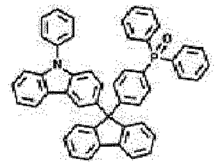
HTH15

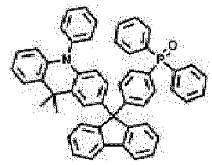
HTH16

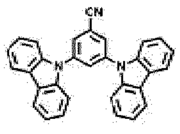
HTH17

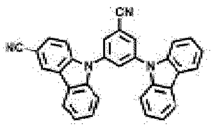
HTH18

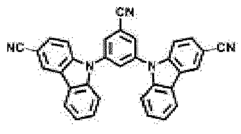
HTH19

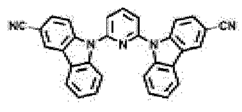
HTH20

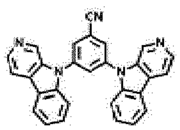
HTH21

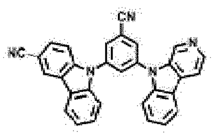
HTH22

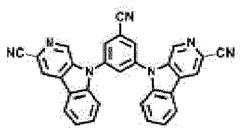
HTH23

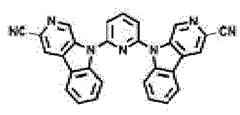
HTH24

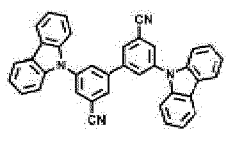
HTH25

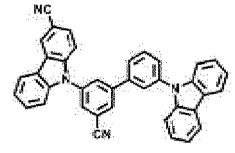
HTH26

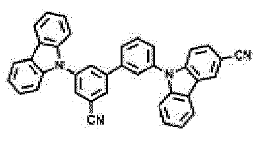
HTH27

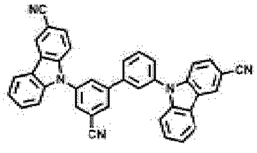
HTH28

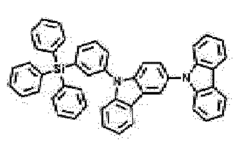
HTH29

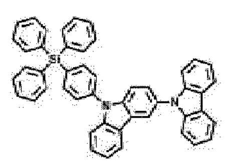
HTH30

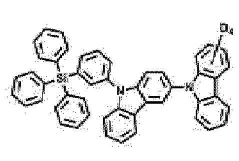
HTH31

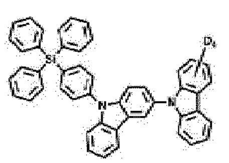
HTH32

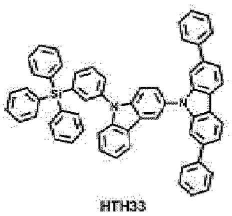
HTH33

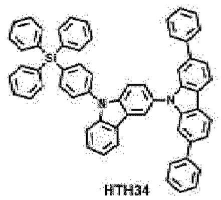
HTH34

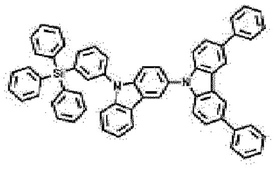
HTH35

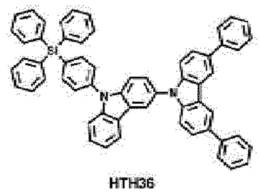
HTH36

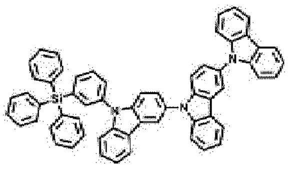
HTH37

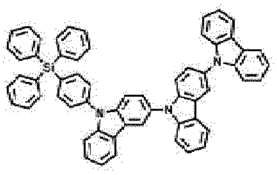
HTH38

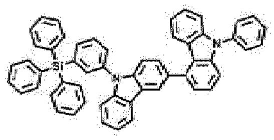
HTH39

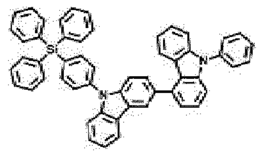
HTH40

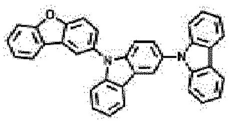
HTH41

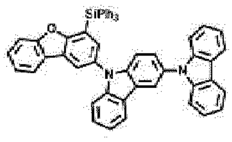
HTH42

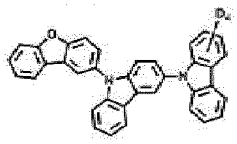
HTH43

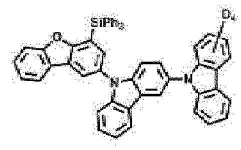
HTH44

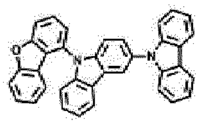
HTH45

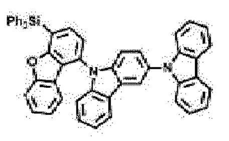
HTH46

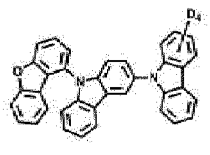
HTH47

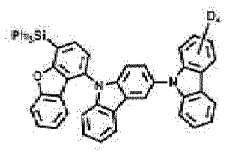
HTH48

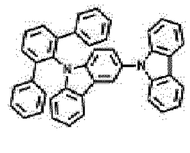
HTH49

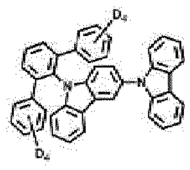
HTH50

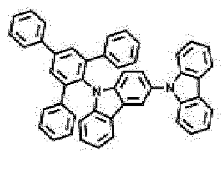
HTH51

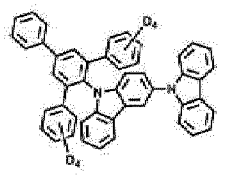
HTH52

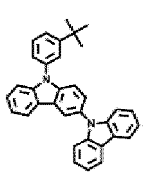
HTH53

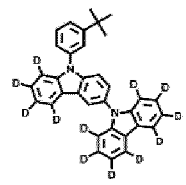
HTH54

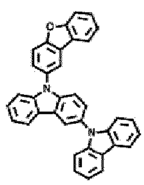
HTH55

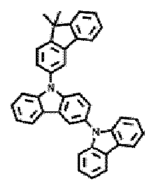
HTH56 .

According to one or more embodiments, the second host may be represented by Formula 302:

## Formula 302

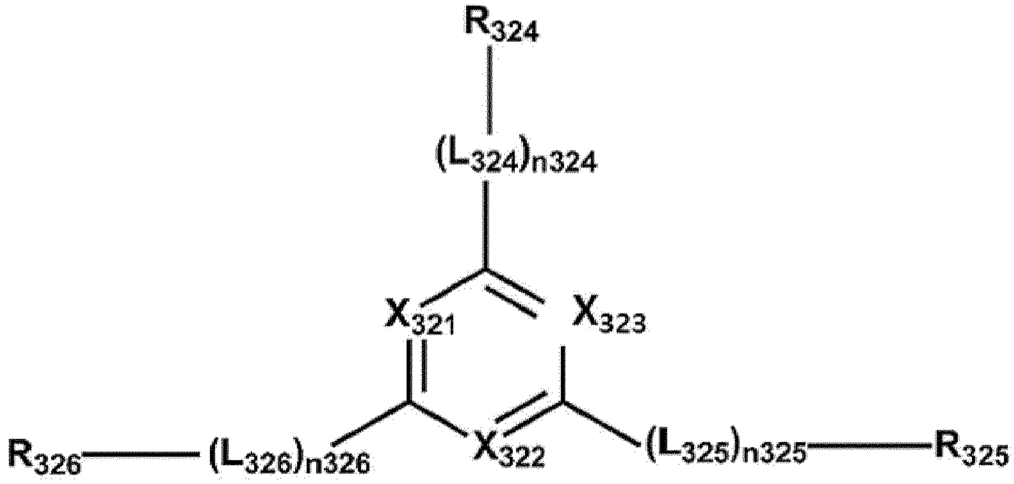

wherein, in Formula 302,

$X_{321}$ may be $C(R_{321})$ or N,
$X_{322}$ may be $C(R_{322})$ or N,
$X_{323}$ may be $C(R_{323})$ or N,
at least one of $X_{321}$ to $X_{323}$ may be N,
$L_{324}$ to $L_{326}$ may each independently be a single bond, a $C_3$-$C_{60}$ carbocyclic group unsubstituted or substituted with at least one $R_{10a}$, a $C_1$-$C_{60}$ heterocyclic group unsubstituted or substituted with at least one $R_{10a}$, *-C($Q_{321}$)($Q_{322}$)-*' *-Si($Q_{321}$)($Q_{322}$)-*' *-B($Q_{321}$)-*', or *-N($Q_{321}$)-*',
n324 to n326 may each independently be an integer from 1 to 5,
$R_{321}$ to $R_{326}$ may each independently be hydrogen, deuterium, -F, -Cl, -Br, -I, a hydroxyl group, a cyano group, a nitro group, a $C_1$-$C_{60}$ alkyl group unsubstituted or substituted with at least one $R_{10a}$, a $C_2$-$C_{60}$ alkenyl group unsubstituted or substituted with at least one $R_{10a}$, a $C_2$-$C_{60}$ alkynyl group unsubstituted or substituted with at least one $R_{10a}$, a $C_1$-$C_{60}$ alkoxy group unsubstituted or substituted with at least one $R_{10a}$, a $C_3$-$C_{60}$ carbocyclic group unsubstituted or substituted with at least one $R_{10a}$, a $C_1$-$C_{60}$ heterocyclic group unsubstituted or substituted with at least one $R_{10a}$, - Si($Q_{323}$)($Q_{324}$)($Q_{325}$), -N($Q_{323}$)($Q_{324}$), -B($Q_{323}$)($Q_{324}$), -C(=O)($Q_{323}$), -S(=O)$_2$($Q_{323}$), or - P(=O)($Q_{323}$)($Q_{324}$),
two or more neighboring groups among $Q_{321}$ to $Q_{325}$ and $R_{321}$ to $R_{326}$ may optionally be bonded to each other to form a $C_5$-$C_{30}$ carbocyclic group unsubstituted or substituted with at least one $R_{10a}$ or a $C_2$-$C_{30}$ heterocyclic group unsubstituted or substituted with at least one $R_{10a}$,
* and *' each indicate a binding site to a neighboring atom,
$R_{10a}$ is the same as described herein, and
$Q_{321}$ to $Q_{325}$ are each as described in connection with $Q_1$.

According to an one or more embodiments, the second host may be one of (e.g., any one selected from among) Compounds ETH1 to ETH86, but embodiments are not limited thereto:

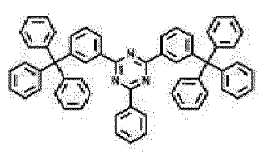

ETH1

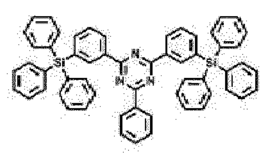

ETH2

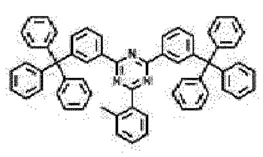

ETH3

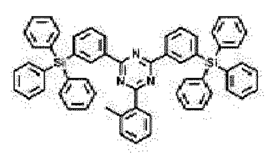

ETH4

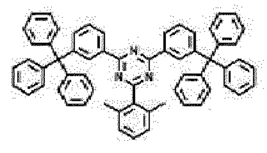

ETH5

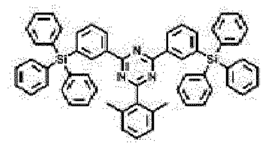

ETH6

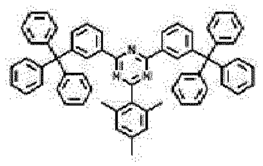

ETH7

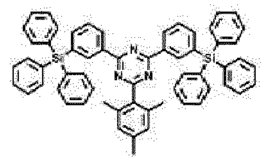

ETH8

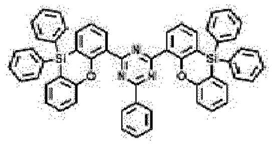

ETH9

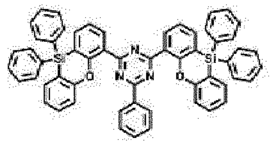

ETH10

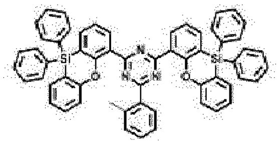

ETH11

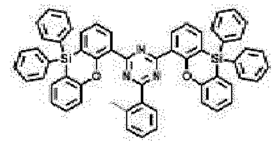

ETH12

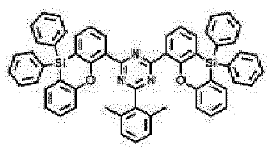

ETH13

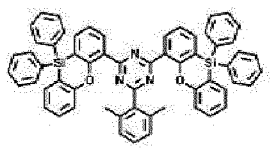

ETH14

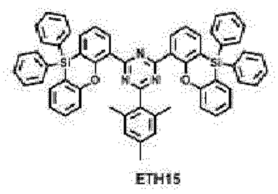

ETH15

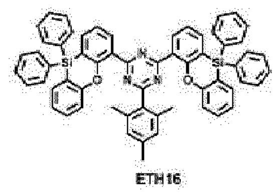

ETH16

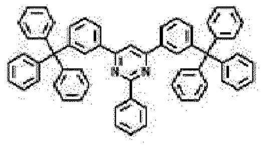

ETH17

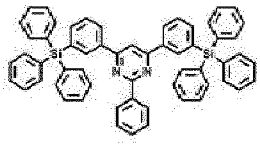

ETH18

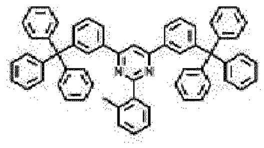

ETH19

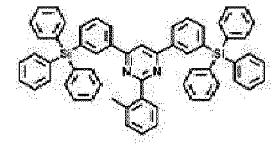

ETH20

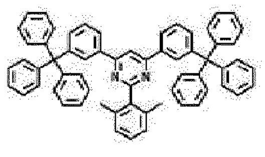

ETH21

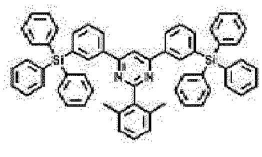

ETH22

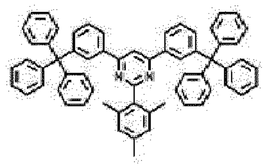

ETH23

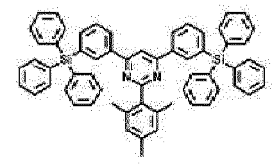

ETH24

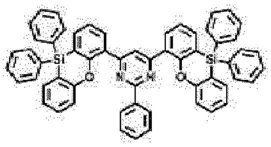

ETH25

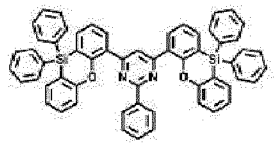

ETH26

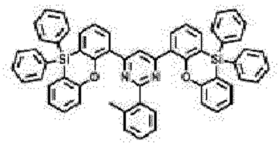

ETH27

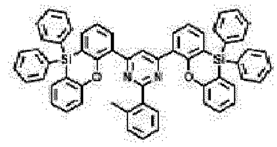

ETH28

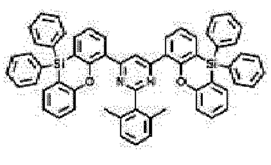

ETH29

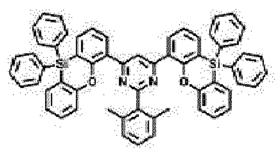

ETH30

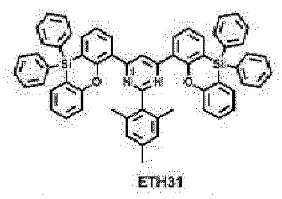

ETH31

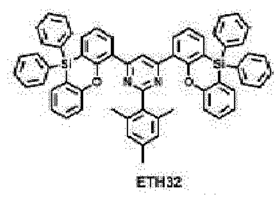

ETH32

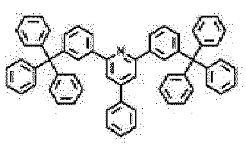

ETH33

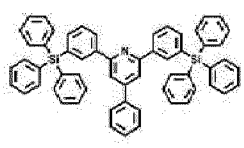

ETH34

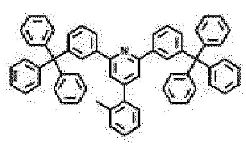

ETH35

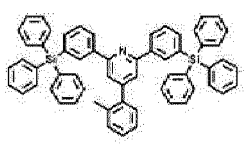

ETH36

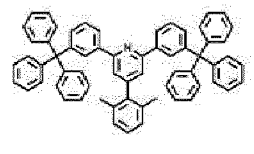
ETH37

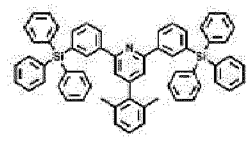
ETH38

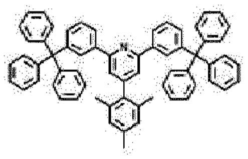
ETH39

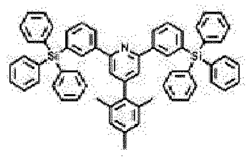
ETH40

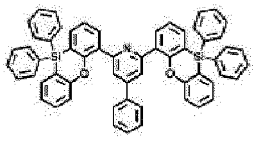
ETH41

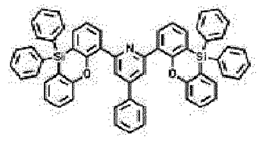
ETH42

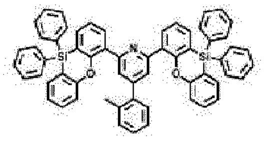
ETH43

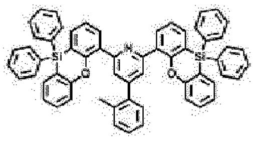
ETH44

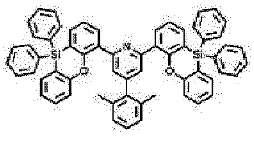
ETH45

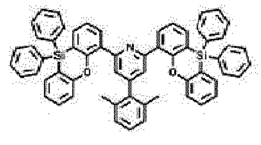
ETH46

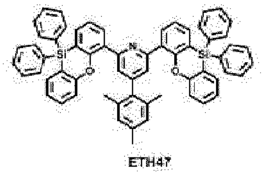
ETH47

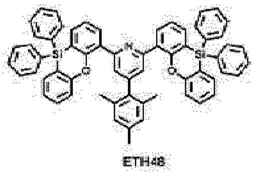
ETH48

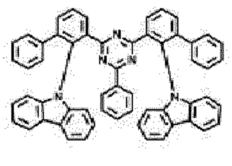
ETH49

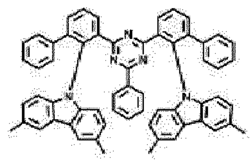
ETH50

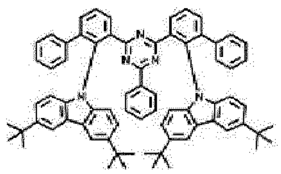
ETH51

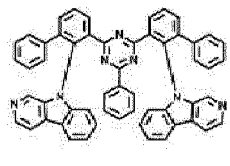
ETH52

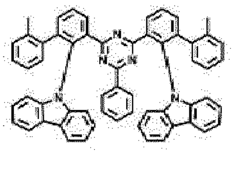
ETH53

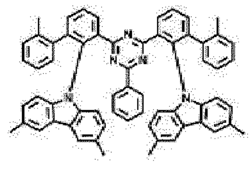
ETH54

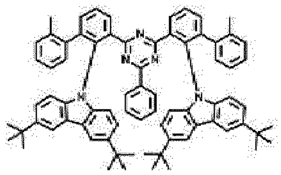
ETH55

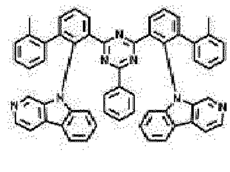
ETH56

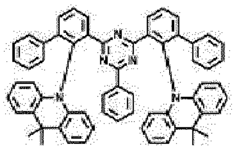
ETH57

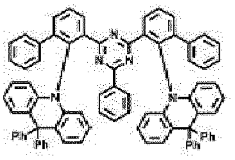
ETH58

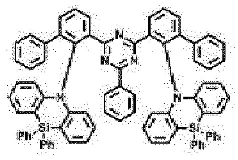
ETH59

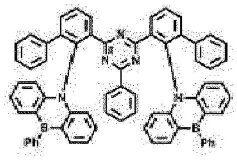
ETH60

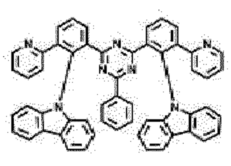
ETH61

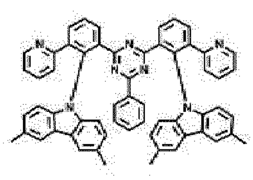
ETH62

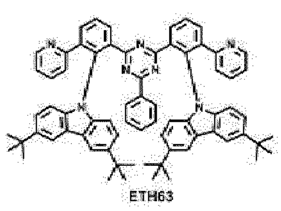
ETH63

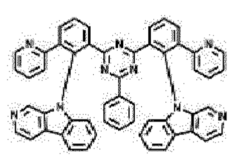
ETH64

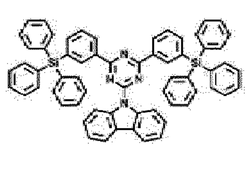

ETH65

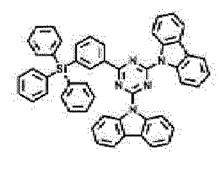

ETH66

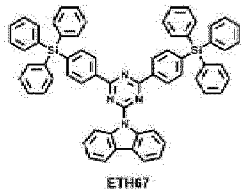

ETH67

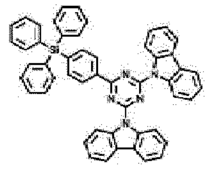

ETH68

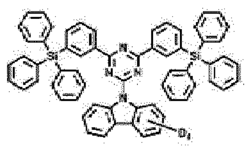

ETH69

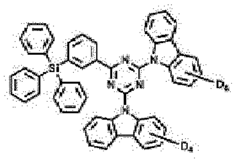

ETH70

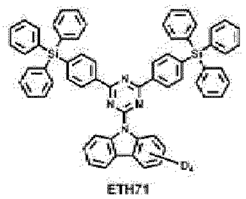

ETH71

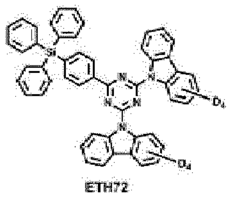

ETH72

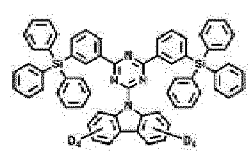

ETH73

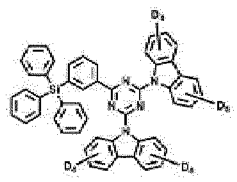

ETH74

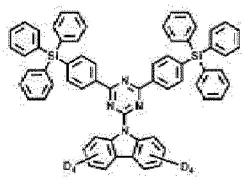

ETH75

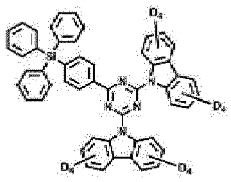

ETH76

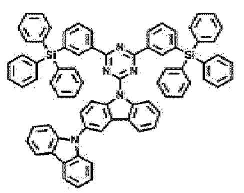

ETH77

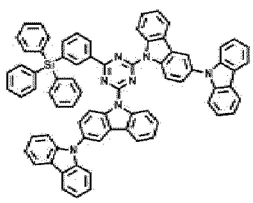

ETH78

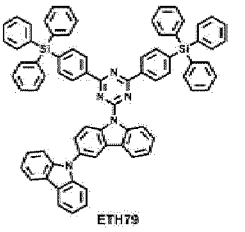

ETH79

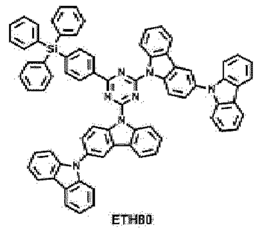

ETH80

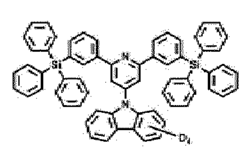

ETH81

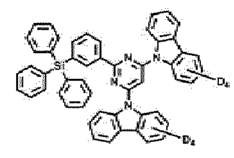

ETH82

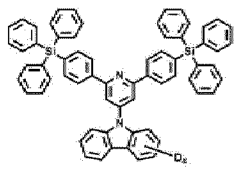

ETH83

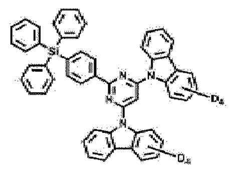

ETH84

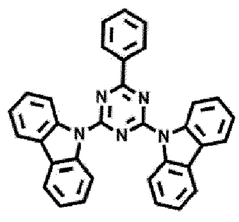

ETH85

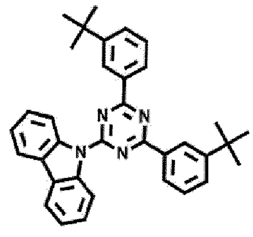

ETH86

According to one or more embodiments, the third compound may be represented by Formula 401A:

**Formula 401A** $M_{401}(L_{401})_{n401} (L_{402})_{n402}$

**Formula 402A**

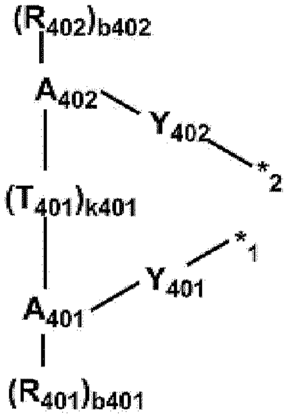

**Formula 402B**

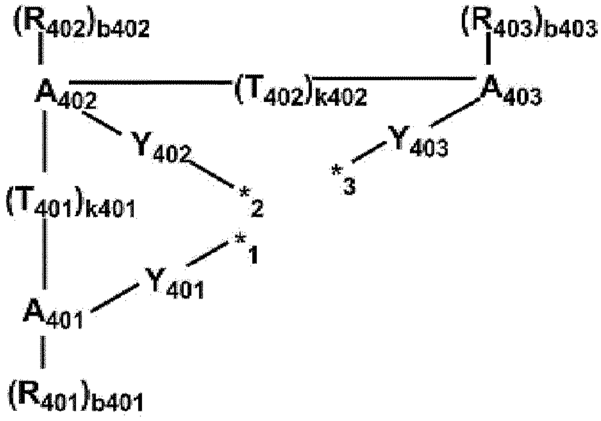

**Formula 402C**

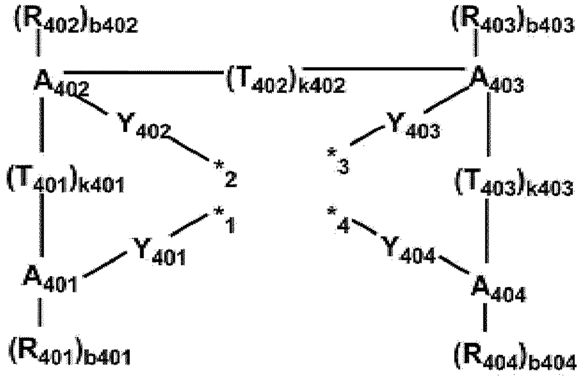

**Formula 402D**

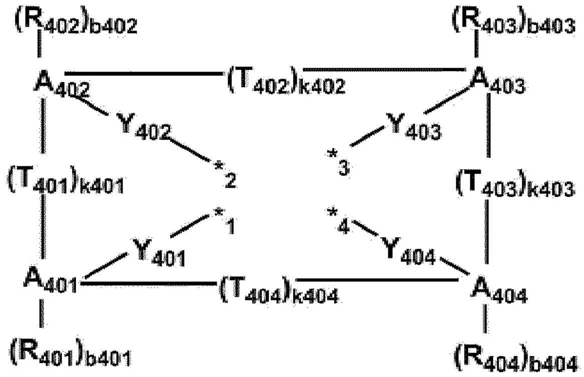

wherein, in Formulae 401A and 402A to 402D,

$M_{401}$ may be a first-row transition metal of the Periodic Table of Elements, a second-row transition metal of the Periodic Table of Elements, or a third-row transition metal of the Periodic Table of Elements,
$L_{401}$ may be a ligand represented by one of Formulae 402A to 402D,
$L_{402}$ may be a monodentate ligand, a bidentate ligand, or a tridentate ligand,
n401 may be 1 or 2,
n402 may be an integer from 0 to 4,
$A_{401}$ to $A_{404}$ may each independently be a $C_5$-$C_{30}$ carbocyclic group or a $C_1$-$C_{30}$ heterocyclic group,
$T_{401}$ to $T_{404}$ may each independently be a single bond, a double bond, *-O-*', *-S-*', *-C(=O)-*', *-S(=O)-*', *-C($R_{405}$)($R_{406}$)-*', *-C($R_{405}$)=C($R_{406}$)-*', *-C($R_{405}$)=*', *-Si($R_{405}$)($R_{406}$)-*', *-B($R_{405}$)-*', *-N($R_{405}$)-*', or *-P($R_{405}$)-*',
k401 to k404 may each independently be 1, 2, or 3,
$Y_{401}$ to $Y_{404}$ may each independently be a single bond (e.g., m a covalent bond or a coordinate bond), *-O-*', *-S-*', *-C($R_{407}$)($R_{408}$)-*', *-Si($R_{407}$)($R_{408}$)-*', *-B($R_{407}$)-*', *-N($R_{407}$)-*', or *-P($R_{407}$)-*',
*1, *2, *3, and *4 each indicate a binding site to $M_{401}$,
$R_{401}$ to $R_{408}$ may each independently be hydrogen, deuterium, -F, -Cl, -Br, -I, a hydroxyl group, a cyano group, a nitro group, a $C_1$-$C_{60}$ alkyl group unsubstituted or substituted with at least one $R_{10a}$, a $C_2$-$C_{60}$ alkenyl group unsubstituted or substituted with at least one $R_{10a}$, a $C_2$-$C_{60}$ alkynyl group unsubstituted or substituted with at least one $R_{10a}$, a $C_1$-$C_{60}$ alkoxy group unsubstituted or substituted with at least one $R_{10a}$, a $C_3$-$C_{60}$ carbocyclic group unsubstituted or substituted with at least one $R_{10a}$, a $C_1$-$C_{60}$ heterocyclic group unsubstituted or substituted with at least one $R_{10a}$, a $C_6$-$C_{60}$ aryloxy group unsubstituted or substituted with at least one $R_{10a}$, a $C_6$-$C_{60}$ arylthio group unsubstituted or substituted with at least one $R_{10a}$, -Si($Q_1$)($Q_2$)($Q_3$), -N($Q_1$)($Q_2$), - B($Q_1$)($Q_2$), -C(=O)($Q_1$), -S(=O)$_2$($Q_1$), or **-P(=O)($Q_1$)($Q_2$),**
$R_{401}$ to $R_{408}$ may optionally be bonded to each other to form a $C_5$-$C_{60}$ carbocyclic group unsubstituted or substituted with at least one $R_{10a}$ or a $C_1$-$C_{60}$ heterocyclic group unsubstituted or substituted with at least one $R_{10a}$,
b401 to b404 may each independently be an integer from 0 to 10,
* and *' each indicate a binding site to a neighboring atom, and

$Q_1$ to $Q_3$ and $R_{10a}$ are each the same as described herein.

According to one or more embodiments, the compound represented by Formula 401A may be a carbene complex.

The term "carbene complex" as used herein refers to a complex which includes metal and a ligand bonded to the metal, wherein at least one bond between the metal and the ligand is a bond between the metal and carbon of carbene.

According to one or more embodiments, the sensitizer may include the compound represented by Formula 401A.

According to one or more embodiments, the third compound may include one of (e.g., any one selected from among) Compounds PD1 to PD41, but one or more embodiments are not limited thereto:

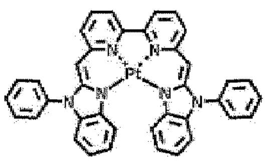
PD1

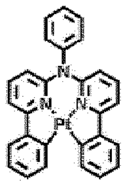
PD2

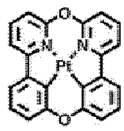
PD3

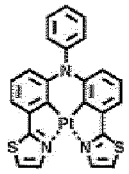
PD4

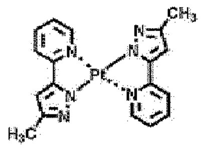
PD5

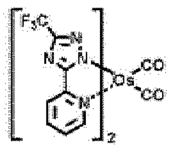
PD6

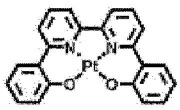
PD7

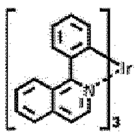
PD8

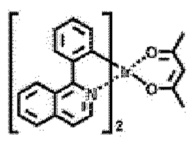
PD9

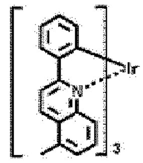
PD10

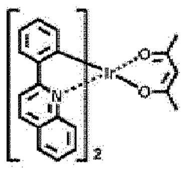
PD11

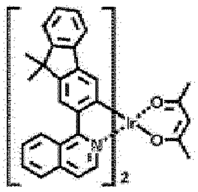
PD12

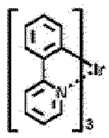
PD13

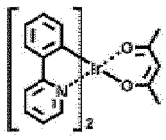
PD14

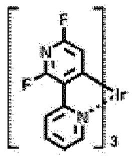
PD15

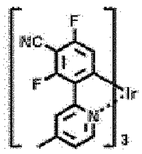
PD16

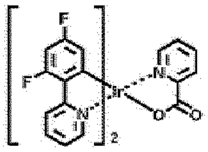
PD17

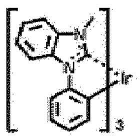
PD18

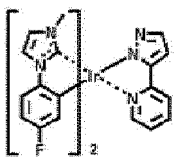
PD19

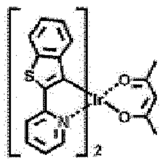
PD20

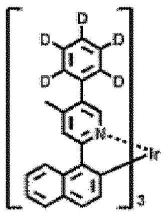
PD21

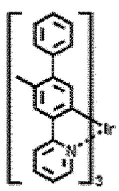
PD22

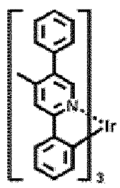
PD23

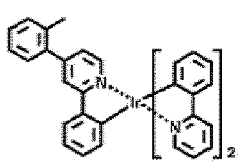
PD24

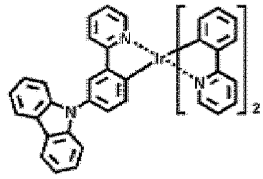
PD25

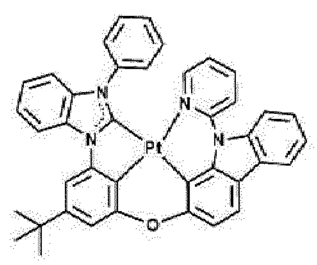
PD26

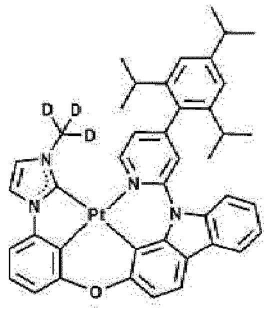
PD27

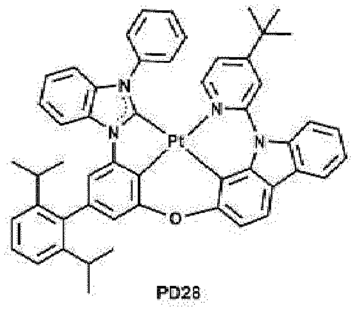
PD28

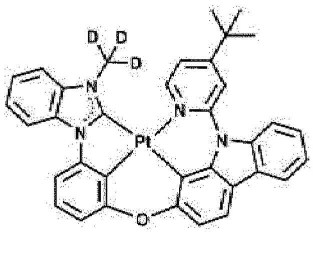
PD29

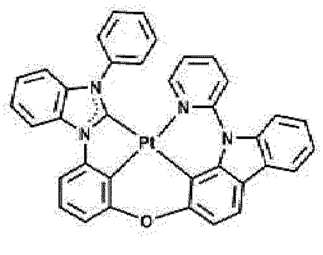
PD30

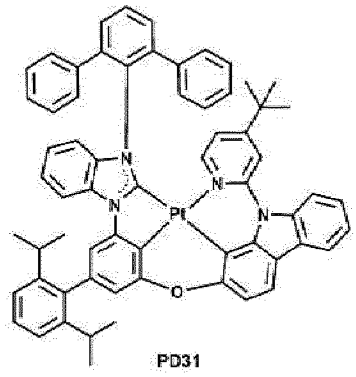
PD31

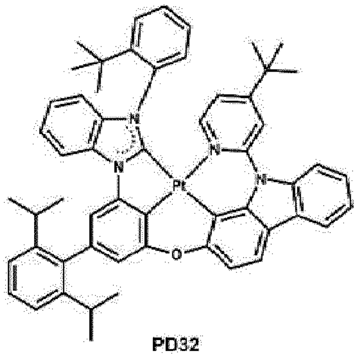
PD32

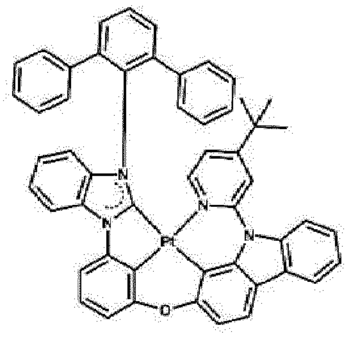
PD33

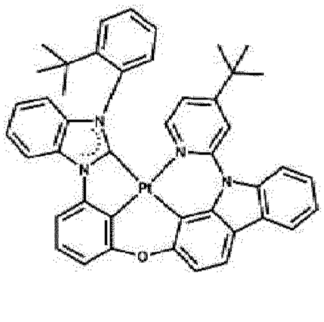
PD34

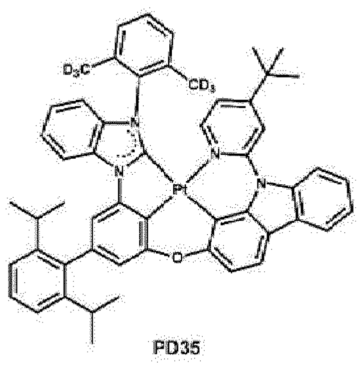
PD35

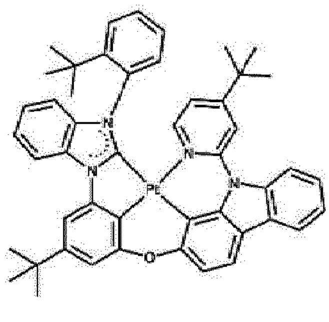
PD36

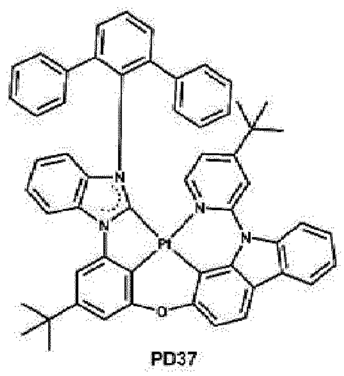
PD37

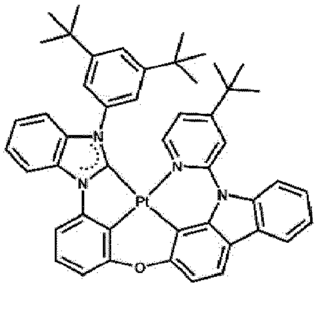

PD38

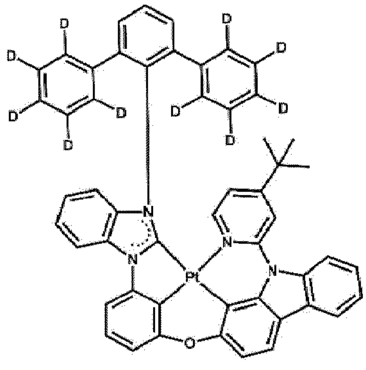

PD39

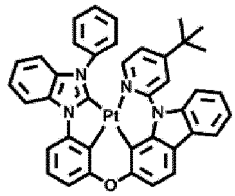

**PD40**

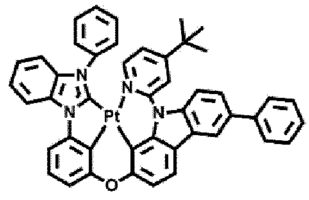

**PD41**

According to one or more embodiments, $R_{301}$ to $R_{303}$, $R_{304a}$ to $R_{306a}$, $R_{304b}$ to $R_{306b}$, and $R_{311}$ to $R_{314}$ in Formulae 301-1A and 301-2A, $R_{321}$ to $R_{326}$ in Formula 302, and $R_{401}$ to $R_{408}$ in Formulae 401A and 402A to 402D may each independently be: hydrogen, deuterium, -F, -Cl, -Br, -I, a hydroxyl group, a cyano group, a nitro group, an amidino group, a hydrazine group, a hydrazone group, a $C_1$-$C_{20}$ alkyl group, or a $C_1$-$C_{20}$ alkoxy group;

a $C_1$-$C_{20}$ alkyl group or a $C_1$-$C_{20}$ alkoxy group, each substituted with deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a $C_1$-$C_{10}$ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a naphthyl group, a pyridinyl group, a pyrimidinyl group, or any combination thereof;

a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a ($C_1$-$C_{10}$ alkyl)phenyl group, a naphthyl group, a tetrahydronaphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a benzoisoquinolinyl group, a phthalazinyl group, a naphthyridinyl group, a quinoxalinyl group, a benzoquinoxalinyl group, a quinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a thiadiazolyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, or an azadibenzosilolyl group, each unsubstituted or substituted with deuterium, -F, -Cl, -Br, - I, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a $C_1$-$C_{20}$alkyl group, a $C_1$-$C_{20}$ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a ($C_1$-$C_{10}$ alkyl)phenyl group, a naphthyl group, a tetrahydronaphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a

quinolinyl group, an isoquinolinyl group, a benzoquinolinyl group, a benzoisoquinolinyl group, a phthalazinyl group, a naphthyridinyl group, a quinoxalinyl group, a benzoquinoxalinyl group, a quinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a thiadiazolyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, an azadibenzosilolyl group, $-Si(Q_{31})(Q_{32})(Q_{33})$, $-B(Q_{31})(Q_{32})$, $-P(Q_{31})(Q_{32})$, $-C(=O)(Q_{31})$, $-S(=O)_2(Q_{31})$, $-P(=O)(Q_{31})(Q_{32})$, or any combination thereof; or
$-C(Q_1)(Q_2)(Q_3)$, $-S(Q_1)(Q_2)(Q_3)$, $-N(Q_1)(Q_2)$, $-B(Q_1)(Q_2)$, $-C(=O)(Q_1)$, $-S(=O)_2(Q_1)$, or $-P(=O)(Q_1)(Q_2)$, and
$Q_1$ to $Q_3$ and $Q_{31}$ to $Q_{33}$ are each the same as described herein.

In one or more embodiments, $R_{301}$ to $R_{303}$, $R_{304a}$ to $R_{306a}$, $R_{304b}$ to $R_{306b}$, and $R_{311}$ to $R_{314}$ in Formulae 301-1A to 301-2A, $R_{321}$ to $R_{326}$ in Formula 302, and $R_{401}$ to $R_{408}$ in Formulae 401A and 402A to 402D may each independently be:

hydrogen, deuterium, -F, -Cl, -Br, -I, $-CD_3$, $-CD_2H$, $-CDH_2$, $-CF_3$, $-CF_2H$, $-CFH_2$, a cyano group, a nitro group, a $C_1$-$C_{60}$ alkyl group, a $C_2$-$C_{60}$ alkenyl group, a $C_2$-$C_{60}$ alkynyl group, or a $C_1$-$C_{60}$ alkoxy group;
a group represented by one of Formulae 9-1 to 9-61 or a group represented by one of (e.g., any one selected from among) Formulae 10-1 to 10-348; or
$-C(Q_1)(Q_2)(Q_3)$, $-Si(Q_1)(Q_2)(Q_3)$, $-N(Q_1)(Q_2)$, $-B(Q_1)(Q_2)$, $-C(=O)(Q_1)$, $-s(=O)_2(Q_1)$, or $-P(=O)(Q_1)(Q_2)$:

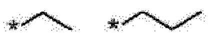
9-1 9-2
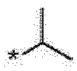
9-3
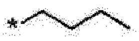
9-4
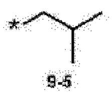
9-5
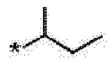
9-6
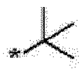
9-7
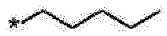
9-8

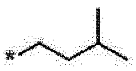
9-9
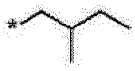
9-10
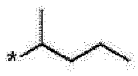
9-11
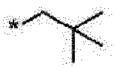
9-12
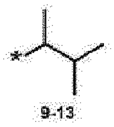
9-13
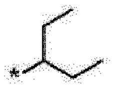
9-14
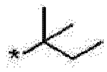
9-15

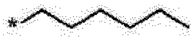
9-16
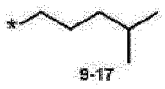
9-17
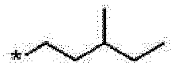
9-18
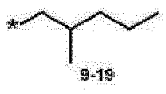
9-19
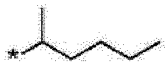
9-20
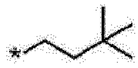
9-21

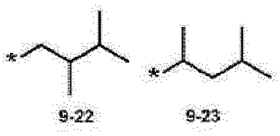
9-22 9-23
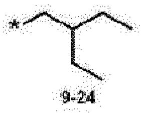
9-24
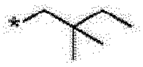
9-25
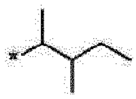
9-26
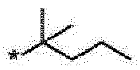
9-27
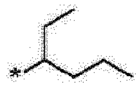
9-28

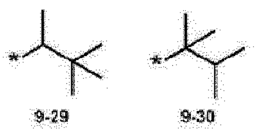
9-29 9-30
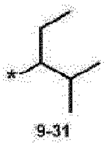
9-31
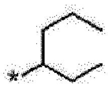
9-32
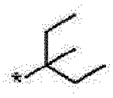
9-33
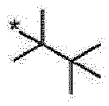
9-34
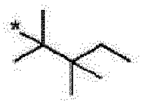
9-35
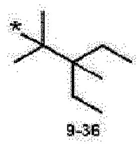
9-36

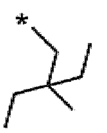
9-37
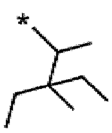
9-38
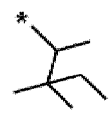
9-39
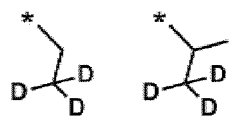
9-40 9-41
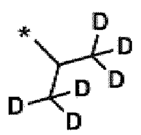
9-42
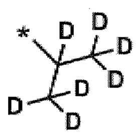
9-43

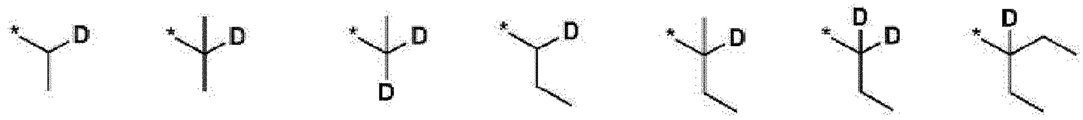

9-44 9-45 9-46 9-47 9-48 9-49 9-50

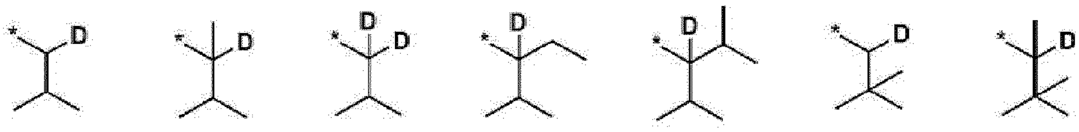

9-51 9-52 9-53 9-54 9-55 9-56 9-57

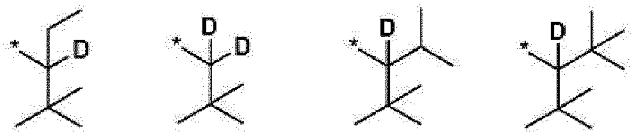

9-58 9-59 9-60 9-61

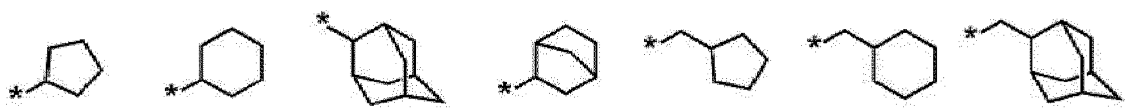

10-1 10-2 10-3 10-4 10-5 10-6 10-7

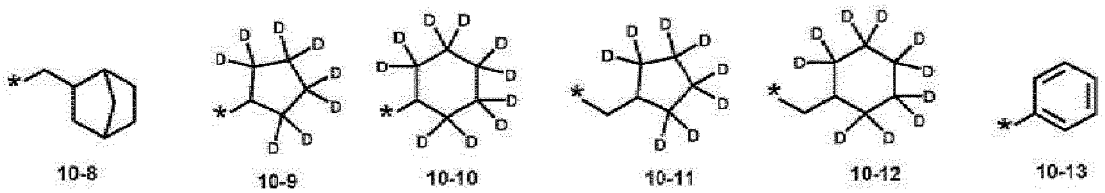

10-8 10-9 10-10 10-11 10-12 10-13

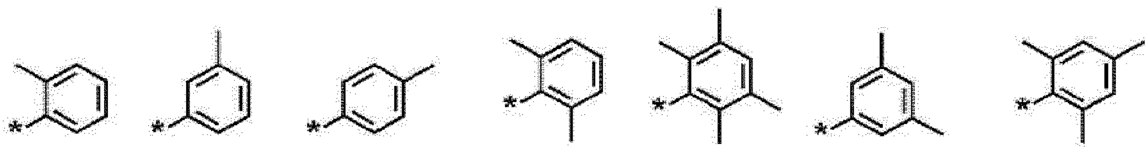

10-14 10-15 10-16 10-17 10-18 10-19 10-20

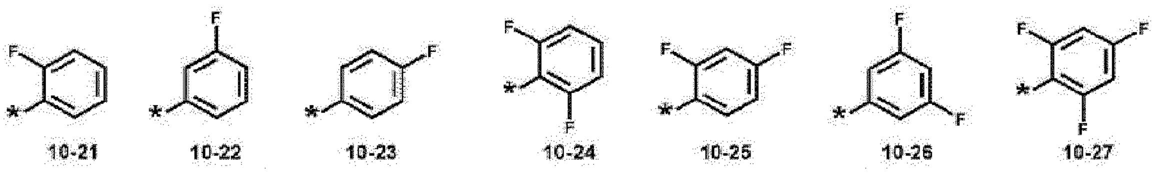

10-21 10-22 10-23 10-24 10-25 10-26 10-27

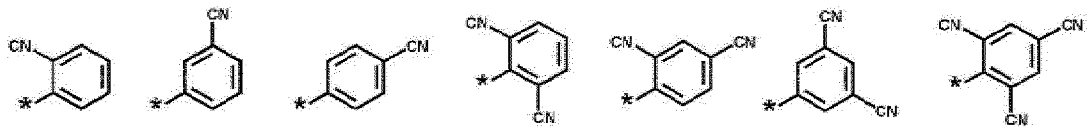

10-28 10-29 10-30 10-31 10-32 10-33 10-34

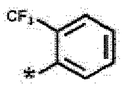 10-35 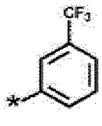 10-36 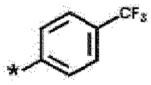 10-37 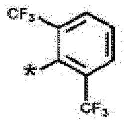 10-38 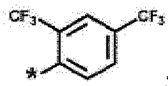 10-39 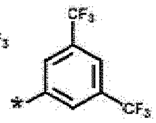 10-40 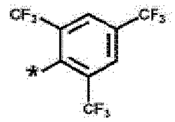 10-41

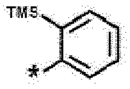 10-42 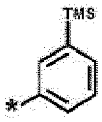 10-43 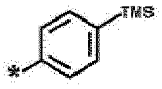 10-44 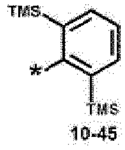 10-45 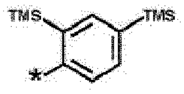 10-46 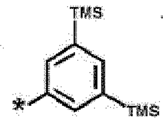 10-47 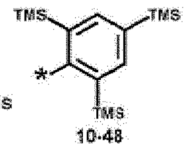 10-48

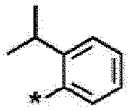 10-49 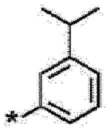 10-50 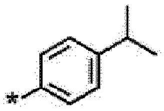 10-51 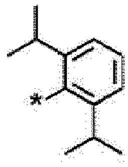 10-52 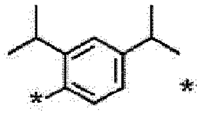 10-53 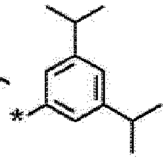 10-54 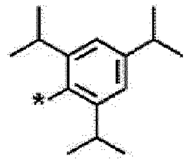 10-55

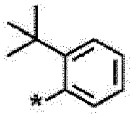 10-56 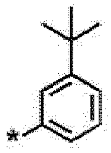 10-57 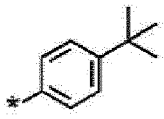 10-58 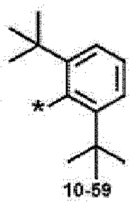 10-59 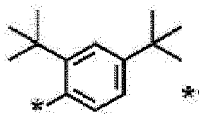 10-60 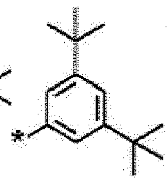 10-61 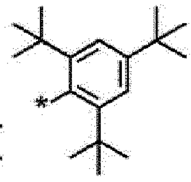 10-62

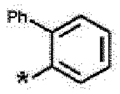 10-63 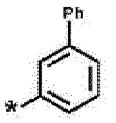 10-64 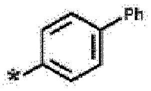 10-65 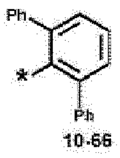 10-66 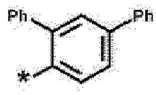 10-67 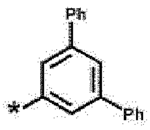 10-68 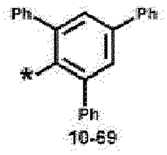 10-69

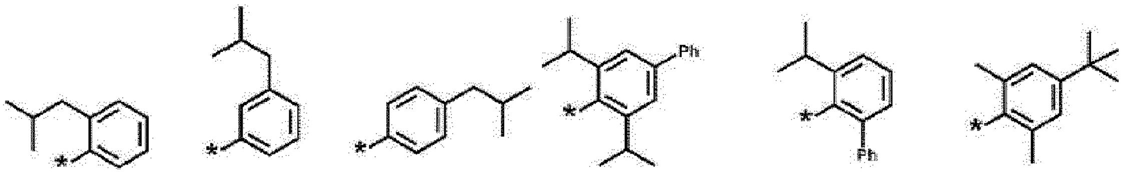

10-70 10-71 10-72 10-73 10-74 10-75

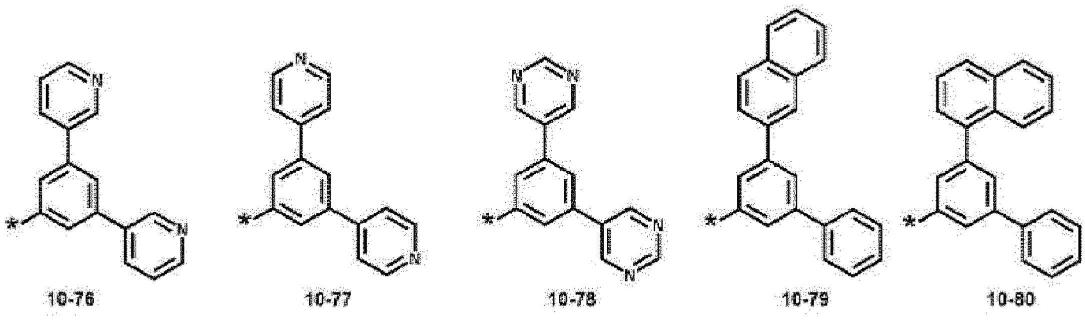

10-76 10-77 10-78 10-79 10-80

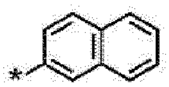
10-81

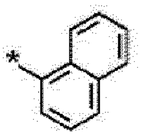
10-82

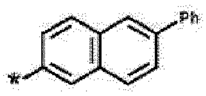
10-83

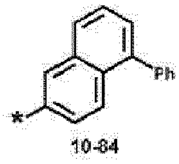
10-84

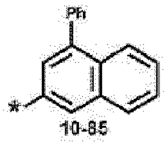
10-85

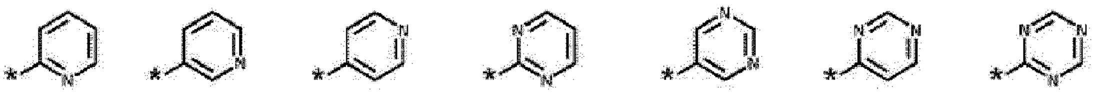
10-86 10-87 10-88 10-89 10-90 10-91 10-92

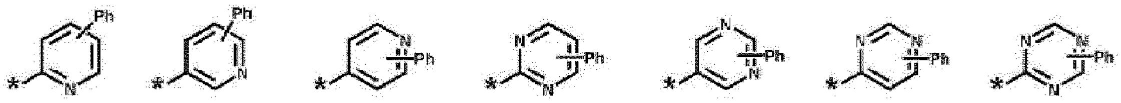
10-93 10-94 10-95 10-96 10-97 10-98 10-99

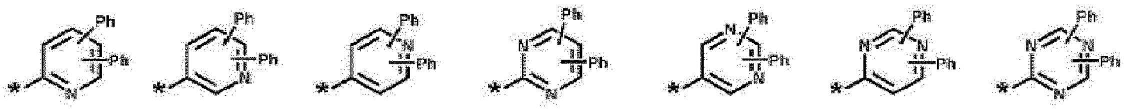
10-100 10-101 10-102 10-103 10-104 10-105 10-106

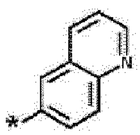
10-107

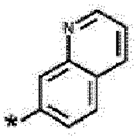
10-108

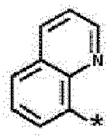
10-109

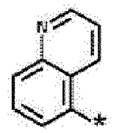
10-110

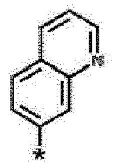
10-111

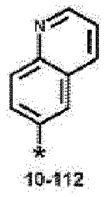
10-112

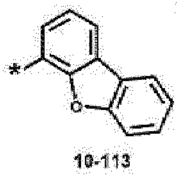
10-113

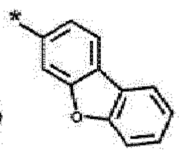
10-114

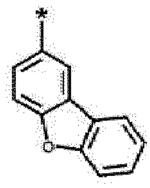
10-115

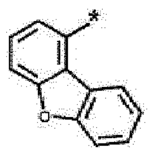
10-116

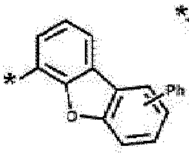
10-117

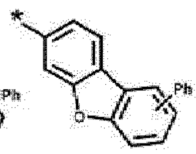
10-118

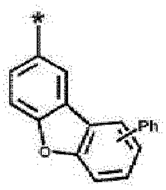
10-119

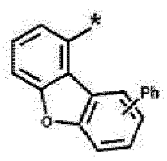
10-120

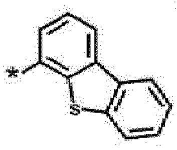
10-121

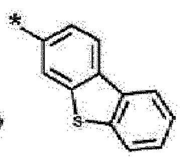
10-122

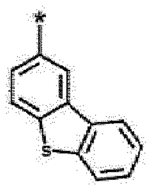
10-123

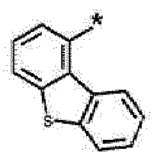
10-124

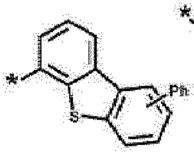
10-125

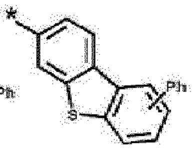
10-126

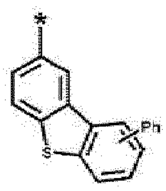
10-127

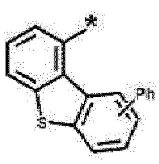
10-128

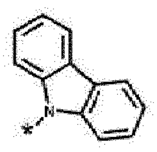
10-129

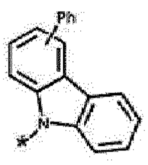
10-130

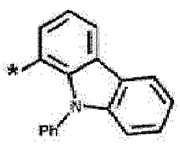 10-131 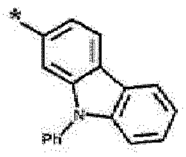 10-132 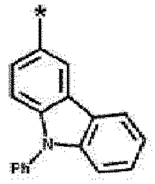 10-133 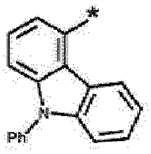 10-134 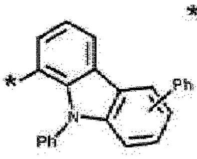 10-135 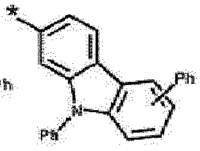 10-136

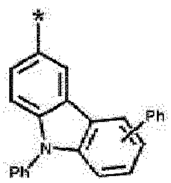 10-137 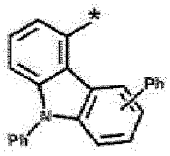 10-138 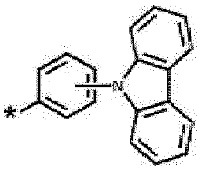 10-139 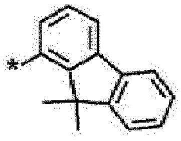 10-140 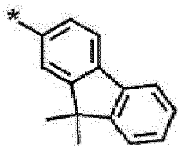 10-141 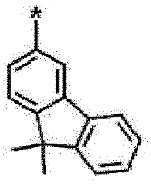 10-142

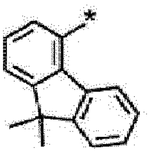 10-143 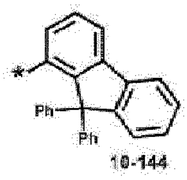 10-144 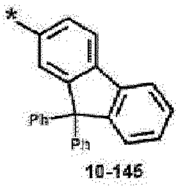 10-145 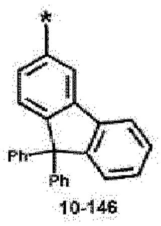 10-146 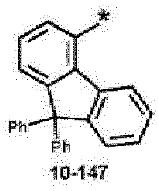 10-147

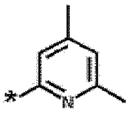 10-148 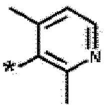 10-149 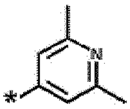 10-150 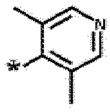 10-151 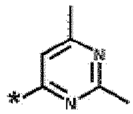 10-152 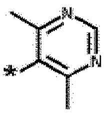 10-153 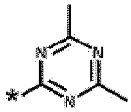 10-154

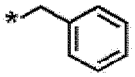 10-155 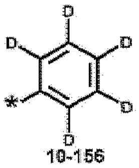 10-156 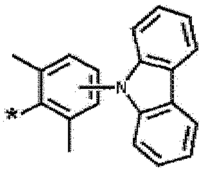 10-157 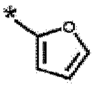 10-158 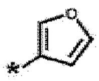 10-159 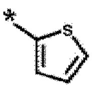 10-160 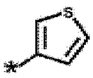 10-161

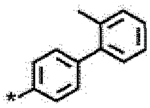 10-162 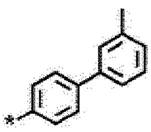 10-163 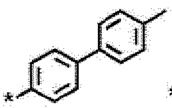 10-164 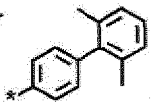 10-165 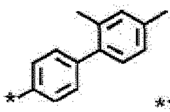 10-166 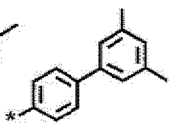 10-167 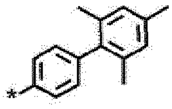 10-168

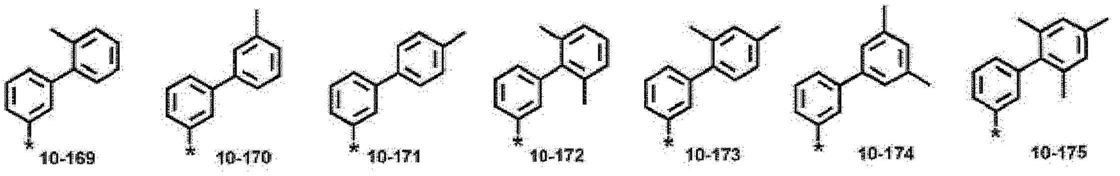 10-169 10-170 10-171 10-172 10-173 10-174 10-175

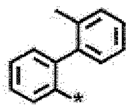
10-176
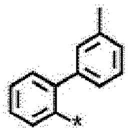
10-177
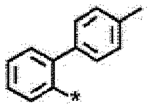
10-178
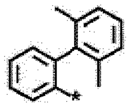
10-179
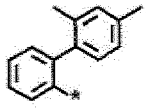
10-180
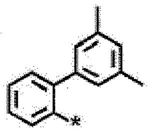
10-181
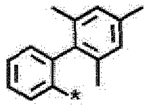
10-182

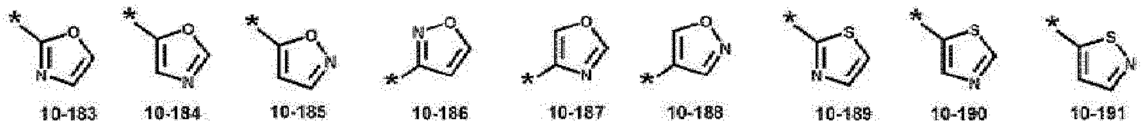
10-183
10-184
10-185
10-186
10-187
10-188
10-189
10-190
10-191

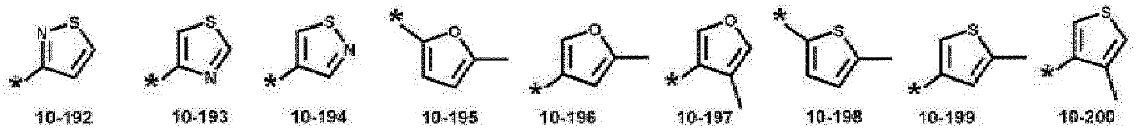
10-192
10-193
10-194
10-195
10-196
10-197
10-198
10-199
10-200

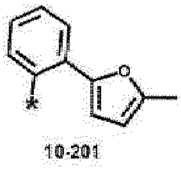
10-201
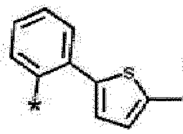
10-202
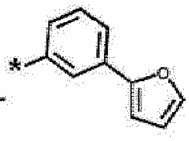
10-203
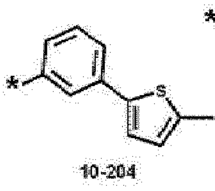
10-204
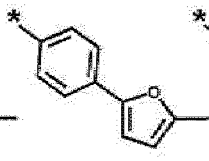
10-205
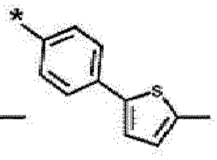
10-206

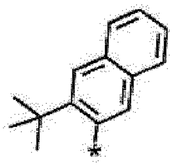
10-207
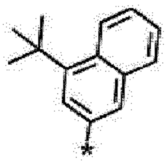
10-208
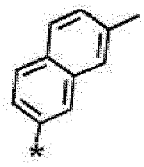
10-209
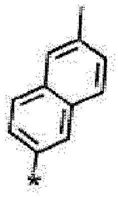
10-210
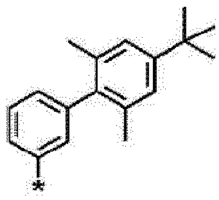
10-211
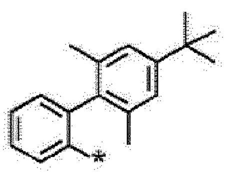
10-212

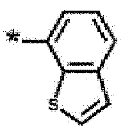
10-213
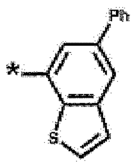
10-214
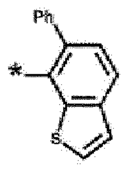
10-215
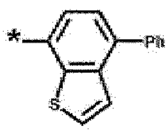
10-216
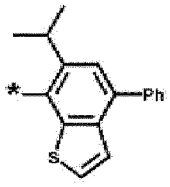
10-217
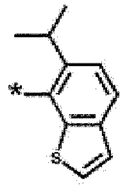
10-218
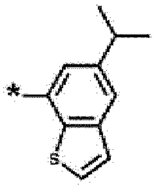
10-219

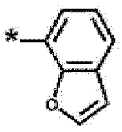
10-220
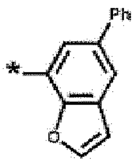
10-221
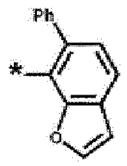
10-222
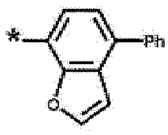
10-223
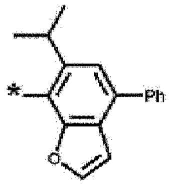
10-224
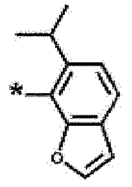
10-225
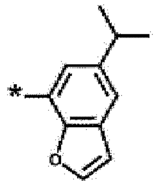
10-226

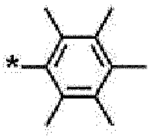
10-227
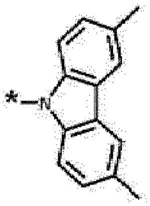
10-228
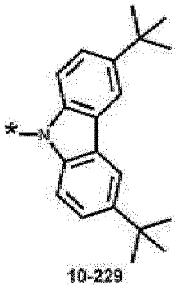
10-229
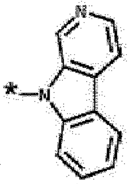
10-230
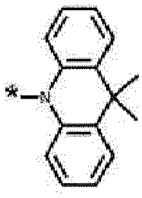
10-231
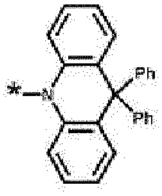
10-232
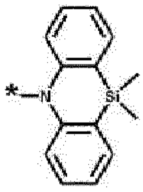
10-233

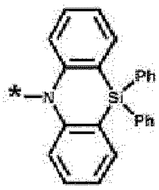
10-234
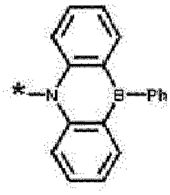
10-235
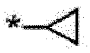
10-236
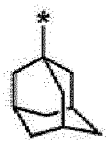
10-237
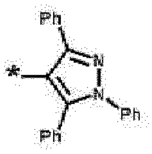
10-238
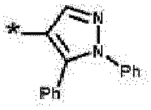
10-239
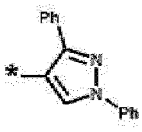
10-240

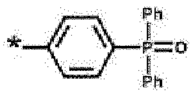
10-241
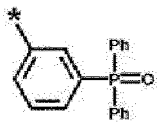
10-242
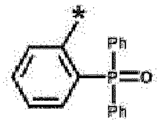
10-243
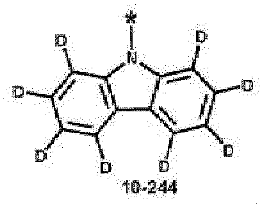
10-244
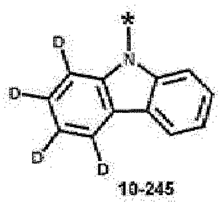
10-245

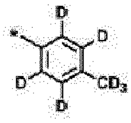
10-246
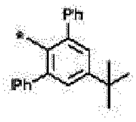
10-247
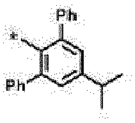
10-248
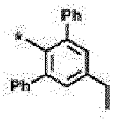
10-249
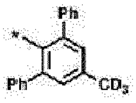
10-250
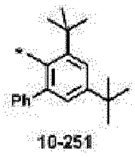
10-251
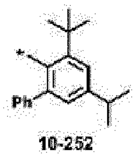
10-252

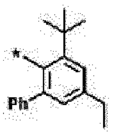
10-253
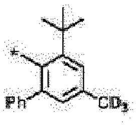
10-254
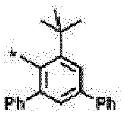
10-255
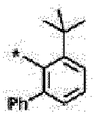
10-256
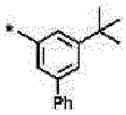
10-257
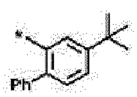
10-258
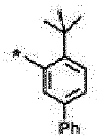
10-259
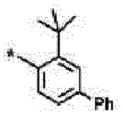
10-260

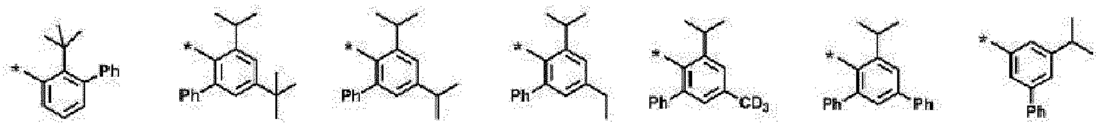
10-261 10-262 10-263 10-264 10-265 10-266 10-267

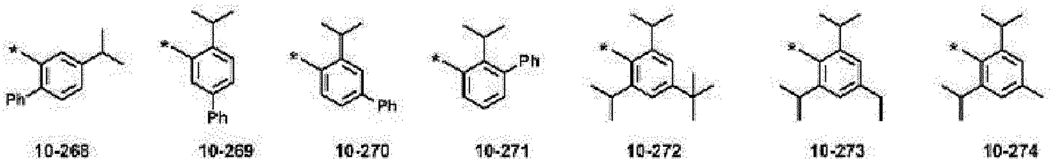
10-268 10-269 10-270 10-271 10-272 10-273 10-274

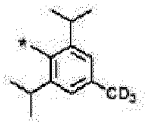
10-275

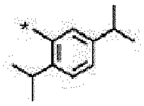
10-276

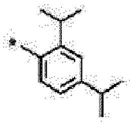
10-277

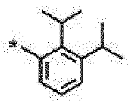
10-278

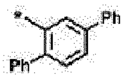
10-279

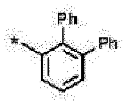
10-280

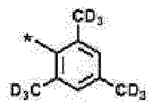
10-281

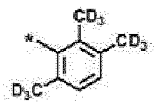
10-282

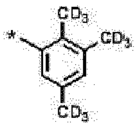
10-283

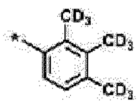
10-284

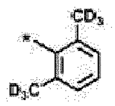
10-285

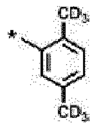
10-286

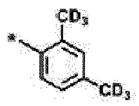
10-287

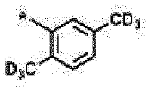
10-288

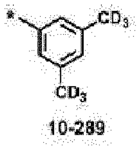
10-289

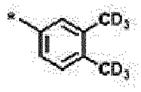
10-290

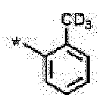
10-291

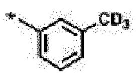
10-292

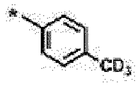
10-293

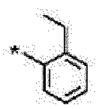
10-294

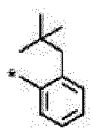
10-295

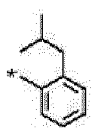
10-296

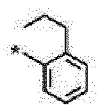
10-297

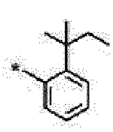
10-298

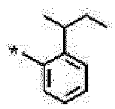
10-299

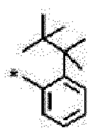
10-300

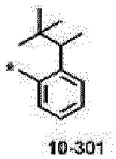
10-301

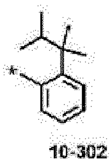
10-302

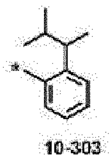
10-303

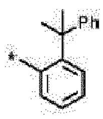
10-304

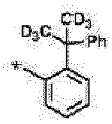
10-305

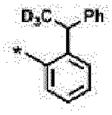
10-306

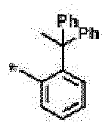
10-307

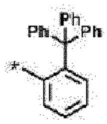
10-308

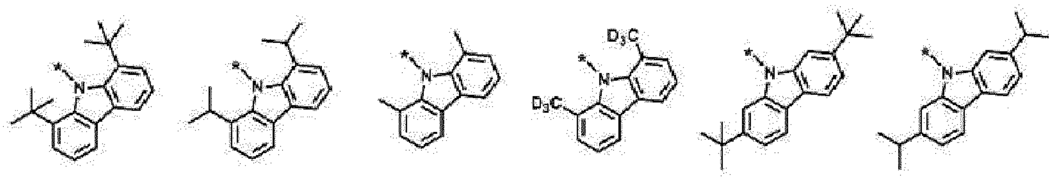
10-309 10-310 10-311 10-312 10-313 10-314

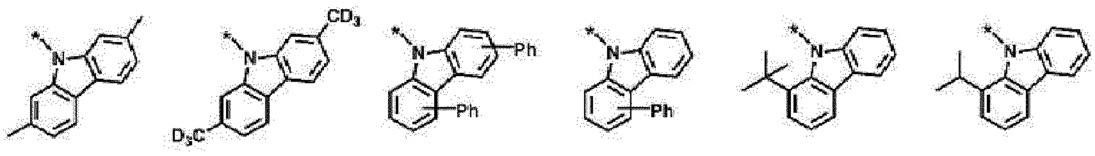
10-315 10-316 10-317 10-318 10-319 10-320

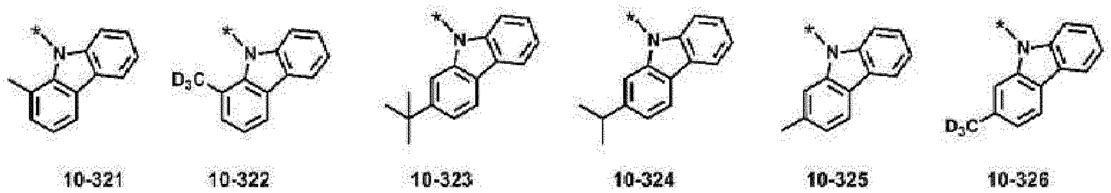
10-321 10-322 10-323 10-324 10-325 10-326

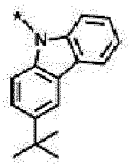 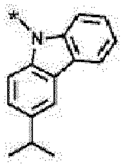 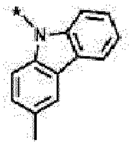 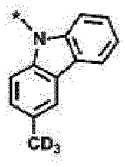 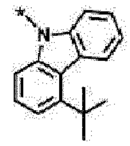 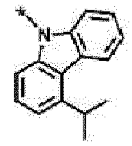

10-327 10-328 10-329 10-330 10-331 10-332

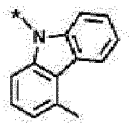 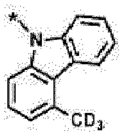 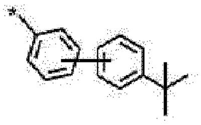 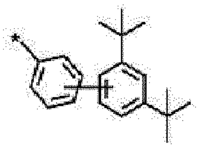 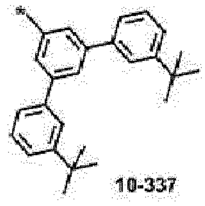

10-333 10-334 10-335 10-336 10-337

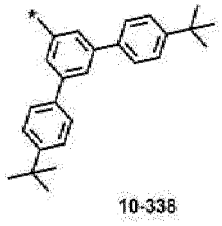 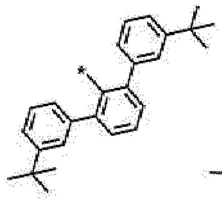 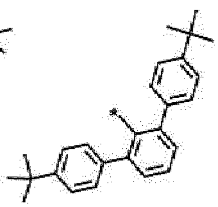 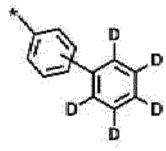 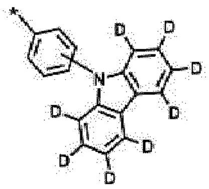

10-338 10-339 10-340 10-341 10-342

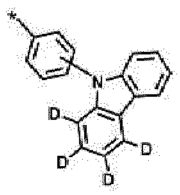 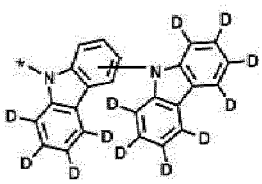 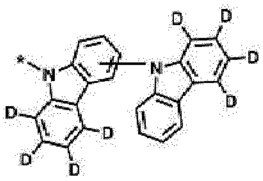 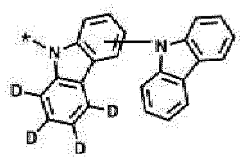

10-343 10-344 10-345 10-346

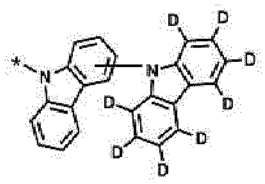 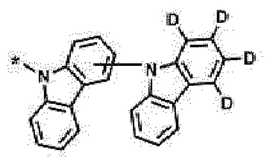

10-347 10-348

wherein, in Formulae 9-1 to 9-61 and 10-1 to 10-348, * indicates a binding site to a neighboring atom, "Ph" represents a phenyl group, and "TMS" represents a trimethylsilyl group.

$Q_1$ to $Q_3$ are each as described herein.

In one or more embodiments, the electron transport region of the light-emitting device may include a hole-blocking layer, and the hole-blocking layer may include a phosphine oxide-containing compound, a silicon-containing compound, or any combination thereof. According to one or more embodiments, the hole-blocking layer may directly contact the emission layer.

According to one or more embodiments, the light-emitting device may further include a capping layer arranged on an outer side of the first electrode or an outer side of the second electrode.

In one or more embodiments, the light-emitting device may further include at least one of a first capping layer arranged outside the first electrode and a second capping layer arranged outside the second electrode, wherein the organometallic compound represented by Formula 1 may be included in at least one of the first capping layer and/or the second capping layer. More details on the first capping layer and/or the second capping layer may be referred to the descriptions provided herein.

According to one or more embodiments, the light-emitting device may further include a first capping layer arranged on an outer side of the first electrode. For example, the first capping layer may include the organometallic compound represented by Formula 1.

According to one or more embodiments, the light-emitting device may further include a second capping layer arranged on an outer side of the second electrode. For example, the second capping layer may include the organometallic compound represented by Formula 1.

According to one or more embodiments, the light-emitting device may further include a first capping layer arranged on an outer side of the first electrode and a second capping layer arranged on an outer side of the second electrode. For example, at least one of the first capping layer and/or the second capping layer may include the organometallic compound represented by Formula 1.

The wording "(interlayer and/or capping layer) includes an organometallic compound" as used herein may be understood as "(interlayer and/or capping layer) may include one kind of organometallic compound represented by Formula 1 or two or more different kinds of organometallic compounds, each represented by Formula 1."

According to one or more embodiments, the interlayer and/or the capping layer may include Compound 1 only as the organometallic compound. In this regard, Compound 1 may be present in the emission layer of the light-emitting device. In one or more embodiments, the interlayer may include, as the organometallic compound, Compound 1 and Compound 2. In this regard, Compound 1 and Compound 2 may be present in substantially the same layer (for example, both (e.g., simultaneously) Compound 1 and Compound 2 may be present in the emission layer), or may be present in different layers (for example, Compound 1 may be present in the emission layer, and Compound 2 may be present in the electron transport region).

The term "interlayer" as used herein refers to a single layer and/or all layers between a first electrode and a second electrode of a light-emitting device.

Another aspect of the disclosure provides an electronic apparatus including the light-emitting device. The electronic apparatus may further include a thin-film transistor. For example, the electronic apparatus may further include a thin-film transistor including a source electrode and a drain electrode, wherein the first electrode of the light-emitting device may be electrically connected to the source electrode or the drain electrode. According to one or more embodiments, the electronic apparatus may further include a color filter, a color conversion layer, a touch screen layer, a polarizing layer, or any combination thereof. More details on the electronic apparatus may be referred to the descriptions provided herein.

Another embodiment of the disclosure provides electronic equipment including the electronic apparatus, and the electronic apparatus may be at least one of (e.g., selected from among) a flat panel display, a curved display, a computer monitor, a medical monitor, a television, a billboard, a light for indoor or outdoor lighting and/or signaling, a head-up display, a fully or partially transparent display, a flexible display, a rollable display, a foldable display, a stretchable display, a laser printer, a telephone, a mobile phone, a tablet, a phablet, a personal digital assistant (PDA), a wearable device, a laptop computer, a digital camera, a camcorder, a viewfinder, a micro display, a 3D display, a virtual reality display, an augmented reality display, a vehicle, a video wall including multiple displays tiled together, a theater screen, a stadium screen, a phototherapy device, a signboard, and/or any suitable combination thereof.

## Description of FIG. 1

FIG. 1 is a schematic cross-sectional view of a light-emitting device 10 according to one or more embodiments. The light-emitting device 10 includes a first electrode 110, an interlayer 130, and a second electrode 150.

Hereinafter, a structure of the light-emitting device 10 according to one or more embodiments and a method of manufacturing the light-emitting device 10 are described with reference to FIG. 1.

## First electrode 110

In FIG. 1, a substrate may be additionally arranged under the first electrode 110 or on the second electrode 150. As the substrate, a glass substrate or a plastic substrate may be used. According to one or more embodiments, the substrate may be a flexible substrate and may include plastics with excellent or suitable heat resistance and durability, such as polyimide, polyethylene terephthalate (PET), polycarbonate, polyethylene naphthalate, polyarylate (PAR), polyetherimide, or any combination thereof.

The first electrode 110 may be formed by, for example, depositing or sputtering a material for forming the first electrode 110 on the substrate. When the first electrode 110 is an anode, a material for forming the first electrode 110 may be a high-work function material that facilitates injection of holes.

The first electrode 110 may be a reflective electrode, a transflective electrode, or a transmissive electrode. When the first electrode 110 is a transmissive electrode, a material for forming the first electrode 110 may include indium tin oxide (ITO), indium zinc oxide (IZO), tin oxide ($SnO_2$), zinc oxide (ZnO), or any combination thereof. According to one or more embodiments, if (e.g., when) the first electrode 110 is a transflective electrode or a reflective electrode, a material for

forming the first electrode 110 may include magnesium (Mg), silver (Ag), aluminium (Al), aluminium-lithium (Al-Li), calcium (Ca), magnesium-indium (Mg-In), magnesium-silver (Mg-Ag), or any combination thereof.

The first electrode 110 may have a single-layer structure including (e.g., consisting of) a single layer or a multilayer structure including a plurality of layers. According to one or more embodiments, the first electrode 110 may have a three-layer structure of ITO/Ag/ITO.

**Interlayer 130**

The interlayer 130 is arranged above the first electrode 110. The interlayer 130 includes the emission layer.

The interlayer 130 may further include a hole transport region arranged between the first electrode 110 and the emission layer, and an electron transport region arranged between the emission layer and the second electrode 150.

The interlayer 130 may further include, in addition to one or more suitable organic materials, a metal-containing compound such as an organometallic compound, an inorganic material such as quantum dots, and/or the like.

According to one or more embodiments, the interlayer 130 may include, i) two or more emitting units sequentially stacked between the first electrode 110 and the second electrode 150, and ii) a charge generation layer between the two or more emitting units. When the interlayer 130 includes emitting units and a charge generation layer as described herein, the light-emitting device 10 may be a tandem light-emitting device.

**Hole transport region in interlayer 130**

The hole transport region may have: i) a single-layer structure including (e.g., consisting of) a single layer including (e.g., consisting of) a single material, ii) a single-layer structure including (e.g., consisting of) a single layer including (e.g., consisting of) a plurality of materials that are different from each other, or iii) a multilayer structure including a plurality of layers including a plurality of materials that are different from each other.

The hole transport region may include a hole injection layer, a hole transport layer, an emission auxiliary layer, an electron-blocking layer, or any combination thereof.

For example, the hole transport region may have a multi-layer structure including a hole injection layer/hole transport layer structure, a hole injection layer/hole transport layer/emission auxiliary layer structure, a hole injection layer/emission auxiliary layer structure, a hole transport layer/emission auxiliary layer structure, or a hole injection layer/hole transport layer/electron-blocking layer structure, wherein layers in each structure are sequentially stacked from the first electrode 110.

The hole transport region may include a compound represented by Formula 201, a compound represented by Formula 202, and/or any combination thereof:

Formula 201

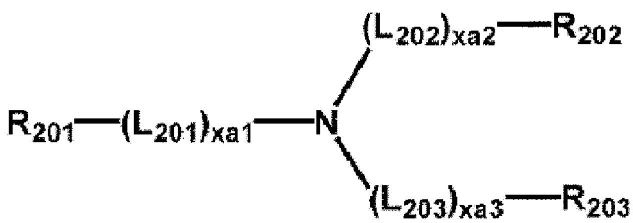

Formula 202

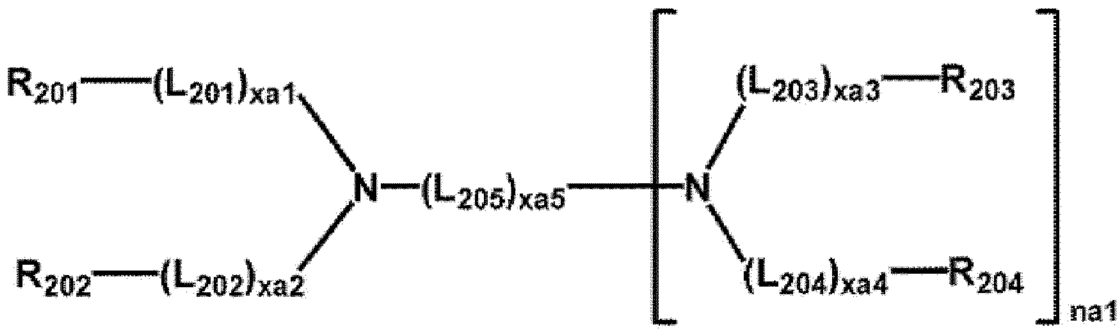

wherein, in Formulae 201 and 202,

$L_{201}$ to $L_{204}$ may each independently be a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,

$L_{205}$ may be *-O-*', *-S-*', *-N($Q_{201}$)-*', a $C_1$-$C_{20}$ alkylene group unsubstituted or substituted with at least one $R_{10a}$, a $C_2$-$C_{20}$ alkenylene group unsubstituted or substituted with at least one $R_{10a}$, a $C_3$-$C_{60}$ carbocyclic group unsubstituted or substituted with at least one $R_{10a}$, or a $C_1$-$C_{60}$ heterocyclic group unsubstituted or substituted with at least one $R_{10a}$,

xa1 to xa4 may each independently be an integer from 0 to 5,

xa5 may be an integer from 1 to 10,

$R_{201}$ to $R_{204}$ and $Q_{201}$ may each independently be a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,

$R_{201}$ and $R_{202}$ may optionally be linked to each other via a single bond, a $C_1$-$C_5$ alkylene group that is unsubstituted or substituted with at least one $R_{10a}$, or a $C_2$-$C_5$ alkenylene group that is unsubstituted or substituted with at least one $R_{10a}$ to form a $C_8$-$C_{60}$ polycyclic group (for example, a carbazole group) that is unsubstituted or substituted with at least one $R_{10a}$ (for example, Compound HT16),

$R_{203}$ and $R_{204}$ may optionally be linked to each other via a single bond, a $C_1$-$C_5$ alkylene group unsubstituted or substituted with at least one $R_{10a}$, or a $C_2$-$C_5$ alkenylene group unsubstituted or substituted with at least one $R_{10a}$, to form a $C_8$-$C_{60}$ polycyclic group unsubstituted or substituted with at least one $R_{10a}$, and

na1 may be an integer from 1 to 4.

According to one or more embodiments, each of Formulae 201 and 202 may include at least one of (e.g., selected from among) groups represented by Formulae CY201 to CY217:

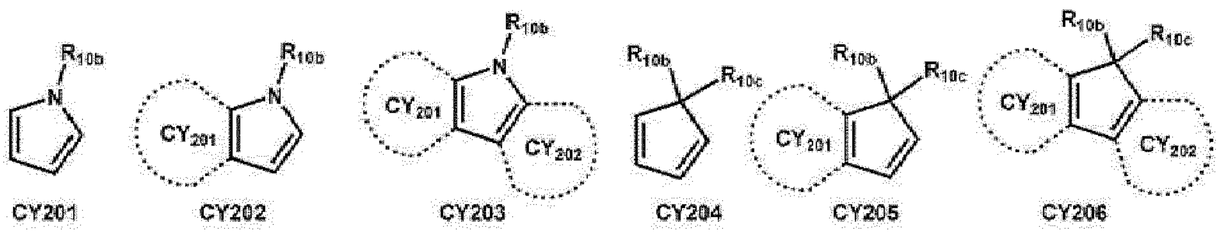

CY201 CY202 CY203 CY204 CY205 CY206

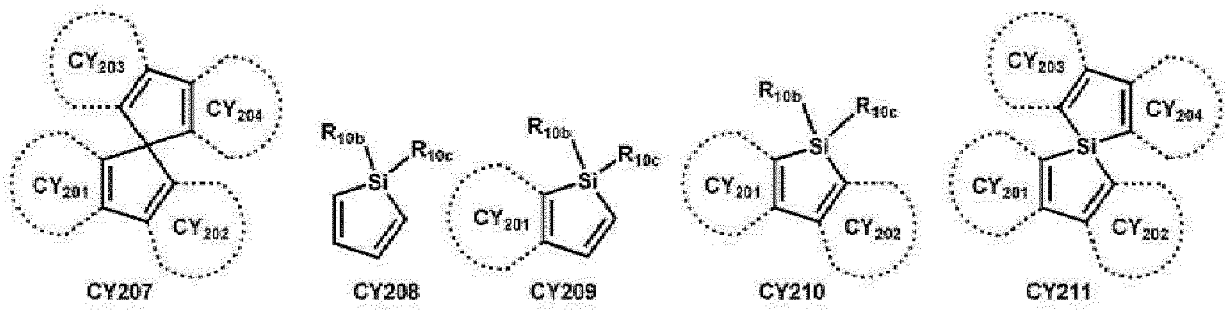

CY207 CY208 CY209 CY210 CY211

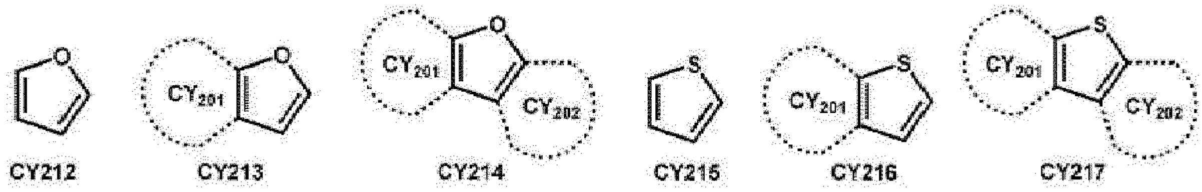

CY212 CY213 CY214 CY215 CY216 CY217

wherein, in Formulae CY201 to CY217, $R_{10b}$ and $R_{10c}$ are each the same as described in connection with $R_{10a}$, ring $CY_{201}$ to ring $CY_{204}$ may each independently be a $C_3$-$C_{20}$ carbocyclic group or a $C_1$-$C_{20}$ heterocyclic group, and at least one hydrogen in Formulae CY201 to CY217 may be unsubstituted or substituted with $R_{10a}$.

According to one or more embodiments, in Formulae CY201 to CY217, ring $CY_{201}$ to ring $CY_{204}$ may each independently be a benzene group, a naphthalene group, a phenanthrene group, or an anthracene group.

According to one or more embodiments, each of Formulae 201 and 202 may include at least one of (e.g., selected from among) groups represented by Formulae CY201 to CY203.

According to one or more embodiments, Formula 201 may include at least one of (e.g., selected from among) groups represented by Formulae CY201 to CY203 and at least one of (e.g., selected from among) groups represented by

Formulae CY204 to CY217.

According to one or more embodiments, in Formula 201, xa1 may be 1, $R_{201}$ may be a group represented by one of (e.g., selected from among) Formulae CY201 to CY203, xa2 may be 0, and $R_{202}$ may be a group represented by one of (e.g., selected from among) Formulae CY204 to CY207.

According to one or more embodiments, each of Formulae 201 and 202 may not include (e.g., may exclude any of the) groups represented by Formulae CY201 to CY203.

According to one or more embodiments, each of Formulae 201 and 202 may not include (e.g., may exclude and of the) groups represented by Formulae CY201 to CY203 and may include at least one of groups represented by Formulae CY204 to CY217.

According to one or more embodiments, each of Formulae 201 and 202 may not include (e.g., may exclude any of the) groups represented by Formulae CY201 to CY217.

According to one or more embodiments, the hole transport region may include at least one of (e.g., selected from among) Compounds HT1 to HT46, m-MTDATA, TDATA, 2-TNATA, NPB(NPD), β-NPB, TPD, Spiro-TPD, Spiro-NPB, methylated NPB, TAPC, HMTPD, 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), and/or any combination thereof:

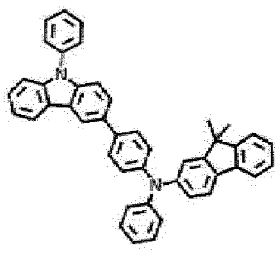

HT1

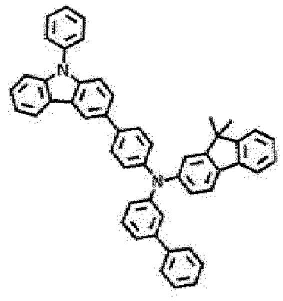

HT2

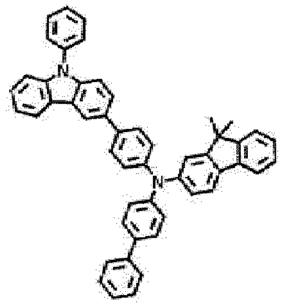

HT3

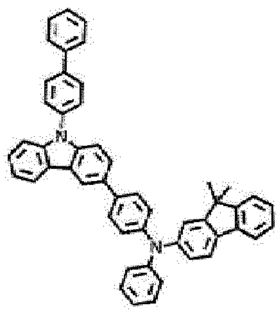

HT4

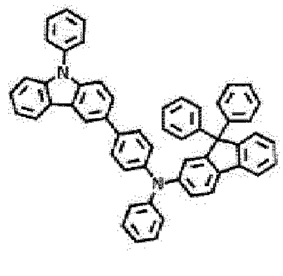

HT5

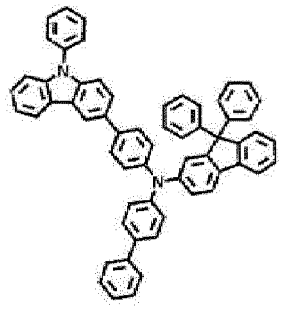

HT6

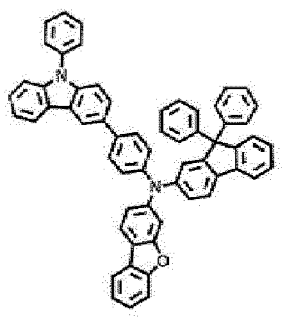

HT7

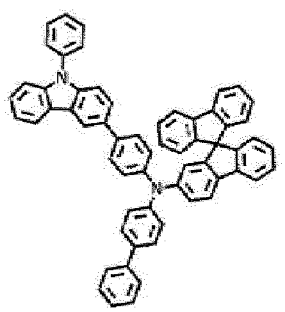

HT8

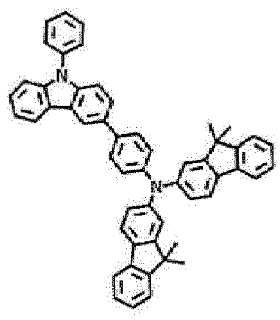

HT9

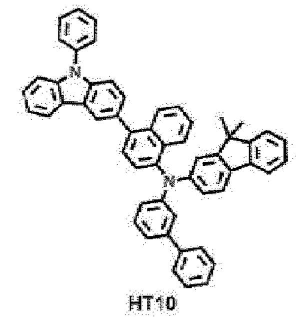

HT10

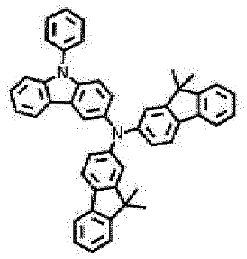

HT11

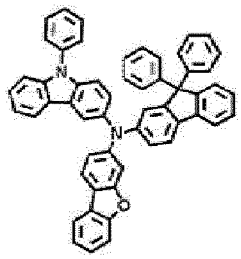

HT12

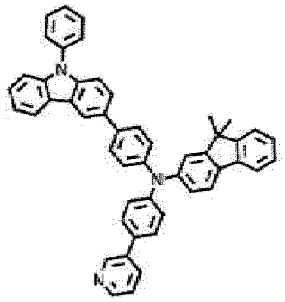

HT13

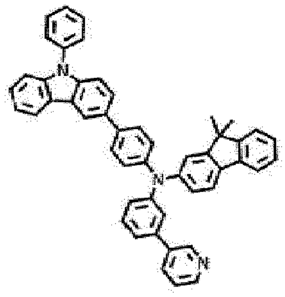

HT14

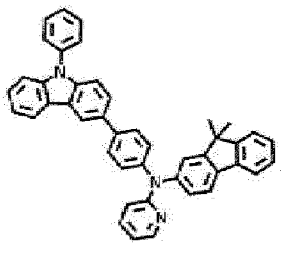

HT15

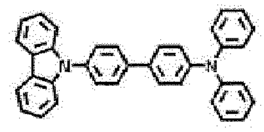

HT16

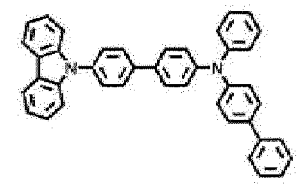

HT17

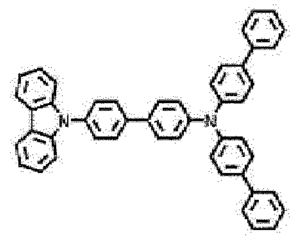

HT18

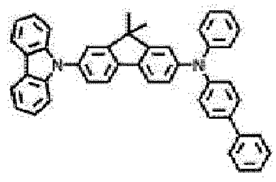

HT19

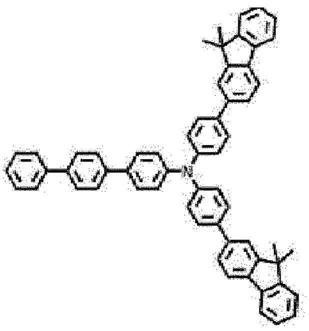

HT20

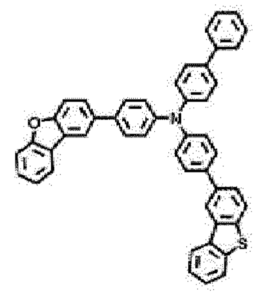

HT21

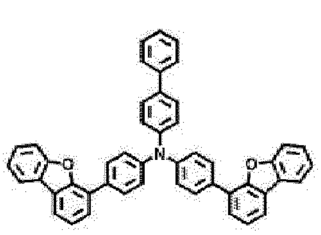

HT22

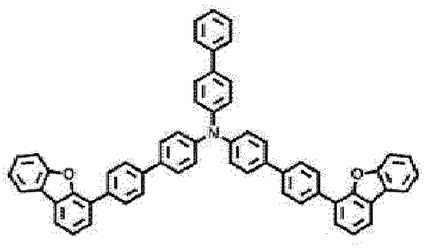

HT23

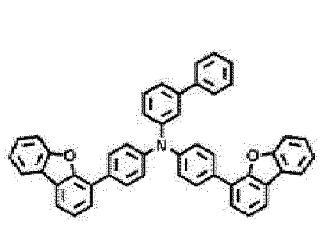

HT24

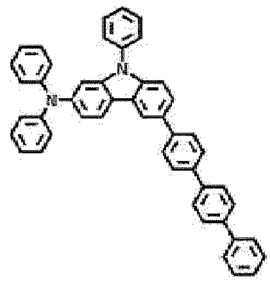

HT25

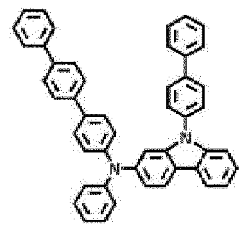

HT26

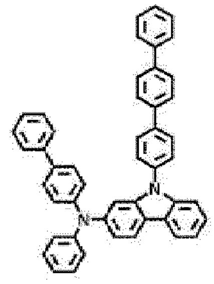

HT27

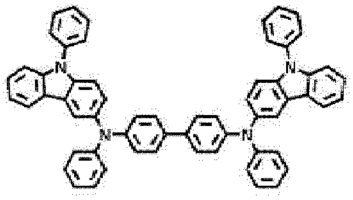

HT28

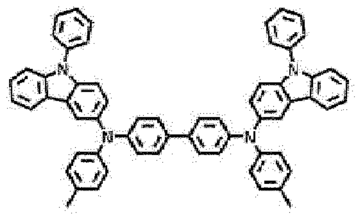

HT29

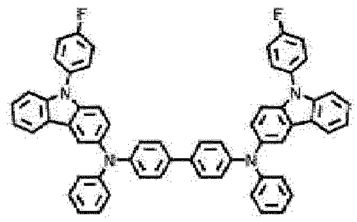

HT30

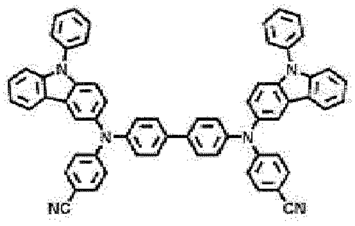

HT31

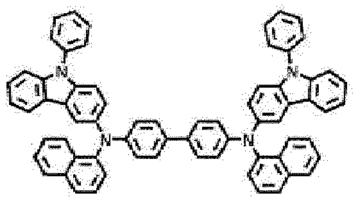

HT32

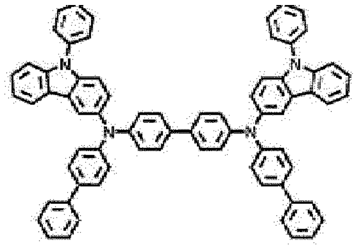

HT33

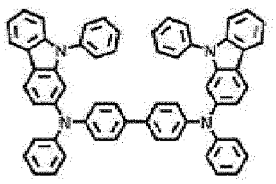

HT34

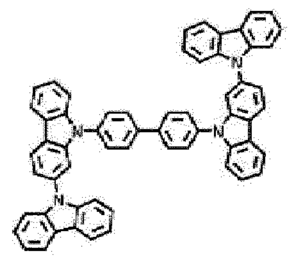

HT35

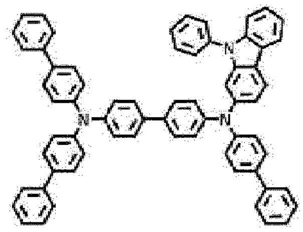

HT36

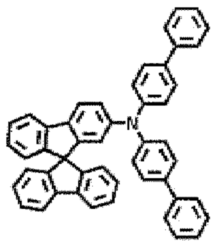

HT37

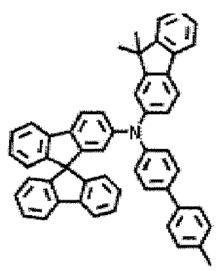

HT38

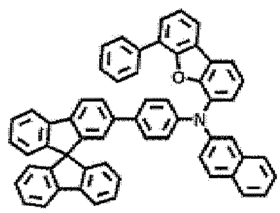

HT39

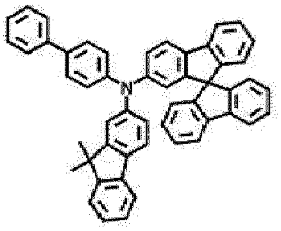

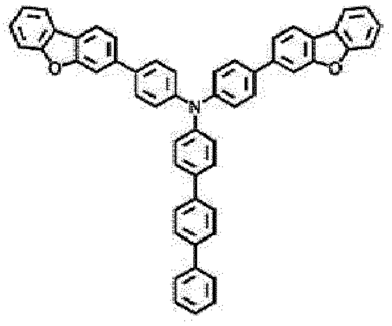

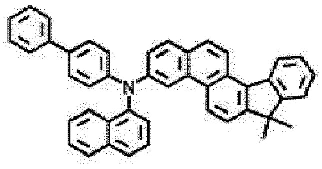

HT40 HT41 HT42

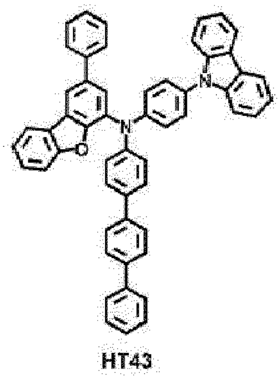

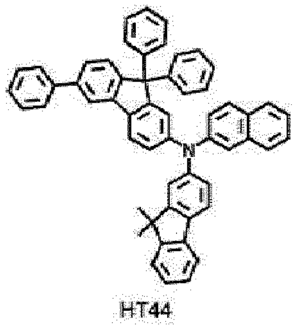

HT43 HT44

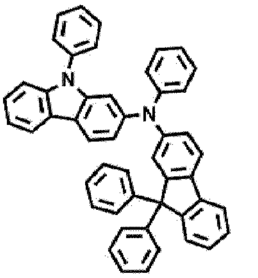

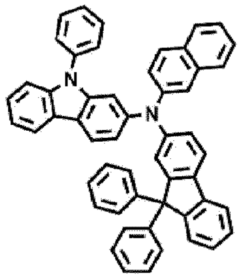

HT45 HT46

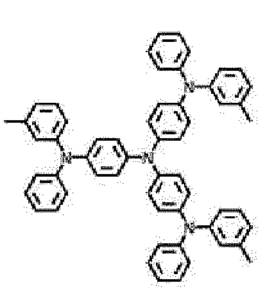

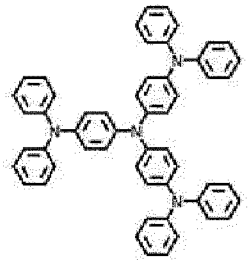

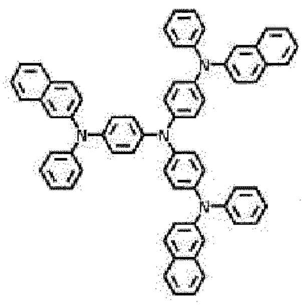

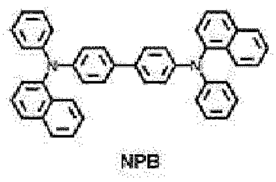

m-MTDATA TDATA 2-TNATA NPB

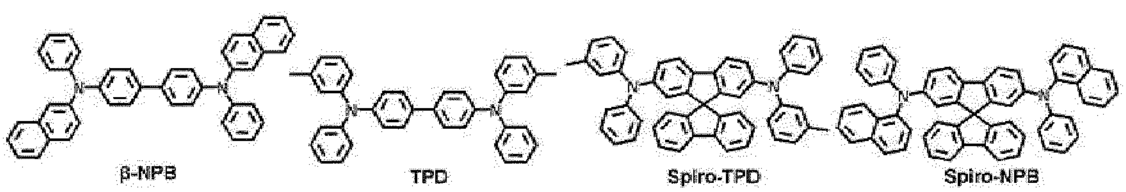

β-NPB TPD Spiro-TPD Spiro-NPB

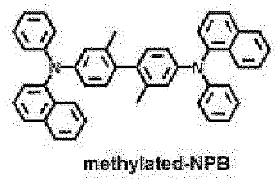

methylated-NPB

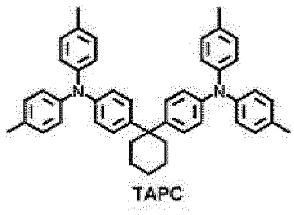

TAPC

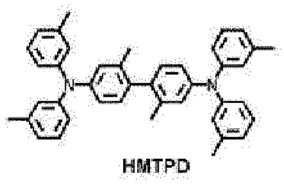

HMTPD

The thickness of the hole transport region may be about 50 angstrom (Å) to about 10,000 Å, for example, about 100 Å to about 4,000 Å. When the hole transport region includes a hole injection layer, a hole transport layer, or any combination thereof, the thickness of the hole injection layer may be about 100 Å to about 9,000 Å, for example, about 100 Å to about 1,000 Å, and the thickness of the hole transport layer may be about 50 Å to about 2,000 Å, for example, about 100 Å to about 1,500 Å. When the thicknesses of the hole transport region, the hole injection layer, and the hole transport layer are within the ranges described herein, satisfactory hole transporting characteristics may be obtained without a substantial increase in driving voltage.

The emission auxiliary layer may increase light emission efficiency by compensating for an optical resonance distance according to the wavelength of light emitted by the emission layer, and the electron-blocking layer may block the leakage of electrons from the emission layer to the hole transport region. Materials that may be included in the hole transport region may be included in the emission auxiliary layer and the electron-blocking layer.

**p-dopant**

The hole transport region may further include, in addition to these materials, a charge-generation material for the improvement of conductive properties. The charge-generation material may be uniformly (e.g., substantially uniformly) or non-uniformly (e.g., substantially non-uniformly) dispersed in the hole transport region (for example, in the form of a single layer including (e.g., consisting of) a charge-generation material).

The charge-generation material may be, for example, a p-dopant (e.g., p type charge-generation material).

For example, the LUMO energy of the p-dopant may be less than or equal to -3.5 electron volt (eV).

According to one or more embodiments, the p-dopant may include a quinone derivative, a cyano group-containing compound, a compound including an element EL1 and an element EL2, or any combination thereof.

Examples of the quinone derivative may include TCNQ and/or F4-TCNQ.

Examples of the cyano group-containing compound may include HAT-CN and/or a compound represented by Formula 221.

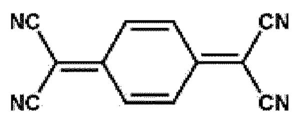

TCNQ

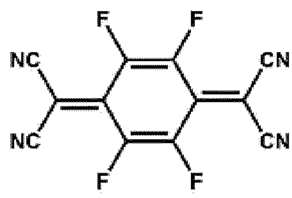

F4-TCNQ

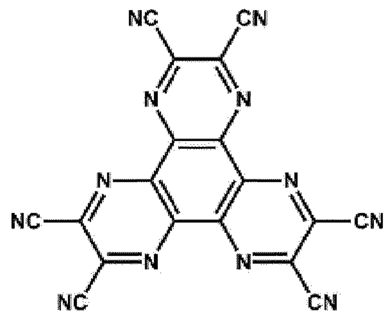

HAT-CN

**Formula 221**

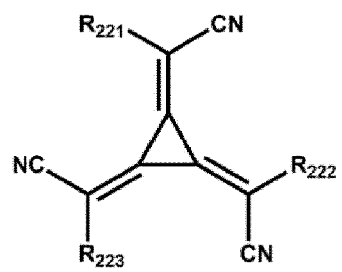

In Formula 221,

$R_{221}$ to $R_{223}$ may each independently be a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$, and at least one of $R_{221}$ to $R_{223}$ may each independently be a $C_3$-$C_{60}$ carbocyclic group or a $C_1$-$C_{60}$ heterocyclic group, each substituted with: a cyano group; -F; -Cl; -Br; -I; a $C_1$-$C_{20}$ alkyl group substituted with a cyano group, -F, -Cl, -Br, -I, or any combination thereof; or any combination thereof.

In the compound including the element EL1 and the element EL2, the element EL1 may be a metal, a metalloid, and/or a (e.g., any suitable) combination thereof, and the element EL2 may be a non-metal, a metalloid, and/or a (e.g., any suitable) combination thereof.

Examples of the metal may include an alkali metal (for example, lithium (Li), sodium (Na), potassium (K), rubidium (Rb), cesium (Cs), and/or the like); an alkaline earth metal (for example, beryllium (Be), magnesium (Mg), calcium (Ca), strontium (Sr), barium (Ba), and/or the like); a transition metal (for example, titanium (Ti), zirconium (Zr), hafnium (Hf), vanadium (V), niobium (Nb), tantalum (Ta), chromium (Cr), molybdenum (Mo), tungsten (W), manganese (Mn), technetium (Tc), rhenium (Re), iron (Fe), ruthenium (Ru), osmium (Os), cobalt (Co), rhodium (Rh), iridium (Ir), nickel (Ni), palladium (Pd), platinum (Pt), copper (Cu), silver (Ag), gold (Au), and/or the like); a post-transition metal (for example, zinc (Zn), indium (In), tin (Sn), and/or the like); and a lanthanide metal (for example, lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb), lutetium (Lu), and/or the like).

Examples of the metalloid may include silicon (Si), antimony (Sb), and tellurium (Te).

Examples of the non-metal may include oxygen (O) and halogen (for example, F, Cl, Br, I, and/or the like).

Examples of the compound including the element EL1 and the element EL2 may include a metal oxide, a metal halide (for example, a metal fluoride, a metal chloride, a metal bromide, a metal iodide, and/or the like), a metalloid halide (for example, a metalloid fluoride, a metalloid chloride, a metalloid bromide, a metalloid iodide, and/or the like), a metal telluride, or any combination thereof.

Examples of the metal oxide may include a tungsten oxide (for example, WO, $W_2O_3$, $WO_2$, $WO_3$, $W_2O_5$, and/or the like), a vanadium oxide (for example, VO, $V_2O_3$, $VO_2$, $V_2O_5$, and/or the like), a molybdenum oxide (MoO, $Mo_2O_3$, $MoO_2$, $MoO_3$, $Mo_2O_5$, and/or the like), and a rhenium oxide (for example, $ReO_3$, and/or the like).

Examples of the metal halide may include an alkali metal halide, an alkaline earth metal halide, a transition metal halide, a post-transition metal halide, and a lanthanide metal halide.

Examples of the alkali metal halide may include LiF, NaF, KF, RbF, CsF, LiCl, NaCl, KCl, RbCl, CsCl, LiBr, NaBr, KBr, RbBr, CsBr, LiI, NaI, KI, RbI, and CsI.

Examples of the alkaline earth metal halide may include $BeF_2$, $MgF_2$, $CaF_2$, $SrF_2$, $BaF_2$, $BeCl_2$, $MgCl_2$, $CaCl_2$, $SrCl_2$, $BaCl_2$, $BeBr_2$, $MgBr_2$, $CaBr_2$, $SrBr_2$, $BaBr_2$, $BeI_2$, $MgI_2$, $CaI_2$, $SrI_2$, and $BaI_2$.

Examples of the transition metal halide may include a titanium halide (for example, $TiF_4$, $TiCl_4$, $TiBr_4$, $TiI_4$, and/or the like), a zirconium halide (for example, $ZrF_4$, $ZrCl_4$, $ZrBr_4$, $ZrI_4$, and/or the like), a hafnium halide (for example, $HfF_4$, $HfCl_4$, $HfBr_4$, $HfI_4$, and/or the like), a vanadium halide (for example, $VF_3$, $VCl_3$, $VBr_3$, $VI_3$, and/or the like), a niobium halide (for example, $NbF_3$, $NbCl_3$, $NbBr_3$, $NbI_3$, and/or the like), a tantalum halide (for example, $TaF_3$, $TaCl_3$, $TaBr_3$, $TaI_3$, and/or the like), a chromium halide (for example, $CrF_3$, $CrCl_3$, $CrBr_3$, $CrI_3$, and/or the like), a molybdenum halide (for example, $MoF_3$, $MoCl_3$, $MoBr_3$, $MoI_3$, and/or the like), a tungsten halide (for example, $WF_3$, $WCl_3$, $WBr_3$, $WI_3$, and/or the like), a manganese halide (for example, $MnF_2$, $MnCl_2$, $MnBr_2$, $MnI_2$, and/or the like), a technetium halide (for example, $TcF_2$, $TcCl_2$, $TcBr_2$, $TcI_2$, and/or the like), a rhenium halide (for example, $ReF_2$, $ReCl_2$, $ReBr_2$, $ReI_2$, and/or the like), an iron(II) halide (for example, $FeF_2$, $FeCl_2$, $FeBr_2$, $FeI_2$, and/or the like), a ruthenium halide (for example, $RuF_2$, $RuCl_2$, $RuBr_2$, $RuI_2$, and/or the like), an osmium halide (for example, $OsF_2$, $OsCl_2$, $OsBr_2$, $OsI_2$, and/or the like), a cobalt halide (for example, $CoF_2$, $CoCl_2$, $CoBr_2$, $CoI_2$, and/or the like), a rhodium halide (for example, $RhF_2$, $RhCl_2$, $RhBr_2$, $RhI_2$, and/or the like), an iridium halide (for example, $IrF_2$, $IrCl_2$, $IrBr_2$, $IrI_2$, and/or the like), a nickel halide (for example, $NiF_2$, $NiCl_2$, $NiBr_2$, $NiI_2$, and/or the like), a palladium halide (for example, $PdF_2$, $PdCl_2$, $PdBr_2$, $PdI_2$, and/or the like), a platinum halide (for example, $PtF_2$, $PtCl_2$, $PtBr_2$, $PtI_2$, and/or the like), a copper(I) halide (for example, CuF, CuCl, CuBr, CuI, and/or the like), a silver halide (for example, AgF, AgCl, AgBr, AgI, and/or the like), and a gold halide (for example, AuF, AuCl, AuBr, AuI, and/or the like).

Examples of the post-transition metal halide may include a zinc halide (for example, $ZnF_2$, $ZnCl_2$, $ZnBr_2$, $ZnI_2$, and/or the like), an indium halide (for example, $InI_3$, and/or the like), and a tin halide (for example, $SnI_2$, and/or the like).

Examples of the lanthanide metal halide may include YbF, $YbF_2$, $YbF_3$, $SmF_3$, YbCl, $YbCl_2$, $YbCl_3$ $SmCl_3$, YbBr, $YbBr_2$, $YbBr_3$, $SmBr_3$, YbI, $YbI_2$, $YbI_3$, and $SmI_3$.

Examples of the metalloid halide may include an antimony halide (for example, $SbCl_5$, and/or the like).

Examples of the metal telluride may include an alkali metal telluride (for example, $Li_2Te$, $Na_2Te$, $K_2Te$, $Rb_2Te$, $Cs_2Te$, and/or the like), an alkaline earth metal telluride (for example, BeTe, MgTe, CaTe, SrTe, BaTe, and/or the like), a transition metal telluride (for example, $TiTe_2$, $ZrTe_2$, $HfTe_2$, $V_2Te_3$, $Nb_2Te_3$, $Ta_2Te_3$, $Cr_2Te_3$, $Mo_2Te_3$, $W_2Te_3$, MnTe, TcTe, ReTe, FeTe, RuTe, OsTe, CoTe, RhTe, IrTe, NiTe, PdTe, PtTe, $Cu_2Te$, CuTe, $Ag_2Te$, AgTe, $Au_2Te$, and/or the like), a post-transition metal telluride (for example, ZnTe, and/or the like), and a lanthanide metal telluride (for example, LaTe, CeTe, PrTe, NdTe, PmTe, EuTe, GdTe, TbTe, DyTe, HoTe, ErTe, TmTe, YbTe, LuTe, and/or the like).

**Emission layer in interlayer 130**

When the light-emitting device 10 is a full-color light-emitting device, the emission layer may be patterned into a red emission layer, a green emission layer, and/or a blue emission layer, according to a sub-pixel. According to one or more embodiments, the emission layer may have a stacked structure of two or more layers of a red emission layer, a green emission layer, and a blue emission layer, in which the two or more layers contact each other or are separated from each other, to emit white light. In one or more embodiments, the emission layer may include two or more materials of a red light-emitting material, a green light-emitting material, and a blue light-emitting material, in which the two or more materials are mixed with each other in a single layer, to emit white light.

The emission layer may include a host and a dopant. The dopant may include a phosphorescent dopant, a fluorescent dopant, or any combination thereof.

The amount of the dopant in the emission layer may be from about 0.01 part by weight to about 15 parts by weight based on 100 parts by weight of the host.

According to one or more embodiments, the emission layer may include a quantum dot.

According to one or more embodiments, the emission layer may include a delayed fluorescence material. The delayed fluorescence material may act as a host or a dopant in the emission layer.

The thickness of the emission layer may be about 100 Å to about 1,000 Å, for example, about 200 Å to about 600 Å. When the thickness of the emission layer is within the range described herein, excellent or suitable luminescence characteristics may be obtained without a substantial increase in driving voltage.

**Host**

The host may further include a compound represented by Formula 301:

**Formula 301** $[Ar_{301}]_{xb11}-[(L_{301})_{xb1}-R_{301}]_{xb21}$

wherein, in Formula 301,

$Ar_{301}$ and $L_{301}$ may each independently be a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,
xb11 may be 1, 2, or 3,
xb1 may be an integer from 0 to 5,
$R_{301}$ may be hydrogen, deuterium, -F, -Cl, -Br, -I, a hydroxyl group, a cyano group, a nitro group, a $C_1$-$C_{60}$ alkyl group that is unsubstituted or substituted with at least one $R_{10a}$, a $C_2$-$C_{60}$ alkenyl group that is unsubstituted or substituted with at least one $R_{10a}$, a $C_2$-$C_{60}$ alkynyl group that is unsubstituted or substituted with at least one $R_{10a}$, a $C_1$-$C_{60}$ alkoxy group that is unsubstituted or substituted with at least one $R_{10a}$, a $C_3$-$C_{60}$ carbocyclic group that is unsubstituted or substituted with at least one $R_{10a}$, a $C_1$-$C_{60}$ heterocyclic group that is unsubstituted or substituted with at least one $R_{10a}$,-$Si(Q_{301})(Q_{302})(Q_{303})$, -$N(Q_{301})(Q_{302})$, -$B(Q_{301})(Q_{302})$, -$C(=O)(Q_{301})$, -$S(=O)_2(Q_{301})$, or - $P(=O)(Q_{301})(Q_{302})$,
xb21 may be an integer from 1 to 5, and $Q_{301}$ to $Q_{303}$ are each as described in connection with $Q_1$.

According to one or more embodiments, if (e.g., when) xb11 in Formula 301 is 2 or more, two or more of $Ar_{301}$ may be linked to each other via a single bond.

According to one or more embodiments, the host may include a compound represented by Formula 301-1, a compound represented by Formula 301-2, or any combination thereof:

**Formula 301-1**

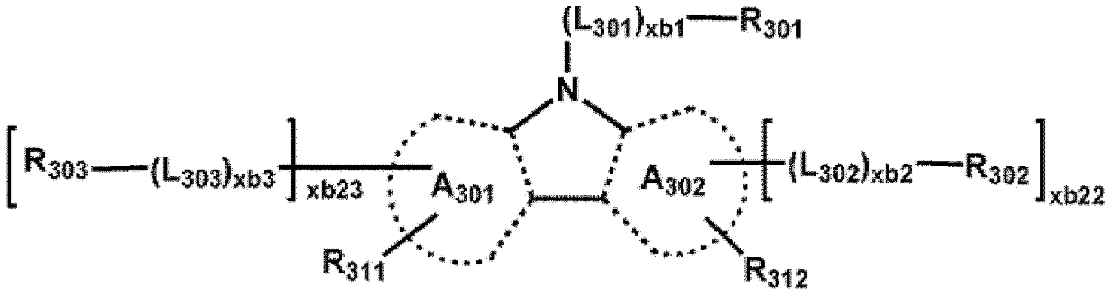

**Formula 301-2**

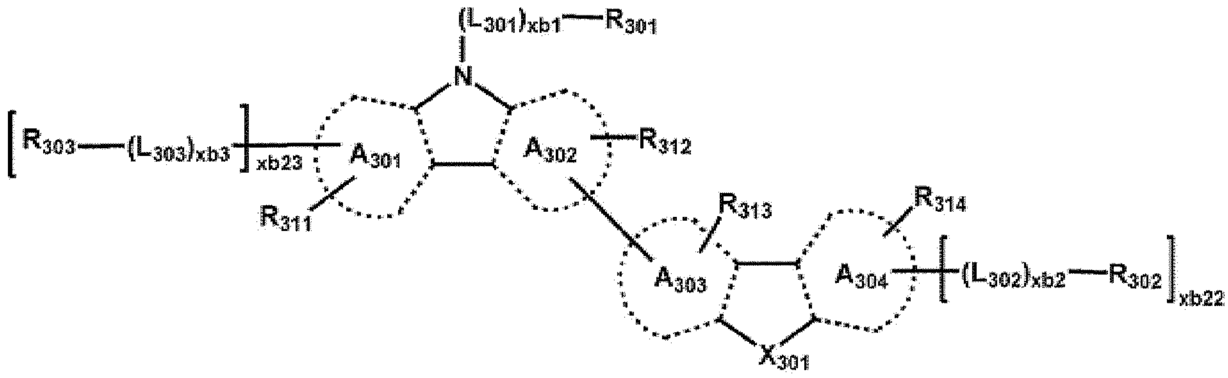

wherein, in Formulae 301-1 and 301-2,

ring $A_{301}$ to ring $A_{304}$ may each independently be a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,
$X_{301}$ may be O, S, N-[$(L_{304})_{xb4}$-$R_{304}$], C($R_{304}$)($R_{305}$), or Si($R_{304}$)($R_{305}$),
xb22 and xb23 may each independently be 0, 1, or 2,
$L_{301}$, xb1, and $R_{301}$ are each as described in the present specification,
$L_{302}$ to $L_{304}$ may each independently be as described in connection with $L_{301}$,
xb2 to xb4 may each independently be as described in connection with xb1, and
$R_{302}$ to $R_{305}$ and $R_{311}$ to $R_{314}$ are each as described in connection with $R_{301}$.

According to one or more embodiments, the host may include an alkaline earth metal complex, a post-transition metal complex, or any combination thereof. According to one or more embodiments, the host may include a Be complex (for example, Compound H55), an Mg complex, a Zn complex, or any combination thereof.

In one or more embodiments, the host may include: at least one of (e.g., be any one selected from among) Compounds H1 to H128; 9,10-di(2-naphthyl)anthracene (ADN); 2-methyl-9,10-bis(naphthalen-2-yl)anthracene (MADN); 9,10-di-(2-naphthyl)-2-t-butyl-anthracene (TBADN); 4,4'-bis(N-carbazolyl)-1,1'-biphenyl (CBP);1,3-di(carbazol-9-yl) benzene (mCP); 1,3,5-tri(carbazol-9-yl)benzene (TCP); or any combination thereof:

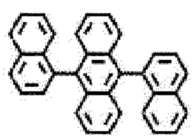
H1

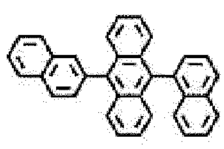
H2

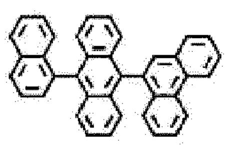
H3

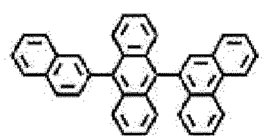
H4

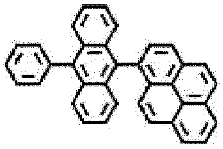
H5

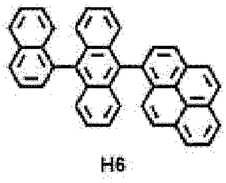
H6

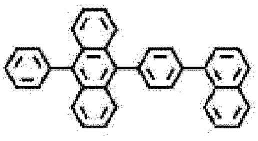
H7

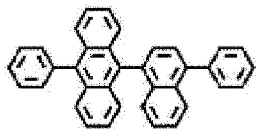
H8

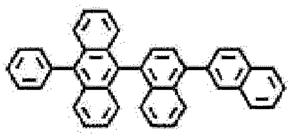
H9

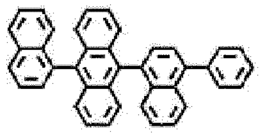
H10

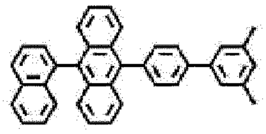
H11

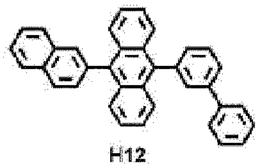
H12

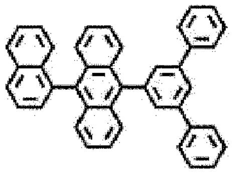
H13

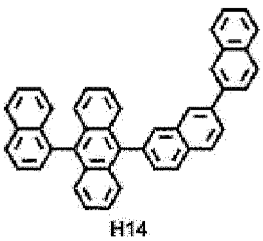
H14

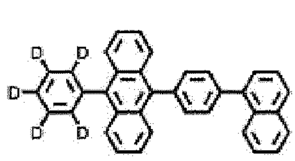
H15

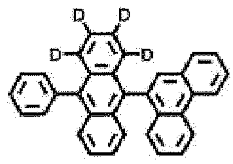
H16

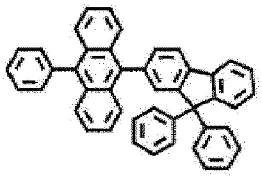
H17

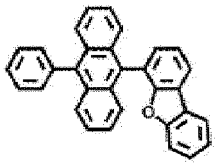
H18

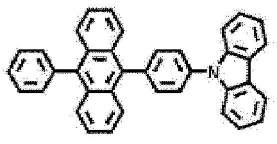
H19

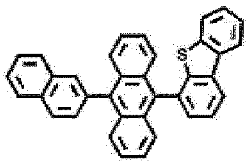
H20

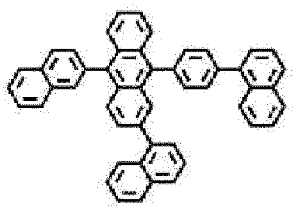
H21

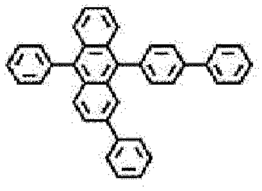
H22

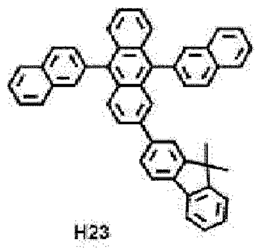
H23

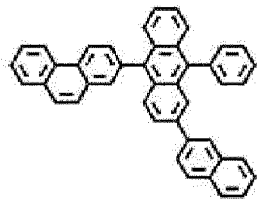
H24

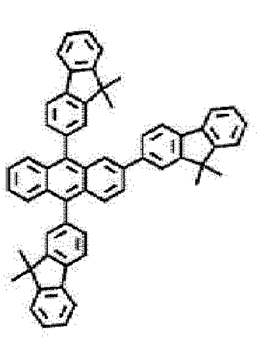
H25

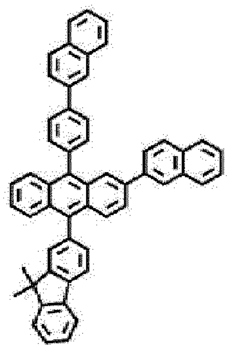
H26

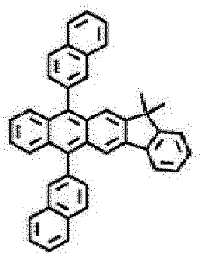
H27

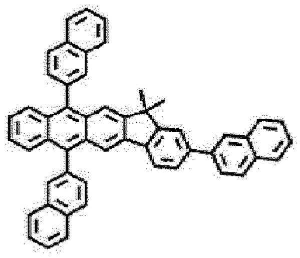
H28

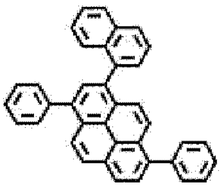
H29

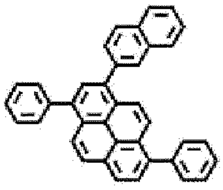
H30

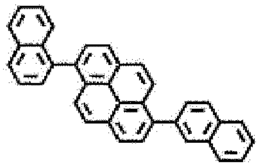
H31

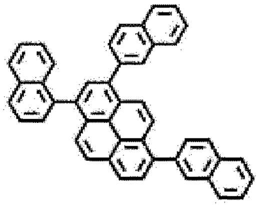
H32

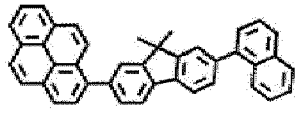
H33

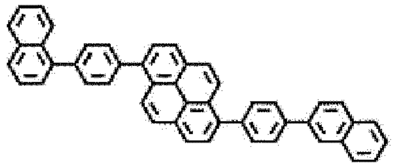
H34

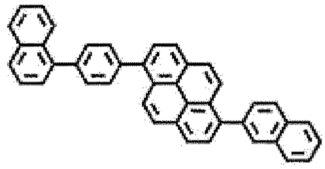
H35

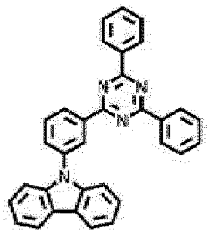
H36

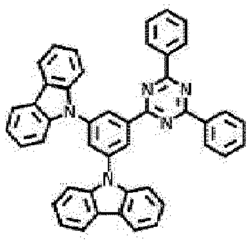
H37

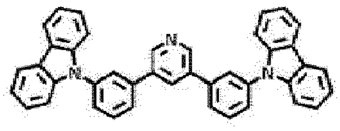
H38

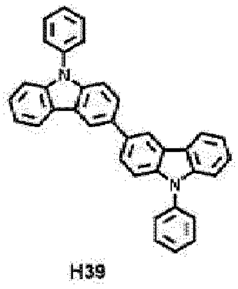
H39

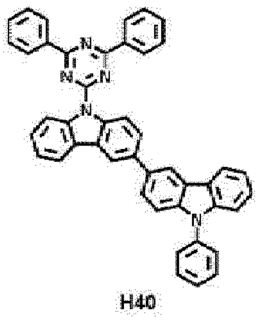
H40

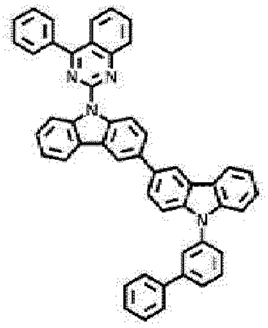
H41

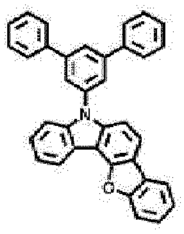
H42

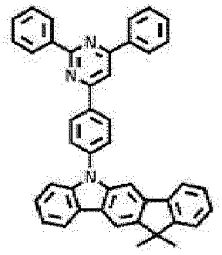
H43

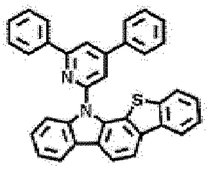
H44

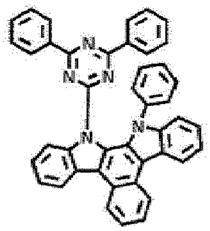
H45

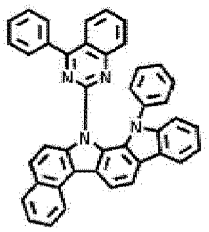
H46

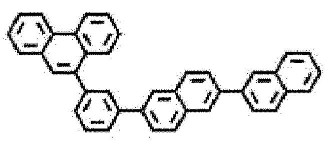
H47

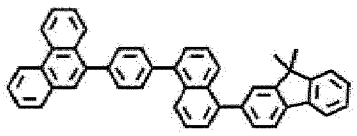
H48

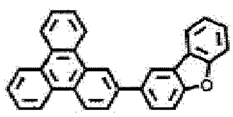
H49

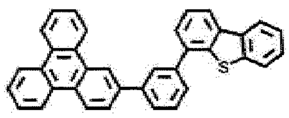
H50

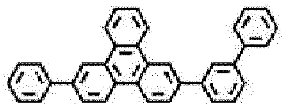
H51
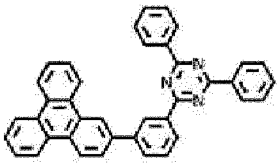
H52
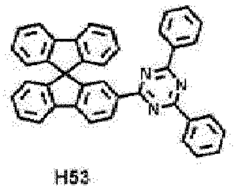
H53
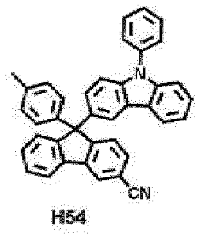
H54

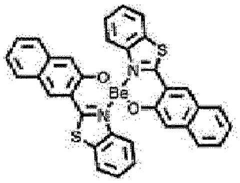
H55
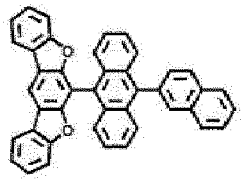
H56
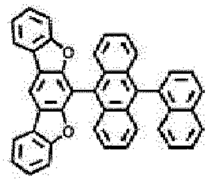
H57
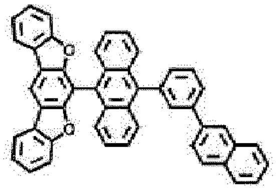
H58

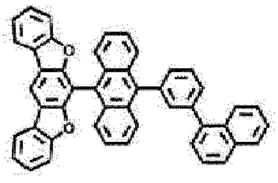
H59
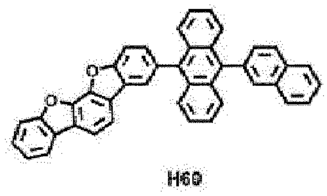
H60
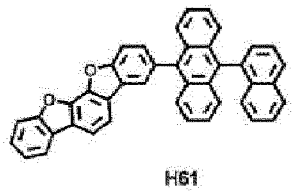
H61

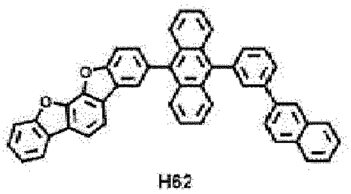
H62
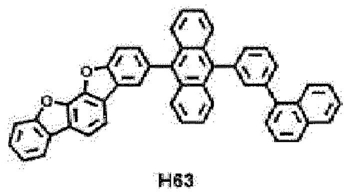
H63
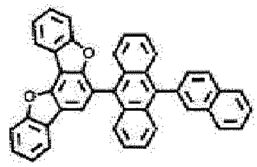
H64

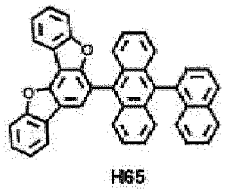
H65
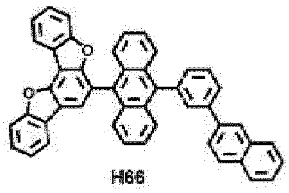
H66
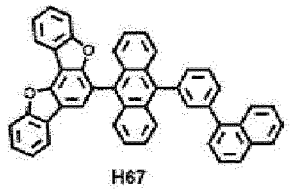
H67

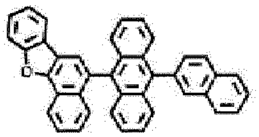
H68
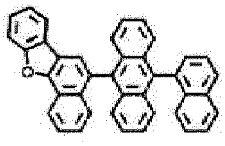
H69
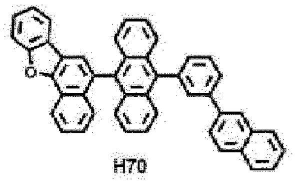
H70
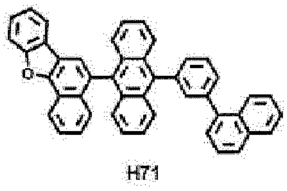
H71

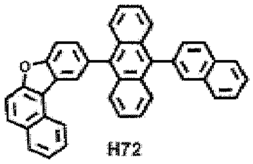
H72
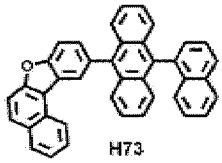
H73
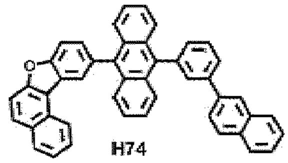
H74
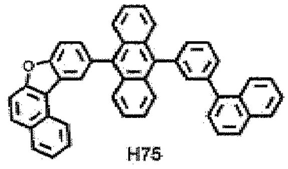
H75

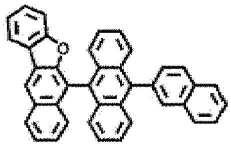
H76

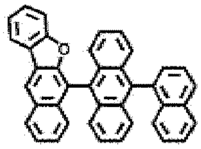
H77

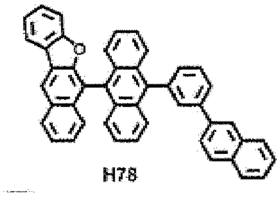
H78

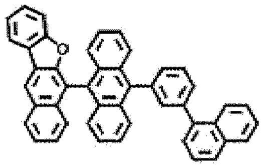
H79

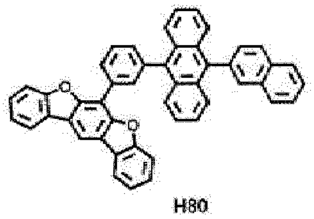
H80

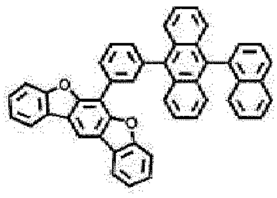
H81

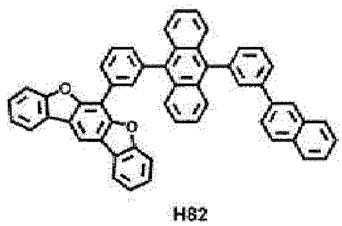
H82

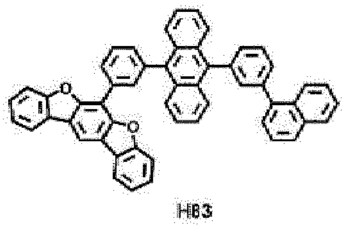
H83

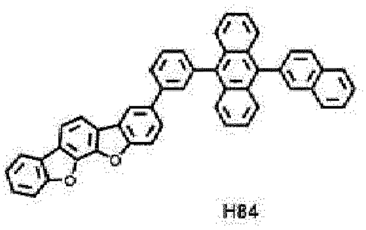
H84

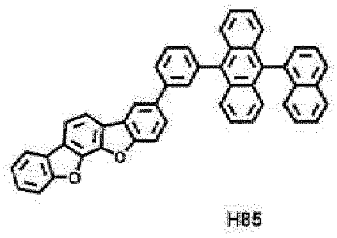
H85

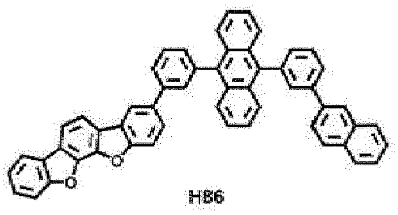
H86

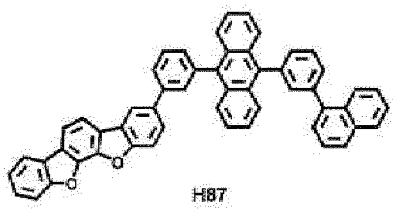
H87

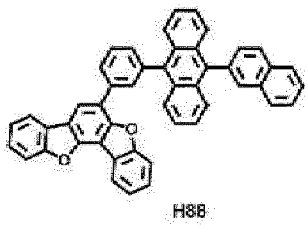
H88

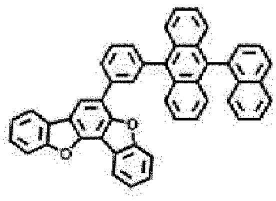
H89

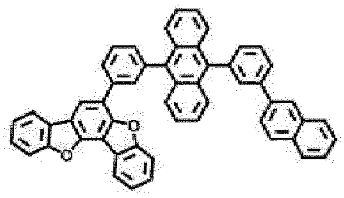
H90

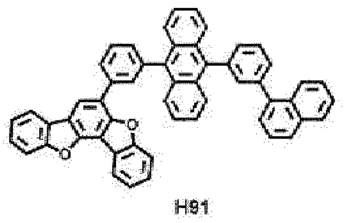
H91

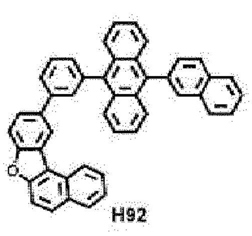
H92

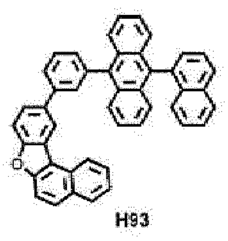
H93

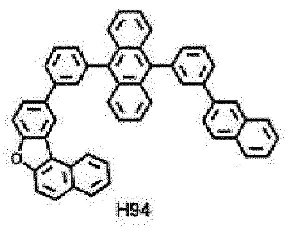
H94

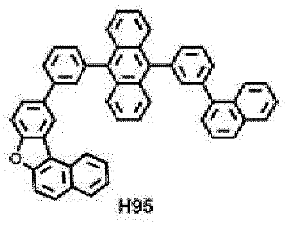
H95

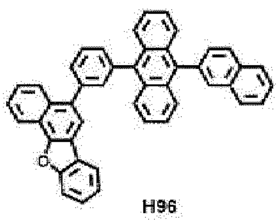
H96
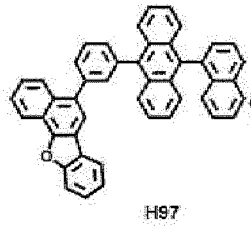
H97
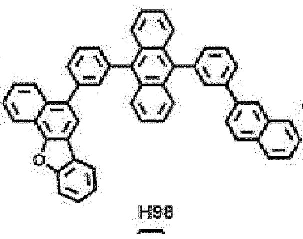
H98
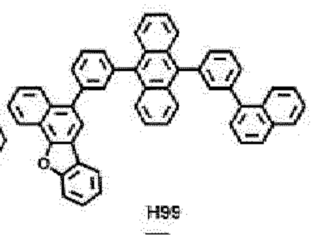
H99

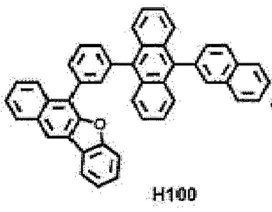
H100
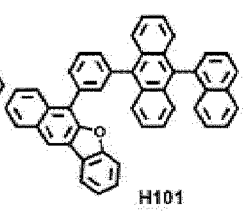
H101
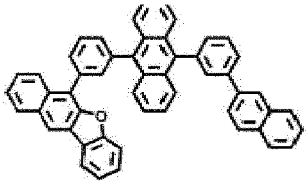
H102
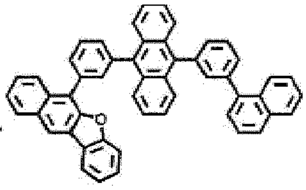
H103

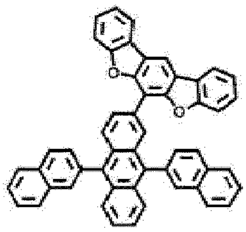
H104
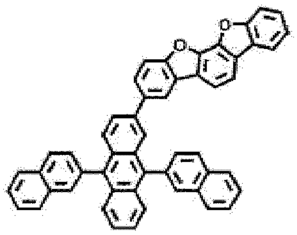
H105
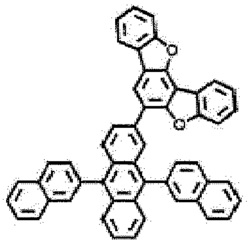
H106
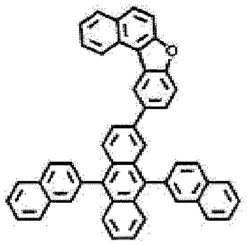
H107

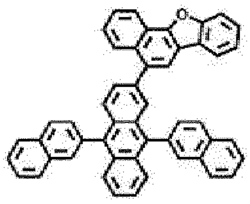
H108
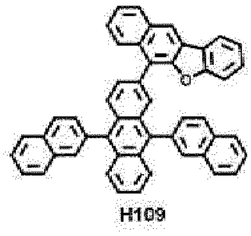
H109
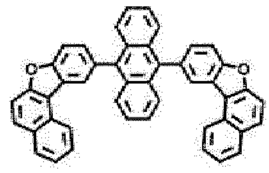
H110
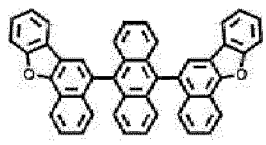
H111

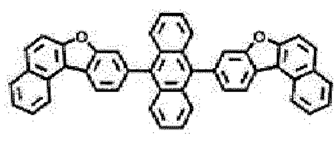
H112
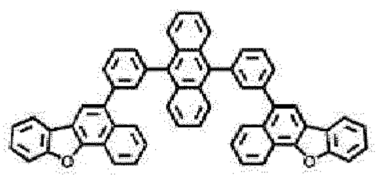
H113
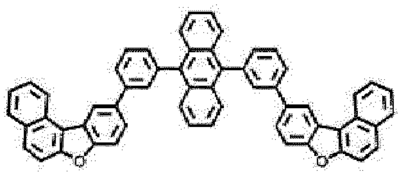
H114

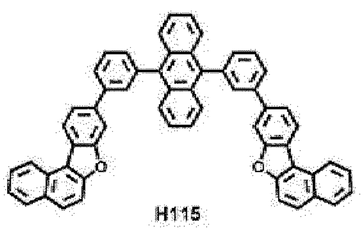
H115
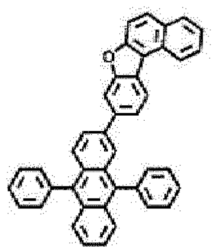
H116
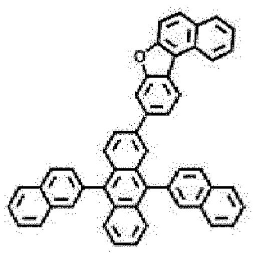
H117

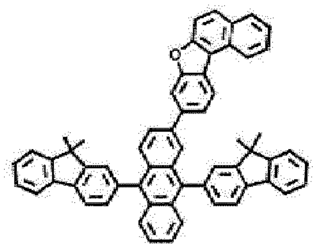
H118

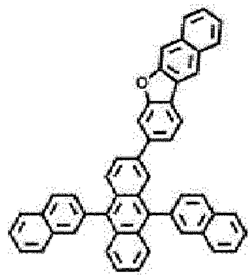
H119

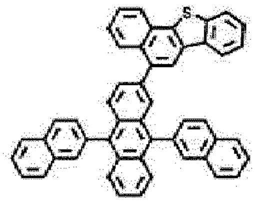
H120

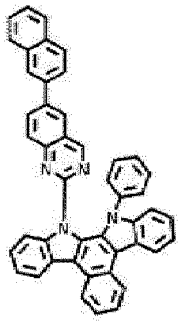
H121

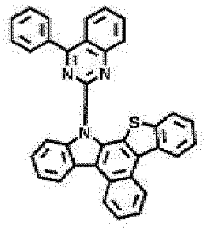
H122

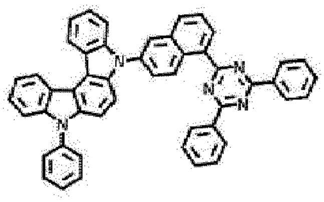
H123

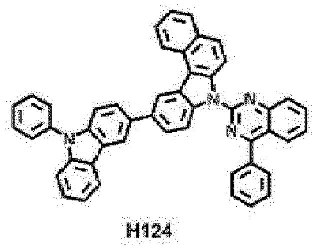
H124

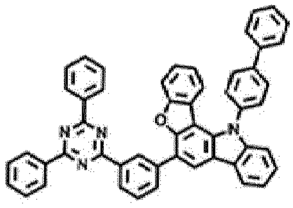
H125

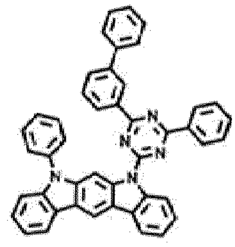
H126

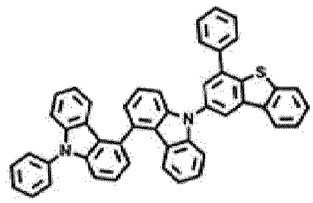
H127

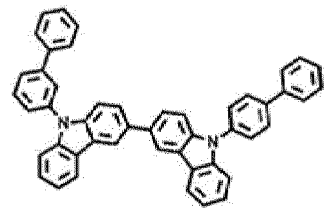
H128

**Phosphorescent dopant**

The phosphorescent dopant may include at least one transition metal as a central metal.

The phosphorescent dopant may include a monodentate ligand, a bidentate ligand, a tridentate ligand, a tetradentate ligand, a pentadentate ligand, a hexadentate ligand, or any combination thereof.

The phosphorescent dopant may be electrically neutral.

According to one or more embodiments, the phosphorescent dopant may include an organometallic compound represented by Formula 401:

**Formula 401** $M(L_{401})_{xc1}(L_{402})_{xc2}$

**Formula 402**

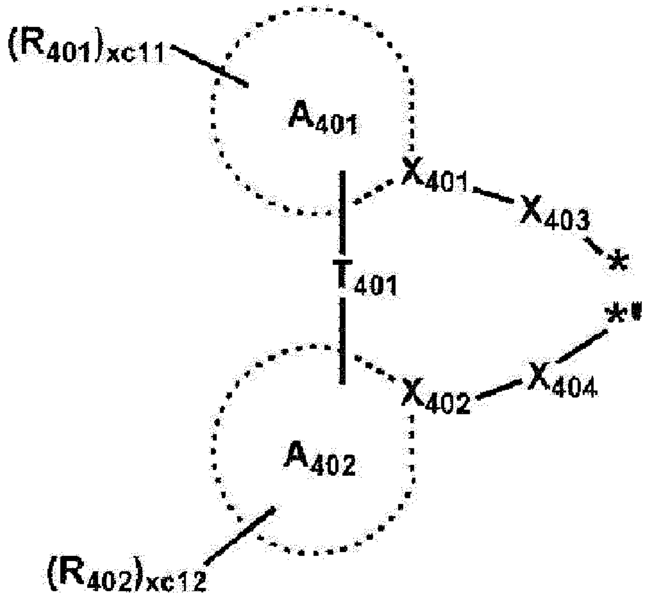

wherein, in Formulae 401 and 402,

M may be a transition metal (e.g., Ir, Pt, Pd, Os, Ti, Au, Hf, Eu, Tb, Rh, Re, or Tm),
$L_{401}$ may be a ligand represented by Formula 402, and xc1 is 1, 2, or 3, wherein, if (e.g., when) xc1 is 2 or more, two or more of $L_{401}$ may be substantially identical to or different from each other,
$L_{402}$ may be an organic ligand, and xc2 may be 0, 1, 2, 3, or 4, wherein, if (e.g., when) xc2 is 2 or more, two or more of $L_{402}$ may be substantially identical to or different from each other,
$X_{401}$ and $X_{402}$ may each independently be nitrogen or carbon,
ring $A_{401}$ and ring $A_{402}$ may each independently be a $C_3$-$C_{60}$ carbocyclic group or a $C_1$-$C_{60}$ heterocyclic group,
$T_{401}$ may be a single bond, *-O-*', *-S-*', *-C(=O)-*', *-N($Q_{411}$)-*', *-C($Q_{411}$)($Q_{412}$)-*', *-C($Q_{411}$)=C($Q_{412}$)-*', *-C($Q_{411}$)=*', or ***=C=*',**
$X_{403}$ and $X_{404}$ may each independently be a chemical bond (for example, a covalent bond or a coordinate bond), O, S, N($Q_{413}$), B($Q_{413}$), P($Q_{413}$), C($Q_{413}$)($Q_{414}$), or Si($Q_{413}$)($Q_{414}$),
$Q_{411}$ to $Q_{414}$ are each as described in connection with $Q_1$,
$R_{401}$ and $R_{402}$ may each independently be hydrogen, deuterium, -F, -Cl, -Br, - I, a hydroxyl group, a cyano group, a nitro group, a $C_1$-$C_{20}$ alkyl group unsubstituted or substituted with at least one $R_{10a}$, a $C_1$-$C_{20}$ alkoxy group unsubstituted or substituted with at least one $R_{10a}$, a $C_3$-$C_{60}$ carbocyclic group unsubstituted or substituted with at least one $R_{10a}$, a $C_1$-$C_{60}$ heterocyclic group unsubstituted or substituted with at least one $R_{10a}$, -Si($Q_{401}$)($Q_{402}$)($Q_{403}$), -N($Q_{401}$)($Q_{402}$), -B($Q_{401}$)($Q_{402}$), -C(=O)($Q_{401}$), - S(=O)$_2$($Q_{401}$), or -P(=O)($Q_{401}$)($Q_{402}$),
$Q_{401}$ to $Q_{403}$ are each as described in connection with $Q_1$,
xc11 and xc12 may each independently be an integer from 0 to 10, and
* and *' in Formula 402 each indicates a binding site to M in Formula 401.

According to one or more embodiments, in Formula 402, i) $X_{401}$ may be nitrogen, and $X_{402}$ may be carbon, or ii) each of $X_{401}$ and $X_{402}$ may be nitrogen.

In one or more embodiments, if (e.g., when) xc1 in Formula 402 is 2 or more, two ring $A_{401}$(s) in two or more of $L_{401}$(s) may optionally be linked to each other via $T_{402}$, which is a linking group, or two ring $A_{402}$(s) may optionally be linked to each other via $T_{403}$, which is a linking group (see Compounds PD1 to PD4 and PD7). $T_{402}$ and $T_{403}$ are each as described in connection with $T_{401}$.

$L_{402}$ in Formula 401 may be an organic ligand. According to one or more embodiments, $L_{402}$ may include a halogen group, a diketone group (for example, an acetylacetonate group), a carboxylic acid group (for example, a picolinate group), - C(=O), an isonitrile group, a -CN group, a phosphorus group (for example, a phosphine group, a phosphite group, and/or the like), or any combination thereof.

The phosphorescent dopant may include, for example, at least one of compounds PD1 to PD39, or any combination thereof:

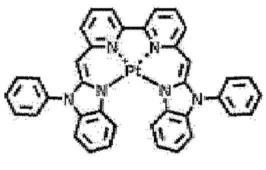

PD1

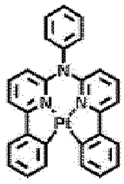

PD2

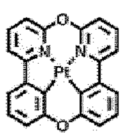

PD3

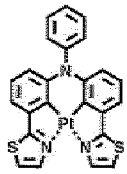

PD4

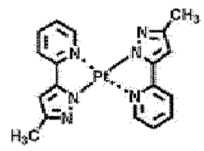

PD5

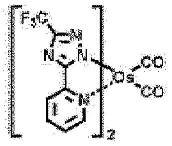

PD6

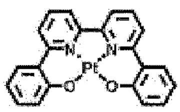

PD7

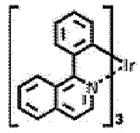

PD8

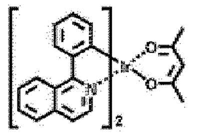

PD9

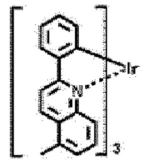

PD10

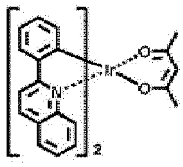

PD11

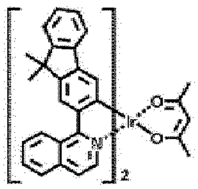

PD12

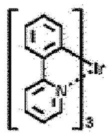

PD13

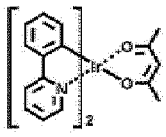

PD14

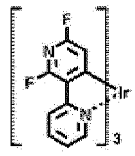

PD15

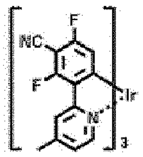

PD16

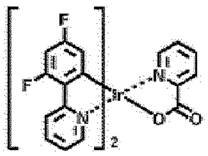

PD17

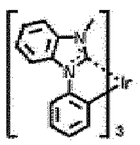

PD18

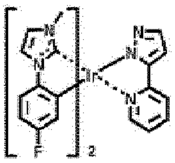

PD19

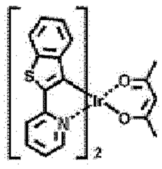

PD20

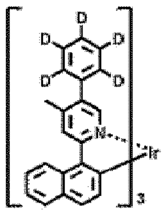

PD21

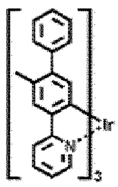

PD22

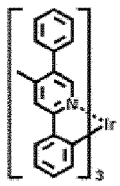

PD23

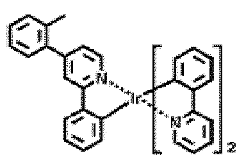

PD24

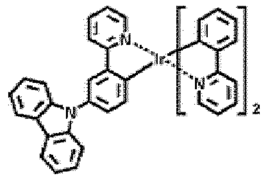

PD25

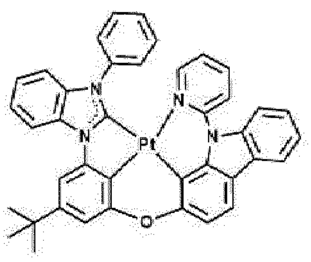

PD26

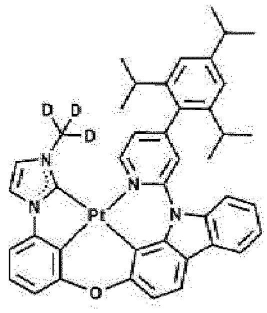

PD27

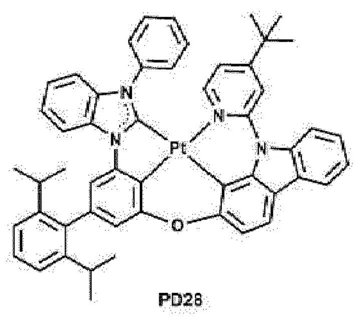

PD28

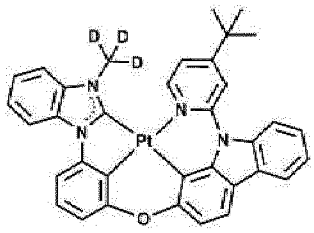

PD29

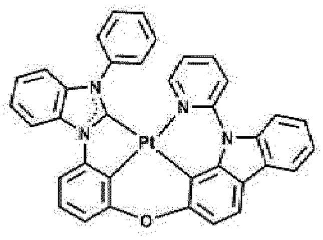

PD30

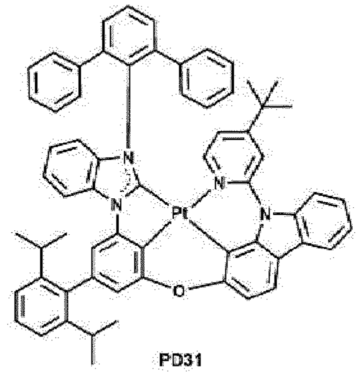

PD31

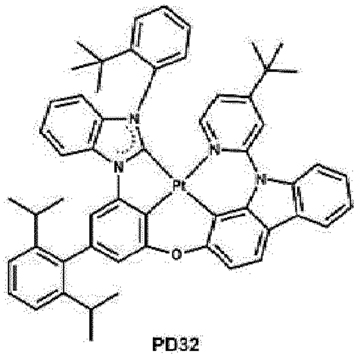

PD32

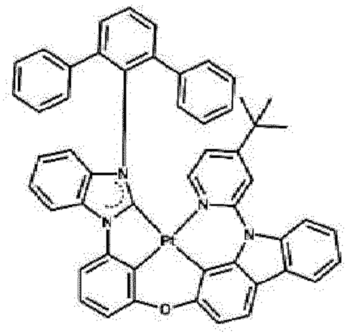

PD33

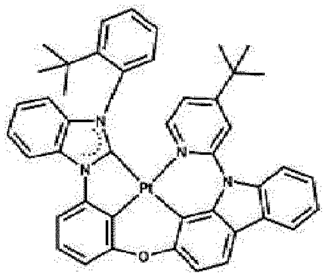

PD34

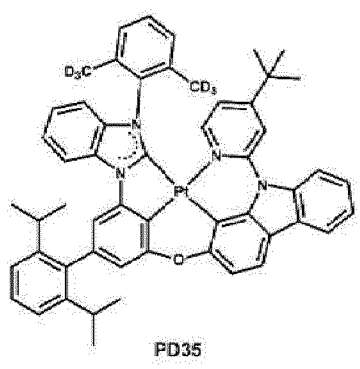

PD35

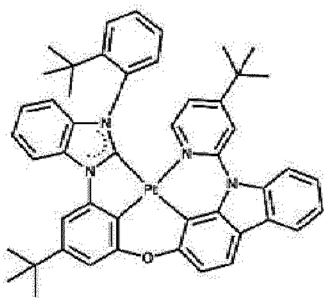

PD36

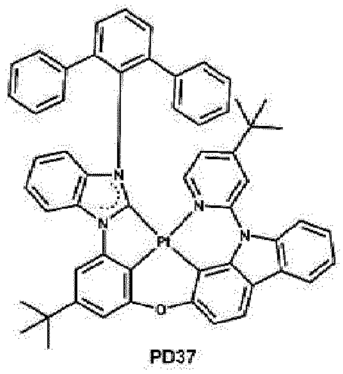

PD37

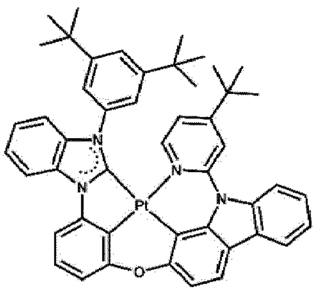

PD38

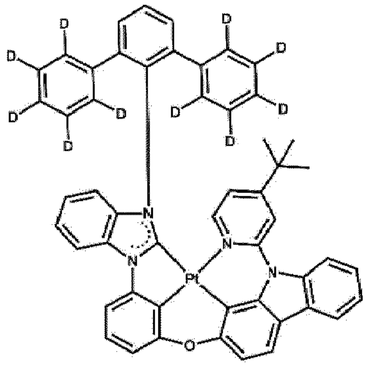

PD39

## Fluorescent dopant

The fluorescent dopant may include an amine group-containing compound, a styryl group-containing compound, or any combination thereof.

For example, the fluorescent dopant may include a compound represented by Formula 501:

## Formula 501

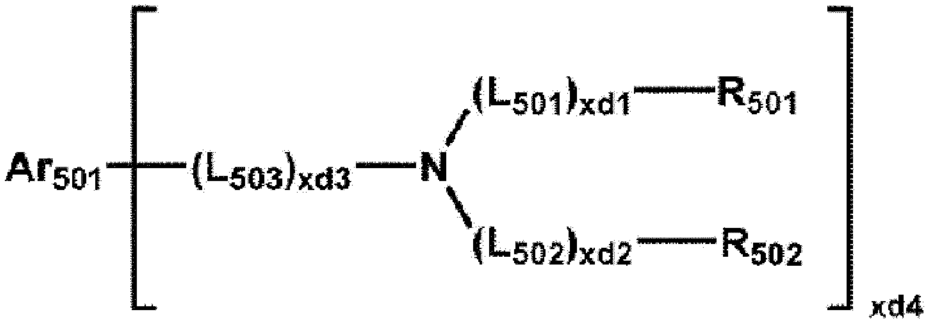

wherein, in Formula 501,

$Ar_{501}$, $L_{501}$ to $L_{503}$, $R_{501}$, and $R_{502}$ may each independently be a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,
xd1 to xd3 may each independently be 0, 1, 2, or 3, and
xd4 may be 1, 2, 3, 4, 5, or 6.

According to one or more embodiments, $Ar_{501}$ in Formula 501 may be a condensed cyclic group (for example, an anthracene group, a chrysene group, a pyrene group, and/or the like) in which three or more monocyclic groups are condensed together.

According to one or more embodiments, xd4 in Formula 501 may be 2.

According to one or more embodiments, the fluorescent dopant may include: at least one of (e.g., selected from among) Compounds FD1 to FD37; DPVBi; DPAVBi; and/or any combination thereof:

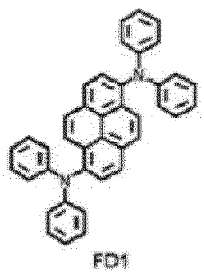

FD1

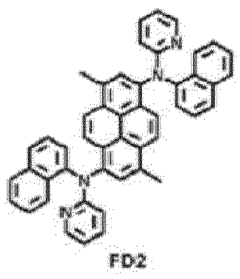

FD2

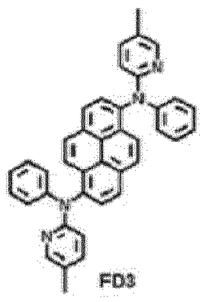

FD3

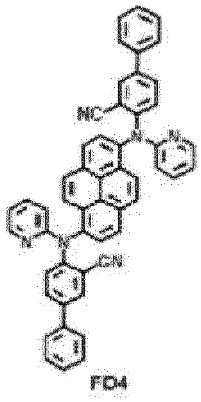

FD4

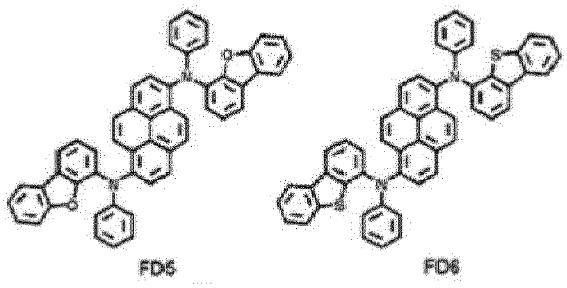

FD5

FD6

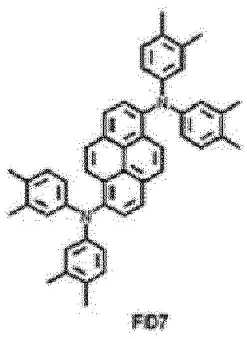

FD7

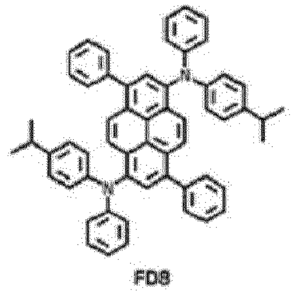

FD8

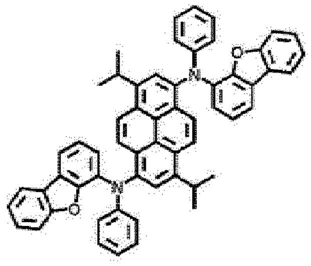
FD9

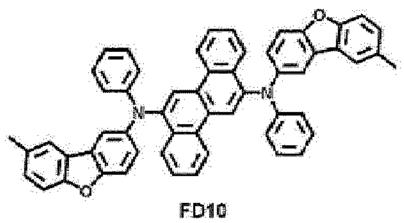
FD10

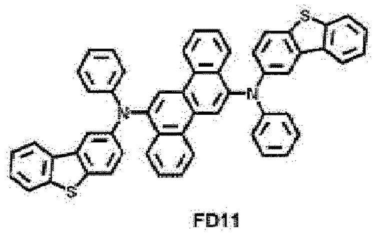
FD11

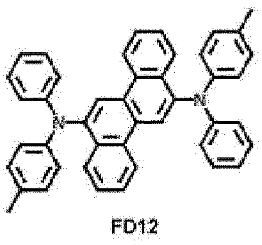
FD12

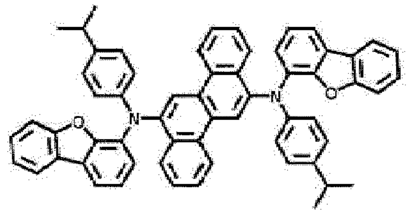
FD13

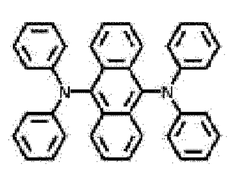
FD14

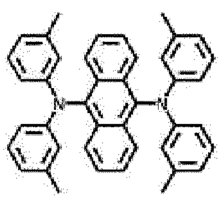
FD15

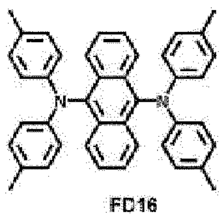
FD16

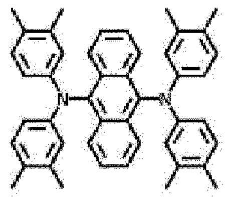
FD17

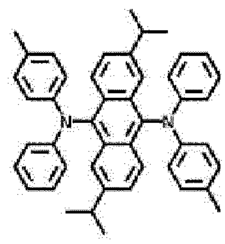
FD18

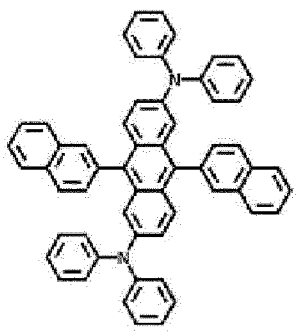
FD19

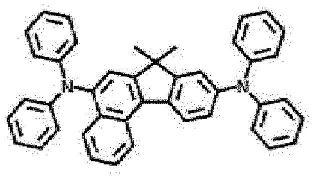
FD20

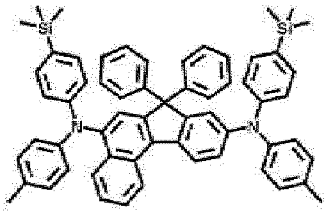
FD21

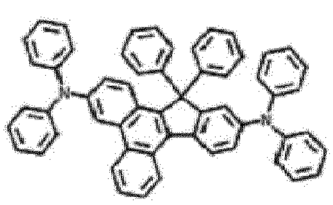
FD22

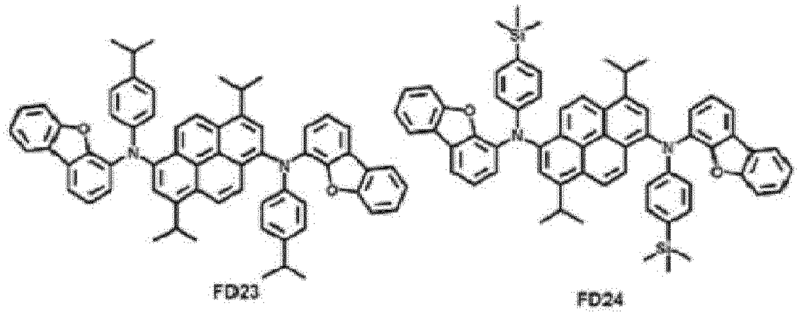
FD23

FD24

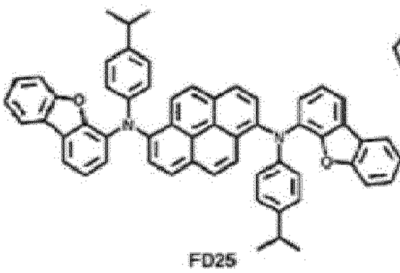
FD25

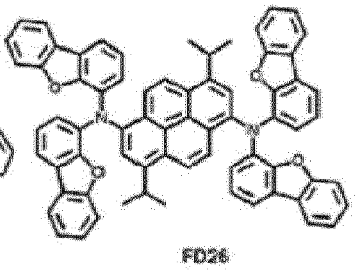
FD26

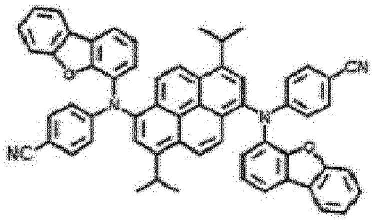
FD27

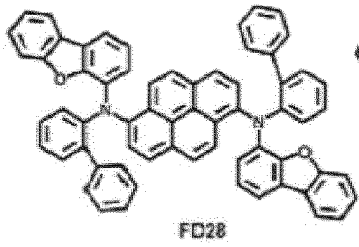
FD28

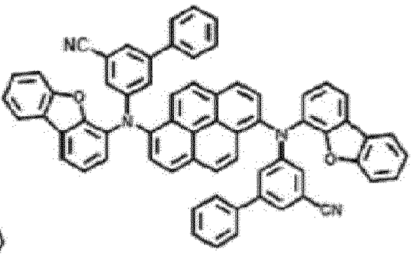
FD29

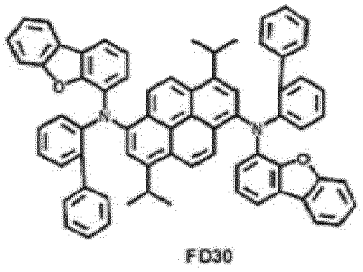
FD30

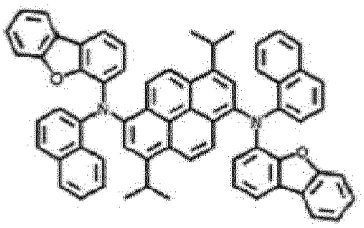
FD31

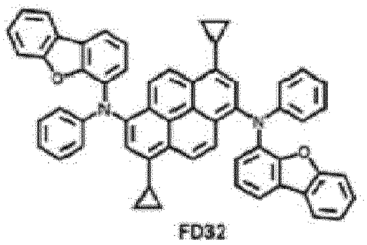
FD32

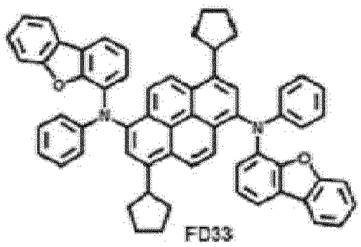
FD33

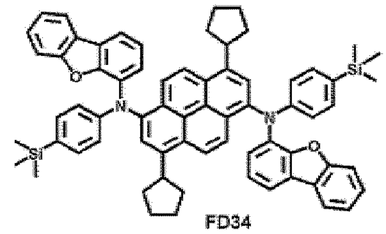
FD34

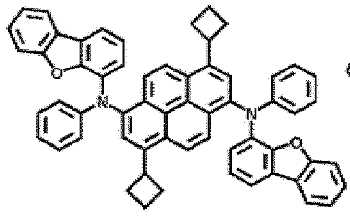
FD35

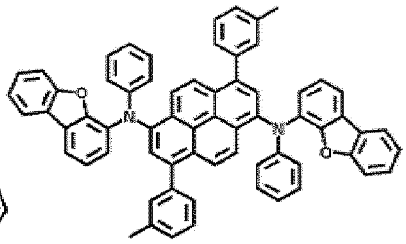
FD36

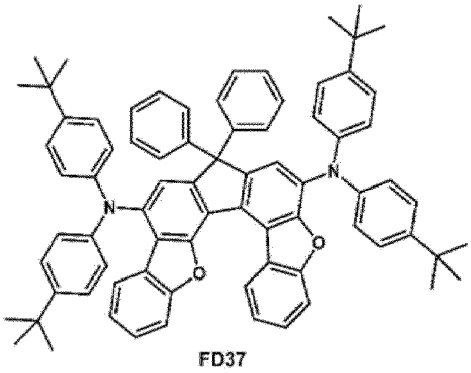
FD37

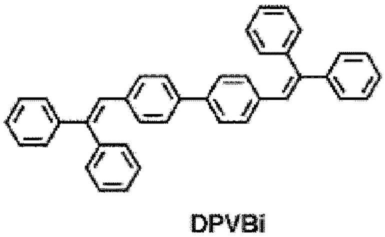

DPVBi

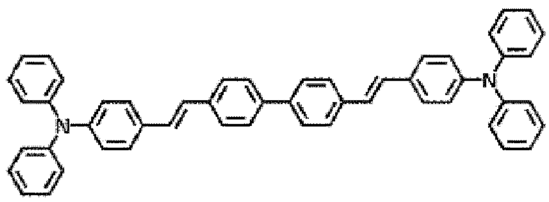

DPAVBi

.

**Delayed fluorescence material**

The emission layer may include a delayed fluorescence material.

Herein, the delayed fluorescence material may be selected from among compounds capable of emitting delayed fluorescence based on a delayed fluorescence emission mechanism.

The delayed fluorescence material included in the emission layer may act as a host or a dopant depending on the type (kind) of other materials included in the emission layer.

According to one or more embodiments, a difference between a triplet energy level (eV) of the delayed fluorescence material and the singlet energy level (eV) of the delayed fluorescence material may be at least about 0 eV and not more than about 0.5 eV. When the difference between the triplet energy level (eV) of the delayed fluorescence material and the singlet energy level (eV) of the delayed fluorescence material satisfies the herein-described range, up-conversion from the triplet state to the singlet state of the delayed fluorescence materials may effectively occur, and thus, the luminescence efficiency of the light-emitting device 10 may be improved.

According to one or more embodiments, the delayed fluorescence material may include: i) a material including at least one electron donor (for example, a $\pi$ electron-rich $C_3$-$C_{60}$ cyclic group such as a carbazole group) and at least one electron acceptor (for example, a sulfoxide group, a cyano group, a $\pi$ electron-deficient nitrogen-containing $C_1$-$C_{60}$ cyclic group, and/or the like), ii) a material including a $C_8$-$C_{60}$ polycyclic group including at least two cyclic groups that are condensed with each other while sharing boron (B).

Examples of the delayed fluorescence material may include at least one of (e.g., selected from among) Compounds DF1 to DF14:

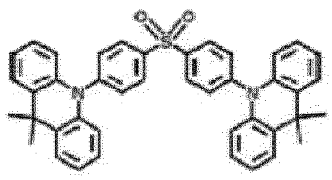

DF1(DMAC-DPS)

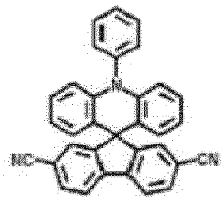

DF2(ACRFLCN)

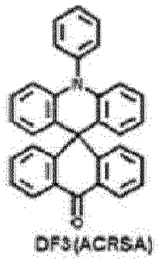

DF3(ACRSA)

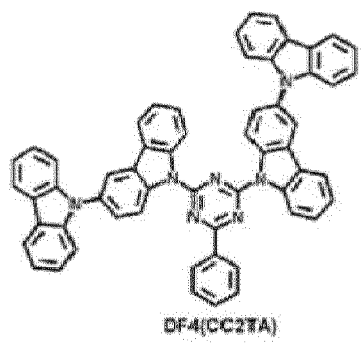

DF4(CC2TA)

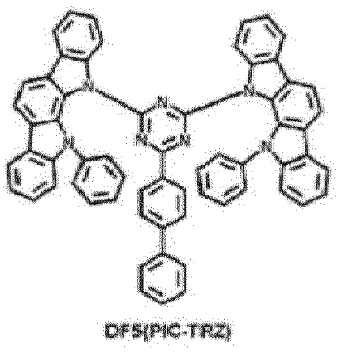

DF5(PIC-TRZ)

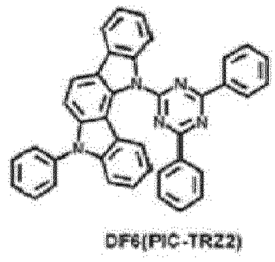

DF6(PIC-TRZ2)

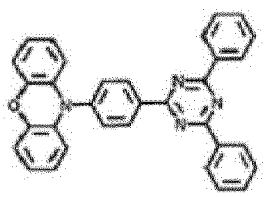

DF7(PXZ-TRZ)

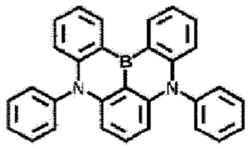

DF8(DABNA-1)

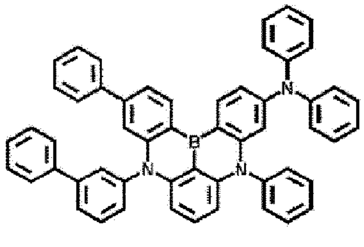

DF9(DABNA-2)

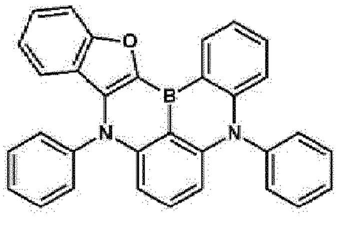

DF10

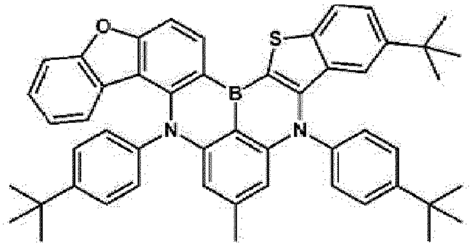

DF11

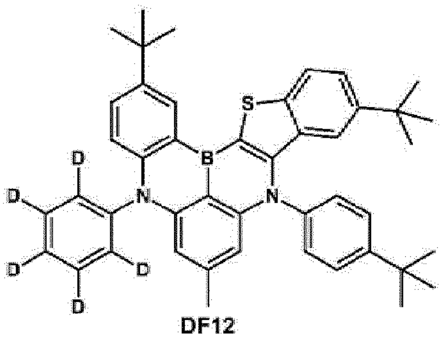

DF12

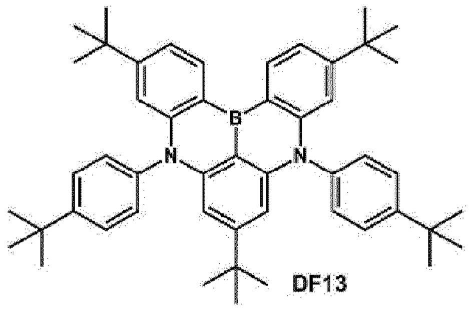

DF13

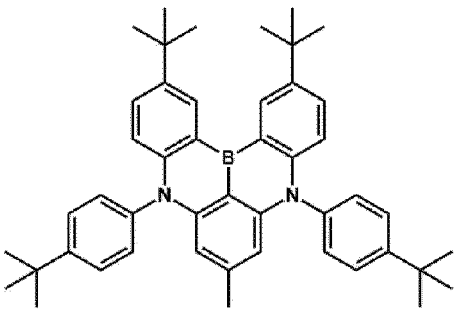

DF14

**Quantum dot**

The emission layer may include a quantum dot.

The term "quantum dot" as used herein refers to a crystal of a semiconductor compound, and may include any material capable of emitting light of one or more suitable emission wavelengths according to the size of the crystal.

A diameter of the quantum dot may be, for example, in a range of about 1 nanometer (nm) to about 10 nm. In the present disclosure, when quantum dot, quantum dots, or quantum dot particles are spherical, "diameter" indicates a particle diameter or an average particle diameter, and when the particles are non-spherical, the "diameter" indicates a major axis length or an average major axis length. The diameter of the particles may be measured utilizing a scanning electron microscope or a particle size analyzer. As the particle size analyzer, for example, HORIBA, LA-950 laser particle size analyzer, may be utilized. When the size of the particles is measured utilizing a particle size analyzer, the average particle diameter is referred to as D50. D50 refers to the average diameter of particles whose cumulative volume corresponds to 50 vol% in the particle size distribution (e.g., cumulative distribution), and refers to the value of the particle

size corresponding to 50% from the smallest particle when the total number of particles is 100% in the distribution curve accumulated in the order of the smallest particle size to the largest particle size.

The quantum dot may be synthesized by a wet chemical process, a metal organic chemical vapor deposition process, a molecular beam epitaxy process, or any process similar thereto.

The wet chemical process is a method including mixing a precursor material with an organic solvent and then growing a quantum dot particle crystal. When the crystal grows, the organic solvent naturally acts as a dispersant coordinated on the surface of the quantum dot crystal and controls the growth of the crystal so that the growth of quantum dot particles can be controlled or selected through a process which costs lower, and is easier than vapor deposition methods, such as metal organic chemical vapor deposition (MOCVD) or molecular beam epitaxy (MBE).

The quantum dot may include Group II-VI semiconductor compounds, Group III-V semiconductor compounds, Group III-VI semiconductor compounds, Group I-III-VI semiconductor compounds, Group IV-VI semiconductor compounds, a Group IV element or compound, and/or a (e.g., any suitable) combination thereof.

Examples of the Group II-VI semiconductor compound are a binary compound, such as CdS, CdSe, CdTe, ZnS, ZnSe, ZnTe, ZnO, HgS, HgSe, HgTe, MgSe, or MgS; a ternary compound, such as CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, or MgZnS; a quaternary compound, such as CdZnSeS, CdZnSeTe, CdZnSTe, CdHgSeS, CdHgSeTe, CdHgSTe, HgZnSeS, HgZnSeTe, or HgZnSTe; and/or a (e.g., any suitable) combination thereof.

Examples of the Group III-V semiconductor compound are: a binary compound, such as GaN, GaP, GaAs, GaSb, AIN, AlP, AlAs, AlSb, InN, InP, InAs, InSb, and/or the like; a ternary compound, such as GaNP, GaNAs, GaNSb, GaPAs, GaPSb, AINP, AlNAs, AlNSb, AlPAs, AlPSb, InGaP, InNP, InAlP, InNAs, InNSb, InPAs, InPSb, and/or the like; a quaternary compound, such as GaAlNP, GaAINAs, GaAINSb, GaAlPAs, GaAlPSb, GaInNP, GaInNAs, GaInNSb, GaInPAs, GaInPSb, InAlNP, InAINAs, InAlNSb, InAlPAs, InAlPSb, and/or the like; or any combination thereof. In one or more embodiments, the Group III-V semiconductor compound may further include a Group II element. Examples of the Group III-V semiconductor compound further including a Group II element are InZnP, InGaZnP, InAlZnP, and/or the like.

Examples of the Group III-VI semiconductor compound are: a binary compound, such as GaS, GaSe, $Ga_2Se_3$, GaTe, InS, InSe, $In_2S_3$, $In_2Se_3$, or InTe; a ternary compound, such as $InGaS_3$, or $InGaSe_3$; and/or a (e.g., any suitable) combination thereof.

Examples of the Group I-III-VI semiconductor compound are: a ternary compound, such as AgInS, $AgInS_2$, CuInS, $CuInS_2$, $CuGaO_2$, $AgGaO_2$, $AgAlO_2$, and/or the like; or any combination thereof.

Examples of the Group IV-VI semiconductor compound are: a binary compound, such as SnS, SnSe, SnTe, PbS, PbSe, or PbTe; a ternary compound, such as SnSeS, SnSeTe, SnSTe, PbSeS, PbSeTe, PbSTe, SnPbS, SnPbSe, or SnPbTe; a quaternary compound, such as SnPbSSe, SnPbSeTe, or SnPbSTe; and/or a (e.g., any suitable) combination thereof.

The Group IV element or compound may include: a single element compound, such as Si or Ge; a binary compound, such as SiC or SiGe; and/or a (e.g., any suitable) combination thereof.

Each element included in a multi-element compound such as the binary compound, the ternary compound, and the quaternary compound may be present at a substantially uniform concentration or substantially non-uniform concentration in a particle.

In one or more embodiments, the quantum dot may have a single structure in which the concentration of each element in the quantum dot is substantially uniform, or a core-shell dual structure. For example, the material included in the core and the material included in the shell may be different from each other.

The shell of the quantum dot may act as a protective layer that prevents chemical degeneration of the core to maintain semiconductor characteristics, and/or as a charging layer that imparts electrophoretic characteristics to the quantum dot. The shell may be a single layer or a multi-layer. The interface between the core and the shell may have a concentration gradient in which the concentration of an element existing in the shell decreases toward the center of the core.

Examples of the shell of the quantum dot may be an oxide of metal, metalloid, or non-metal, a semiconductor compound, and/or a (e.g., any suitable) combination thereof. Examples of the oxide of metal, metalloid, or non-metal are a binary compound, such as $SiO_2$, $Al_2O_3$, $TiO_2$, ZnO, MnO, $Mn_2O_3$, $Mn_3O_4$, CuO, FeO, $Fe_2O_3$, $Fe_3O_4$, CoO, $Co_3O_4$, or NiO; a ternary compound, such as $MgAl_2O_4$, $CoFe_2O_4$, $NiFe_2O_4$, or $CoMn_2O_4$; and/or a (e.g., any suitable) combination thereof. Examples of the semiconductor compound are, as described herein, a Group II-VI semiconductor compound; a Group III-V semiconductor compound; a Group III-VI semiconductor compound; a Group I-III-VI semiconductor compound; a Group IV-VI semiconductor compound; and/or a (e.g., any suitable) combination thereof. For example, the semiconductor compound may include CdS, CdSe, CdTe, ZnS, ZnSe, ZnTe, ZnSeS, ZnTeS, GaAs, GaP, GaSb, HgS, HgSe, HgTe, InAs, InP, InGaP, InSb, AlAs, AlP, AlSb, and/or a (e.g., any suitable) combination thereof.

A full width at half maximum (FWHM) of the emission wavelength spectrum of the quantum dot may be about 45 nm or less, for example, about 40 nm or less, for example, about 30 nm or less, and within these ranges, color purity or color reproducibility may be increased. In some embodiments, because the light emitted through the quantum dot is emitted in

all directions, the wide viewing angle may be improved.

In some embodiments, the quantum dot may be in the form of a spherical particle, a pyramidal particle, a multi-arm particle, a cubic nanoparticle, a nanotube particle, a nanowire particle, a nanofiber particle, or a nanoplate particle.

Because an energy band gap may be adjusted by controlling the size of the quantum dot, light having one or more suitable wavelength bands may be obtained from the quantum dot emission layer. Accordingly, by using quantum dots of different sizes, a light-emitting device that emits light of one or more suitable wavelengths may be implemented. In one or more embodiments, the size of the quantum dot may be selected to emit red, green and/or blue light. In some embodiments, the size of the quantum dot may be configured to emit white light by combination of light of one or more suitable colors.

**Electron transport region in interlayer 130**

The electron transport region may have: i) a single-layered structure including (e.g., consisting of) a single layer including (e.g., consisting of) a single material, ii) a single-layered structure including (e.g., consisting of) a single layer including multiple different materials, or iii) a multilayer structure including multiple layers including multiple different materials.

The electron transport region may include a buffer layer, a hole-blocking layer, an electron control layer, an electron transport layer, an electron injection layer, or any combination thereof.

For example, the electron transport region may have an electron transport layer/electron injection layer structure, a hole-blocking layer/electron transport layer/electron injection layer structure, an electron control layer/electron transport layer/electron injection layer structure, or a buffer layer/electron transport layer/electron injection layer structure, wherein layers in each structure are sequentially stacked from the emission layer.

The electron transport region (e.g., the buffer layer, the hole-blocking layer, the electron control layer, or the electron transport layer in the electron transport region) may include a metal-free compound including at least one $\pi$ electron-deficient nitrogen-containing $C_1$-$C_{60}$ cyclic group.

According to one or more embodiments, the electron transport region may include a compound represented by Formula 601.

**Formula 601** $[Ar_{601}]_{xe11}$-$[(L_{601})_{xe1}$-$R_{601}]_{xe21}$

In Formula 601,

$Ar_{601}$ and $L_{601}$ may each independently be a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,
xe11 may be 1, 2, or 3,
xe1 may be 0, 1, 2, 3, 4, or 5,
$R_{601}$ may be a $C_3$-$C_{60}$ carbocyclic group that is unsubstituted or substituted with at least one $R_{10a}$, a $C_1$-$C_{60}$ heterocyclic group that is unsubstituted or substituted with at least one $R_{10a}$, $-Si(Q_{601})(Q_{602})(Q_{603})$, $-C(=O)(Q_{601})$, $-S(=O)_2(Q_{601})$, or - $P(=O)(Q_{601})(Q_{602})$,
$Q_{601}$ to $Q_{603}$ are each as described in connection with $Q_1$,
xe21 may be 1, 2, 3, 4, or 5, and
at least one of $Ar_{601}$, $L_{601}$, and $R_{601}$ may each independently be a $\pi$ electron-deficient nitrogen-containing $C_1$-$C_{60}$ cyclic group unsubstituted or substituted with at least one $R_{10a}$.

According to one or more embodiments, if (e.g., when) xe11 in Formula 601 is 2 or more, two or more of $Ar_{601}$ may be linked together via a single bond.

According to one or more embodiments, $Ar_{601}$ in Formula 601 may be a substituted or unsubstituted anthracene group.

According to one or more embodiments, the electron transport region may include a compound represented by Formula 601-1:

**Formula 601-1**

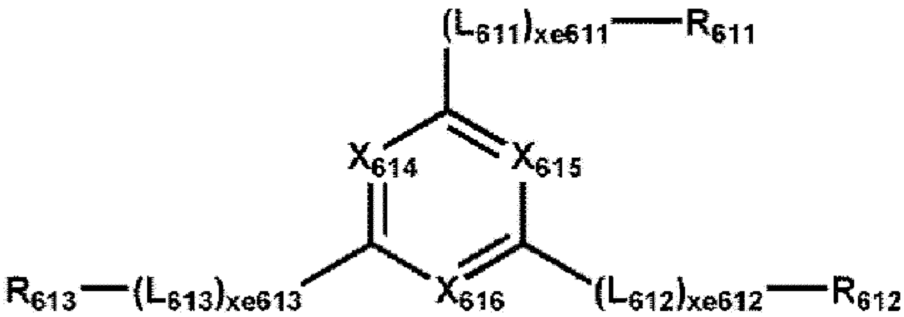

wherein, in Formula 601-1,

$X_{614}$ may be N or $C(R_{614})$, $X_{615}$ may be N or $C(R_{615})$, $X_{616}$ may be N or $C(R_{616})$, and at least one of $X_{614}$ to $X_{616}$ may be N,
$L_{611}$ to $L_{613}$ are each as described in connection with $L_{601}$,
xe611 to xe613 are each as described in connection with xe1,
$R_{611}$ to $R_{613}$ are each as described in connection with $R_{601}$, and
$R_{614}$ to $R_{616}$ may each independently be hydrogen, deuterium, -F, -Cl, -Br, -I, a hydroxyl group, a cyano group, a nitro group, a $C_1$-$C_{20}$ alkyl group, a $C_1$-$C_{20}$ alkoxy group, a $C_3$-$C_{60}$ carbocyclic group that is unsubstituted or substituted with at least one $R_{10a}$, or a $C_1$-$C_{60}$ heterocyclic group that is unsubstituted or substituted with at least one $R_{10a}$.

According to one or more embodiments, xe1 and xe611 to xe613 in Formulae 601 and 601-1 may each independently be 0, 1, or 2.

The electron transport region may include at least one of of (e.g., selected from among) Compounds ET1 to ET45, 2,9-dimethyl-4,7-diphenyl-1,10-phenanthroline (BCP), 4,7-diphenyl-1,10-phenanthroline (Bphen), $Alq_3$, BAlq, TAZ, NTAZ, and/or any combination thereof:

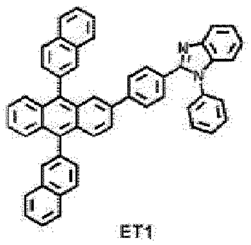
ET1

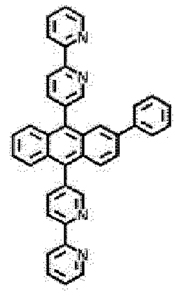
ET2

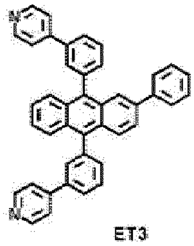
ET3

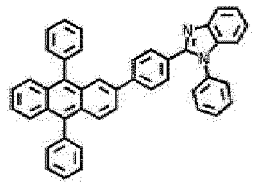
ET4

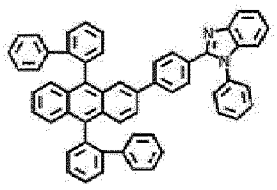
ET5

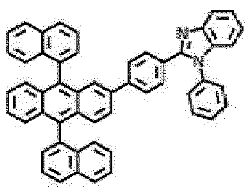
ET6

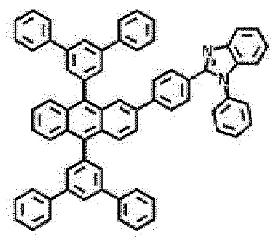
ET7

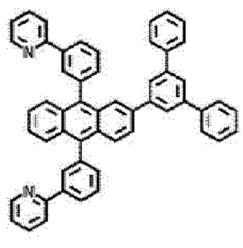
ET8

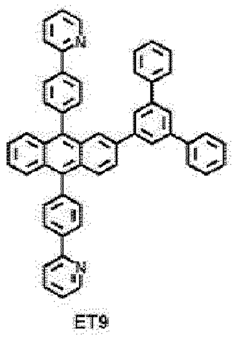
ET9

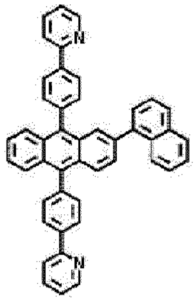
ET10

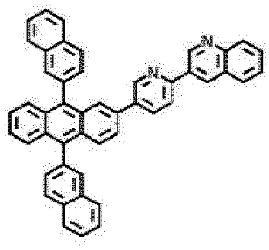
ET11

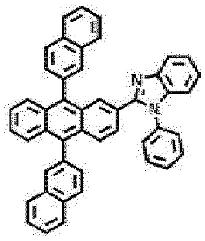
ET12

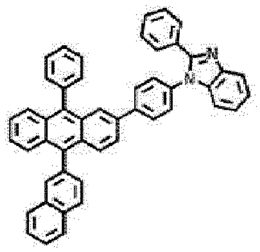
ET13

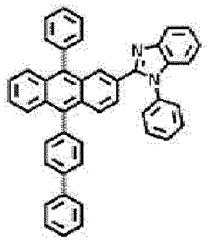
ET14

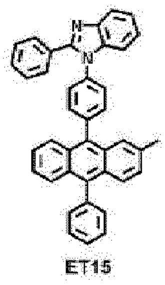
ET15

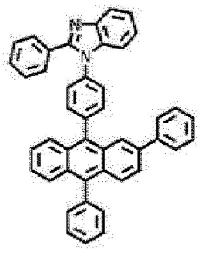
ET16

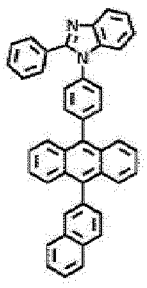
ET17

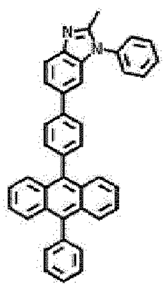
ET18

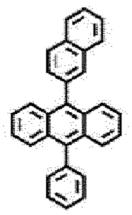
ET19

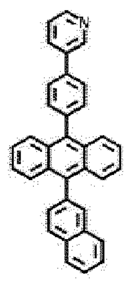
ET20

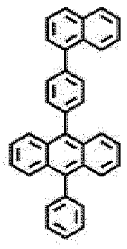
ET21

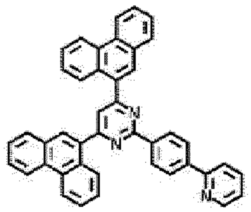
ET22

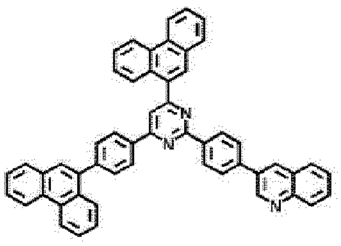
ET23

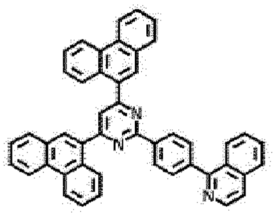
ET24

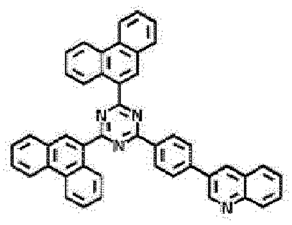
ET25

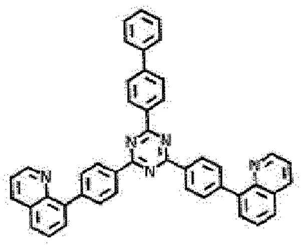
ET26

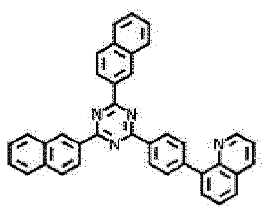
ET27

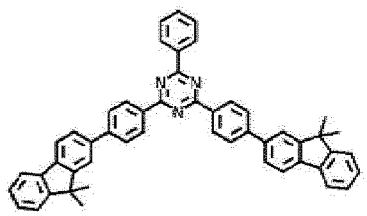
ET28

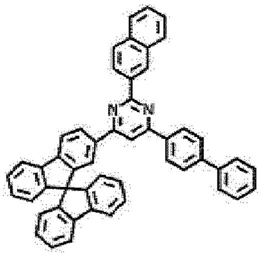
ET29

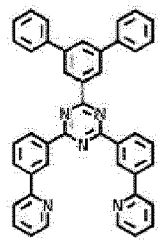
ET30

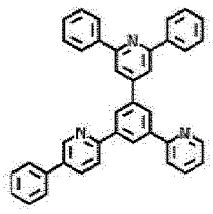
ET31

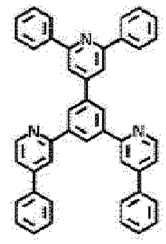
ET32

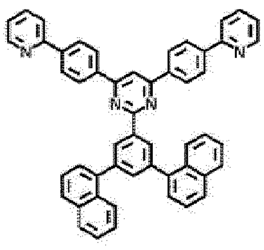
ET33

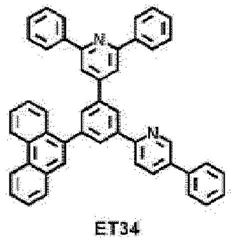
ET34

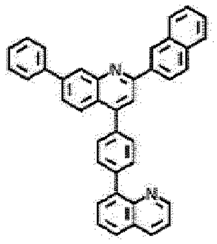
ET35

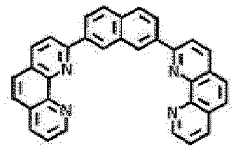
ET36

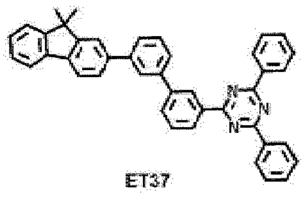
ET37

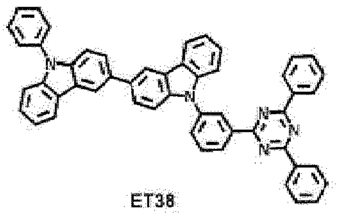
ET38

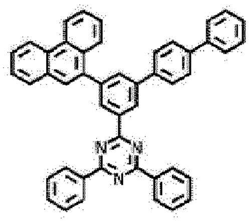
ET39

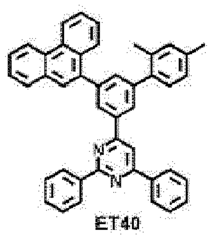
ET40

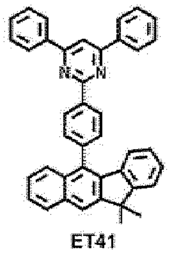
ET41

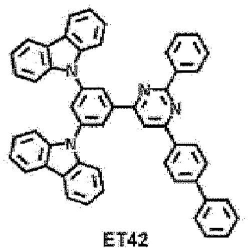
ET42

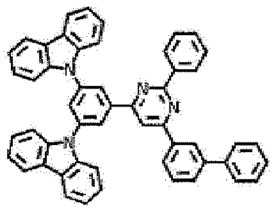
ET43

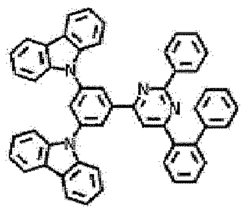
ET44

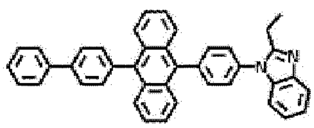
ET45

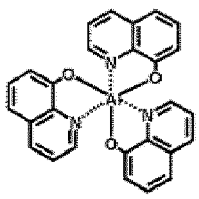
$Alq_3$

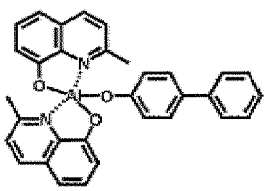
BAlq

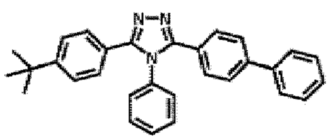
TAZ

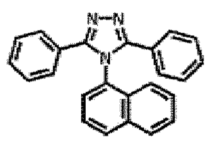
NTAZ .

The thickness of the electron transport region may be about 100 Å to about 5,000 Å, for example, about 160 Å to about 4,000 Å. When the electron transport region includes a buffer layer, a hole-blocking layer, an electron control layer, an electron transport layer, or any combination thereof, a thickness of the buffer layer, the hole-blocking layer, or the

electron control layer may each independently be in a range of about 20 Å to about 1,000 Å, for example, about 30 Å to about 300 Å, and a thickness of the electron transport layer may be in a range of about 100 Å to about 1,000 Å, for example, about 150 Å to about 500 Å. When the thicknesses of the buffer layer, the hole-blocking layer, the electron control layer, the electron transport layer, and/or the electron transport region are within the ranges described herein, satisfactory electron transporting characteristics may be obtained without a substantial increase in driving voltage.

The electron transport region (for example, the electron transport layer in the electron transport region) may further include, in addition to the materials described herein, a metal-containing material.

The metal-containing material may include an alkali metal complex, an alkaline earth metal complex, or any combination thereof. A metal ion of the alkali metal complex may be a Li ion, a Na ion, a K ion, a Rb ion, or a Cs ion, and a metal ion of the alkaline earth metal complex may be a Be ion, a Mg ion, a Ca ion, a Sr ion, or a Ba ion. A ligand coordinated with the metal ion of the alkali metal complex or the alkaline earth-metal complex may include a hydroxyquinoline, a hydroxyisoquinoline, a hydroxybenzoquinoline, a hydroxyacridine, a hydroxyphenanthridine, a hydroxyphenyloxazole, a hydroxyphenylthiazole, a hydroxyphenyloxadiazole, a hydroxyphenylthiadiazole, a hydroxyphenylpyridine, a hydroxyphenylbenzimidazole, a hydroxyphenylbenzothiazole, a bipyridine, a phenanthroline, a cyclopentadiene, or any combination thereof.

According to one or more embodiments, the metal-containing material may include a Li complex. The Li complex may include, for example, Compound ET-D1 (LiQ) or ET-D2:

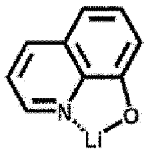

ET-D1

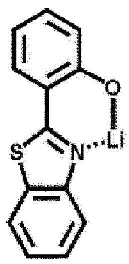

ET-D2 .

The electron transport region may include an electron injection layer that facilitates the injection of electrons from the second electrode 150. The electron injection layer may directly contact the second electrode 150.

The electron injection layer may have: i) a single-layered structure including (e.g., consisting of) a single layer including (e.g., consisting of) a single material, ii) a single-layered structure including (e.g., consisting of) a single layer including multiple different materials, or iii) a multilayer structure including multiple layers including multiple different materials.

The electron injection layer may include an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or any combination thereof.

The alkali metal may include Li, Na, K, Rb, Cs, or any combination thereof. The alkaline earth metal may include Mg, Ca, Sr, Ba, or any combination thereof. The rare earth metal may include Sc, Y, Ce, Tb, Yb, Gd, or any combination thereof.

The alkali metal-containing compound, the alkaline earth metal-containing compound, and the rare earth metal-containing compound may include oxides, halides (for example, fluorides, chlorides, bromides, iodides, and/or the like), or tellurides of the alkali metal, the alkaline earth metal, and the rare earth metal, or any combination thereof.

The alkali metal-containing compound may include: alkali metal oxides, such as $Li_2O$, $Cs_2O$, or $K_2O$; alkali metal halides, such as LiF, NaF, CsF, KF, LiI, NaI, CsI, or KI; or any combination thereof. The alkaline earth metal-containing compound may include an alkaline earth metal compound, such as BaO, SrO, CaO, $Ba_xSr_{1-x}O$ (x is a real number satisfying 0<x<1), or $Ba_xCa_{1-x}O$ (x is a real number satisfying 0<x<1). The rare earth metal-containing compound may include $YbF_3$, $ScF_3$, $Sc_2O_3$, $Y_2O_3$, $Ce_2O_3$, $GdF_3$, $TbF_3$, $YbI_3$, $ScI_3$, $TbI_3$, or any combination thereof. According to one or more embodiments, the rare earth metal-containing compound may include lanthanide metal telluride. Examples of the lanthanide metal telluride may include LaTe, CeTe, PrTe, NdTe, PmTe, SmTe, EuTe, GdTe, TbTe, DyTe, HoTe, ErTe, TmTe, YbTe, LuTe, $La_2Te_3$, $Ce_2Te_3$, $Pr_2Te_3$, $Nd_2Te_3$, $Pm_2Te_3$, $Sm_2Te_3$, $Eu_2Te_3$, $Gd_2Te_3$, $Tb_2Te_3$, $Dy_2Te_3$, $Ho_2Te_3$, $Er_2Te_3$, $Tm_2Te_3$, $Yb_2Te_3$, and $Lu_2Te_3$.

The alkali metal complex, the alkaline earth-metal complex, and the rare earth metal complex may include i) at least one of (e.g., selected from among) metal ions of the alkali metal, the alkaline earth metal, and the rare earth metal and ii) a ligand bonded to the metal ions (e.g., the selected metal ions), for example, hydroxyquinoline, hydroxyisoquinoline, hydroxybenzoquinoline, hydroxyacridine, hydroxyphenanthridine, hydroxyphenyloxazole, hydroxyphenylthiazole, hydroxyphenyloxadiazole, hydroxyphenylthiadiazole, hydroxyphenylpyridine, hydroxyphenylbenzimidazole, hydroxyphenylbenzothiazole, bipyridine, phenanthroline, cyclopentadiene, or any combination thereof.

The electron injection layer may include (e.g., consist of) an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or any combination thereof, as described herein. According to one or more embodiments, the electron injection layer may further include an organic material (for example, a compound represented by Formula 601).

According to one or more embodiments, the electron injection layer may include (e.g., consist of) i) an alkali metal-containing compound (for example, alkali metal halide), ii) a) an alkali metal-containing compound (for example, alkali metal halide); and b) an alkali metal, an alkaline earth metal, a rare earth metal, or any combination thereof. According to one or more embodiments, the electron injection layer may be a KI:Yb co-deposited layer, an RbI:Yb co-deposited layer, a LiF:Yb co-deposited layer, and/or the like.

When the electron injection layer further includes an organic material, the alkali metal, the alkaline earth metal, the rare earth metal, the alkali metal-containing compound, the alkaline earth metal-containing compound, the rare earth metal-containing compound, the alkali metal complex, the alkaline earth-metal complex, the rare earth metal complex, or any combination thereof may be uniformly (e.g., substantially uniformly) or substantially non-uniformly dispersed in a matrix including the organic material.

The thickness of the electron injection layer may be about 1 Å to about 100 Å, and, for example, about 3 Å to about 90 Å. When the thickness of the electron injection layer is within the range as described herein, satisfactory electron injection characteristics may be obtained without a substantial increase in driving voltage.

**Second electrode 150**

The second electrode 150 is arranged on the interlayer 130. The second electrode 150 may be a cathode, which is an electron injection electrode, and as a material for forming the second electrode 150, a metal, an alloy, an electrically conductive compound, or any combination thereof, each having a low-work function, may be used.

The second electrode 150 may include lithium (Li), silver (Ag), magnesium (Mg), aluminium (Al), aluminium-lithium (Al-Li), calcium (Ca), magnesium-indium (Mg-In), magnesium-silver (Mg-Ag), ytterbium (Yb), silver-ytterbium (Ag-Yb), ITO, IZO, or any combination thereof. The second electrode 150 may be a transmissive electrode, a transflective electrode, or a reflective electrode.

The second electrode 150 may have a single-layer structure or a multilayer structure including a plurality of layers.

**Capping layer**

A first capping layer may be arranged outside (and e.g., on) the first electrode 110, and/or a second capping layer may be arranged outside (and e.g., on) the second electrode 150. In more detail, the light-emitting device 10 may have a structure in which the first capping layer, the first electrode 110, the interlayer 130, and the second electrode 150 are sequentially stacked in the stated order, a structure in which the first electrode 110, the interlayer 130, the second electrode 150, and the second capping layer are sequentially stacked in the stated order, or a structure in which the first capping layer, the first electrode 110, the interlayer 130, the second electrode 150, and the second capping layer are sequentially stacked in the stated order.

Light generated in the emission layer of the interlayer 130 of the light-emitting device 10 may be extracted toward the outside through the first electrode 110 which is a transflective electrode or a transmissive electrode, and the first capping layer. Light generated in the emission layer of the interlayer 130 of the light-emitting device 10 may be extracted toward the outside through the second electrode 150 which is a transflective electrode or a transmissive electrode, and the second capping layer.

The first capping layer and the second capping layer may increase external emission efficiency according to the principle of constructive interference. Accordingly, the light extraction efficiency of the light-emitting device 10 is increased, such that the luminescence efficiency of the light-emitting device 10 may be increased.

Each of the first capping layer and the second capping layer may include a material having a refractive index of 1.6 or more (at 589 nm).

The first capping layer and the second capping layer may each independently be an organic capping layer including an organic material, an inorganic capping layer including an inorganic material, or an organic-inorganic composite capping layer including an organic material and an inorganic material.

At least one of the first capping layer and/or the second capping layer may each independently include a carbocyclic compound, a heterocyclic compound, an amine group-containing compound, a porphine derivative, a phthalocyanine derivative, a naphthalocyanine derivative, an alkali metal complex, an alkaline earth metal complex, or any combination thereof. The carbocyclic compound, the heterocyclic compound, and the amine group-containing

compound may optionally be substituted with a substituent including O, N, S, Se, Si, F, Cl, Br, I, or any combination thereof. According to an embodiment, at least one of the first capping layer and/or the second capping layer may each independently include an amine group-containing compound.

According to one or more embodiments, at least one of the first capping layer and/or the second capping layer may each independently include a compound represented by Formula 201, a compound represented by Formula 202, or any combination thereof.

According to one or more embodiments, at least one of the first capping layer and/or the second capping layer may each independently include at least one of (e.g., selected from among) Compounds HT28 to HT33, at least one of (e.g., selected from among) Compounds CP1 to CP6, β-NPB, and/or any combination thereof:

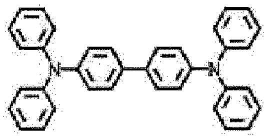

CP1

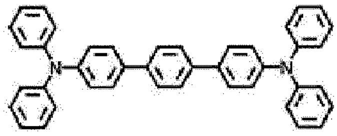

CP2

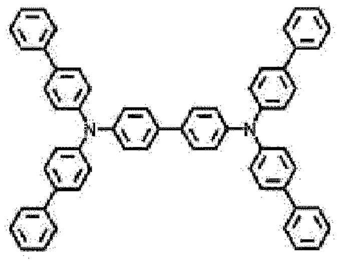

CP3

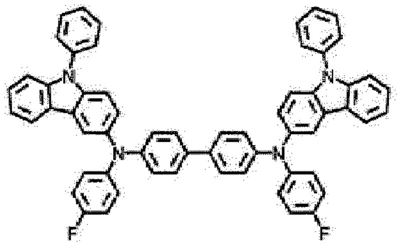

CP4

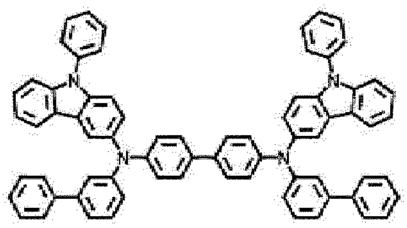

CP5

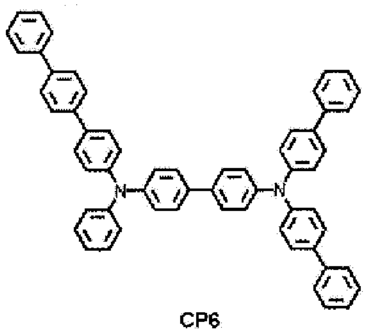

CP6

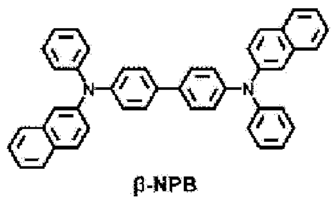

β-NPB

## Film

The organometallic compound represented by Formula 1 may be included in one or more suitable films. Accordingly, another aspect of the disclosure provides a film including the organometallic compound represented by Formula 1. The film may be, for example, an optical member (or a light control component) (e.g., a color filter, a color conversion member, a capping layer, a light extraction efficiency enhancement layer, a selective light absorbing layer, a polarizing layer, a quantum dot-containing layer, and/or the like), a light-blocking member (e.g., a light reflective layer, a light absorbing layer, and/or the like), a protective member (e.g., an insulating layer, a dielectric layer, and/or the like), and/or the like.

## Electronic apparatus

The light-emitting device may be included in one or more suitable electronic apparatuses. For example, the electronic apparatus including the light-emitting device may be a light-emitting apparatus, an authentication apparatus, and/or the like.

The electronic apparatus (for example, a light-emitting apparatus) may further include, in addition to the light-emitting device, i) a color filter, ii) a color conversion layer, or iii) a color filter and a color conversion layer. The color filter and/or the color conversion layer may be arranged in at least one traveling direction of light emitted from the light-emitting device. For example, the light emitted from the light-emitting device may be blue light or white light. A detailed description of the light-emitting device is provided herein. According to one or more embodiments, the color conversion layer may include quantum dots. The quantum dot may be, for example, a quantum dot as described herein.

The electronic apparatus may include a first substrate. The first substrate may include a plurality of subpixel areas, the color filter may include a plurality of color filter areas respectively corresponding to the subpixel areas, and the color conversion layer may include a plurality of color conversion areas respectively corresponding to the subpixel areas.

A pixel-defining film may be arranged among the subpixel areas to define each of the subpixel areas.

The color filter may further include a plurality of color filter areas and light-shielding patterns arranged among the color filter areas, and the color conversion layer may further include a plurality of color conversion areas and light-shielding patterns arranged among the color conversion areas.

The plurality of color filter areas (or the plurality of color conversion areas) may include a first area emitting first color light, a second area emitting second color light, and/or a third area emitting third color light, wherein the first color light, the second color light, and/or the third color light may have different maximum emission wavelengths. According to one or more embodiments, the first color light may be red light, the second color light may be green light, and the third color light may be blue light. According to one or more embodiments, the plurality of color filter areas (or the plurality of color conversion areas) may include quantum dots. In more detail, the first area may include red quantum dots, the second area may include green quantum dots, and the third area may not include (e.g., may exclude) quantum dots. A detailed description of the quantum dots is provided herein. The first area, the second area, and/or the third area may each further include a scatterer.

According to one or more embodiments, the light-emitting device may be to emit first light, the first area may be to absorb the first light to emit first-1 color light, the second area may be to absorb the first light to emit second-1 color light, and the third area may be to absorb the first light to emit third-1 color light. In this case, the first-1 color light, the second-1 color light, and the third-1 color light may have different maximum emission wavelengths. In more detail, the first light may be blue light, the first-1 color light may be red light, the second-1 color light may be green light, and the third-1 color light may be blue light.

The electronic apparatus may further include a thin-film transistor, in addition to the light-emitting device as described herein. The thin-film transistor may include a source electrode, a drain electrode, and an active layer, wherein any one of the source electrode and the drain electrode may be electrically connected to any one of the first electrode and the second electrode of the light-emitting device.

The thin-film transistor may further include a gate electrode, a gate insulating film, and/or the like.

The activation layer may include crystalline silicon, amorphous silicon, an organic semiconductor, an oxide semiconductor, and/or the like.

The electronic apparatus may further include a sealing portion for sealing the light-emitting device. The sealing portion may be arranged between the color filter and/or the color conversion layer and the light-emitting device. The sealing portion allows light from the light-emitting device to be extracted to the outside, and concurrently (e.g., simultaneously) prevents ambient air and moisture from penetrating into the light-emitting device. The sealing portion may be a sealing substrate including a transparent glass substrate or a plastic substrate. The sealing portion may be a thin-film encapsulation layer including at least one layer of an organic layer and/or an inorganic layer. When the sealing portion is a thin film encapsulation layer, the electronic apparatus may be flexible.

Various functional layers may be additionally arranged on the sealing portion, in addition to the color filter and/or the color conversion layer, according to the use of the electronic apparatus. Examples of the functional layers may include a touch screen layer and a polarizing layer. The touch screen layer may be a pressuresensitive touch screen layer, a capacitive touch screen layer, or an infrared touch screen layer. The authentication apparatus may be, for example, a biometric authentication apparatus that authenticates an individual by using biometric information of a living body (for example, fingertips, pupils, and/or the like.).

The authentication apparatus may further include, in addition to the light-emitting device as described herein, a biometric information collector.

The electronic apparatus may be applied to one or more selected from among displays, light sources, lighting, personal computers (for example, a mobile personal computer), mobile phones, digital cameras, electronic organizers, electronic dictionaries, electronic game machines, medical instruments (for example, electronic thermometers, sphygmomanometers, blood glucose meters, pulse measurement devices, pulse wave measurement devices, electrocardiogram displays, ultrasonic diagnostic devices, or endoscope displays), fish finders, one or more suitable measuring instruments, meters (for example, meters for a vehicle, an aircraft, and a vessel), projectors, and/or the like.

## Electronic equipment

The light-emitting device may be included in one or more suitable electronic equipment.

According to one or more embodiments, the electronic equipment including the light-emitting device may be at least one of a flat panel display, a curved display, a computer monitor, a medical monitor, a television, a billboard, a light for indoor or outdoor lighting and/or signaling, a head-up display, a fully or partially transparent display, a flexible display, a rollable display, a foldable display, a stretchable display, a laser printer, a telephone, a mobile phone, a tablet, a phablet, a personal digital assistant (PDA), a wearable device, a laptop computer, a digital camera, a camcorder, a viewfinder, a micro display, a 3D display, a virtual display, an augmented-reality display, a vehicle, a video wall including multiple displays tiled together, a theater screen, a stadium screen, a phototherapy device, and/or a signboard.

Because the light-emitting device has excellent or suitable effects in terms of luminescence efficiency long lifespan, the electronic equipment including the light-emitting device may have characteristics with high luminance, high resolution, and low power consumption.

## Description of FIGS. 2 and 3

FIG. 2 is a cross-sectional view showing a light-emitting apparatus according to one or more embodiments; and

The light-emitting apparatus of FIG. 2 includes a substrate 100, a thin-film transistor (TFT), a light-emitting device, and an encapsulation portion 300 that seals the light-emitting device.

The substrate 100 may be a flexible substrate, a glass substrate, or a metal substrate. A buffer layer 210 may be arranged on the substrate 100. The buffer layer 210 may prevent or reduce penetration of impurities through the substrate 100 and may provide a flat surface on the substrate 100.

A TFT may be arranged on the buffer layer 210. The TFT may include an activation layer 220, a gate electrode 240, a source electrode 260, and a drain electrode 270.

The activation layer 220 may include an inorganic semiconductor, such as silicon or polysilicon, an organic semiconductor, or an oxide semiconductor, and may include a source region, a drain region, and a channel region.

A gate insulating film 230 for insulating the activation layer 220 from the gate electrode 240 may be arranged on the activation layer 220, and the gate electrode 240 may be arranged on the gate insulating film 230.

An interlayer insulating film 250 may be arranged on the gate electrode 240. The interlayer insulating film 250 may be arranged between the gate electrode 240 and the source electrode 260 and between the gate electrode 240 and the drain electrode 270, to insulate from one another.

The source electrode 260 and the drain electrode 270 may be arranged on the interlayer insulating film 250. The interlayer insulating film 250 and the gate insulating film 230 may be formed to expose the source region and the drain region of the activation layer 220, and the source electrode 260 and the drain electrode 270 may be arranged in contact with the exposed portions of the source region and the drain region of the activation layer 220.

The TFT may be electrically connected to a light-emitting device to drive the light-emitting device, and may be covered and protected by a passivation layer 280. The passivation layer 280 may include an inorganic insulating film, an organic insulating film, or any combination thereof. A light-emitting device may be provided on the passivation layer 280. The light-emitting device may include the first electrode 110, the interlayer 130, and the second electrode 150.

The first electrode 110 may be arranged on the passivation layer 280. The passivation layer 280 may be arranged to expose a portion of the drain electrode 270, not fully covering the drain electrode 270, and the first electrode 110 may be arranged to be connected to the exposed portion of the drain electrode 270.

A pixel-defining film 290 including an insulating material may be arranged on the first electrode 110. The pixel-defining film 290 may expose a certain region of the first electrode 110, and the interlayer 130 may be formed in the exposed region of the first electrode 110. The pixel-defining film 290 may be a polyimide-based organic film or a polyacrylic organic film. Although not shown in FIG. 2, at least some layers of the interlayer 130 may extend beyond the upper portion of the pixel-defining film 290 to be arranged in the form of a common layer.

The second electrode 150 may be arranged on the interlayer 130, and a capping layer 170 may be additionally formed on the second electrode 150. The capping layer 170 may be formed to cover the second electrode 150.

The encapsulation portion 300 may be located on the capping layer 170. The encapsulation portion 300 may be arranged on a light-emitting device to protect the light-emitting device from moisture or oxygen. The encapsulation portion 300 may include: an inorganic film including silicon nitride (SiNx), silicon oxide (SiOx), indium tin oxide, indium zinc oxide, or any combination thereof; an organic film including polyethylene terephthalate, polyethylene naphthalate, polycarbonate, polyimide, polyethylene sulfonate, polyoxymethylene, polyarylate, hexamethyldisiloxane, an acrylic resin (for example, polymethyl methacrylate, polyacrylic acid, and/or the like), an epoxy-based resin (for example, aliphatic glycidyl ether (AGE), and/or the like), or any combination thereof; and/or a (e.g., any suitable) combination of the inorganic film and the organic film.

FIG. 3 shows a cross-sectional view showing a light-emitting apparatus according to one or more embodiments.

The light-emitting apparatus of FIG. 3 is the same as the light-emitting apparatus of FIG. 2, except that a light-shielding pattern 500 and a functional region 400 are additionally arranged on the encapsulation portion 300. The functional region 400 may be i) a color filter area, ii) a color conversion area, or iii) a combination of the color filter area and the color conversion area. According to one or more embodiments, a light-emitting device included in the light-emitting apparatus of FIG. 4 may be a tandem light-emitting device.

**Description of FIG. 4**

FIG. 4 is a schematic perspective view of electronic equipment 1 including a light-emitting device according to one or more embodiments. The electronic equipment 1 may be, as an apparatus that displays a moving image or a still image, portable electronic apparatus, such as a mobile phone, a smartphone, a tablet personal computer (PC), a mobile communication terminal, an electronic notebook, an electronic book, a portable multimedia player (PMP), a navigation, or an ultra-mobile PC (UMPC), and/or may be, as one or more suitable products, such as a television, a laptop, a monitor, a billboard, or an Internet of things (IoT) device. The electronic apparatus 1 may be such a product as described herein or a part thereof. In some embodiments, the electronic apparatus 1 may be a wearable device, such as a smart watch, a watch phone, a glasses-type (kind) display, or a head mounted display (HMD), or a part of the wearable device. However, embodiments are not limited thereto. According to one or more embodiments, the electronic device 1 may be a dashboard of a vehicle, a center information display (CID) arranged on a center fascia or dashboard of a vehicle, a room mirror display instead of a side-view mirror of a vehicle, an entertainment for the back seat of a vehicle, or a display arranged on the back of the front seat of a vehicle, a head up display (HUD) installed on the front of a vehicle or projected on a front window glass, or a computer generated hologram augmented reality head up display (CGH AR HUD). FIG. 4 illustrates one or more embodiments in which the electronic apparatus 1 is a smartphone for convenience of explanation.

The electronic equipment 1 may include a display area DA and a non-display area NDA outside the display area DA. A display apparatus may implement an image through an array of a plurality of pixels that are two-dimensionally arranged in the display area DA.

The non-display area NDA is an area that does not display an image, and may entirely be around (e.g., surround) the display area DA. On the non-display area NDA, a driver for providing electrical signals or power to display devices arranged on the display area DA may be arranged. On the non-display area NDA, a pad, which is an area to which an electronic element or a printed circuit board, may be electrically connected may be arranged.

In the electronic equipment 1, the length in an x-axis direction and the length in a y-axis direction may be different from each other. According to one or more embodiments, as shown in FIG. 4, the length in the x-axis direction may be less than the length in the y-axis direction. According to one or more embodiments, the length in the x-axis direction may be the same as the length in the y-axis direction. According to one or more embodiments, the length in the x-axis direction may be greater than the length in the y-axis direction.

**Descriptions of FIGS. 5 and 6A to 6C**

FIG. 5 is a diagram illustrating the exterior of a vehicle 1000 as electronic equipment including a light-emitting device according to one or more embodiments. FIGS. 6A to 6C are each a schematic view of the interior of the vehicle 1000 according to one or more embodiments.

Referring to FIGS. 5, 6A, 6B, and 6C, the vehicle 1000 may refer to one or more suitable apparatuses for moving a subject to be transported, such as a human, an object, or an animal, from a departure point to a destination point. The vehicle 1000 may include a vehicle traveling on a road or track, a vessel moving over the sea or river, an airplane flying in the sky using the action of air, and/or the like.

The vehicle 1000 may travel on a road or a track. The vehicle 1000 may move in a certain direction according to rotation of at least one wheel. According to one or more embodiments, the vehicle 1000 may include a three-wheeled or four-wheeled vehicle, a construction machine, a two-wheeled vehicle, a prime mover device, a bicycle, and a train running on a track.

The vehicle 1000 may include a body having an interior and an exterior, and a chassis in which mechanical apparatuses necessary for driving are installed as other parts except for the body of the vehicle 1000. The exterior of the body of the vehicle may include a front panel, a bonnet, a roof panel, a rear panel, a trunk, a pillar provided at a boundary between doors, and/or the like. The chassis of the vehicle 1000 may include a power generating device, a power transmitting device, a driving device, a steering device, a braking device, a suspension device, a transmission device, a fuel device, front and rear wheels, left and right wheels, and/or the like.

The vehicle 1000 may include a side window glass 1100, a front window glass 1200, a side-view mirror 1300, a cluster 1400, a center fascia 1500, a passenger seat dashboard 1600, and a display apparatus 2.

The side window glass 1100 and the front window glass 1200 may be partitioned by a pillar arranged between the side window glass 1100 and the front window glass 1200.

The side window glass 1100 may be installed on the side of the vehicle 1000. According to one or more embodiments, the side window glass 1100 may be installed on a door of the vehicle 1000. A plurality of side window glasses 1100 may be provided and may face each other. According to one or more embodiments, the side window glass 1100 may include a first side window glass 1110 and a second side window glass 1120. According to one or more embodiments, the first side window glass 1110 may be arranged adjacent to the cluster 1400. The second side window glass 1120 may be arranged adjacent to the passenger seat dashboard 1600.

According to one or more embodiments, the side window glasses 1100 may be spaced and/or apart (e.g., spaced apart or separated) from each other in an x direction or a -x direction. According to one or more embodiments, the first side window glass 1110 and the second side window glass 1120 may be spaced and/or apart (e.g., spaced apart or separated) from each other in the x direction or the -x direction. For example, an imaginary straight line L connecting the side window glasses 1100 may extend in the x direction or the -x direction. According to one or more embodiments, an imaginary straight line L connecting the first side window glass 1110 and the second side window glass 1120 to each other may extend in the x direction or the -x direction.

The front window glass 1200 may be installed in front of the vehicle 1000. The front window glass 1200 may be arranged between the side window glasses 1100 opposite to (e.g., facing) each other.

The side-view mirror 1300 may provide a rear view of the vehicle 1000. The side-view mirror 1300 may be installed on the exterior of the body of the vehicle. According to one or more embodiments, a plurality of side-view mirrors 1300 may be provided. Any one of the plurality of side-view mirrors 1300 may be arranged outside the first side window glass 1110. The other one of the plurality of side-view mirrors 1300 may be arranged outside the second side window glass 1120.

The cluster 1400 may be arranged in front of a steering wheel. The cluster 1400 may include a tachometer, a speedometer, a coolant thermometer, a fuel gauge, a turn signal indicator, a high beam indicator, a warning light, a seat belt warning light, an odometer, a tachograph, an automatic shift selector indicator, a door open warning light, an engine oil warning light, and/or a low fuel warning light.

The center fascia 1500 may include a control panel on which a plurality of buttons for adjusting an audio device, an air conditioning device, and a seat heater are arranged. The center fascia 1500 may be arranged on one side of the cluster 1400.

The passenger seat dashboard 1600 may be spaced and/or apart (e.g., spaced apart or separated) from the cluster 1400, and the center fascia 1500 may be arranged between the cluster 1400 and the passenger seat dashboard 1600. According to one or more embodiments, the cluster 1400 may be arranged to correspond to a driver seat, and the passenger seat dashboard 1600 may be arranged to correspond to a passenger seat. According to one or more embodiments, the cluster 1400 may be adjacent to the first side window glass 1110, and the passenger seat dashboard 1600 may be adjacent to the second side window glass 1120.

According to one or more embodiments, the display apparatus 2 may include a display panel 3, and the display panel 3 may display an image. The display apparatus 2 may be arranged inside the vehicle 1000. According to one or more embodiments, the display apparatus 2 may be arranged between the side window glasses 1100 opposite to (e.g., facing) each other. The display apparatus 2 may be arranged on at least one of the cluster 1400, the center fascia 1500, and the passenger seat dashboard 1600.

The display apparatus 2 may include an organic light-emitting display, an inorganic electroluminescent display, a quantum dot display, and/or the like. Hereinafter, as the display apparatus 2 according to one or more embodiments, an organic light-emitting display apparatus including the light-emitting device will be described as an example, but one or more suitable types (kinds) of display apparatuses as described herein may be used in embodiments.

Referring to FIG. 6A, the display apparatus 2 may be arranged on the center fascia 1500. According to one or more embodiments, the display apparatus 2 may display navigation information. According to one or more embodiments, the display apparatus 2 may display information regarding audio settings, video setting, or vehicle settings.

Referring to FIG. 6B, the display apparatus 2 may be arranged on the cluster 1400. In this case, the cluster 1400 may display driving information and/or the like through the display apparatus 2. For example, the cluster 1400 may be implemented in a digital manner. The digital cluster 1400 implemented in a digital manner may display vehicle information and driving information in the form of images. According to one or more embodiments, a needle and a gauge of a tachometer and one or more suitable warning light icons may be displayed by a digital signal.

Referring to FIG. 6C, the display apparatus 2 may be arranged on the passenger seat dashboard 1600. The display apparatus 2 may be embedded in the passenger seat dashboard 1600 or arranged on the passenger seat dashboard 1600. According to one or more embodiments, the display apparatus 2 arranged on the passenger seat dashboard 1600 may display an image related to information displayed on the cluster 1400 and/or information displayed on the center fascia 1500. According to one or more embodiments, the display apparatus 2 arranged on the passenger seat dashboard 1600 may display information different from information displayed on the cluster 1400 and/or information displayed on the center fascia 1500.

## Manufacturing method

Layers constituting the hole transport region, the emission layer, and the layers constituting the electron transport region may be formed in a certain region by using one or more suitable methods such as vacuum deposition, spin coating, casting, Langmuir-Blodgett (LB) deposition, ink-jet printing, laser-printing, laser-induced thermal imaging, and/or the like.
When the layers constituting the hole transport region, the emission layer, and the layers constituting the electron transport region are formed by vacuum deposition, the deposition may be performed at a deposition temperature in a range of about 100 °C to about 500 °C, at a vacuum degree in a range of about $10^{-8}$ torr to about $10^{-3}$ torr, and at a deposition speed in a range of about 0.01 angstrom per second (Å/sec) to about 100 Å/sec, depending on a material to be included in a layer to be formed and the structure of a layer to be formed.

## Definition of terms

The term "$C_3$-$C_{60}$ carbocyclic group" as used herein refers to a cyclic group consisting of carbon atoms as the only ring-forming atoms and having three to sixty carbon atoms, and the term "$C_1$-$C_{60}$ heterocyclic group" as used herein refers to a cyclic group that has one to sixty carbon atoms and further includes, in addition to a carbon atom, a heteroatom as a ring-forming atom. The $C_3$-$C_{60}$ carbocyclic group and the $C_1$-$C_{60}$ heterocyclic group may each be a monocyclic group consisting of one ring or a polycyclic group in which two or more rings are condensed with each other. According to one or more embodiments, the number of ring-forming atoms of the $C_1$-$C_{60}$ heterocyclic group may be 3 to 61.
The "cyclic group" as used herein may include both (e.g., simultaneously) the $C_3$-$C_{60}$ carbocyclic group and the $C_1$-$C_{60}$ heterocyclic group.
The term "$\pi$ electron-rich $C_3$-$C_{60}$ cyclic group" as used herein refers to a cyclic group that has three to sixty carbon atoms and does not include *-N=*' as a ring-forming moiety, and the term "$\pi$ electron-deficient nitrogen-containing $C_1$-$C_{60}$ cyclic group" as used herein refers to a heterocyclic group that has one to sixty carbon atoms and includes *-N=*' as a ring-forming moiety.
According to one or more embodiments,

the $C_3$-$C_{60}$ carbocyclic group may be i) Group T1 or ii) a condensed cyclic group in which two or more of Group T1 are condensed with each other (for example, a cyclopentadiene group, an adamantane group, a norbornane group, a benzene group, a pentalene group, a naphthalene group, an azulene group, an indacene group, an acenaphthylene group, a phenalene group, a phenanthrene group, an anthracene group, a fluoranthene group, a triphenylene group, a pyrene group, a chrysene group, a perylene group, a pentaphene group, a heptalene group, a naphthacene group, a picene group, a hexacene group, a pentacene group, a rubicene group, a coronene group, an ovalene group, an indene group, a fluorene group, a spiro-bifluorene group, a benzofluorene group, an indenophenanthrene group, or an indenoanthracene group),

the $C_1$-$C_{60}$ heterocyclic group may be i) Group T2, ii) a condensed cyclic group in which two or more of Group T2 are condensed with each other, or iii) a condensed cyclic group in which at least one Group T2 and at least one Group T1 are condensed with each other (for example, a pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, and/or the like),

the $\pi$ electron-rich $C_3$-$C_{60}$ cyclic group may be i) Group T1, ii) a condensed cyclic group in which two or more of Group T1 are condensed with each other, iii) Group T3, iv) a condensed cyclic group in which two or more of Group T3 are condensed with each other, or v) a condensed cyclic group in which at least one Group T3 and at least one Group T1 are condensed with each other (for example, the $C_3$-$C_{60}$ carbocyclic group, a 1H-pyrrole group, a silole group, a borole group, a 2H-pyrrole group, a 3H-pyrrole group, a thiophene group, a furan group, an indole group, a benzoindole

group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, and/or the like), the $\pi$ electron-deficient nitrogen-containing $C_1$-$C_{60}$ cyclic group may be i) Group T4, ii) a condensed cyclic group in which two or more of Group T4 are condensed with each other, iii) a condensed cyclic group in which at least one Group T4 and at least one Group T1 are condensed with each other, iv) a condensed cyclic group in which at least one Group T4 and at least one Group T3 are condensed with each other, or v) a condensed cyclic group in which at least one Group T4, at least one Group T1, and at least one Group T3 are condensed with one another (for example, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, and/or the like),

Group T1 may be a cyclopropane group, a cyclobutane group, a cyclopentane group, a cyclohexane group, a cycloheptane group, a cyclooctane group, a cyclobutene group, a cyclopentene group, a cyclopentadiene group, a cyclohexene group, a cyclohexadiene group, a cycloheptene group, an adamantane group, a norbornane (or bicyclo [2.2.1]heptane) group, a norbornene group, a bicyclo[1.1.1]pentane group, a bicyclo[2.1.1]hexane group, a bicyclo [2.2.2]octane group, or a benzene group,

Group T2 may be a furan group, a thiophene group, a 1H-pyrrole group, a silole group, a borole group, a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, a tetrazine group, a pyrrolidine group, an imidazolidine group, a dihydropyrrole group, a piperidine group, a tetrahydropyridine group, a dihydropyridine group, a hexahydropyrimidine group, a tetrahydropyrimidine group, a dihydropyrimidine group, a piperazine group, a tetrahydropyrazine group, a dihydropyrazine group, a tetrahydropyridazine group, or a dihydropyridazine group,

Group T3 may be a furan group, a thiophene group, a 1H-pyrrole group, a silole group, or a borole group, and

Group T4 may be a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, or a tetrazine group.

The terms "cyclic group", "$C_3$-$C_{60}$ carbocyclic group", "$C_1$-$C_{60}$ heterocyclic group", "$\pi$ electron-rich $C_3$-$C_{60}$ cyclic group", or "$\pi$ electron-deficient nitrogen-containing $C_1$-$C_{60}$ cyclic group" as used herein may refer to a group condensed to any cyclic group, a monovalent group, or a polyvalent group (for example, a divalent group, a trivalent group, a tetravalent group, and/or the like) according to the structure of a formula for which the corresponding term is used. According to one or more embodiments, "a benzene group" may be a benzo group, a phenyl group, a phenylene group, and/or the like, which may be easily understand by one of ordinary skill in the art according to the structure of a formula including the "benzene group."

Depending on context, a divalent group may refer or be a polyvalent group (e.g., trivalent, tetravalent, etc., and not just divalent) per, e.g., the structure of a formula in connection with which of the terms are utilized.

Examples of the monovalent $C_3$-$C_{60}$ carbocyclic group and the monovalent $C_1$-$C_{60}$ heterocyclic group may include a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_1$-$C_{60}$ heteroaryl group, a monovalent non-aromatic condensed polycyclic group, and a monovalent non-aromatic condensed heteropolycyclic group. Examples of the divalent $C_3$-$C_{60}$ carbocyclic group and the monovalent $C_1$-$C_{60}$ heterocyclic group are a $C_3$-$C_{10}$ cycloalkylene group, a $C_1$-$C_{10}$ heterocycloalkylene group, a $C_3$-$C_{10}$ cycloalkenylene group, a $C_1$-$C_{10}$ heterocycloalkenylene group, a $C_6$-$C_{60}$ arylene group, a $C_1$-$C_{60}$ heteroarylene group, a divalent non-aromatic condensed polycyclic group, and a substituted or unsubstituted divalent non-aromatic condensed heteropolycyclic group.

The term "$C_1$-$C_{60}$ alkyl group" as used herein refers to a linear or branched aliphatic hydrocarbon monovalent group that has one to sixty carbon atoms, and examples thereof include a methyl group, an ethyl group, an n-propyl group,

an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isoctyl group, a secoctyl group, a tert-octyl group, an n-nonyl group, an isononyl group, a sec-nonyl group, a tert-nonyl group, an n-decyl group, an isodecyl group, a sec-decyl group, and a tertdecyl group. The term "$C_1$-$C_{60}$ alkylene group" as used herein refers to a divalent group having the same structure as the $C_1$-$C_{60}$ alkyl group.

The term "$C_2$-$C_{60}$ alkenyl group" as used herein refers to a monovalent hydrocarbon group having at least one carbon-carbon double bond in the middle or at the terminus of the $C_2$-$C_{60}$ alkyl group, and examples thereof include an ethenyl group, a propenyl group, and a butenyl group. The term "$C_2$-$C_{60}$ alkenylene group" as used herein refers to a divalent group having the same structure as the $C_2$-$C_{60}$ alkenyl group.

The term "$C_2$-$C_{60}$ alkynyl group" as used herein refers to a monovalent hydrocarbon group having at least one carbon-carbon triple bond in the middle or at the terminus of the $C_2$-$C_{60}$ alkyl group, and examples thereof include an ethynyl group and a propynyl group. The term "$C_2$-$C_{60}$ alkynylene group" as used herein refers to a divalent group having the same structure as the $C_2$-$C_{60}$ alkynyl group.

The term "$C_1$-$C_{60}$ alkoxy group" as used herein refers to a monovalent group represented by $-OA_{101}$ (wherein $A_{101}$ is the $C_1$-$C_{60}$ alkyl group), and examples thereof include a methoxy group, an ethoxy group, and an isopropyloxy group.

The term "$C_3$-$C_{10}$ cycloalkyl group" as used herein refers to a monovalent saturated hydrocarbon cyclic group having 3 to 10 carbon atoms, and examples thereof may include a cyclopropyl group, a cyclobutyl group, a cyclopentyl group, a cyclohexyl group, a cycloheptyl group, a cyclooctyl group, an adamantanyl group, a norbornanyl group (or bicyclo [2.2.1]heptyl group), a bicyclo[1.1.1]pentyl group, a bicyclo[2.1.1]hexyl group, a bicyclo[2.2.2]octyl group, and/or the like. The term "$C_3$-$C_{10}$ cycloalkylene group" as used herein refers to a divalent group having the same structure as the $C_3$-$C_{10}$ cycloalkyl group.

The term "$C_1$-$C_{10}$ heterocycloalkyl group" as used herein refers to a monovalent cyclic group that has one to ten carbon atoms and further includes, in addition to the carbon atoms, at least one heteroatom as a ring-forming atom, and examples thereof include a 1,2,3,4-oxatriazolidinyl group, a tetrahydrofuranyl group, and a tetrahydrothiophenyl group. The term "$C_1$-$C_{10}$ heterocycloalkylene group" as used herein refers to a divalent group having the same structure as the $C_1$-$C_{10}$ heterocycloalkyl group.

The term "$C_3$-$C_{10}$ cycloalkenyl group" as used herein refers to a monovalent cyclic group that has three to ten carbon atoms and at least one carbon-carbon double bond in the ring thereof and no aromaticity, and examples thereof include a cyclopentenyl group, a cyclohexenyl group, and a cycloheptenyl group. The term "$C_3$-$C_{10}$ cycloalkenylene group" as used herein refers to a divalent group having the same structure as the $C_3$-$C_{10}$ cycloalkenyl group.

The term "$C_1$-$C_{10}$ heterocycloalkenyl group" as used herein refers to a monovalent cyclic group that has one to ten carbon atoms, further includes, in addition to the carbon atoms, at least one heteroatom as a ring-forming atom, and has at least one double bond in the ring thereof. Examples of the $C_1$-$C_{10}$ heterocycloalkenyl group include a 4,5-dihydro-1,2,3,4-oxatriazolyl group, a 2,3-dihydrofuranyl group, and a 2,3-dihydrothiophenyl group. The term "$C_1$-$C_{10}$ heterocycloalkenylene group" as used herein refers to a divalent group having the same structure as the $C_1$-$C_{10}$ heterocycloalkenyl group.

The term "$C_6$-$C_{60}$ aryl group" as used herein refers to a monovalent group having a carbocyclic aromatic system of six to sixty carbon atoms, and the term "$C_6$-$C_{60}$ arylene group" as used herein refers to a divalent group having a carbocyclic aromatic system of six to sixty carbon atoms. Examples of the $C_6$-$C_{60}$ aryl group include a phenyl group, a pentalenyl group, a naphthyl group, an azulenyl group, an indacenyl group, an acenaphthyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a heptalenyl group, a naphthacenyl group, a picenyl group, a hexacenyl group, a pentacenyl group, a rubicenyl group, a coronenyl group, and an ovalenyl group. When the $C_6$-$C_{60}$ aryl group and the $C_6$-$C_{60}$ arylene group each include two or more rings, the two or more rings may be condensed with each other.

The term "$C_1$-$C_{60}$ heteroaryl group" as used herein refers to a monovalent group having a heterocyclic aromatic system that has one to sixty carbon atoms and further includes, in addition to the carbon atoms, at least one heteroatom as a ring-forming atom. The term "$C_1$-$C_{60}$ heteroarylene group" as used herein refers to a divalent group having a heterocyclic aromatic system that has one to sixty carbon atoms and further includes, in addition to the carbon atoms, at least one heteroatom as a ring-forming atom. Examples of the $C_1$-$C_{60}$ heteroaryl group include a pyridinyl group, a pyrimidinyl group, a pyrazinyl group, a pyridazinyl group, a triazinyl group, a quinolinyl group, a benzoquinolinyl group, an isoquinolinyl group, a benzoisoquinolinyl group, a quinoxalinyl group, a benzoquinoxalinyl group, a quinazolinyl group, a benzoquinazolinyl group, a cinnolinyl group, a phenanthrolinyl group, a phthalazinyl group, and a naphthyridinyl group. When the $C_1$-$C_{60}$ heteroaryl group and the $C_1$-$C_{60}$ heteroarylene group each include two or more rings, the two or more rings may be condensed with each other.

The term "monovalent non-aromatic condensed polycyclic group" as used herein refers to a monovalent group

having two or more rings condensed with each other, only carbon atoms (for example, eight to sixty carbon atoms) as ring-forming atoms, and no aromaticity in its molecular structure if (e.g., when) considered as a whole.

Examples of the monovalent non-aromatic condensed polycyclic group include an indenyl group, a fluorenyl group, a spiro-bifluorenyl group, a benzofluorenyl group, an indenophenanthrenyl group, and an indeno anthracenyl group. The term "divalent non-aromatic condensed polycyclic group" as used herein refers to a divalent group having the same structure as the monovalent non-aromatic condensed polycyclic group.

The term "monovalent non-aromatic condensed heteropolycyclic group" as used herein refers to a monovalent group that has two or more rings condensed with each other, further includes, in addition to carbon atoms (for example, one to sixty carbon atoms), at least one heteroatom as a ring-forming atom, and has no aromaticity in its molecular structure if (e.g., when) considered as a whole. Examples of the monovalent non-aromatic condensed heteropolycyclic group include a pyrrolyl group, a thiophenyl group, a furanyl group, an indolyl group, a benzoindolyl group, a naphthoindolyl group, an isoindolyl group, a benzoisoindolyl group, a naphthoisoindolyl group, a benzosilolyl group, a benzothiophenyl group, a benzofuranyl group, a carbazolyl group, a dibenzosilolyl group, a dibenzothiophenyl group, a dibenzofuranyl group, an azacarbazolyl group, an azafluorenyl group, an azadibenzosilolyl group, an azadibenzothiophenyl group, an azadibenzofuranyl group, a pyrazolyl group, an imidazolyl group, a triazolyl group, a tetrazolyl group, an oxazolyl group, an isoxazolyl group, a thiazolyl group, an isothiazolyl group, an oxadiazolyl group, a thiadiazolyl group, a benzopyrazolyl group, a benzimidazolyl group, a benzoxazolyl group, a benzothiazolyl group, a benzoxadiazolyl group, a benzothiadiazolyl group, an imidazopyridinyl group, an imidazopyrimidinyl group, an imidazotriazinyl group, an imidazopyrazinyl group, an imidazopyridazinyl group, an indeno carbazolyl group, an indolocarbazolyl group, a benzofurocarbazolyl group, a benzothienocarbazolyl group, a benzosilolocarbazolyl group, a benzoindolocarbazolyl group, a benzocarbazolyl group, a benzonaphthofuranyl group, a benzonaphthothiophenyl group, a benzonaphthosilolyl group, a benzofurodibenzofuranyl group, a benzofurodibenzothiophenyl group, and a benzothienodibenzothiophenyl group. The term "divalent non-aromatic condensed heteropolycyclic group" as used herein refers to a divalent group having the same structure as the monovalent non-aromatic condensed heteropolycyclic group.

The term "$C_6$-$C_{60}$ aryloxy group" as used herein refers to -$OA_{102}$ (wherein $A_{102}$ is the $C_6$-$C_{60}$ aryl group), and the term "$C_6$-$C_{60}$ arylthio group" as used herein refers to -$SA_{103}$ (wherein $A_{103}$ is the $C_6$-$C_{60}$ aryl group).

The term "$C_7$-$C_{60}$ arylalkyl group" as used herein refers to -$A_{104}A_{105}$ (wherein $A_{104}$ is a $C_1$-$C_{54}$ alkylene group, and $A_{105}$ is a $C_6$-$C_{59}$ aryl group), and the term "$C_2$-$C_{60}$ heteroarylalkyl group" as used herein refers to -$A_{106}A_{107}$ (wherein $A_{106}$ is a $C_1$-$C_{59}$ alkylene group, and $A_{107}$ is a $C_1$-$C_{59}$ heteroaryl group).

The term "$R_{10a}$" as used herein refers to:

deuterium, -F, -Cl, -Br, -I, a hydroxyl group, a cyano group, or a nitro group;

a $C_1$-$C_{60}$ alkyl group, a $C_2$-$C_{60}$ alkenyl group, a $C_2$-$C_{60}$ alkynyl group, or a $C_1$-$C_{60}$ alkoxy group, each unsubstituted or substituted with deuterium, -F, -Cl, -Br, -I, a hydroxyl group, a cyano group, a nitro group, a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_7$-$C_{60}$ arylalkyl group, a $C_2$-$C_{60}$ heteroarylalkyl group, -Si($Q_{11}$)($Q_{12}$)($Q_{13}$), -N($Q_{11}$)($Q_{12}$), -B($Q_{11}$)($Q_{12}$), - C(=O)($Q_{11}$), -S(=O)$_2$($Q_{11}$), -P(=O)($Q_{11}$)($Q_{12}$), or any combination thereof;

a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_7$-$C_{60}$ aryl alkyl group, or a $C_2$-$C_{60}$ heteroaryl alkyl group, each unsubstituted or substituted with deuterium, -F, -Cl, -Br, -I, a hydroxyl group, a cyano group, a nitro group, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_7$-$C_{60}$ aryl alkyl group, a $C_2$-$C_{60}$ heteroaryl alkyl group, -Si($Q_{21}$)($Q_{22}$)($Q_{23}$), -N($Q_{21}$)($Q_{22}$), -B($Q_{21}$)($Q_{22}$), - C(=O)($Q_{21}$), -S(=O)$_2$($Q_{21}$), -P(=O)($Q_{21}$)($Q_{22}$), or any combination thereof; or

-Si($Q_{31}$)($Q_{32}$)($Q_{33}$), -N($Q_{31}$)($Q_{32}$), -B($Q_{31}$)($Q_{32}$), -C(=O)($Q_{31}$), -S(=O)$_2$($Q_{31}$), or - P(=O)($Q_{31}$)($Q_{32}$),

$Q_1$ to $Q_3$, $Q_{11}$ to $Q_{13}$, $Q_{21}$ to $Q_{23}$, and $Q_{31}$ to $Q_{33}$ used herein may each independently be: hydrogen; deuterium; -F; -Cl; -Br; -I; a hydroxyl group; a cyano group; a nitro group; a $C_1$-$C_{60}$ alkyl group; a $C_2$-$C_{60}$ alkenyl group; a $C_2$-$C_{60}$ alkynyl group; a $C_1$-$C_{60}$ alkoxy group; a $C_3$-$C_{60}$ carbocyclic group or a $C_1$-$C_{60}$ heterocyclic group, each unsubstituted or substituted with deuterium, -F, a cyano group, a $C_1$-$C_{60}$ alkyl group, a $C_1$-$C_{60}$ alkoxy group, a phenyl group, a biphenyl group, or any combination thereof; a $C_7$-$C_{60}$ arylalkyl group; or a $C_2$-$C_{60}$ heteroarylalkyl group.

The term "heteroatom" as used herein refers to any atom other than a carbon atom. Examples of the heteroatom include O, S, N, P, Si, B, Ge, Se, or any combination thereof.

The term "third-row transition metal" used herein includes hafnium (Hf), tantalum (Ta), tungsten (W), rhenium (Re), osmium (Os), iridium (Ir), platinum (Pt), gold (Au), and/or the like.

The term "Ph" as used herein refers to a phenyl group, the term "Me" as used herein refers to a methyl group, the term "Et" as used herein refers to an ethyl group, the term "tert-Bu" or "$Bu^t$" as used herein refers to a tert-butyl group, and the term "OMe" as used herein refers to a methoxy group.

The term "biphenyl group" as used herein refers to "a phenyl group substituted with a phenyl group." For example,

the "biphenyl group" is a substituted phenyl group having a $C_6$-$C_{60}$ aryl group as a substituent.

The term "terphenyl group" as used herein refers to "a phenyl group substituted with a biphenyl group". For example, the "terphenyl group" is a substituted phenyl group having, as a substituent, a $C_6$-$C_{60}$ aryl group substituted with a $C_6$-$C_{60}$ aryl group.

**[0307]** * and *' as used herein, unless defined otherwise, each refer to a binding site to a neighboring atom in a corresponding formula or moiety.

The terms "x-axis", "y-axis", and "z-axis" as used herein are not limited to three axes in an orthogonal coordinate system, and may be interpreted in a broader sense than the aforementioned three axes in an orthogonal coordinate system. For example, the x-axis, y-axis, and z-axis may describe axes that are orthogonal to each other, or may describe axes that are in different directions that are not orthogonal to each other.

Terms such as "substantially," "about," and "approximately" are used as relative terms and not as terms of degree, and are intended to account for the inherent deviations in measured or calculated values that would be recognized by those of ordinary skill in the art. They may be inclusive of the stated value and an acceptable range of deviation as determined by one of ordinary skill in the art, considering the limitations and error associated with measurement of that quantity. For example, "about" may refer to one or more standard deviations, or $\pm$ 30%, 20%, 10%, 5% of the stated value.

Numerical ranges disclosed herein include and are intended to disclose all subsumed sub-ranges of the same numerical precision. For example, a range of "1.0 to 10.0" includes all subranges having a minimum value equal to or greater than 1.0 and a maximum value equal to or less than 10.0, such as, for example, 2.4 to 7.6.

The light-emitting device, the electronic apparatus, a device of manufacturing thereof, and/or any other relevant devices or components according to embodiments of the present disclosure described herein may be implemented utilizing any suitable hardware, firmware (e.g., an application-specific integrated circuit), software, or a combination of software, firmware, and hardware. For example, the one or more suitable components of the light-emitting device and/or the electronic apparatus, may be formed on one integrated circuit (IC) chip or on separate IC chips. Further, the one or more suitable components of the light-emitting device and/or the electronic apparatus may be implemented on a flexible printed circuit film, a tape carrier package (TCP), a printed circuit board (PCB), or formed on one substrate. Further, the one or more suitable components of the device and/or apparatus may be a process or thread, running on one or more processors, in one or more computing devices, executing computer program instructions and interacting with other system components for performing the one or more suitable functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of one or more suitable computing devices may be combined or integrated into a single computing device, or the functionality of a particular computing device may be distributed across one or more other computing devices without departing from the scope of the embodiments of the present disclosure.

Hereinafter, compounds according to one or more embodiments and light-emitting devices according to one or more embodiments will be described in more detail with reference to the following synthesis examples and examples. The wording "B was used instead of A" used in describing Synthesis Examples refers to that a substantially identical molar equivalent of B was used in place of A.

## Examples

### Synthesis Example 1 (Synthesis of Compound BD1)

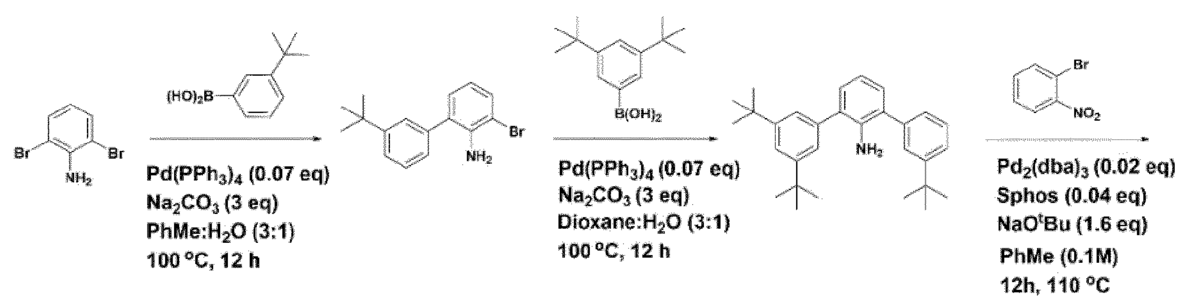

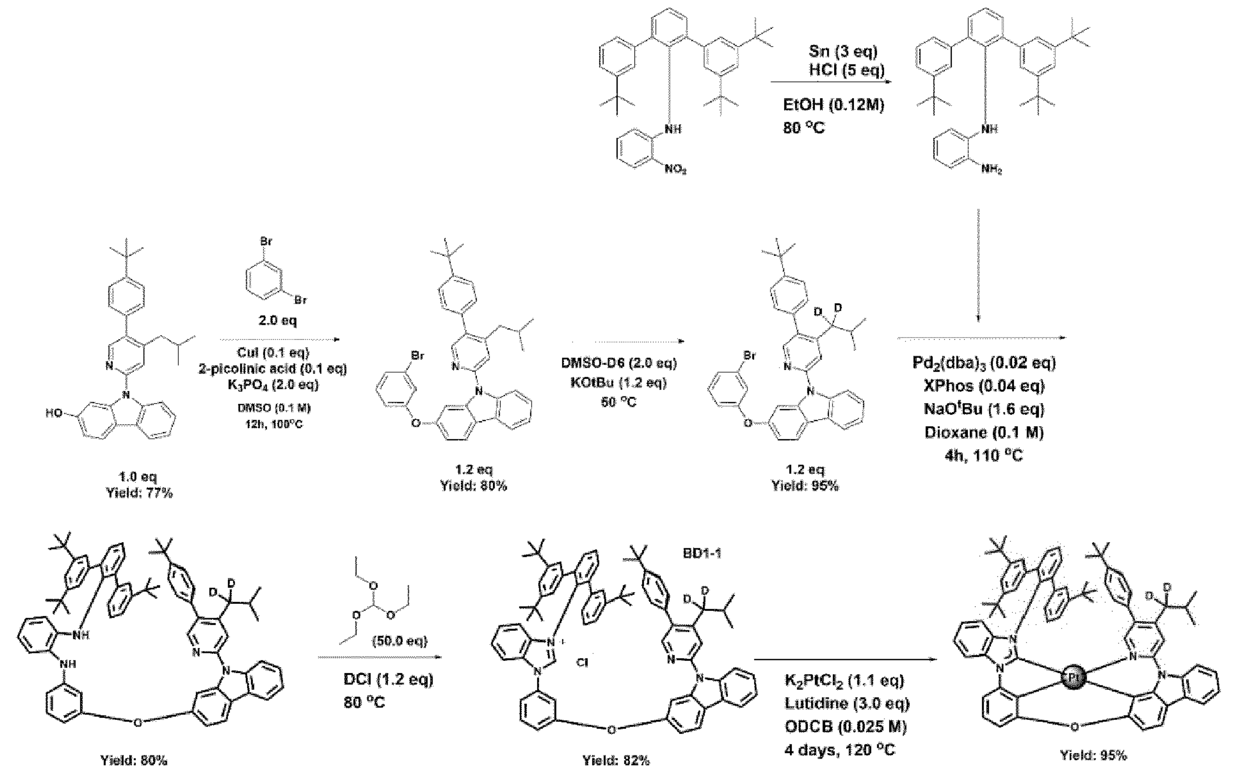


2,6-dibromoaniline (1.0 eq), (4-(tert-butyl)phenyl)boronic acid (1.0 eq), $Pd(PPh_3)_4$ (0.07 eq), and $Na_2CO_3$ (3.0 eq) were added to a PhMe/$H_2O$ 3:1 solution (7.8 mL), and then, stirred at a temperature of 100 °C for 12 hours to obtain 12.3 g of 3-bromo-3'-(tert-butyl)-[1,1'-biphenyl]-2-amine (yield: 92%).

3-bromo-3'-(tert-butyl)-[1,1'-biphenyl]-2-amine (1.0 eq), which is an intermediate, (3,5-di-tert-butylphenyl)boronic acid (1.0 eq), $Pd(PPh_3)_4$ (0.07 eq), and $Na_2CO_3$ (3.0 eq) were added to 7.8 mL of a dioxane/$H_2O$ 3:1 solution, and then, stirred at a temperature of 100 °C for 12 hours to obtain 11.7 g of 3,3",5-tri-tert-butyl-[1,1':3',1"-terphenyl]-2'-amine (yield: 95%).

11.7 g (1.0 eq) of 3,3",5-tri-tert-butyl-[1,1':3',1"-terphenyl]-2'-amine, which is an intermediate, 1-bromo-2-nitrobenzene (3.0 eq), $Pd_2(dba)_3$ (0.02) eq, SPhos (0.04 eq), and NaO*t*Bu (1.6 eq) were added to PhMe (0.1 M), and then, stirred at a temperature of 110 °C for 12 hours to obtain 10.5 g of intermediate 3,3",5-tri-tert-butyl-N-(2-nitrophenyl)-[1,1':3',1"-terphenyl]-2'-amine (yield: 90%).

10.5 g (1.0 eq) of intermediate 3,3",5-tri-tert-butyl-N-(2-nitrophenyl)-[1,1':3',1"-terphenyl]-2'-amine, tin (3.0 eq), and HCl (5.0 eq) were added to 7.1 mL of EtOH, and then, stirred at a temperature of 80 °C for 12 hours to obtain 10.1 g of intermediate $N^{1}$-(3,3",5-tri-tert-butyl-[1,1':3',1"-terphenyl]-2'-yl)benzene-1,2-diamine (yield: 96%).

9-(5-(4-(tert-butyl)phenyl)-4-isobutylpyridin-2-yl)-9H-carbazol-2-ol (1.0 eq), 1,3-dibromo-benzene (2.0 eq), CuI (0.1 eq), 2-picolinic acid (0.1 eq), and $K_3PO_4$ (2.0 eq) were added to DMSO (0.1M) and stirred at a temperature of 100 °C for 12 hours to obtain 10.5 g of intermediate 2-(3-bromophenoxy)-9-(5-(4-(tert-butyl)phenyl)-4-isobutylpyridin-2-yl)-9H-carbazole (yield: 80%).

10.5 g (1.0 eq) of intermediate 2-(3-bromophenoxy)-9-(5-(4-(tert-butyl)phenyl)-4-isobutylpyridin-2-yl)-9H-carbazole, and $KO^tBu$ (1.2 eq) were added to DMSO-$D^6$ (2.0 eq), and stirred at a temperature of 50 °C to obtain 9.97 g (1.2 eq) of intermediate 2-(3-bromophenoxy)-9-(5-(4-(tert-butyl)phenyl)-4-(2-methylpropyl-1,1-$d^2$)pyridin-2-yl)-9H-carbazole (yield: 95%).

9.9 g of intermediate $N^{1}$-(3,3",5-tri-tert-butyl-[1,1':3',1"-terphenyl]-2'-yl)benzene-1,2-diamine, 10.6 g of 2-(3-bromophenoxy)-9-(5-(4-(tert-butyl)phenyl)-4-(2-methylpropyl-1,1-$d^2$)pyridin-2-yl)-9H-carbazole, $Pd_2(dba)_3$ (0.02 eq), XPhos (0.04 eq), and NaO*t*Bu (1.6 eq) were added to dioxane (0.1 M), and then stirred at a temperature of 110 °C for 4 hours to obtain 7.9 g of intermediate $N^{1}$-(3-((9-(5-(4-(tert-butyl)phenyl)-4-(2-methylpropyl-1,1-$d^2$)pyridin-2-yl)-9H-carbazol-2-yl)oxy)phenyl)-$N^2$-(3,3",5-tri-tert-butyl-[1,1':3',1"-terphenyl]-2'-yl)benzene-1,2-diamine (yield: 80%).

7.9 g of Intermediate $N^{1}$-(3-((9-(5-(4-(tert-butyl)phenyl)-4-(2-methylpropyl-1,1-$d^2$)pyridin-2-yl)-9H-carbazol-2-yl)oxy)phenyl)-$N^2$-(3,3",5-tri-tert-butyl-[1,1':3',1"-terphenyl]-2'-yl)benzene-1,2-diamine, and triethoxymethane (50.0 eq) were added to DCl (1.2 eq), and then stirred at a temperature of 80 °C to obtain 6.4 g (1.0eq) of Intermediate BD1-1 (yield: 82%).

6.6 g of Intermediate BD1-1, lutidine (3.0 eq), and $K_2PtCl_2$ (1.1 eq) were added to ODCB (0.025 M), and stirred at

a temperature of 120 °C for 4 days to obtain 6.1 g of Compound BD1 (yield: 95%).

**Synthesis Example 2 (Synthesis of Compound BD2)**

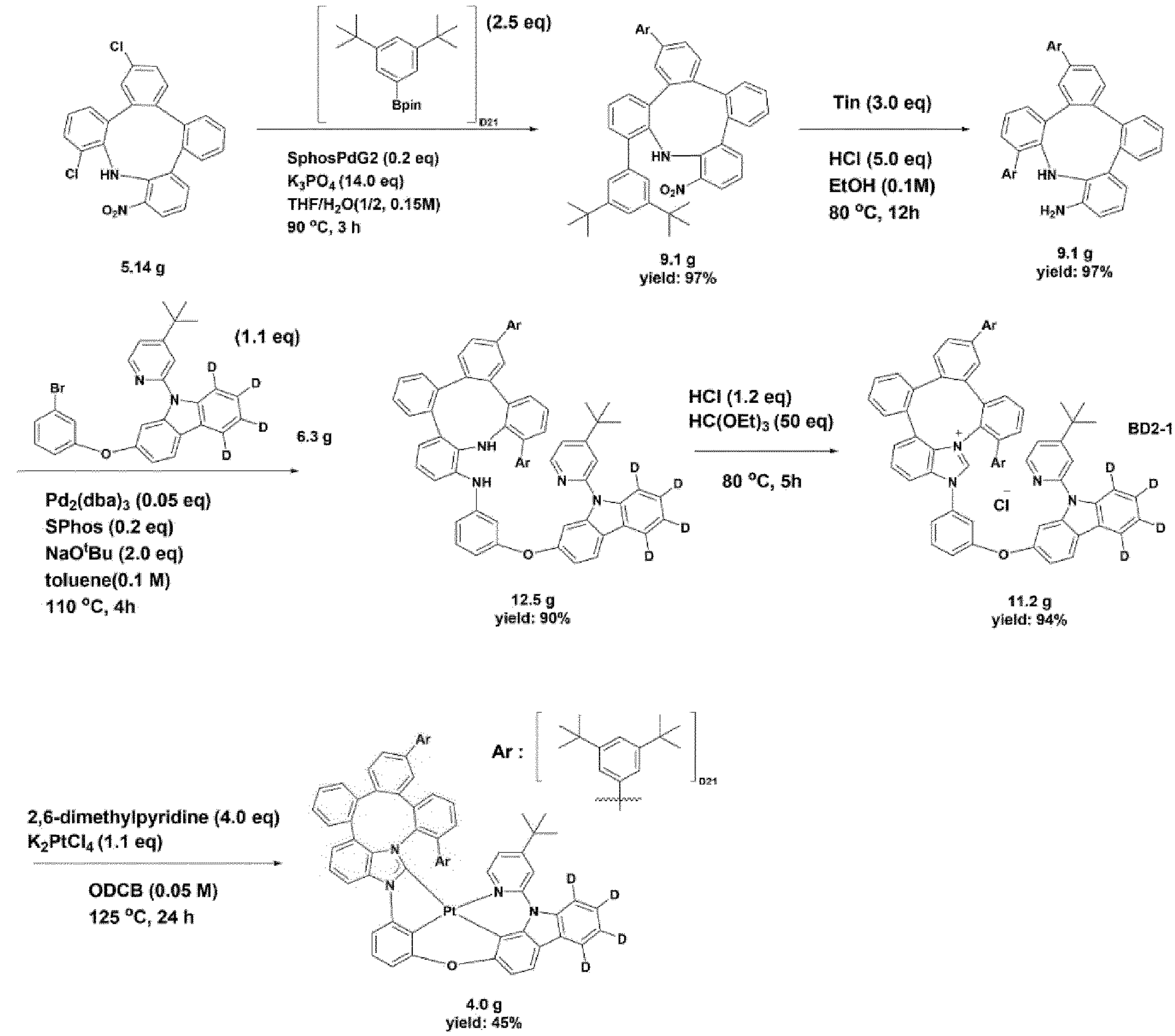


5.14 g (1.0 eq) of 3,8-dichloro-10-nitro-9H-tetrabenzo[b,d,f,h]azonine, 2-(3,5-di-tert-butylphenyl)-4,4,5,5-tetramethyl-1,3,2-dioxaborolane (2.5 eq), SphosPdG2 (0.2 eq), and $K_3PO_4$ (14.0 eq) were added to THF/$H_2O$ (1:2) solution (0.15 M), and stirred at a temperature of 90 °C for 3 hours to obtain 9.1 g of 3,8-bis(3,5-di-tert-butylphenyl)-10-nitro-9H-tetrabenzo[b,d,f,h]azonine (yield: 97%).

9.1 g of 3,8-bis(3,5-di-tert-butylphenyl)-10-nitro-9H-tetrabenzo[b,d,f,h]azonine, 6.3 g of 2-(3-bromophenoxy)-9-(4-(tert-butyl)pyridin-2-yl)-9H-carbazole-5,6,7,8-d4, tin (3.0 eq), and HCl (5.0 eq) were added to EtOH (0.1 M), and then, stirred at a temperature of 80 °C for 12 hours to obtain 9.1 g of 10,15-bis(3,5-di-tert-butylphenyl)-9H-tetrabenzo[b,d,f,h]azonin-8-amine (yield: 97%).

9.1 g of 10,15-bis(3,5-di-tert-butylphenyl)-9H-tetrabenzo[b,d,f,h]azonin-8-amine (1.1 eq), $Pd_2(dba)_2$ (0.05 eq), SPhos (0.2 eq), and NaOtBu (2.0 eq) were added to toluene (0.1 M), and then stirred at a temperature of 110 °C for 4 hours to obtain 12.5 g of N-(3-((9-(4-(tert-butyl)pyridin-2-yl)-9H-carbazol-2-yl-5,6,7,8-d4)oxy)phenyl)-10,15-bis(3,5-di-tert-butylphenyl)-9H-tetrabenzo[b,d,f,h]azonin-8-amine (yield: 90%).

12.5 g of N-(3-((9-(4-(tert-butyl)pyridin-2-yl)-9H-carbazol-2-yl-5,6,7,8-d4)oxy)phenyl)-10,15-bis(3,5-di-tert-butylphenyl)-9H-tetrabenzo[b,d,f,h]azonin-8-amine, HCl (1.2 eq), and $HC(OEt)_3$ (50.0 eq) were stirred at a temperature of 80 °C for 5 hours to obtain 11.2 g of Intermediate BD2-1 (yield: 94%).

Intermediate BD2-1 12.5 g, 2,6-dimethylpyridine (4.0 eq), $K_2PtCl_4$ (1.1 eq), and SPhos (0.2 eq) were added to ODCB (0.05 M), and stirred at a temperature of 125 °C for 24 hours to obtain 4.0 g of BD2 (yield: 45%).

**Synthesis Example 3 (Synthesis of Compound BD3)**

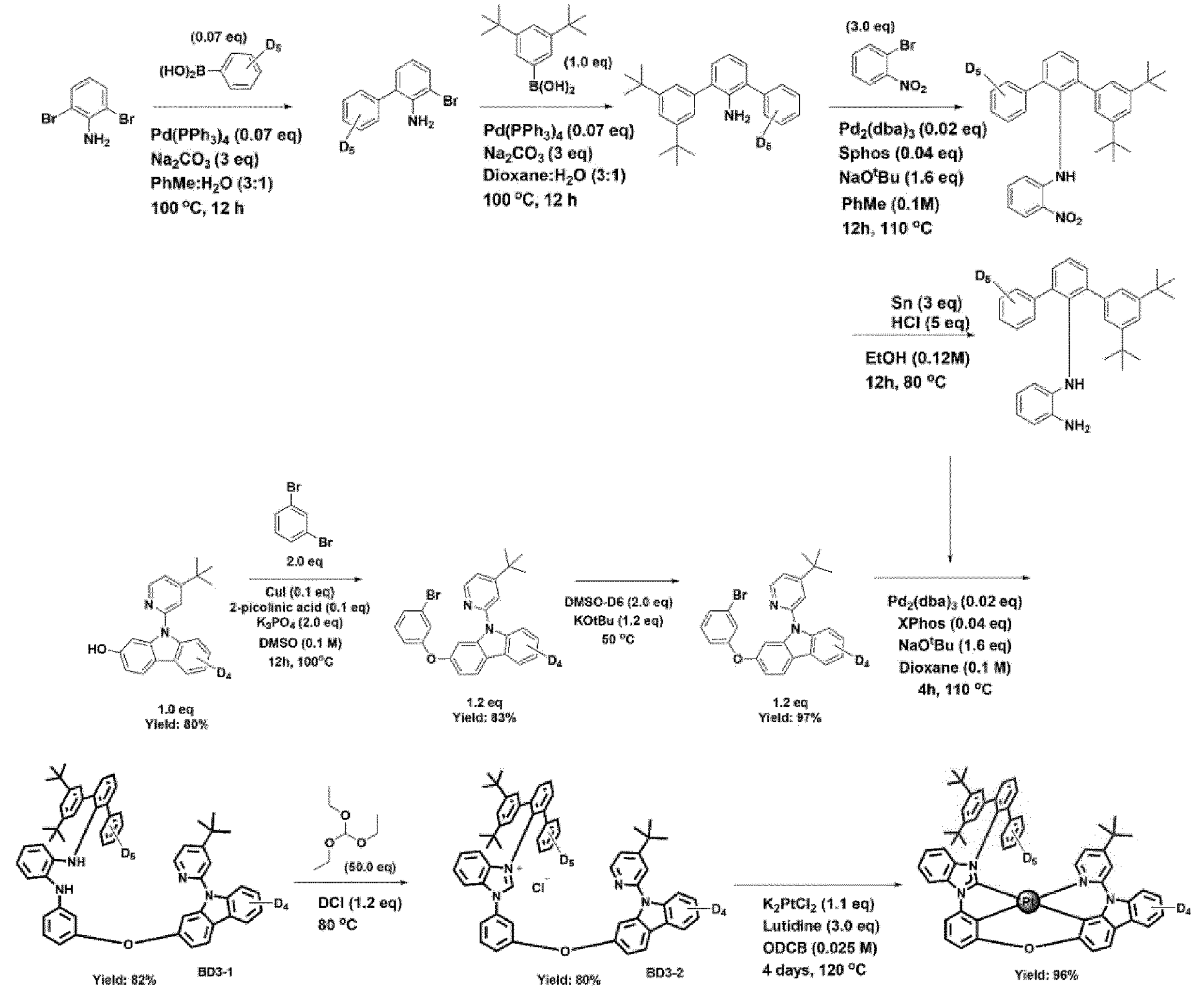


2,6-dibromoaniline (1.0 eq), (phenyl-d5)boronic acid (0.07) eq, $Pd(PPh_3)_4$ (0.07 eq), and $Na_2CO_3$ (3.0 eq) were added to 7.8 mL of $PhMe/H_2O$ (3:1) solution, and then, stirred at a temperature of 100 °C for 12 hours to obtain 11.5 g of 3-bromo-[1,1'-biphenyl]-2',3',4',5',6'-d5-2-amine (yield: 93%).

Then, intermediate 3-bromo-[1,1'-biphenyl]-2',3',4',5',6'-d5-2-amine (1.0 eq), (3,5-di-tert-butylphenyl)boronic acid (1.0 eq), $Pd(PPh_3)_4$ (0.07 eq), and $Na_2CO_3$ (3.0 eq) were added to dioxane/$H_2O$ (3:1) solution (7.8 mL), and then, stirred at a temperature of 100 °C for 12 hours to obtain 10.8 g of 3,5-di-tert-butyl-[1,1':3',1"-terphenyl]-2",3",4",5",6"-d5-2'-amine (yield: 94%).

10.8 g (1.0 eq) of intermediate 3,5-di-tert-butyl-[1,1':3',1"-terphenyl]-2",3",4",5",6"-d5-2'-amine, 1-bromo-2-nitrobenzene (3.0 eq), $Pd_2(dba)_3$ (0.02 eq), SPhos (0.04 eq), and NaOtBu (1.6 eq) were added to PhMe(0.1M), and stirred at a temperature of 110 °C for 12 hours to obtain 9.7 g of intermediate 3,5-di-tert-butyl-N-(2-nitrophenyl)-[1,1':3',1"-terphenyl]-2",3",4",5",6"-d5-2'-amine (yield: 90%).

9.7 g (1.0 eq) of intermediate 3,5-di-tert-butyl-N-(2-nitrophenyl)-[1,1':3',1"-terphenyl]-2",3",4",5",6"-d5-2'-amine, tin (3.0 eq), and HCl (5.0 eq) were added to 7.1 mL of EtOH and stirred at a temperature of 80 °C for 12 hours to obtain 9.1 g of intermediate N1-(3,5-di-tert-butyl-[1,1':3',1"-terphenyl]-2'-yl-2",3",4",5",6"-d5)benzene-1,2-diamine (yield: 94%).

9-(4-(tert-butyl)pyridin-2-yl)-9H-carbazol-5,6,7,8-d4-2-ol (1.0 eq), 1,3-dibromo-benzene (2.0 eq), CuI (0.1 eq), 2-picolinic acid (0.1 eq), and $K_3PO_4$ (2.0 eq) were added to DMSO (0.1M) and stirred at a temperature of 100 °C for 12 hours to obtain 10.3 g of intermediate 2-(3-bromophenoxy)-9-(4-(tert-butyl)pyridin-2-yl)-9H-carbazole-5,6,7,8-d4 (yield: 83%).

10.3 g (1.0 eq) of intermediate 2-(3-bromophenoxy)-9-(4-(tert-butyl)pyridin-2-yl)-9H-carbazole-5,6,7,8-d4 and $KO^tBu$ (1.2 eq) were added to DMSO-$D^6$ (2.0 eq) and stirred at a temperature of 50 °C to obtain 9.9 g (1.2 eq) of intermediate 2-(3-bromophenoxy)-9-(4-(tert-butyl)pyridin-2-yl)-9H-carbazole-5,6,7,8-d4 (yield: 97 %).

9.1 g of intermediate N1-(3,5-di-tert-butyl-[1,1':3',1"-terphenyl]-2'-yl-2",3",4",5",6"-d5)benzene-1,2-diamine, 10.3 g of 2-(3-bromophenoxy)-9-(4-(tert-butyl)pyridin-2-yl)-9H-carbazole-5,6,7,8-d4, $Pd_2(dba)_3$ (0.02 eq), XPhos (0.04 eq), and NaOtBu (1.6 eq) were added to dioxane (0.1 M) and stirred at a temperature of 110 °C for 4 hours to obtain 7.4 g of Intermediate BD3-1 (yield: 82%).

7.4 g of Intermediate BD3-1 and triethoxymethane (50.0 eq) were added to DCl (1.2 eq) and stirred at a temperature of 80 °C to obtain 5.9 g (1.0 eq) of Intermediate BD3-2 (yield: 80%).

5.9 g of Intermediate BD3-2, lutidine (3.0 eq), and $K_2PtCl_2$ (1.1 eq) were added to ODCB (0.025 M) and stirred at a temperature of 120 °C for 4 days to obtain 5.7 g of Compound BD3 (yield: 96%).

**Synthesis Example 4 (Synthesis of Compound BD4)**

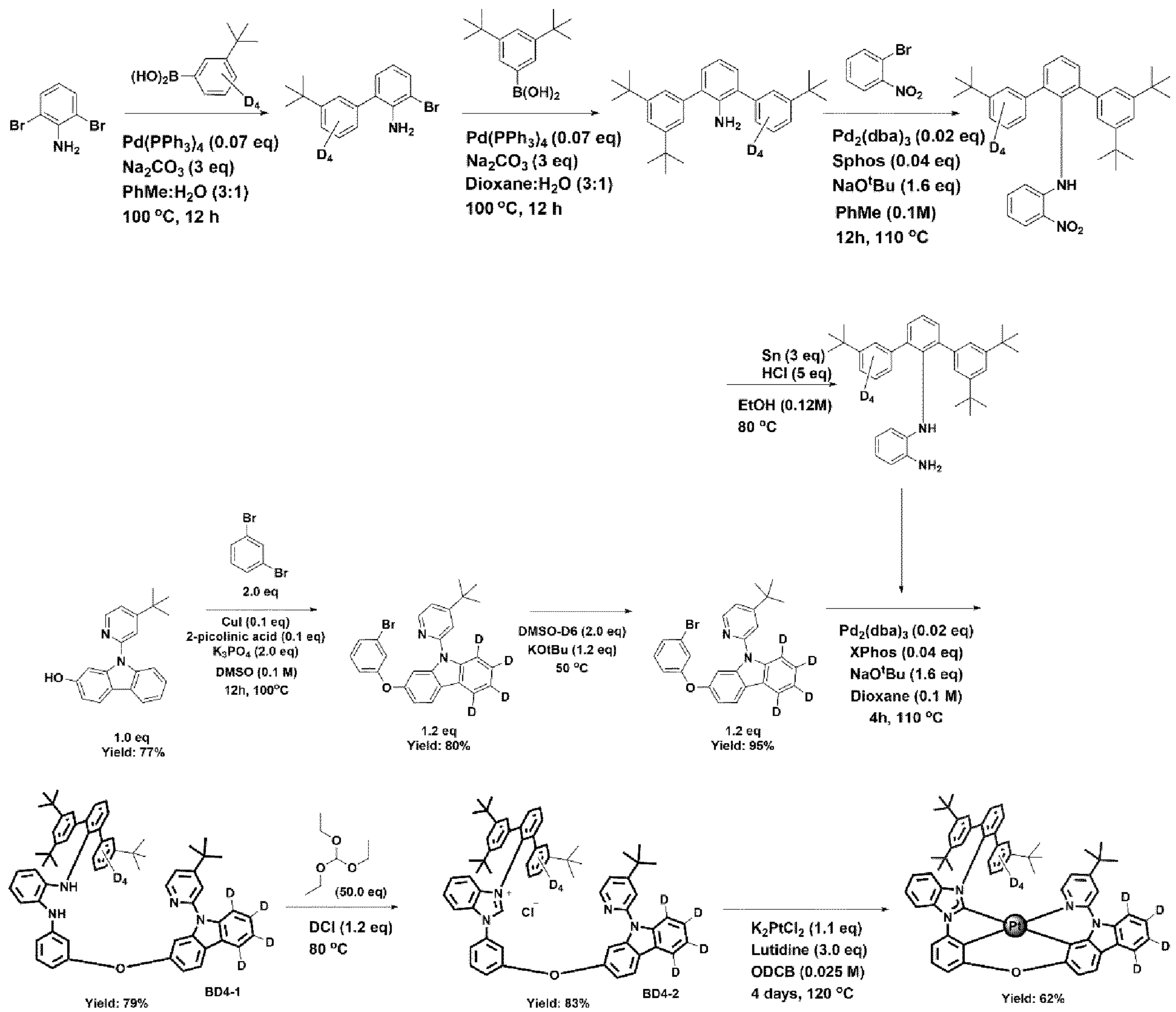


2,6-dibromoaniline (1.0 eq), (3-(tert-butyl)phenyl-2,4,5,6-d4)boronic acid (0.07) eq, $Pd(PPh_3)_4$ (0.07 eq), and $Na_2CO_3$ (3.0 eq) were added to PhMe/$H_2O$ 3:1 solution (7.8 mL) and stirred at a temperature of 100 °C for 12 hours to obtain 11.5 g of 3-bromo-3'-(tert-butyl)-[1,1'-biphenyl]-2', 4',5',6'-d4-2-amine (yield: 93%).

Then, intermediate 3-bromo-3'-(tert-butyl)-[1,1'-biphenyl]-2', 4',5',6'-d4-2-amine (1.0 eq), (3,5-di-tert-butylphenyl)boronic acid (1.0 eq), $Pd(PPh_3)_4$ (0.07 eq), and $Na_2CO_3$ (3.0 eq) were added to dioxane/$H_2O$ (3:1) solution (7.8 mL), and then, stirred at a temperature of 100 °C for 12 hours to obtain 10.8 g of 3,3",5-tri-tert-butyl-[1,1':3',1"-terphenyl]-2",4",5",6"-d4-2'-amine (yield: 94%).

10.8 g (1.0 eq) of intermediate 3,3",5-tri-tert-butyl-[1,1':3',1"-terphenyl]-2",4",5",6"-d4-2'-amine, 1-bromo-2-nitrobenzene (3.0 eq), $Pd_2(dba)_3$ 0.02 eq, SPhos (0.04 eq), and NaOtBu (1.6 eq) were added to PhMe(0.1M) and stirred at a temperature of 110 °C for 12 hours to obtain 9.7 g of intermediate 3,5-di-tert-butyl-N-(2-nitrophenyl)-[1,1':3',1"-terphenyl]-2",4",5",6"-d4-2'-amine (yield: 90%).

9.7 g (1.0 eq) of intermediate 3,5-di-tert-butyl-N-(2-nitrophenyl)-[1,1':3',1"-terphenyl]-2",4",5",6"-d4-2'-amine, tin (3.0 eq), and HCl (5.0 eq) were added to EtOH (7.1 mL) and stirred at a temperature of 80 °C for 12 hours to obtain 9.1 g of intermediate N1-(3,3",5-tri-tert-butyl-[1,1':3',1"-terphenyl]-2'-yl-2",4",5",6"-d4)benzene-1,2-diamine (yield: 94%).

9-(4-(tert-butyl)pyridin-2-yl)-9H-carbazol-2-ol (1.0 eq), 1,3-dibromo-benzene (2.0 eq), CuI (0.1 eq), 2-picolinic acid (0.1 eq), and $K_3PO_4$ (2.0 eq) were added to DMSO (0.1M) and stirred at a temperature of 100 °C for 12 hours to obtain 9.2 g of intermediate 2-(3-bromophenoxy)-9-(4-(tert-butyl)pyridin-2-yl)-9H-carbazole (yield: 80%).

9.2 g (1.0 eq) of intermediate 2-(3-bromophenoxy)-9-(4-(tert-butyl)pyridin-2-yl)-9H-carbazole and $KO^tBu$ (1.2 eq) were added to DMSO-$D^6$ (2.0 eq) and stirred at a temperature of 50 °C to obtain 8.7 g (1.2 eq) of intermediate 2-(3-bromophenoxy)-9-(4-(tert-butyl)pyridin-2-yl)-9H-carbazole-5,6,7,8-d4 (yield: 95%).

9.1 g of intermediate N1-(3,3",5-tri-tert-butyl-[1,1':3',1"-terphenyl]-2'-yl-2",4",5",6"-d4)benzene-1,2-diamine, 8.7 g of 2-(3-bromophenoxy)-9-(4-(tert-butyl)pyridin-2-yl)-9H-carbazole-5,6,7,8-d4, $Pd_2(dba)_3$ (0.02 eq), XPhos (0.04 eq), and NaOtBu (1.6 eq) were added to dioxane (0.1 M) and stirred at a temperature of 110 °C for 4 hours to obtain 6.8 g of Intermediate BD4-1 (yield: 79%).

6.8 g of Intermediate BD4-1 and triethoxymethane (50.0 eq) were added to DCI (1.2 eq) and stirred at a temperature of 80 °C to obtain 5.6 g of Intermediate BD4-2 (1.0eq) (yield: 83%).

5.6 g of Intermediate BD4-2, lutidine (3.0 eq), and $K_2PtCl_2$ (1.1 eq) were added to ODCB (0.025 M) and stirred at a temperature of 120 °C for 4 days to obtain 3.5 g of Compound BD4 (yield: 62%).

**Synthesis Example 5 (Synthesis of Compound BD5)**

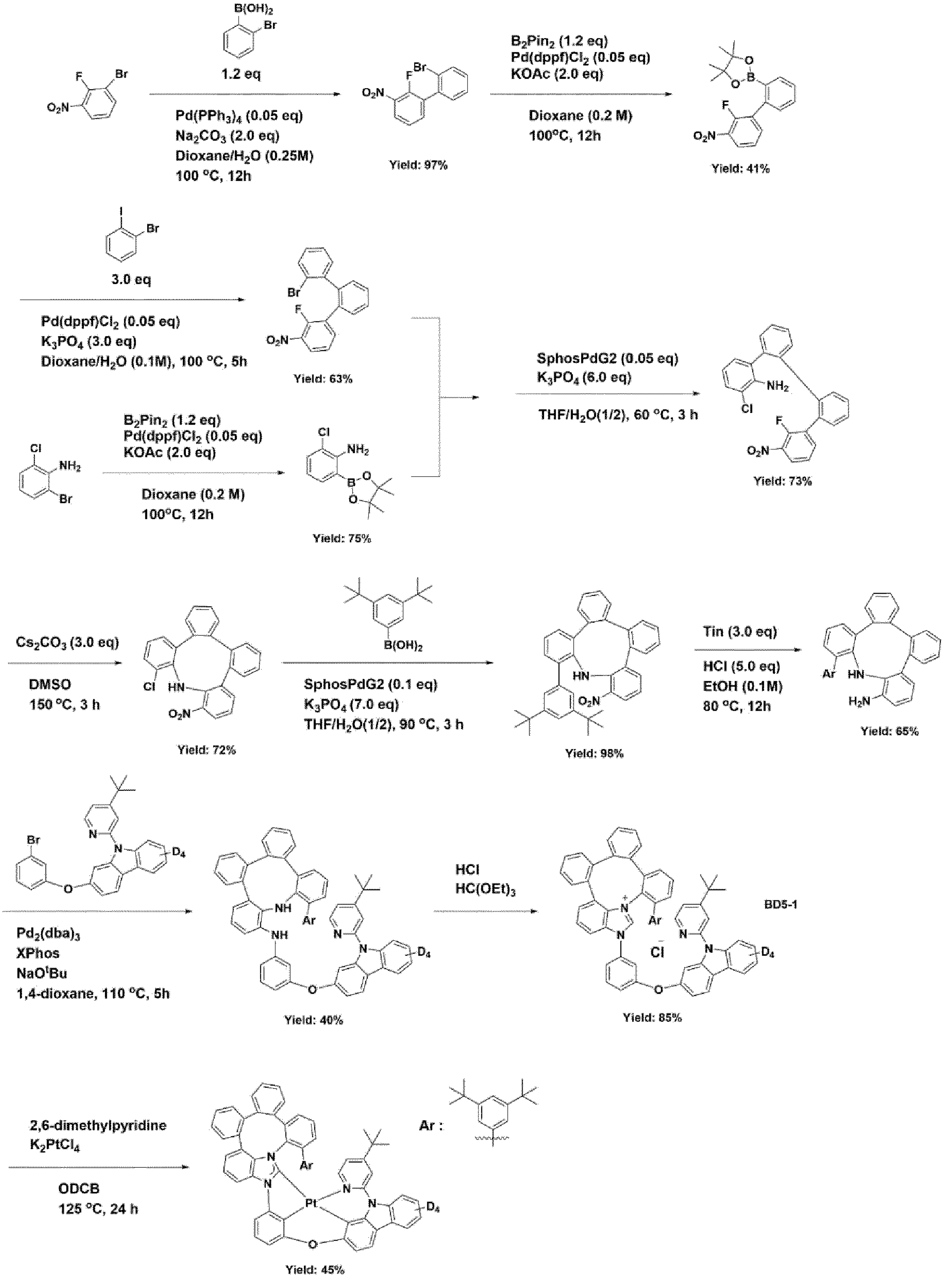


1-bromo-2-fluoro-3-nitrobenzene 30 g, (2-bromophenyl)boronic acid (1.2) eq, $Pd(PPh_3)_4$ (0.05 eq), and $Na_2CO_3$ (2.0 eq) were added to dioxane/$H_2O$ (3:1) solution (0.25 M) and stirred at a temperature of 100 °C for 12 hours to obtain 29.1 g of 2'-bromo-2-fluoro-3-nitro-1,1'-biphenyl (yield: 97%).

Then, 29.1 g of 2'-bromo-2-fluoro-3-nitro-1,1'-biphenyl, which is an intermediate, pinacolborane (1.2 eq), $Pd(dppf)Cl_2$ (0.05 eq), and KOAc (2.0 eq) were added to dioxane (0.2 M) and then stirred at a temperature of 100 °C for 12 hours to obtain 11.9 g of 2-(2'-fluoro-3'-nitro-[1,1'-biphenyl]-2-yl)-4,4,5,5-tetramethyl-1,3,2-dioxaborolane (yield:

41%).

11.9 g of intermediate 2-(2'-fluoro-3'-nitro-[1,1'-biphenyl]-2-yl)-4,4,5,5-tetramethyl-1,3,2-dioxaborolane, 1-bromo-2-iodobenzene (3.0 eq), Pd(dppf)$Cl_2$ (0.05 eq), and $K_3PO_4$ (3.0 eq) were added to dioxane/$H_2O$ (0.1 M) and stirred at a temperature of 100 °C for 5 hours to obtain 7.5 g of 2"-bromo-2-fluoro-3-nitro-1 ,1':2',1"-terphenyl (yield: 63%).

2-bromo-6-chloroaniline (1.0 eq), pinacolborane (1.2 eq), Pd(dppf)$Cl_2$ (0.05 eq), and KOAc (2.0 eq) were added to dioxane (0.2 M) and stirred at a temperature of 100 °C for 12 hours to obtain 8.5 g of 2-chloro-6-(4,4,5,5-tetramethyl-1,3,2-dioxaborolan-2-yl)aniline (yield: 75%).

7.5 g of intermediate 2"-bromo-2-fluoro-3-nitro-1,1':2',1"-terphenyl, 8.5 g of 2-chloro-6-(4,4,5,5-tetramethyl-1,3,2-dioxaborolan-2-yl)aniline, SphosPdG2 (0.05 eq), and $K_3PO_4$ (6.0 eq) were added to THF:$H_2O$ (1:2) (0.2 M) and stirred at a temperature of 60 °C for 3 hours to obtain 5.5 g of 3-chloro-2‴-fluoro-3‴-nitro-[1,1':2',1":2",1‴-quaterphenyl]-2-amine (yield: 73%).

5.5 g of intermediate 3-chloro-2‴-fluoro-3‴-nitro-[1,1':2',1":2",1‴-quaterphenyl]-2-amine and $Cs_2CO_3$ (3.0 eq) were added to DMSO (0.5 M) and stirred at a temperature of 150 °C for 3 hours to obtain 4.0 g of 8-chloro-10-nitro-9H-tetrabenzo[b,d,f,h]azonine (yield: 72%).

4.0 g of 8-chloro-10-nitro-9H-tetrabenzo[b,d,f,h]azonine, which is an intermediate, (3,5-di-tert-butylphenyl) boronic acid (1.0 eq), SphosPdG2 (0.1 eq), and $K_3PO_4$ (7.0 eq) were added to THF:$H_2O$ (1:2) (0.2 M) and stirred at a temperature of 90 °C for 3 hours to synthesize 3.9 g of 8-(3,5-di-tert-butylphenyl)-10-nitro-9H-tetrabenzo[b,d,f,h]azonine (yield: 98%).

3.9 g (1.0 eq) of 8-(3,5-di-tert-butylphenyl)-10-nitro-9H-tetrabenzo[b,d,f,h]azonine, which is an intermediate, tin (3.0 eq), and HCl (5.0 eq) were added to EtOH (0.1 M) and stirred at a temperature of 80 °C for 12 hours to obtain 2.5 g of intermediate 10-(3,5-di-tert-butylphenyl)-9H-tetrabenzo[b,d,f,h]azonin-8-amine (yield: 65%).

2.5 g of intermediate 10-(3,5-di-tert-butylphenyl)-9H-tetrabenzo[b,d,f,h]azonin-8-amine, 2-(3-bromophenoxy)-9-(4-(tert-butyl)pyridin-2-yl)-9H-carbazole-5,6,7,8-d4 (1.0 eq), $Pd_2(dba)_3$ (0.02 eq), XPhos (0.04 eq), and NaOtBu (1.6 eq) were added to dioxane (0.1 M) and stirred at a temperature of 110 °C for 5 hours to obtain 1.0 g of N-(3-((9-(4-(tert-butyl)pyridin-2-yl)-9H-carbazol-2-yl-5,6,7,8-d4)oxy)phenyl)-10-(3,5-di-tert-butylphenyl)-9H-tetrabenzo[b,d,f,h]azonin-8-amine (yield: 40%).

1.0 g of N-(3-((9-(4-(tert-butyl)pyridin-2-yl)-9H-carbazol-2-yl-5,6,7,8-d4)oxy)phenyl)-10-(3,5-di-tert-butylphenyl)-9H-tetrabenzo[b,d,f,h]azonin-8-amine, HCl (1.2 eq), and $HC(OEt)_3$ (50.0 eq) were stirred at a temperature of 80 °C for 5 hours to obtain 0.9 g of Intermediate BD5-1 (yield: 85%).

0.9 g of Intermediate BD5-1, 2,6-dimethylpyridine (4.0 eq), and $K_2PtCl_4$ (1.1 eq) were added to ODCB (0.05 M) and stirred at a temperature of 125 °C for 24 hours to obtain 0.4 g of BD5 (yield: 45%).

**Synthesis Example 6 (Synthesis of Compound BD6)**

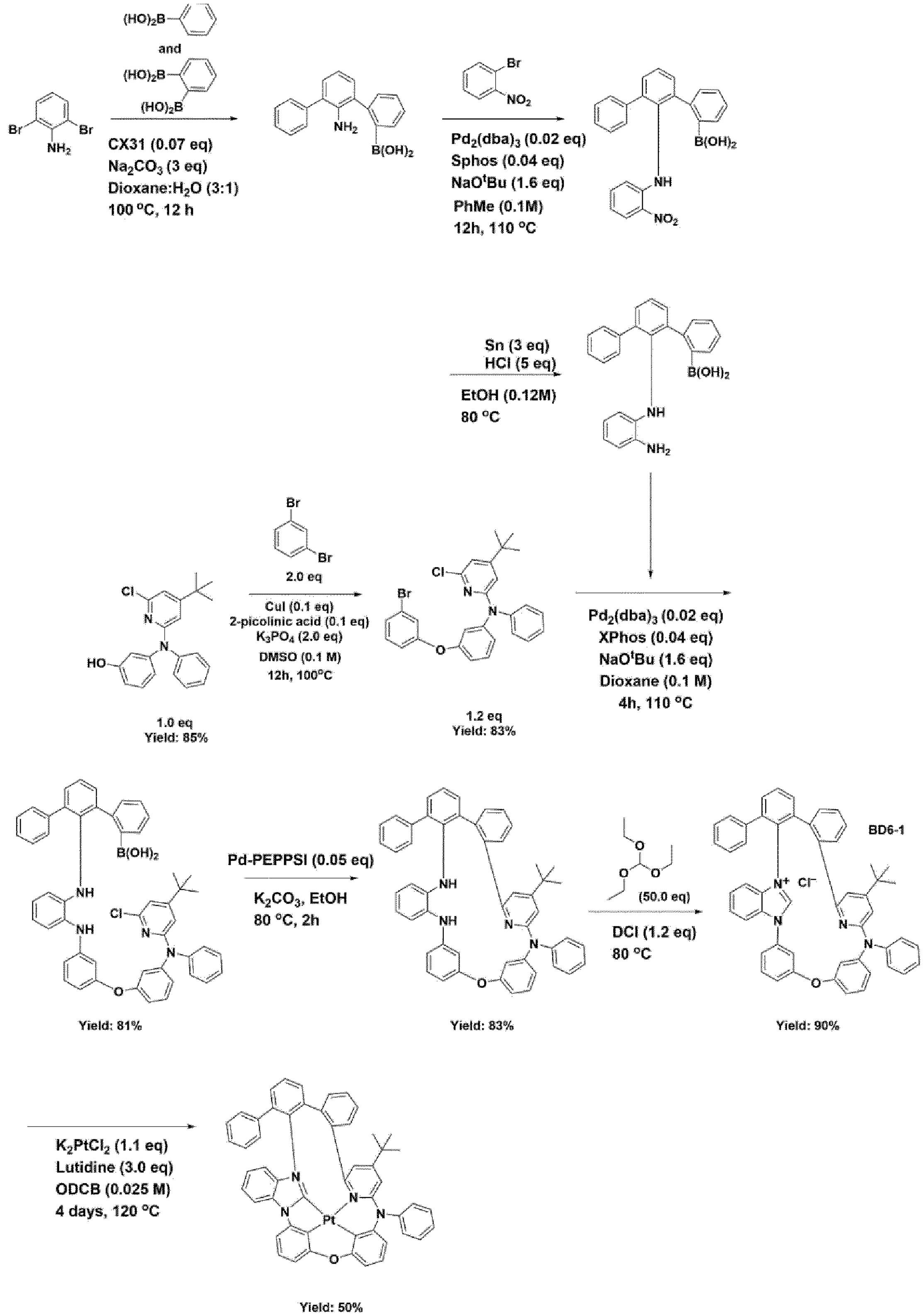


2,6-dibromoaniline (1.0 eq), phenylboronic acid, 1,2-phenylenediboronic acid (0.07 eq), CX31 (0.07 eq), and $Na_2CO_3$ (3.0 eq) were added to dioxane/$H_2O$ 3:1 solution (7.8 mL) and stirred at a temperature of 100 °C for 12 hours to obtain 13.2 g of (2'-amino-[1,1':3',1"-terphenyl]-2-yl)boronic acid (yield: 93%).

Then, 13.8 g of (2'-amino-[1,1':3',1"-terphenyl]-2-yl)boronic acid, which is an intermediate, 1-bromo-2-nitrobenzene (1.0 eq), $Pd_2(dba)_3$ (0.02 eq), Sphos (0.04 eq), and NaOtBu (1.6 eq) were added to toluene (0.1 M) and stirred at a temperature of 110 °C for 12 hours to obtain 12.3 g of (2'-((2-nitrophenyl)amino)-[1,1':3',1"-terphenyl]-2-yl)boronic acid

(yield: 94%).

12.8 g (1.0 eq) of (2'-((2-nitrophenyl)amino)-[1,1':3',1"-terphenyl]-2-yl)boronic acid, which is an intermediate, tin (3.0 eq), and HCl (5.0 eq) were added to EtOH (0.12 M) and stirred at a temperature of 80 °C for 12 hours to obtain 11.6 g of intermediate (2'-((2-aminophenyl)amino)-[1,1':3',1"-terphenyl]-2-yl)boronic acid (yield: 94%).

3-((4-(tert-butyl)-6-chloropyridin-2-yl)(phenyl)amino)phenol (1.0 eq), 1,3-dibromo-benzene (2.0 eq), CuI (0.1 eq), 2-picolinic acid (0.1 eq), and $K_3PO_4$ (2.0 eq) were added to DMSO (0.1 M) and stirred at a temperature of 100 °C for 12 hours to obtain 10.3 g of intermediate N-(3-(3-bromophenoxy)phenyl)-4-(tert-butyl)-6-chloro-N-phenylpyridin-2-amine (yield: 83%).

11.6 g of intermediate (2'-((2-aminophenyl)amino)-[1,1':3',1"-terphenyl]-2-yl)boronic acid, 10.3 g of N-(3-(3-bromophenoxy)phenyl)-4-(tert-butyl)-6-chloro-N-phenylpyridin-2-amine, $Pd_2(dba)_3$ (0.02 eq), XPhos (0.04 eq), and NaOtBu (1.6 eq) were added to dioxane (0.1 M) and stirred at a temperature of 110 °C for 4 hours to obtain 8.3 g of intermediate (2'-((2-((3-(3-((4-(tert-butyl)-6-chloropyridin-2-yl)(phenyl)amino)phenoxy)phenyl)amino)phenyl)amino)-[1,1':3',1"-terphenyl]-2-yl)boronic acid (yield: 81%).

8.3 g of intermediate (2'-((2-((3-(3-((4-(tert-butyl)-6-chloropyridin-2-yl)(phenyl)amino)phenoxy)phenyl)amino)phenyl)amino)-[1,1':3',1"-terphenyl]-2-yl)boronic acid, Pd-PEPPSI (0.05 eq), and $K_2CO_3$ (2.0 eq) were added to EtOH (0.1 M) and stirred at a temperature of 80 °C for 2 hours to obtain 7.1 g of intermediate $1^4$-(tert-butyl)-$3^2$,10-diphenyl-8-oxa-4,6,10-triaza-1(2,6)-pyridina-2,3,5(1,2),7,9(1,3)-pentabenzenacyclodecaphane (yield: 81%).

7.1 g of intermediate $1^4$-(tert-butyl)-$3^3$,10-diphenyl-8-oxa-4,6,10-triaza-1(2,6)-pyridina-2,3,5(1,2),7,9(1,3)-pentabenzenacyclodecaphane and triethoxymethane (50.0 eq) were added to DCl (1.2 eq) and stirred at a temperature of 80 °C to obtain 6.4 g of Intermediate BD6-1 (yield: 90%).

6.4 g of Intermediate BD6-1, lutidine (3.0 eq), and $K_2PtCl_2$ (1.1 eq) were added to ODCB (0.025 M) and stirred at a temperature of 120 °C for 4 days to obtain 4.0 g of Compound BD6 (yield: 62%).

**Synthesis Example 7 (Synthesis of Compound BD7)**

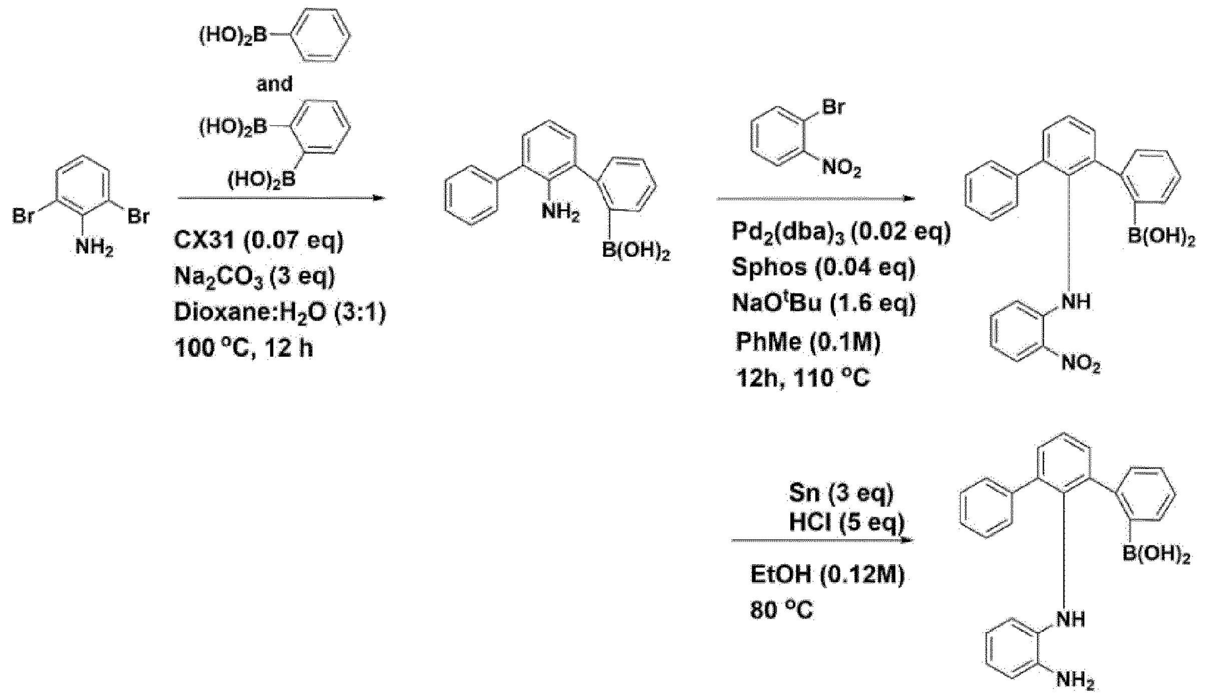

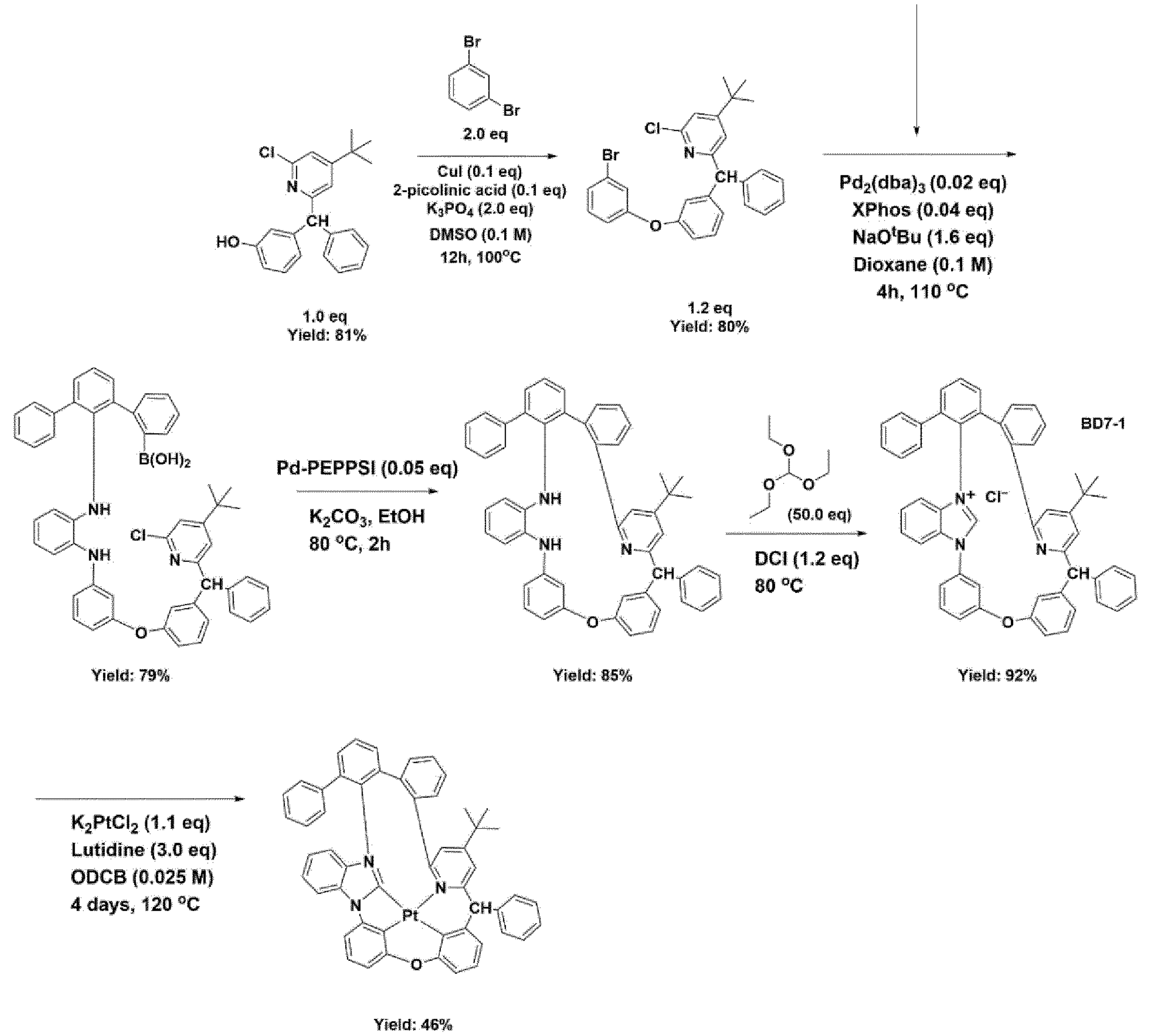


2,6-dibromoaniline (1.0 eq), phenylboronic acid, 1,2-phenylenediboronic acid (0.07 eq), CX31 (0.07 eq), and $Na_2CO_3$ (3.0 eq) were added to dioxane/$H_2O$ (3:1) solution (7.8 mL) and stirred at a temperature of 100 °C for 12 hours to obtain 13.2 g of (2'-amino-[1,1':3',1"-terphenyl]-2-yl)boronic acid (yield: 93%).

Then, 13.8 g of intermediate (2'-amino-[1,1':3',1"-terphenyl]-2-yl)boronic acid, 1-bromo-2-nitrobenzene (1.0 eq), $Pd_2(dba)_3$ (0.02 eq), Sphos (0.04 eq), and NaOtBu (1.6 eq) were added to toluene (0.1 M) and stirred at a temperature of 110 °C for 12 hours to obtain 12.3 g of (2'-((2-nitrophenyl)amino)-[1,1':3',1"-terphenyl]-2-yl)boronic acid (yield: 94%).

12.8 g (1.0 eq) of intermediate (2'-((2-nitrophenyl)amino)-[1,1':3',1"-terphenyl]-2-yl)boronic acid, tin (3.0 eq), and HCl (5.0 eq) were added to EtOH (0.12 M) and stirred at a temperature of 80 °C for 12 hours to obtain 11.6 g of intermediate (2'-((2-aminophenyl)amino)-[1,1':3',1"-terphenyl]-2-yl)boronic acid (yield: 94%).

3-((4-(tert-butyl)-6-chloropyridin-2-yl)(phenyl)methyl)phenol (1.0 eq), 1,3-dibromo-benzene (2.0 eq), CuI (0.1 eq), 2-picolinic acid (0.1 eq), and $K_3PO_4$ (2.0 eq) were added to DMSO (0.1 M) and stirred at a temperature of 100 °C for 12 hours to obtain 9.9 g of intermediate 2-((3-(3-bromophenoxy)phenyl)(phenyl)methyl)-4-(tert-butyl)-6-chloropyridine (yield: 80%).

11.6 g of intermediate (2'-((2-aminophenyl)amino)-[1,1':3',1"-terphenyl]-2-yl)boronic acid, 9.9 g of 2-((3-(3-bromophenoxy)phenyl)(phenyl)methyl)-4-(tert-butyl)-6-chloropyridine, $Pd_2(dba)_3$ (0.02 eq), XPhos (0.04 eq), and NaOt-Bu (1.6 eq) were added to dioxane (0.1 M) and stirred at a temperature of 110 °C for 4 hours to obtain 7.8 g of intermediate (2'-((2-((3-(3-((4-(tert-butyl)-6-chloropyridin-2-yl)(phenyl)amino)phenoxy)phenyl)amino)phenyl)amino)-[1,1':3',1"-terphenyl]-2-yl)boronic acid (yield: 79%).

7.8 g of intermediate (2'-((2-((3-(3-((4-(tert-butyl)-6-chloropyridin-2-yl)(phenyl)amino)phenoxy)phenyl)amino)phenyl)amino)-[1,1':3',1"-terphenyl]-2-yl)boronic acid, Pd-PEPPSI (0.05 eq), and $K_2CO_3$ (2.0 eq) were added to EtOH (0.1M), and stirred at a temperature of 80 °C for 2 hours to obtain 6.6 g of intermediate $1^4$-(tert-butyl)-$3^2$,10-diphenyl-8-

oxa-4,6-diaza-1(2,6)-pyridina-2,3,5(1,2),7,9(1,3)-pentabenzenacyclodecaphane (yield: 85%).

6.6 g of intermediate $1^4$-(tert-butyl)-$3^3$,10-diphenyl-8-oxa-4,6-diaza-1(2,6)-pyridina-2,3,5(1,2),7,9(1,3)-pentabenzenacyclodecaphane and triethoxymethane (50.0 eq) were added to DCl (1.2 eq) and stirred at a temperature of 80 °C to thiobtain 6.1 g of Intermediate BD7-1 (yield: 92%).

6.1 g of Intermediate BD7-1, lutidine (3.0 eq), and $K_2PtCl_2$ (1.1 eq) were added to ODCB (0.025 M) and stirred at a temperature of 120 °C for 4 days to obtain 2.8 g of Compound BD7 (yield: 46%).

**Synthesis Example 8 (Synthesis of Compound BD8)**

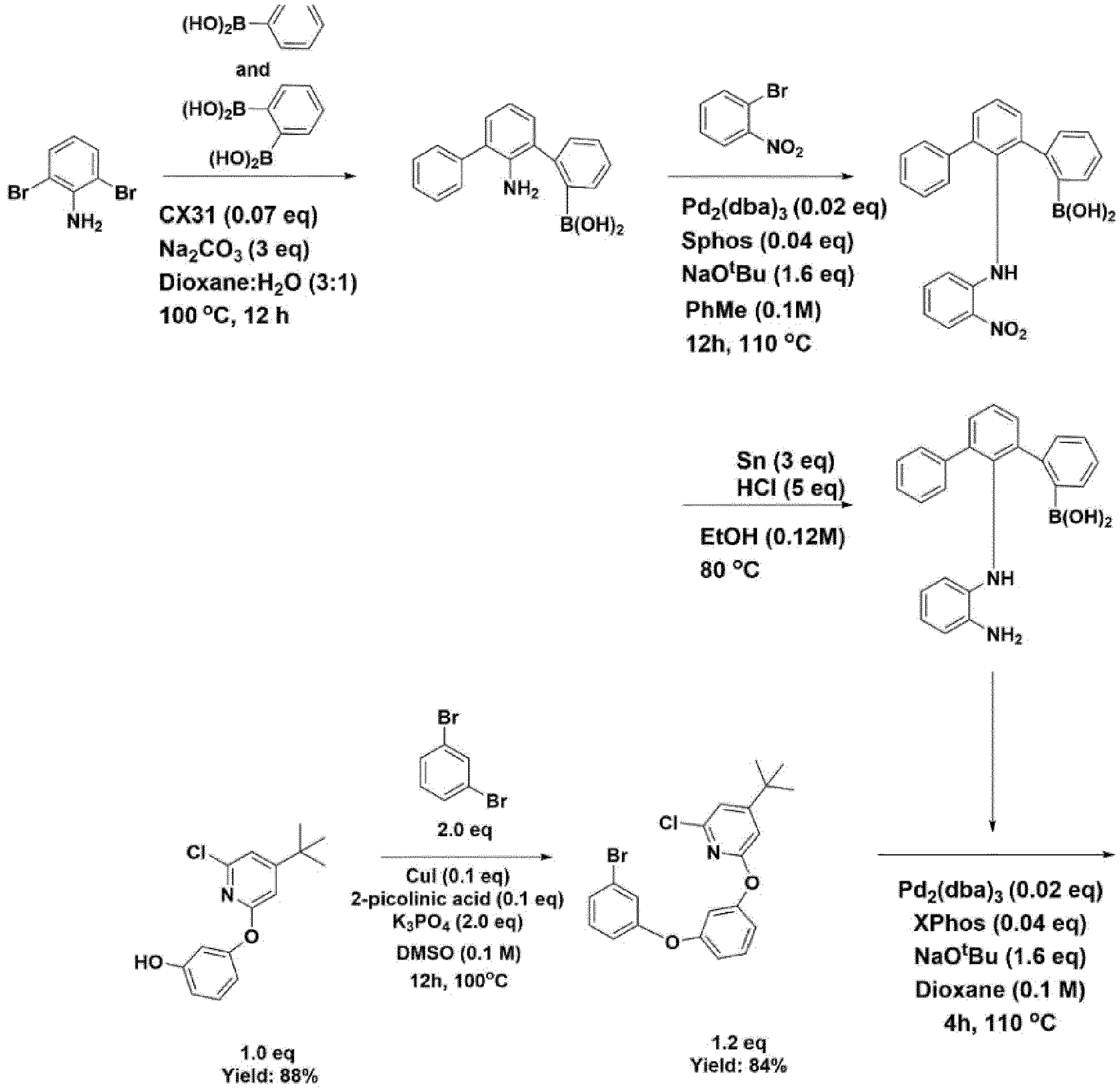

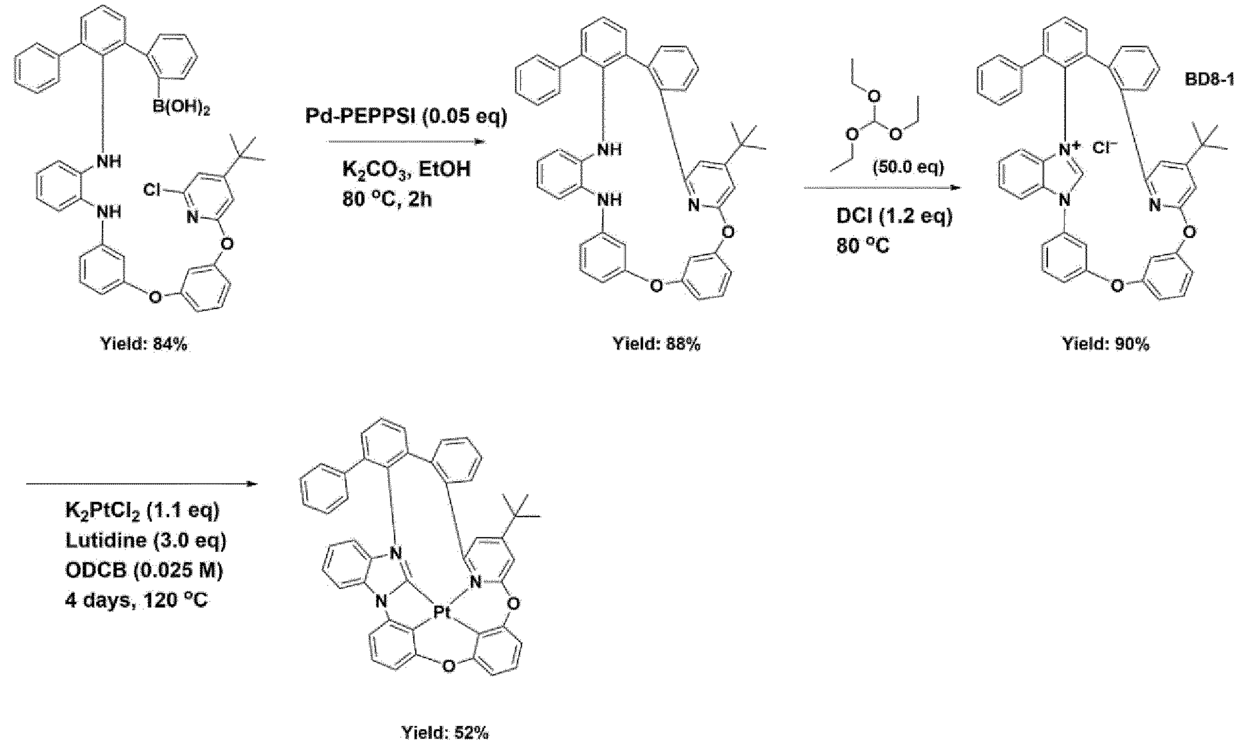


2,6-dibromoaniline (1.0 eq), phenylboronic acid, 1,2-phenylenediboronic acid (0.07 eq), CX31 (0.07 eq), and $Na_2CO_3$ (3.0 eq) were added to a dioxane/$H_2O$ (3:1) solution (7.8 mL) and stirred at a temperature of 100 °C for 12 hours to obtain 13.2 g of (2'-amino-[1,1':3',1"-terphenyl]-2-yl)boronic acid (yield: 93%).

Then, 13.8 g of intermediate (2'-amino-[1,1':3',1"-terphenyl]-2-yl)boronic acid, 1-bromo-2-nitrobenzene (1.0 eq), $Pd_2(dba)_3$ (0.02 eq), Sphos (0.04 eq), and NaOtBu (1.6 eq) were added to toluene (0.1 M) and stirred at a temperature of 110 °C for 12 hours to obtain 12.3 g of (2'-((2-nitrophenyl)amino)-[1,1':3',1"-terphenyl]-2-yl)boronic acid (yield: 94%).

12.8 g (1.0 eq) of (2'-((2-nitrophenyl)amino)-[1,1':3',1"-terphenyl]-2-yl)boronic acid, which is an intermediate, tin (3.0 eq), and HCl (5.0 eq) were added to EtOH (0.12 M) and stirred at a temperature of 80 °C for 12 hours to obtain 11.6 g of intermediate (2'-((2-aminophenyl)amino)-[1,1':3',1"-terphenyl]-2-yl)boronic acid (yield: 94%).

3-((4-(tert-butyl)-6-chloropyridin-2-yl)oxy)phenol (1.0 eq), 1,3-dibromo-benzene (2.0 eq), CuI (0.1 eq), 2-picolinic acid (0.1 eq), and $K_3PO_4$ (2.0 eq) were added to DMSO (0.1 M) and stirred at a temperature of 100 °C for 12 hours to obtain 10.4 g of intermediate 2-(3-(3-bromophenoxy)phenoxy)-4-(tert-butyl)-6-chloropyridine (yield: 84%).

11.6 g of intermediate (2'-((2-aminophenyl)amino)-[1,1':3',1"-terphenyl]-2-yl)boronic acid, 10.4 g of intermediate 2-(3-(3-bromophenoxy)phenoxy)-4-(tert-butyl)-6-chloropyridine, $Pd_2(dba)_3$ (0.02 eq), XPhos (0.04 eq), and NaOtBu (1.6 eq) were added to dioxane (0.1 M) and then stirred at a temperature of 110 °C for 4 hours to obtain 8.7 g of intermediate (2'-((2-((3-(3-((4-(tert-butyl)-6-chloropyridin-2-yl)oxy)phenoxy)phenyl)amino)phenyl)amino)-[1,1':3',1"-terphenyl]-2-yl) boronic acid (yield: 84%).

8.7 g of intermediate (2'-((2-((3-(3-((4-(tert-butyl)-6-chloropyridin-2-yl)oxy)phenoxy)phenyl)amino)phenyl)amino)-[1,1':3',1"-terphenyl]-2-yl)boronic acid, Pd-PEPPSI (0.05 eq), and $K_2CO_3$ (2.0 eq) were added to EtOH (0.1 M) and stirred at a temperature of 80 °C for 2 hours to obtain 7.7 g of intermediate $1^4$-(tert-butyl)-$3^3$-phenyl-8,10-dioxa-4,6-diaza-1(2,6)-pyridina-2,3,5(1,2),7,9(1,3)-pentabenzenacyclodecaphane (yield: 88%).

7.7 g of intermediate $1^4$-(tert-butyl)-$3^3$-phenyl-8,10-dioxa-4,6-diaza-1(2,6)-pyridina-2,3,5(1,2),7,9(1,3)-pentabenzenacyclodecaphane and triethoxymethane (50.0 eq) were added to DCl (1.2 eq) and stirred at a temperature of 80 °C to obtain 6.9 g of Intermediate BD8-1 (yield: 90%).

6.9 g of Intermediate BD8-1, lutidine (3.0 eq), and $K_2PtCl_2$ (1.1 eq) were added to ODCB (0.025 M) and stirred at a temperature of 120 °C for 4 days to obtain 3.6 g of Compound BD8 (yield: 52%).

For the compounds synthesized in Synthesis Examples 1 to 8, $^1H$ NMR and high-resolution mass (HR-MS) were measured. Results thereof are shown in Table 1. Synthesis methods of other compounds in addition to the compounds synthesized in Synthesis Examples 1 to 8 may be easily recognized by those of ordinary skill in the art by referring to the synthesis paths and source materials.

Table 1

| Synthesis Example | $^1$H NMR ($CDCl_3$, 500 MHz) | HR-MS (m/z) [$M^+$] | |
|---|---|---|---|
| | | found | calc. |
| 1 | 9.08(d, 1H), 8.39(m, 1H), 8.20(m, 2H), 7.93(m, 1H), 7.73(m, 2H), 7.59-7.46(m, 6H), 7.39-7.38(m, 3H), 7.31-7.30(m, 3H), 7.20-7.14(m, 4H), 6.95-6.90(m, 3H), 6.69-6.66(m, 2H), 2.1(m, 1H), 1.43(d, 9H), 1.33-1.32(m, 27H), 0.93(m, 6H) | 1232.57 | 1233.54 |
| 2 | 8.74(m, 1H), 8.39(m, 1H), 8.20-8.15(m, 3H), 8.15-8.13(m, 2H), 7.79(m, 1H), 7.73(m, 4H), 7.58-7.50(m, 4H), 7.50-7.35(m, 8H), 7.20-7.14(m, 3H) 6.95-6.90(m, 3H), 6.69-6.66(m, 2H), 1.32(m, 45H) | 1350.86 | 1351.89 |
| 3 | 8.74(m, 1H), 8.39(m, 1H), 8.20(m, 2H), 7.73(m, 2H), 7.58-7.50(m, 4H), 7.43-7.39(m, 6H), 7.20-7.08(m, 6H), 6.95-6.90(m, 3H), 6.69-6.66(m, 2H), 1.32(d, 27H) | 1071.52 | 1072.34 |
| 4 | 8.74(m, 1H), 8.56(m, 2H), 8.39(m, 1H), 8.19(m, 1H), 7.93(m, 1H), 7.87(m, 2H), 7.73(m, 3H), 7.58-7.40(m, 7H), 7.33-7.28(m, 5H), 7.20(m, 1H), 7.00(m, 1H), 6.69(m, 1H), 1.43(d, 9H), 1.32(d, 27H) | 1106.52 | 1107.37 |
| 5 | 8.74(m, 1H), 8.56(m, 1H), 8.39(m, 1H), 8.19(m, 1H), 7.96(m, 2H), 7.87(m, 2H), 7.79-7.73(m, 4H), 7.60-7.50(m, 4H), 7.50-7.40(m, 6H), 7.33-7.28(m, 4H), 7.20(m, 1H), 7.00(m, 1H), 6.69(m, 1H), 1.32(d, 27H) | 1120.44 | 1121.32 |
| 6 | 8.35(m, 1H), 7.96(m, 1H), 7.75-7.73(m, 3H), 7.61-7.60(m, 4H), 7.49-7.41(m, 3H), 7.24-7.17(m, 4H), 7.08-7.00(m, 5H), 6.90(m, 2H), 6.71-6.66(m, 5H), 6.12(d, 1H), 1.32(d, 9H) | 874.21 | 874.89 |
| 7 | 8.56(m, 1H), 8.35(m, 1H), 7.96 (m, 1H), 7.75-7.73(m, 3H), 7.64-7.41(m, 9H), 7.33-7.14(m, 11H), 7.00(m, 1H), 6.90(m, 2H), 5.34(d, 1H), 1.32(d, 9H) | 930.28 | 931.00 |
| 8 | 8.56(m, 1H), 8.35(m, 1H), 7.96(m, 1H), 7.75-7.73(m, 3H), 7.61-7.49(m, 8H), 7.33-7.18(m, 5H), 7.00(m, 1H), 6.84(m, 1H), 6.56-6.53(m, 2H), 5.47(d, 1H), 1.32(d, 9H) | 929.28 | 930.01 |

**Evaluation Example 1**

By using methods described in Table 2, lowest unoccupied molecular orbital (LUMO), highest occupied molecular orbital (HOMO), and bandgap and MLCT values of the compounds of the preceding Synthesis Examples were measured. Results are shown in Table 3.

Table 2

| | |
|---|---|
| HOMO energy level evaluation method | By using cyclic voltammetry (CV) (electrolyte: 0.1 M $Bu_4NPF_6$ / solvent: dimethylformamide (DMF) / electrode: 3-electrode system (working electrode: GC, reference electrode: Ag/AgCl, and auxiliary electrode: Pt)), the potential (V)-current (A) graph of each compound was obtained, and then, from the oxidation onset of the graph, the HOMO energy level of each compound was calculated. |
| LUMO energy level evaluation method | By using cyclic voltammetry (CV) (electrolyte: 0.1 M $Bu_4NPF_6$ / solvent: dimethylformamide (DMF) / electrode: 3-electrode system (working electrode: GC, reference electrode: Ag/AgCl, and auxiliary electrode: Pt)), the potential (V)-current (A) graph of each compound was obtained, and then, from the reduction onset of the graph, the LUMO energy level of each compound was calculated. |
| MLCT | A percentage (%) of triplet metal-to-ligand charge transfer ($^3$MLCT) was calculated by using the DFT method of the Gaussian program, which is structure-improved or optimized at the B3LYP/6-311G(d,p) level. |

Table 3

| Synthesis Example | HOMO (eV) | LUMO (eV) | Energy gap (eV) | MLCT (%) |
|---|---|---|---|---|
| 1 | -4.87 | -1.45 | 3.39 | 10.69 |
| 2 | -4.85 | -1.44 | 3.41 | 11.13 |
| 3 | -4.88 | -1.45 | 3.43 | 11.57 |
| 4 | -4.87 | -1.44 | 3.43 | 12.27 |
| 5 | -4.84 | -1.44 | 3.40 | 10.92 |
| 6 | -5.01 | -1.69 | 3.32 | 13.66 |
| 7 | -4.97 | -1.56 | 3.41 | 15.46 |
| 8 | -4.86 | -1.50 | 3.36 | 18.04 |

**Evaluation Example 2**

The $\Delta G(T_1)$ - $\Delta G$(BDE) values and percent buried volumes with respect to the compounds of Synthesis Examples 1 to 8, Comparative Example 1 and Comparative Example 2 were measured. The results thereof are shown in Table 4. The $\Delta G(T_1)$ - $\Delta G$(BDE) values and percent buried volumes were measured based on values obtained using a quantum chemistry package (e.g. Gaussian, ADF, and/or the like). For each compound, the singlet spin ground state was obtained through geometry optimization calculations based on a combination of the B3LYP density functional and the 6-311g(d,p) basis set, and the structure of each compound was verified through vibrational frequency calculations. Then, based on the improved or optimized ground state structure, the triplet spin state and the structure in which the CN bond is broken in the form of a radical were obtained, and $\Delta G(T_1)$ and $\Delta G$(BDE) were obtained from the difference in Gibbs free energy between these structures and the singlet state, respectively. In the case of percent buried volume, the structure of the single-point ground state can be obtained through the relative value of the volume occupying a virtual sphere created using the SambVca package (https://doi.org/10.1002/ejic.200801160). The radius of the sphere was assumed to be 10.0 angstrom (Å).

Table 4

| | $\Delta E$ ($T_1$, nm) | $\Delta G$ ($T_1$, eV) | $\Delta G$ ($T_1$, nm) | $\Delta G$(BDE) (kcal/mol) | $\Delta G$($T_1$-BDE) (kcal/mol) | Percent buried volume (%) |
|---|---|---|---|---|---|---|
| Synthesis Example 1 | 463.31 | 2.492 | 497.62 | 59.74 | 2.27 | 22.0 |
| Synthesis Example 2 | 465.21 | 2.495 | 496.92 | 59.45 | 1.90 | 23.7 |
| Synthesis Example 3 | 463.00 | 2.480 | 499.92 | 60.84 | 3.65 | 24.0 |
| Synthesis Example 4 | 463.35 | 2.481 | 499.78 | 60.83 | 3.61 | 24.4 |
| Synthesis Example 5 | 464.25 | 2.497 | 496.52 | 58.52 | 0.93 | 22.8 |
| Synthesis Example 6 | 461.36 | 2.494 | 497.16 | 67.23 | 9.72 | 19.3 |
| Synthesis Example 7 | 465.70 | 2.478 | 500.30 | 64.77 | 7.61 | 19.3 |
| Synthesis Example 8 | 451.96 | 2.572 | 482.17 | 68.32 | 9.02 | 15.5 |
| Comparative Example 1 | 462.23 | 2.523 | 491.56 | 53.86 | -4.31 | 22.8 |
| Comparative Example 2 | 465.94 | 2.484 | 499.28 | 57.587 | 0.31 | 25.5 |

**Comparative Example Compound 1** **Comparative Example Compound 2**

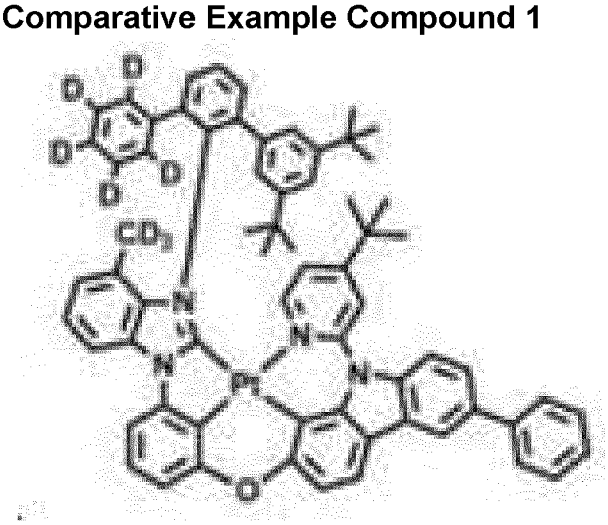

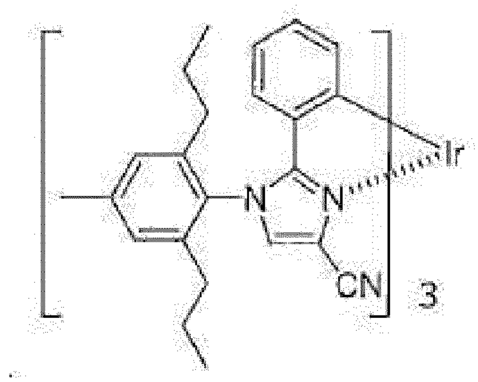

**Example 1**

A Corning 15 ohm per square centimeter ($\Omega/cm^2$) (1,200 angstrom (Å)) ITO glass substrate, which acts as an anode, was cut to a size of 50 millimeter (mm) x 50 mm x 0.7 mm, sonicated in isopropyl alcohol and pure water for 5 minutes each, and cleaned by irradiation of ultraviolet rays and exposure of ozone thereto for 30 minutes, and the glass substrate was loaded onto a vacuum deposition apparatus.

2-TNATA was deposited on the ITO glass substrate to form a hole injection layer having a thickness of 600 Å, and then, NPB was deposited on hole injection layer to form a hole transport layer having a thickness of 300 Å.

A host (ETH2 and HTH2 in a weight ratio of 1:1) and a dopant (Compound BD1) were concurrently (e.g., simultaneously) deposited in a weight ratio of 90:10 on the hole transport layer to form an emission layer having a thickness of 300 Å.

Next, ETH2 was deposited on the emission layer to form a hole-blocking layer having a thickness of 50 Å, ETH2 was deposited on the hole-blocking layer to form an electron transport layer having a thickness of 300 Å, LiF was deposited on the electron transport layer to form an electron injection layer having a thickness of 10 Å, and Al was vacuum-deposited on the electron injection layer to form a LiF/Al electrode (cathode) having a thickness of 3,000 Å.

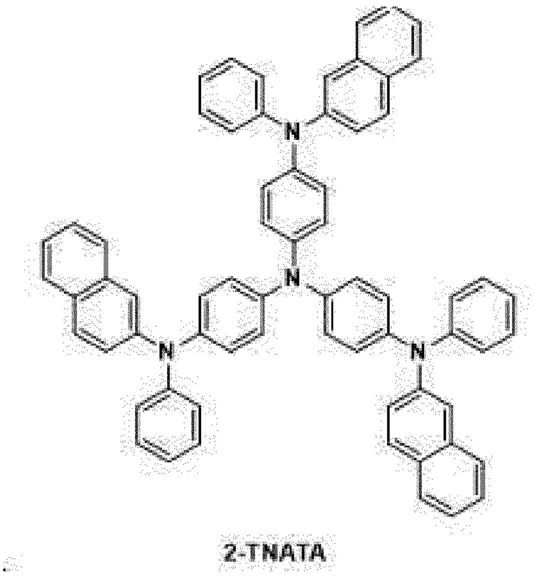

2-TNATA

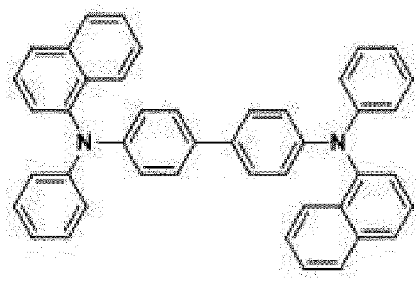

NPB

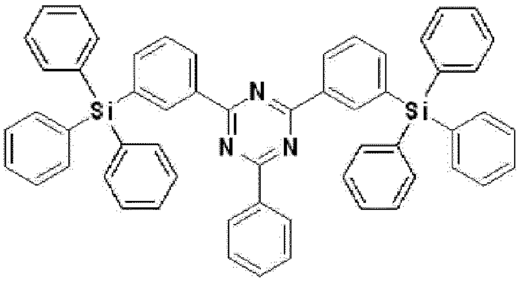

ETH2

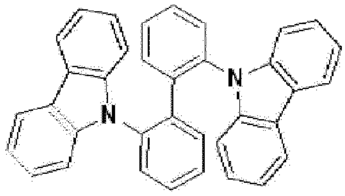

HTH2

**Examples 2 to 8, and Comparative Examples 1 and 2**

Organic light-emitting devices of Examples 2 to 8 and Comparative Examples 1 and 2 were manufactured in substantially the same manner as in Example 1, except that the dopant in Example 1 was changed as shown in Table 4.

**Evaluation Example 3**

In order to evaluate the characteristics of the organic light-emitting devices manufactured in Examples 1 to 8 and Comparative Examples 1 and 2, the driving voltage at a current density of 10 milliampere per square centimeter ($mA/cm^2$), relative luminescence efficiency, luminance, and device lifespan were measured. Results are shown in Table 5 with Examples 1 to 8 and Comparative Examples 1 and 2 represented by "EX 1" to "EX 8," "CE1" and "CE2." The driving voltage of the organic light-emitting devices was measured using a source meter (Keithley Instrument, 2400 series), and the maximum luminescence efficiency was measured using the external quantum efficiency measurement device C9920-2-12 from Hamamatsu Photonics. For the evaluation of luminescence efficiency, the brightness/current density was measured using a luminance meter calibrated for wavelength sensitivity, and the relative luminescence efficiency value was calculated assuming an angular luminance distribution (Lambertian) based on a perfectly diffuse reflective surface. In addition, to measure the device lifespan, the time required to reach 90 % of the initial luminance was measured. In Table 5 below, the values of luminescence efficiency and lifespan are expressed as relative values.

Table 5

| ID | Dopant | Lumininescence ($cd/m^2$) | Driving voltage (V) | Relative luminescence efficiency (%) | Relative lifespan ($T_{90}$) | Maximum emission wavelength (nm) |
|---|---|---|---|---|---|---|
| EX 1 | BD1 | 1000 | 4.4 | 122.00 | 162.30 | 461 |
| EX 2 | BD2 | 1000 | 4.5 | 110.20 | 296.00 | 459 |
| EX 3 | BD3 | 1000 | 4.6 | 95.90 | 258.00 | 462 |
| EX 4 | BD4 | 1000 | 4.5 | 110.80 | 184.00 | 461 |
| EX 5 | BD5 | 1000 | 4.5 | 122.60 | 163.00 | 461 |
| EX 6 | BD6 | 1000 | 4.5 | 111.40 | 298.40 | 460 |
| EX 7 | BD7 | 1000 | 4.3 | 108.50 | 305.00 | 463 |
| EX 8 | BD8 | 1000 | 4.7 | 120.20 | 270.00 | 458 |

(continued)

| ID | Dopant | Lumininescence ($cd/m^2$) | Driving voltage (V) | Relative luminescence efficiency (%) | Relative lifespan ($T_{90}$) | Maximum emission wavelength (nm) |
|---|---|---|---|---|---|---|
| CE 1 | Comparative Example Compound 1 | 1000 | 4.5 | 112.50 | 86.60 | 462 |
| CE 2 | Comparative Example Compound 2 | 1000 | 4.5 | 96.90 | 50.00 | 468 |

According to the one or more embodiments, the use of an organometallic compound may enable the manufacture of a light-emitting device with having high efficiency and long lifespan and enable a high-quality electronic apparatus including the light-emitting device.

In the context of the present application and unless otherwise defined, the terms "use," "using," and "used" may be considered synonymous with the terms "utilize," "utilizing," and "utilized," respectively.

A person of ordinary skill in the art, in view of the present disclosure in its entirety, would appreciate that each suitable feature of the one or more suitable embodiments of the present disclosure may be combined or combined with each other, partially or entirely, and may be technically interlocked and operated in one or more suitable ways, and each embodiment may be implemented independently of each other or in conjunction with each other in any suitable manner unless otherwise stated or implied.

It should be understood that embodiments described herein should be considered in a descriptive sense only and not for purposes of limitation. Descriptions of features or aspects within each embodiment should typically be considered as available for other similar features or aspects in one or more embodiments. While one or more embodiments have been described with reference to the drawings, it will be understood by those of ordinary skill in the art that one or more suitable changes in form and details may be made therein without departing from the scope as defined by the following claims and equivalents thereof.

## Claims

**1.** A light-emitting device comprising:

a first electrode;
a second electrode opposite to the first electrode; and
an interlayer between the first electrode and the second electrode and comprising an emission layer, wherein
the light-emitting device comprises an organometallic compound represented by Formula 1:

**Formula 1**

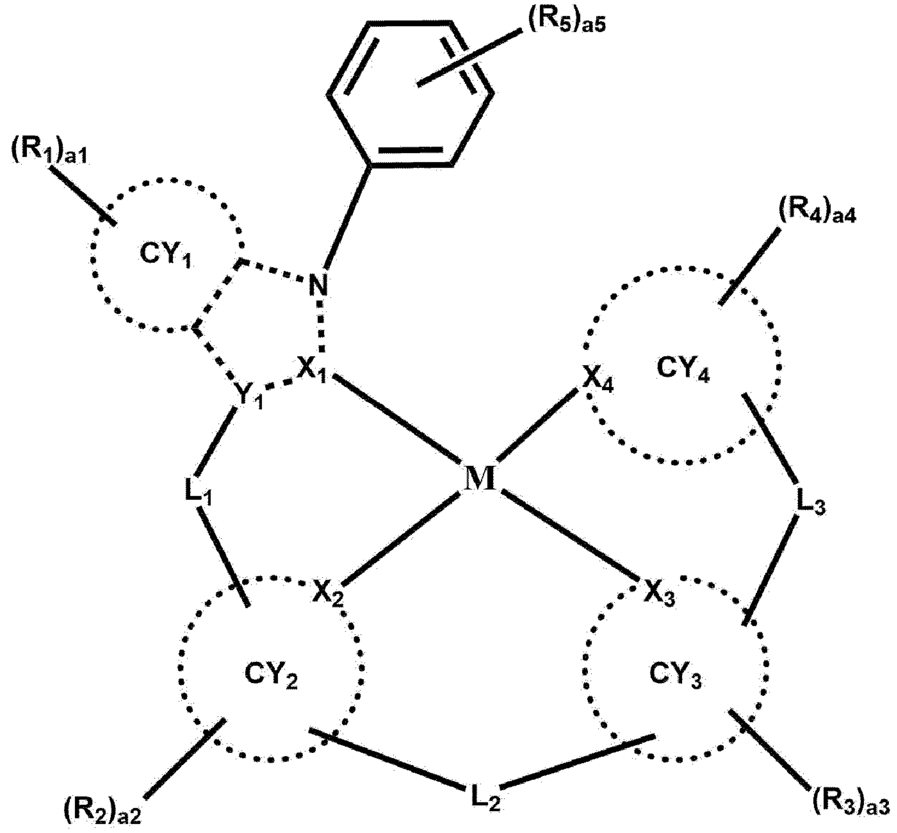

,

wherein, in Formula 1,

M is platinum (Pt), palladium (Pd), cobalt (Co), gold (Au), iridium (Ir), rhenium (Re), nickel (Ni), silver (Ag), or copper (Cu),
$X_1$ to $X_4$ and $Y_1$ are each independently C or N,
$L_1$ to $L_3$ are each independently a single bond, *-O-*', *-S-*', *-C($R_6$)($R_7$)-*', *-Si($R_6$)($R_7$)-*', *-B($R_6$)-*', *-N($R_6$)-*', or *-P($R_6$)-*',
$CY_1$ to $CY_4$ are each independently a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,
a1 to a4 are each independently an integer from 0 to 10,
a5 is an integer from 1 to 5,
$R_1$ to $R_7$ are each independently hydrogen, deuterium, -F, -Cl, -Br, -I, a hydroxyl group, a cyano group, a nitro group, a $C_1$-$C_{60}$ alkyl group unsubstituted or substituted with at least one $R_{10a}$, a $C_2$-$C_{60}$ alkenyl group unsubstituted or substituted with at least one $R_{10a}$, a $C_2$-$C_{60}$ alkynyl group unsubstituted or substituted with at least one $R_{10a}$, a $C_1$-$C_{60}$ alkoxy group unsubstituted or substituted with at least one $R_{10a}$, a $C_3$-$C_{60}$ carbocyclic group unsubstituted or substituted with at least one $R_{10a}$, a $C_1$-$C_{60}$ heterocyclic group unsubstituted or substituted with at least one $R_{10a}$, -C($Q_1$)($Q_2$)($Q_3$), - Si($Q_1$)($Q_2$)($Q_3$), -N($Q_1$)($Q_2$), -B($Q_1$)($Q_2$), -C(=O)($Q_1$), -S(=O)$_2$($Q_1$), or -P(=O)($Q_1$)($Q_2$),
$R_{10a}$ is:

deuterium, -F, -Cl, -Br, -I, a hydroxyl group, a cyano group, or a nitro group;
a $C_1$-$C_{60}$ alkyl group, a $C_2$-$C_{60}$ alkenyl group, a $C_2$-$C_{60}$ alkynyl group, or a $C_1$-$C_{60}$ alkoxy group, each unsubstituted or substituted with deuterium, -F, -Cl, -Br, -I, a hydroxyl group, a cyano group, a nitro group, a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_7$-$C_{60}$ arylalkyl group, a $C_2$-$C_{60}$ heteroarylalkyl group, -Si($Q_{11}$)($Q_{12}$)($Q_{13}$), -N($Q_{11}$)($Q_{12}$), -B($Q_{11}$)($Q_{12}$), - C(=O)($Q_{11}$), -S(=O)$_2$($Q_{11}$), -P(=O)($Q_{11}$)($Q_{12}$), or any combination thereof;
a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_7$-$C_{60}$ arylalkyl group, or a $C_2$-$C_{60}$ heteroarylalkyl group, each unsubstituted or substituted with deuterium, -F, -Cl, -Br, -I, a hydroxyl group, a cyano group, a nitro group, a $C_1$-$C_{60}$ alkyl group, a $C_2$-$C_{60}$

alkenyl group, a $C_2$-$C_{60}$ alkynyl group, a $C_1$-$C_{60}$ alkoxy group, a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_7$-$C_{60}$ arylalkyl group, a $C_2$-$C_{60}$ heteroarylalkyl group, $-Si(Q_{21})(Q_{22})(Q_{23})$, $-N(Q_{21})(Q_{22})$, $-B(Q_{21})(Q_{22})$, $-C(=O)(Q_{21})$, $-S(=O)_2(Q_{21})$, $-P(=O)(Q_{21})(Q_{22})$, or any combination thereof; or

$-Si(Q_{31})(Q_{32})(Q_{33})$, $-N(Q_{31})(Q_{32})$, $-B(Q_{31})(Q_{32})$, $-C(=O)(Q_{31})$, $-S(=O)_2(Q_{31})$, or $-P(=O)(Q_{31})(Q_{32})$,

$Q_1$ to $Q_3$, $Q_{11}$ to $Q_{13}$, $Q_{21}$ to $Q_{23}$, and $Q_{31}$ to $Q_{33}$ are each independently hydrogen, deuterium, -F, -Cl, -Br, -I, a hydroxyl group, a cyano group, a nitro group, or a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{60}$ carbocyclic group, or a $C_1$-$C_{60}$ heterocyclic group, each unsubstituted or substituted with deuterium, -F, a cyano group, a $C_1$-$C_{60}$ alkyl group, a $C_1$-$C_{60}$ alkoxy group, a phenyl group, a biphenyl group, or any combination thereof, and

the organometallic compound satisfies Condition 1 and Condition 2:

## Condition 1

$$\Delta G(T_1) - \Delta G(BDE)$$

is greater than (>) 0 kilocalorie per mole (kcal/mol),

**Condition 2**

a percent buried volume of the organometallic compound is 25% or less, and

wherein $\Delta G(T_1)$ is a triplet excited state energy of the organometallic compound, and $\Delta G(BDE)$ is a binding energy of N* and C* in

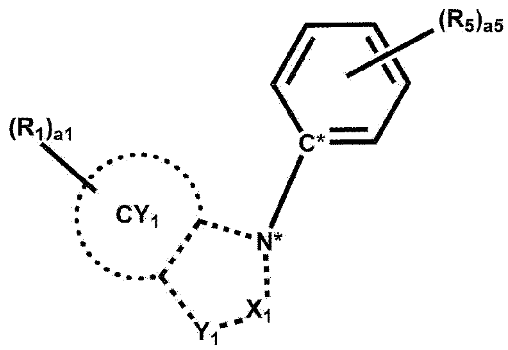

in Formula 1, and

the percent buried volume of the organometallic compound is a percentage of a ratio of a volume of the organometallic compound to a volume of a sphere around a molecule of the organometallic compound.

**2.** The light-emitting device of claim 1, wherein

the first electrode is an anode,

the second electrode is a cathode,

the interlayer further comprises a hole transport region between the first electrode and the emission layer and an electron transport region between the emission layer and the second electrode,

the hole transport region comprises a hole injection layer, a hole transport layer, an emission auxiliary layer, an electron blocking layer, or any combination thereof, and

the electron transport region comprises a hole-blocking layer, an electron transport layer, an electron injection layer, an electron control layer, or any combination thereof.

**3.** The light-emitting device of claim 1 or claim 2, wherein the organometallic compound is in the interlayer.

**4.** The light-emitting device of any one of claims 1 to 3, wherein the organometallic compound is in the emission layer.

**5.** The light-emitting device of any one of claims 1 to 4, wherein

the light-emitting device further comprises a host and a dopant, and
the dopant comprises the organometallic compound.

**6.** An electronic apparatus comprising the light-emitting device of any one of claims 1 to 5, optionally further comprising a color filter, a color conversion layer, a touch screen layer, a polarizing layer, or any combination thereof.

**7.** An electronic equipment comprising the light-emitting device of any one of claims 1 to 5, optionally wherein the electronic equipment is at least one selected from among a flat panel display, a curved display, a computer monitor, a medical monitor, a television, a billboard, an indoor or outdoor light and/or light for signal, a head-up display, a fully or partially transparent display, a flexible display, a rollable display, a foldable display, a stretchable display, a laser printer, a telephone, a portable phone, a tablet personal computer, a phablet, a personal digital assistant (PDA), a wearable device, a laptop computer, a digital camera, a camcorder, a viewfinder, a micro display, a three-dimensional (3D) display, a virtual reality, an augmented reality display, a vehicle, a video wall with multiple displays tiled together, a theater screen, a stadium screen, a phototherapy device, a signboard, and a combination thereof.

**8.** An organometallic compound represented by Formula 1:

**Formula 1**

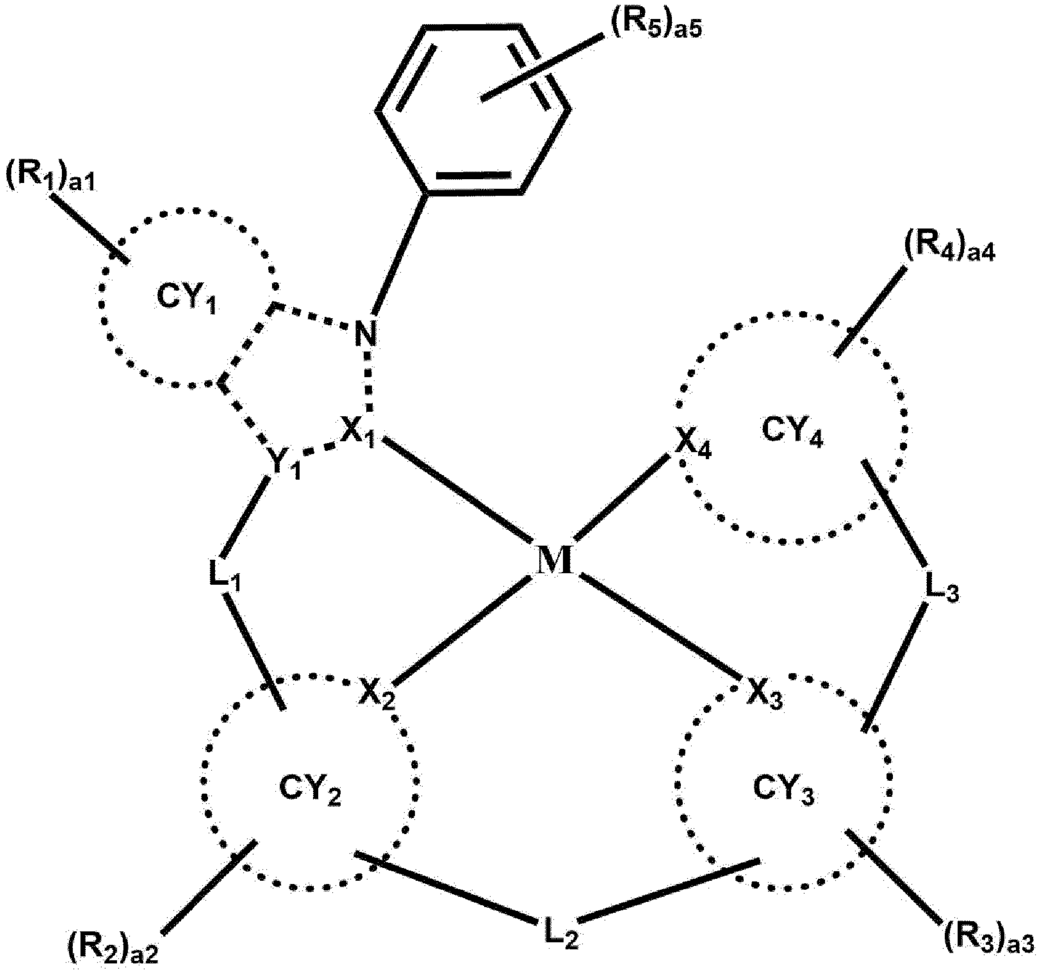

,

wherein, in Formula 1,

M is platinum (Pt), palladium (Pd), cobalt (Co), gold (Au), iridium (Ir), rhenium (Re), nickel (Ni), silver (Ag), or copper (Cu),
$X_1$ to $X_4$ and $Y_1$ are each independently a C atom or a N atom,
$L_1$ to $L_3$ are each independently a single bond, *-O-*', *-S-*', *-C($R_6$)($R_7$)-*', *-Si($R_6$)($R_7$)-*', *-B($R_6$)-*', *-N($R_6$)-*', or *-P($R_6$)-*',

$CY_1$ to $CY_4$ are each independently a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,
a1 to a4 are each independently an integer from 0 to 10,
a5 is an integer from 1 to 5,
$R_1$ to $R_7$ are each independently hydrogen, deuterium, -F, -Cl, -Br, -I, a hydroxyl group, a cyano group, a nitro group, a $C_1$-$C_{60}$ alkyl group unsubstituted or substituted with at least one $R_{10a}$, a $C_2$-$C_{60}$ alkenyl group unsubstituted or substituted with at least one $R_{10a}$, a $C_2$-$C_{60}$ alkynyl group unsubstituted or substituted with at least one $R_{10a}$, a $C_1$-$C_{60}$ alkoxy group unsubstituted or substituted with at least one $R_{10a}$, a $C_3$-$C_{60}$ carbocyclic group unsubstituted or substituted with at least one $R_{10a}$, a $C_1$-$C_{60}$ heterocyclic group unsubstituted or substituted with at least one $R_{10a}$, -C($Q_1$)($Q_2$)($Q_3$), - Si($Q_1$)($Q_2$)($Q_3$), -N($Q_1$)($Q_2$), -B($Q_1$)($Q_2$), -C(=O)($Q_1$), -S(=O)$_2$($Q_1$), or -P(=O)($Q_1$)($Q_2$),
$R_{10a}$ is:

deuterium, -F, -Cl, -Br, -I, a hydroxyl group, a cyano group, or a nitro group;
a $C_1$-$C_{60}$ alkyl group, a $C_2$-$C_{60}$ alkenyl group, a $C_2$-$C_{60}$ alkynyl group, or a $C_1$-$C_{60}$ alkoxy group, each unsubstituted or substituted with deuterium, -F, -Cl, -Br, -I, a hydroxyl group, a cyano group, a nitro group, a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_7$-$C_{60}$ arylalkyl group, a $C_2$-$C_{60}$ heteroarylalkyl group, -Si($Q_{11}$)($Q_{12}$)($Q_{13}$), -N($Q_{11}$)($Q_{12}$), -B($Q_{11}$)($Q_{12}$), - C(=O)($Q_{11}$), -S(=O)$_2$($Q_{11}$), -P(=O)($Q_{11}$)($Q_{12}$), or any combination thereof;
a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_7$-$C_{60}$ arylalkyl group, or a $C_2$-$C_{60}$ heteroarylalkyl group, each unsubstituted or substituted with deuterium, -F, -Cl, -Br, -I, a hydroxyl group, a cyano group, a nitro group, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_7$-$C_{60}$ arylalkyl group, a $C_2$-$C_{60}$ heteroarylalkyl group, -Si($Q_{21}$)($Q_{22}$)($Q_{23}$), -N($Q_{21}$)($Q_{22}$), -B($Q_{21}$)($Q_{22}$), -C(=O)($Q_{21}$), - S(=O)$_2$($Q_{21}$), -P(=O)($Q_{21}$)($Q_{22}$), or any combination thereof; or
-Si($Q_{31}$)($Q_{32}$)($Q_{33}$), -N($Q_{31}$)($Q_{32}$), -B($Q_{31}$)($Q_{32}$), -C(=O)($Q_{31}$), -S(=O)$_2$($Q_{31}$), or - P(=O)($Q_{31}$)($Q_{32}$),
$Q_1$ to $Q_3$, $Q_{11}$ to $Q_{13}$, $Q_{21}$ to $Q_{23}$, and $Q_{31}$ to $Q_{33}$ are each independently: hydrogen; deuterium; -F; -Cl; -Br; -I; a hydroxyl group; a cyano group; a nitro group; or a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{60}$ carbocyclic group, or a $C_1$-$C_{60}$ heterocyclic group, each unsubstituted or substituted with deuterium, -F, a cyano group, a $C_1$-$C_{60}$ alkyl group, a $C_1$-$C_{60}$ alkoxy group, a phenyl group, a biphenyl group, or any combination thereof, and
the organometallic compound satisfies Condition 1 and Condition 2,

## Condition 1

$$\Delta G(T_1) - \Delta G(BDE)$$

is greater than (>) 0 kilocalorie per mole (kcal/mol),
**Condition 2**
a percent buried volume of the organometallic compound is 25% or less, and
wherein $\Delta G(T_1)$ is a triplet excited state energy of the organometallic compound, and $\Delta G(BDE)$ is a binding energy of N* and C* in

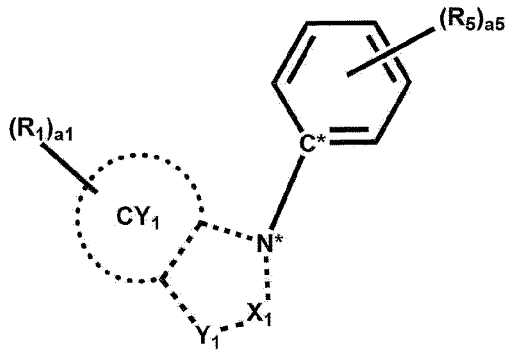

of Formula 1, and
the percent buried volume of the organometallic compound is a percentage of a ratio of a volume of the organometallic compound to a volume of a sphere around a molecule of the organometallic compound.

**9.** The organometallic compound of claim 8, wherein:

(i) the organometallic compound satisfies the condition: $\Delta G(T_1)$ - $\Delta G(BDE)$ > 0.9 kcal/mol; and/or
(ii) M is platinum (Pt).

**10.** The organometallic compound of claim 8 or claim 9, wherein:

(i) $L_1$ to $L_3$ are each independently a single bond, *-N($R_6$)-*', *-C($R_6$)($R_7$)-*', *-Si($R_6$)($R_7$)-*', or *-O-*'; and/or
(ii) the organometallic compound comprises at least one selected from among deuterium, a tert-butyl group, and a combination thereof.

**11.** The organometallic compound of any one of claims 8 to 10, wherein:

(i) a bond between $X_1$ and M and a bond between $X_4$ and M are each a coordinate bond, and a bond between $X_2$ and M and a bond between and $X_3$ and M are each a covalent bond; and/or
(ii) $X_1$ is the C atom comprising a carbene.

**12.** The organometallic compound of any one of claims 8 to 11, wherein:

i) $R_1$ is hydrogen; or
ii) each of a1 and a5 are not 0, and
at least one $R_1$ and at least one $R_5$ are bonded together in a $C_3$-$C_{60}$ carbocyclic group or a $C_1$-$C_{60}$ heterocyclic group; or
iii) each of a4 and a5 are not 0,

at least one $R_4$ and at least one $R_5$ are bonded together in a cyclometallated group comprising M, $X_1$, and $X_4$, and
the cyclometallated group comprises at least 9 ring forming atoms.

**13.** The organometallic compound of any one of claims 8 to 12, wherein
the organometallic compound is represented by any one of Formulae 1-1 to 1-3:

## Formula 1-1

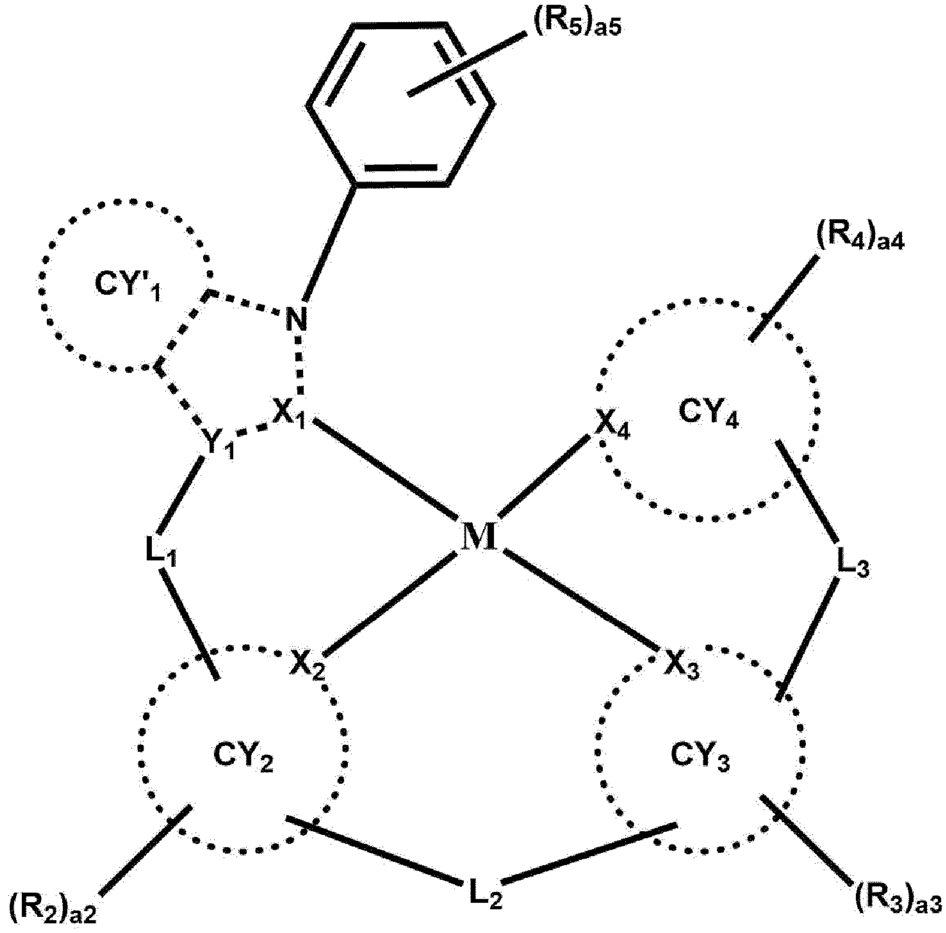

**Formula 1-2**

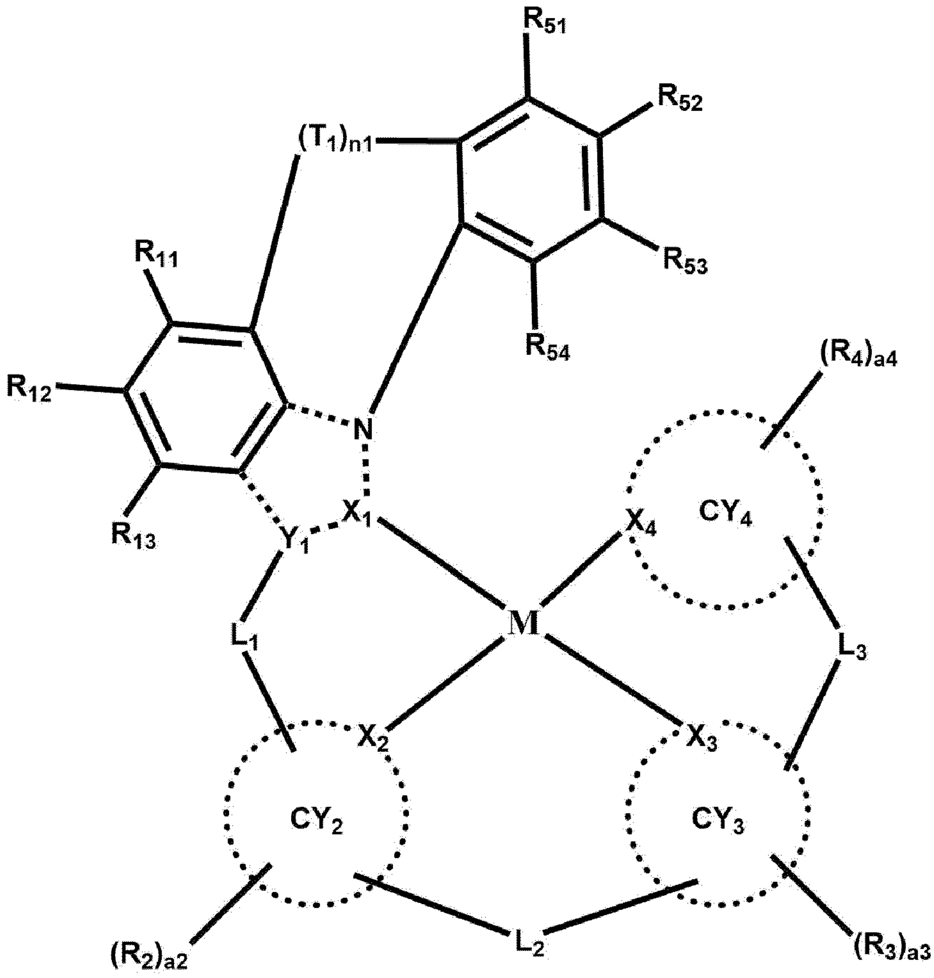

**Formula 1-3**

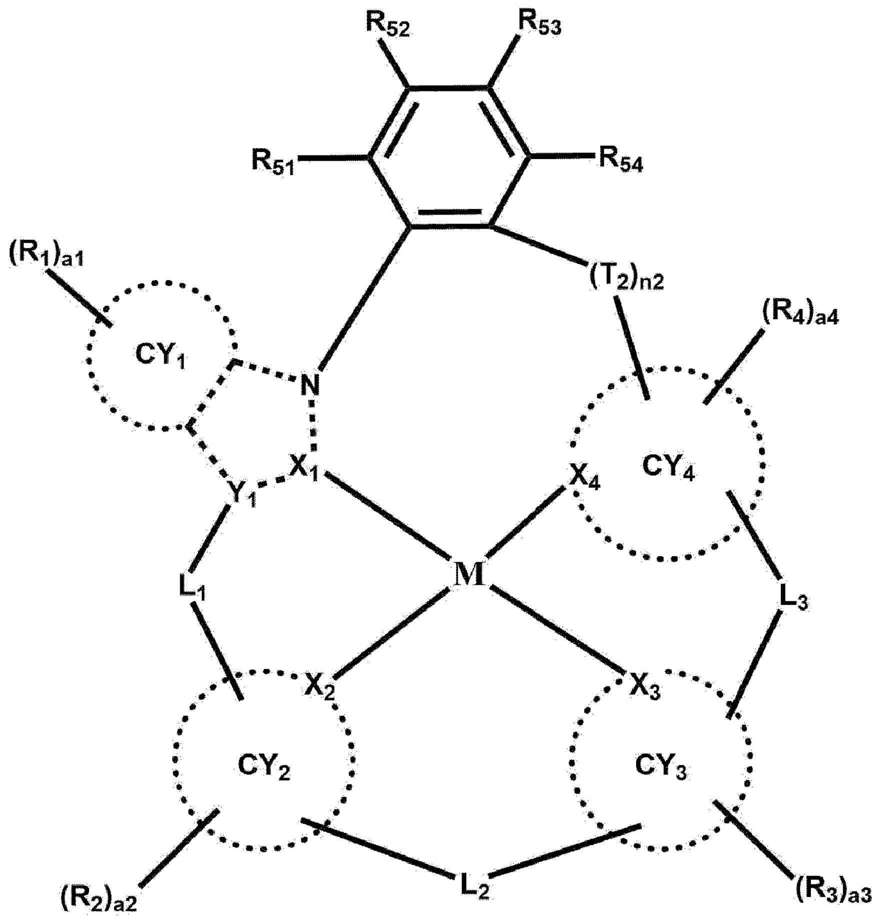

,

wherein, in Formulae 1-1 to 1-3,

M, $CY_1$ to $CY_4$, $X_1$ to $X_4$, $Y_1$, $L_1$ to $L_3$, a1 to a5, and $R_1$ to $R_5$ are each as described in Formula 1,
$CY'_1$ is an unsubstituted $C_3$-$C_{60}$ carbocyclic group or an unsubstituted $C_1$-$C_{60}$ heterocyclic group,
$T_1$ and $T_2$ are each independently *-O-*', *-S-*', *-C(=O)-*', *-N($R_8$)-*', *-C($R_8$)($R_9$)-*', *-C($R_8$)=C($R_9$)-*', *-C($R_8$)=*', *=C=*', a $C_3$-$C_{60}$ carbocyclic group unsubstituted or substituted with at least one $R_{10a}$, or a $C_1$-$C_{60}$ heterocyclic group unsubstituted or substituted with at least one $R_{10a}$,
n1 and n2 are each independently an integer of 1 to 5,
$R_8$, $R_9$ and $R_{11}$ to $R_{13}$ are each independently defined as for $R_1$ in Formula 1, and
$R_{51}$ to $R_{54}$ are each independently defined as for $R_5$ in Formula 1.

**14.** The organometallic compound of any one of claims 8 to 13, wherein
$R_1$ to $R_7$ are each independently:

hydrogen, deuterium, -F, or a cyano group;
a methyl group, an ethyl group, an n-propyl group, an isopropyl group, an n-butyl group, an isobutyl group, a sec-butyl group, a tert-butyl group, an n-pentyl group, an isopentyl group, a sec-pentyl group, a tert-pentyl group, a 2-methylbutyl group, a 2,2-dimethylpropyl group, a 1-ethylpropyl group, or a 1,2-dimethylpropyl group, each unsubstituted or substituted with deuterium, -F, -Cl, -Br, -I, a hydroxyl group, a cyano group, or a nitro group; or
a benzene group, a naphthalene group, a biphenyl group, a terphenyl group, a pyridine group, a dibenzofuran group, a dibenzothiophene group, a carbazole group, an azadibenzofuran group, an azadibenzothiophene group, or an azacarbazole group, each unsubstituted or substituted with deuterium, -F, -Cl, -Br, -I, a hydroxyl group, a cyano group, a nitro group, a methyl group, an ethyl group, an n-propyl group, an isopropyl group, an n-butyl group, an isobutyl group, a sec-butyl group, a tert-butyl group, an n-pentyl group, an isopentyl group, a sec-pentyl group, a tert-pentyl group, a 2-methylbutyl group, a 2,2-dimethylpropyl group, a 1-ethylpropyl, 1,2-dimethylpropyl group, or a phenyl group.

**15.** The organometallic compound of claim 8, wherein the organometallic compound is any one of Compounds BD1 to BD8:

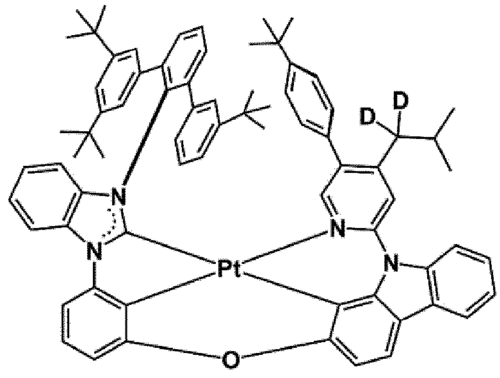

**BD1**

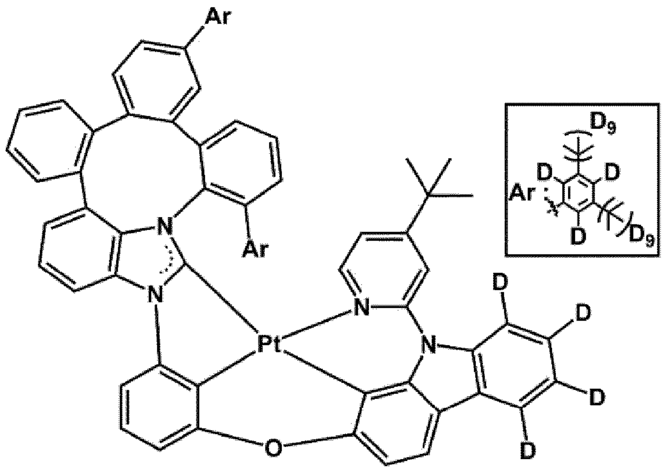

**BD2**

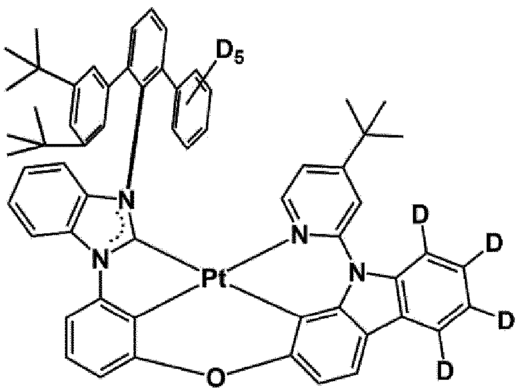

**BD3**

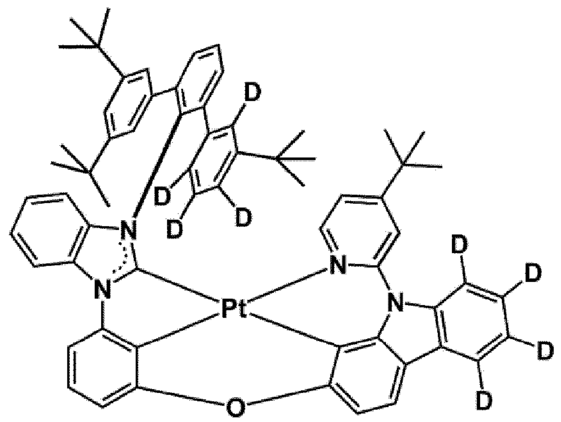

**BD4**

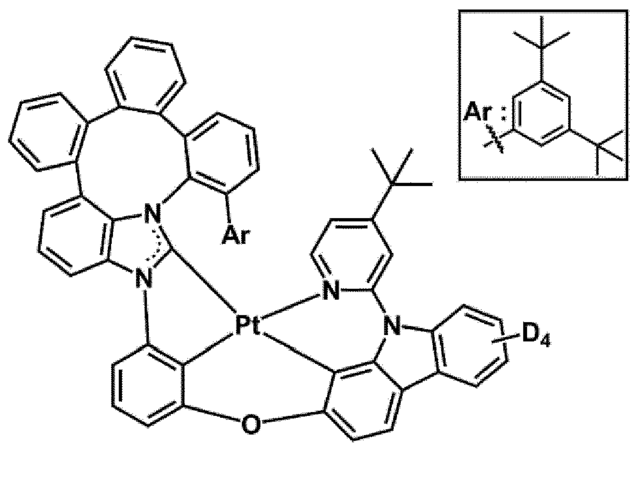

**BD5**

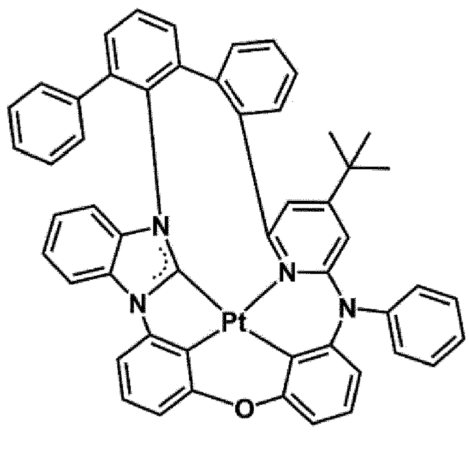

**BD6**

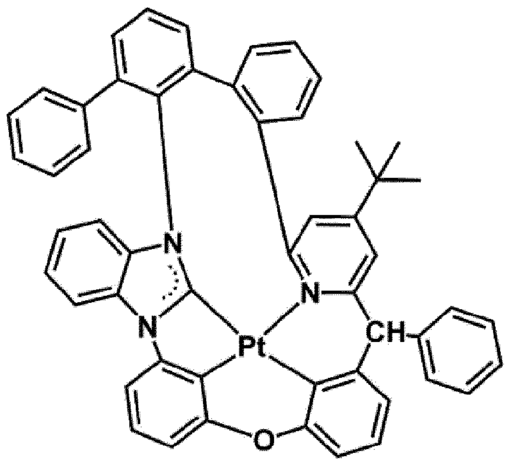

BD7

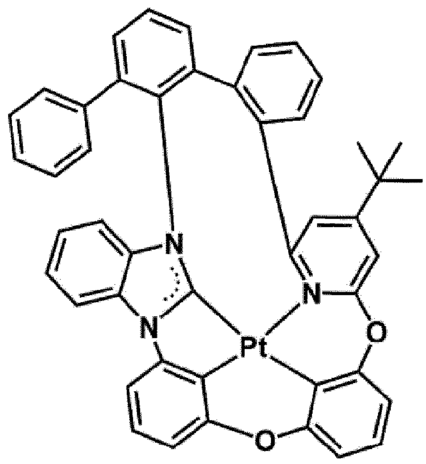

BD8

FIG. 1

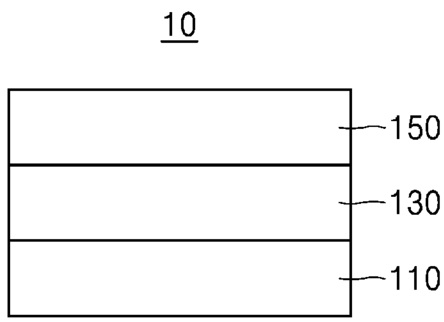

FIG. 2

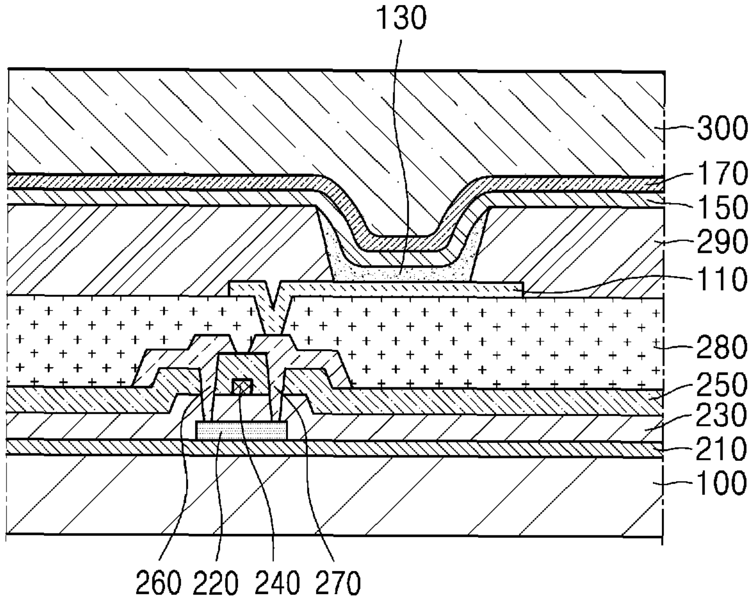

FIG. 3

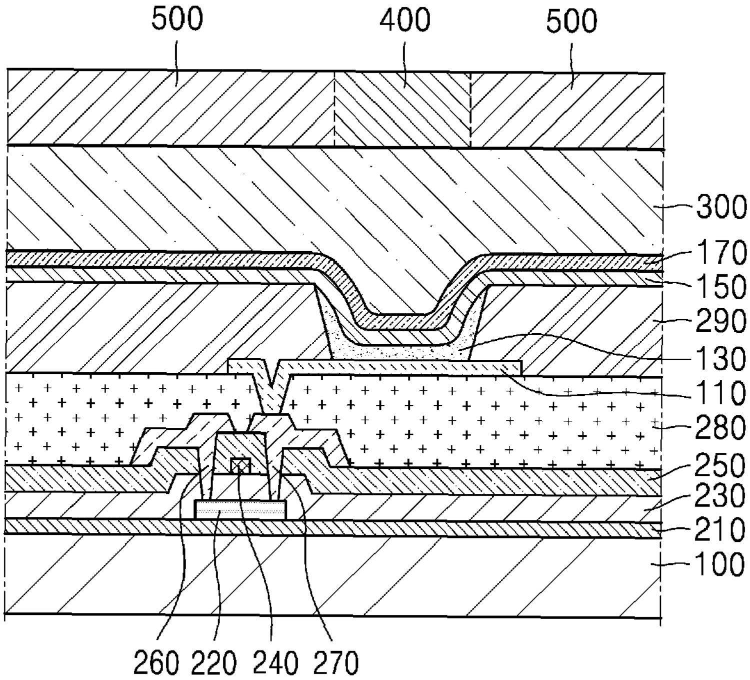
500
400
500
300
170
150
290
130
110
280
250
230
210
100
260 220 240 270

FIG. 4

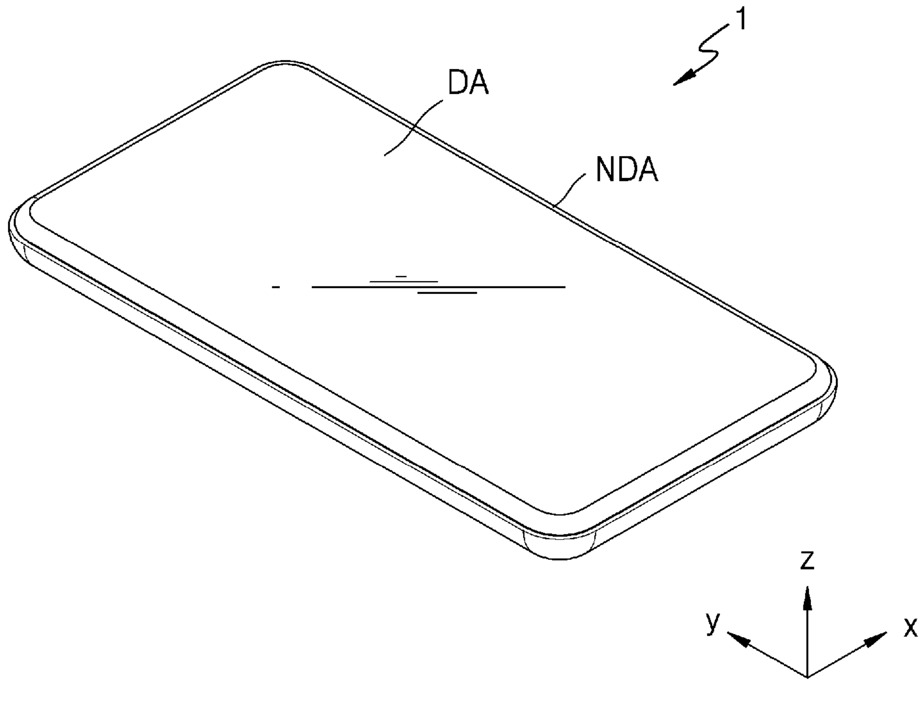

FIG. 5

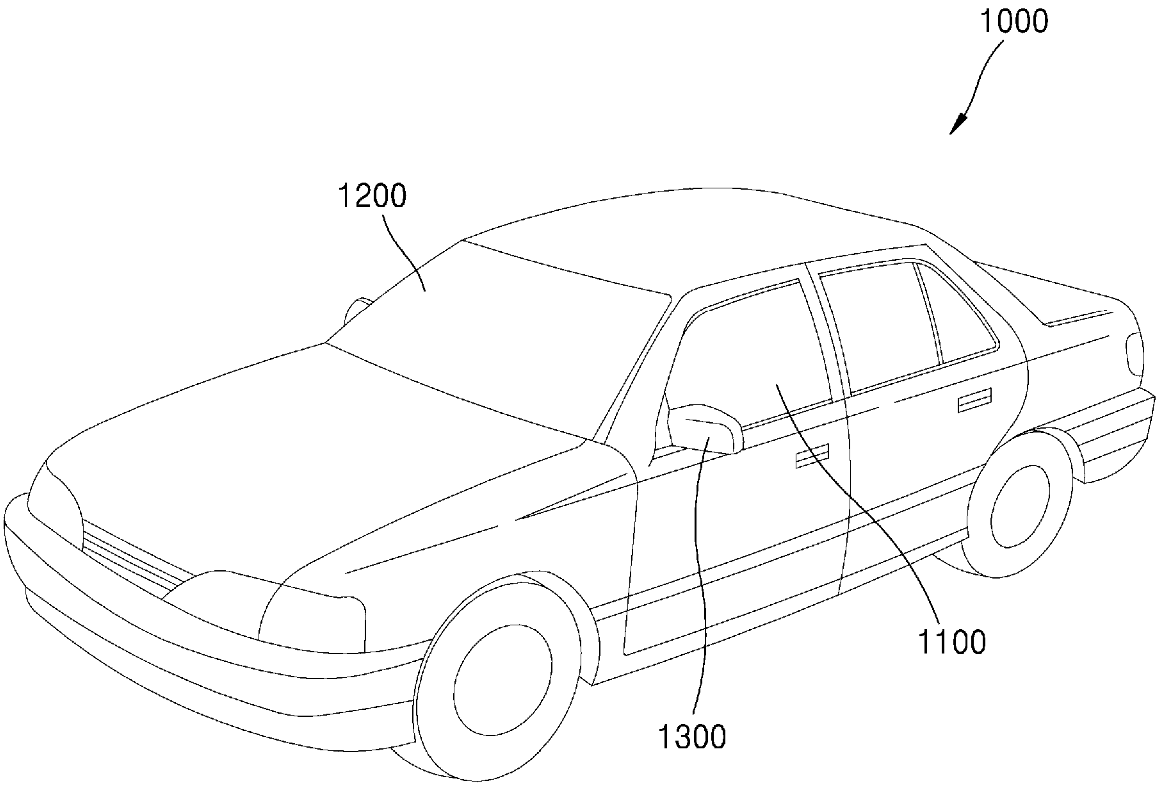

FIG. 6A

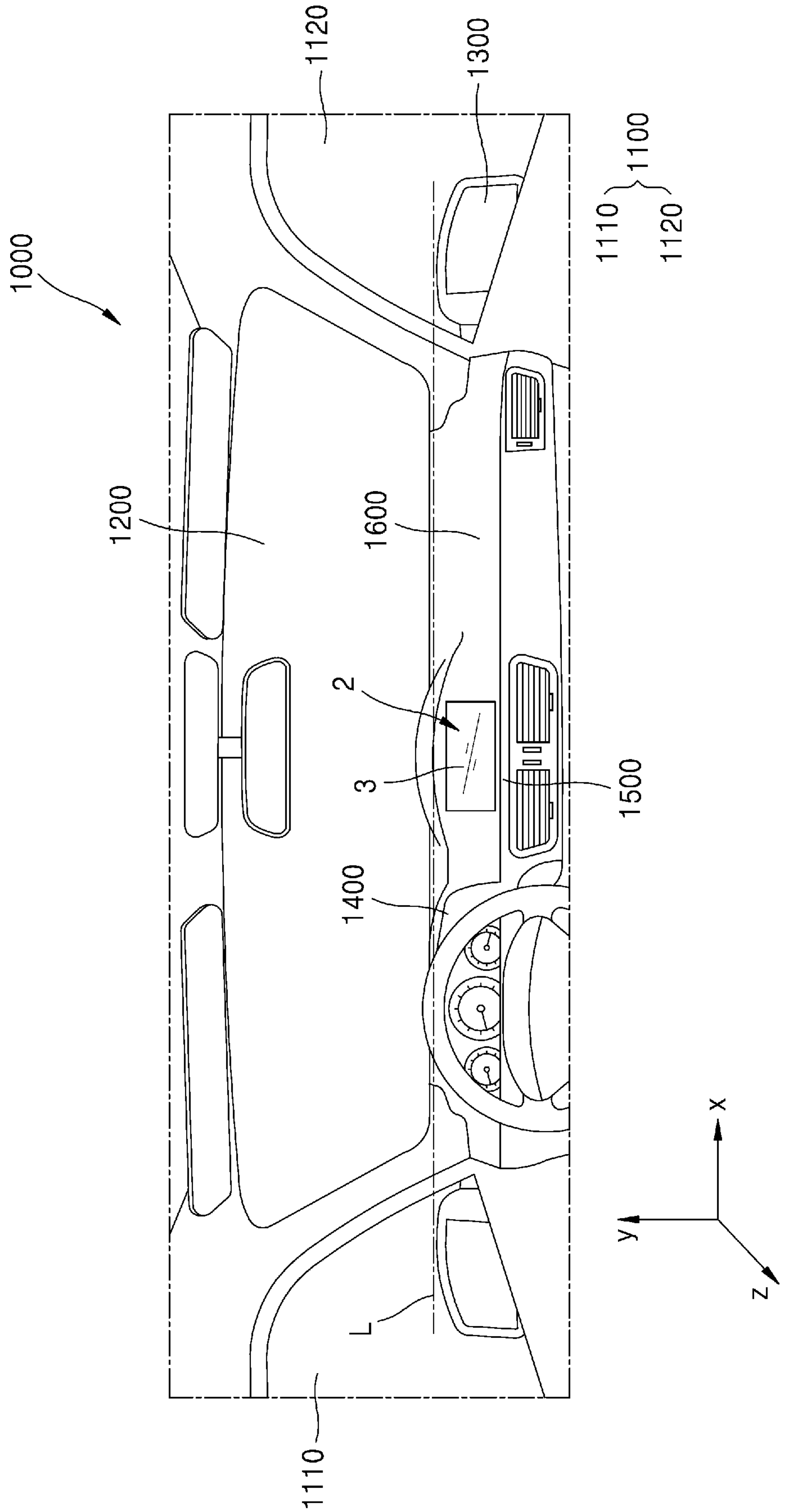
1000
1120
1300
1100
1110
1120
1200
1600
2
3
1500
1400
L
1110
x
y
z

FIG. 6B

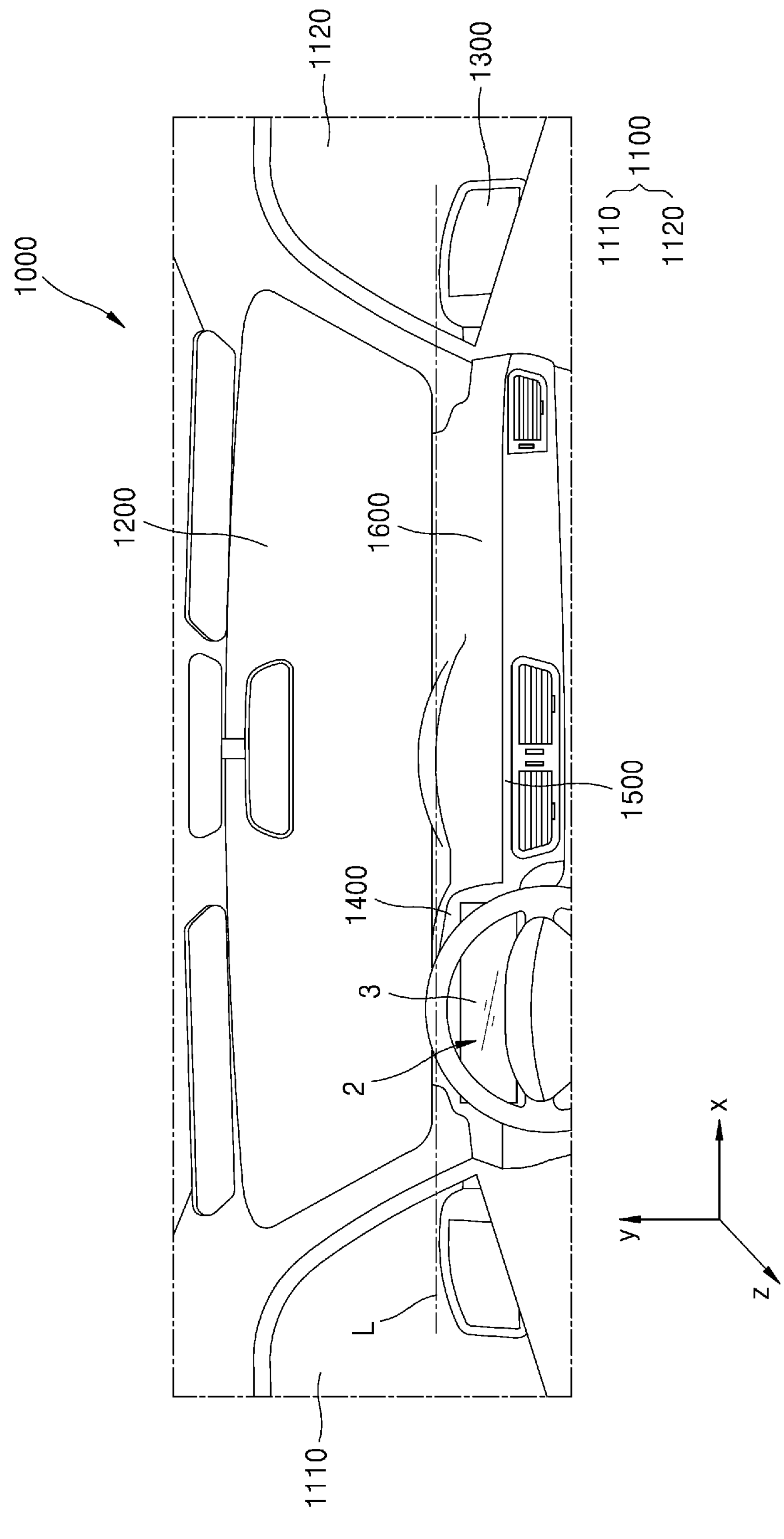
1000
1120
1300
1100
1110
1120
1200
1600
1500
1400
3
2
L
1110
x
y
z

FIG. 6C

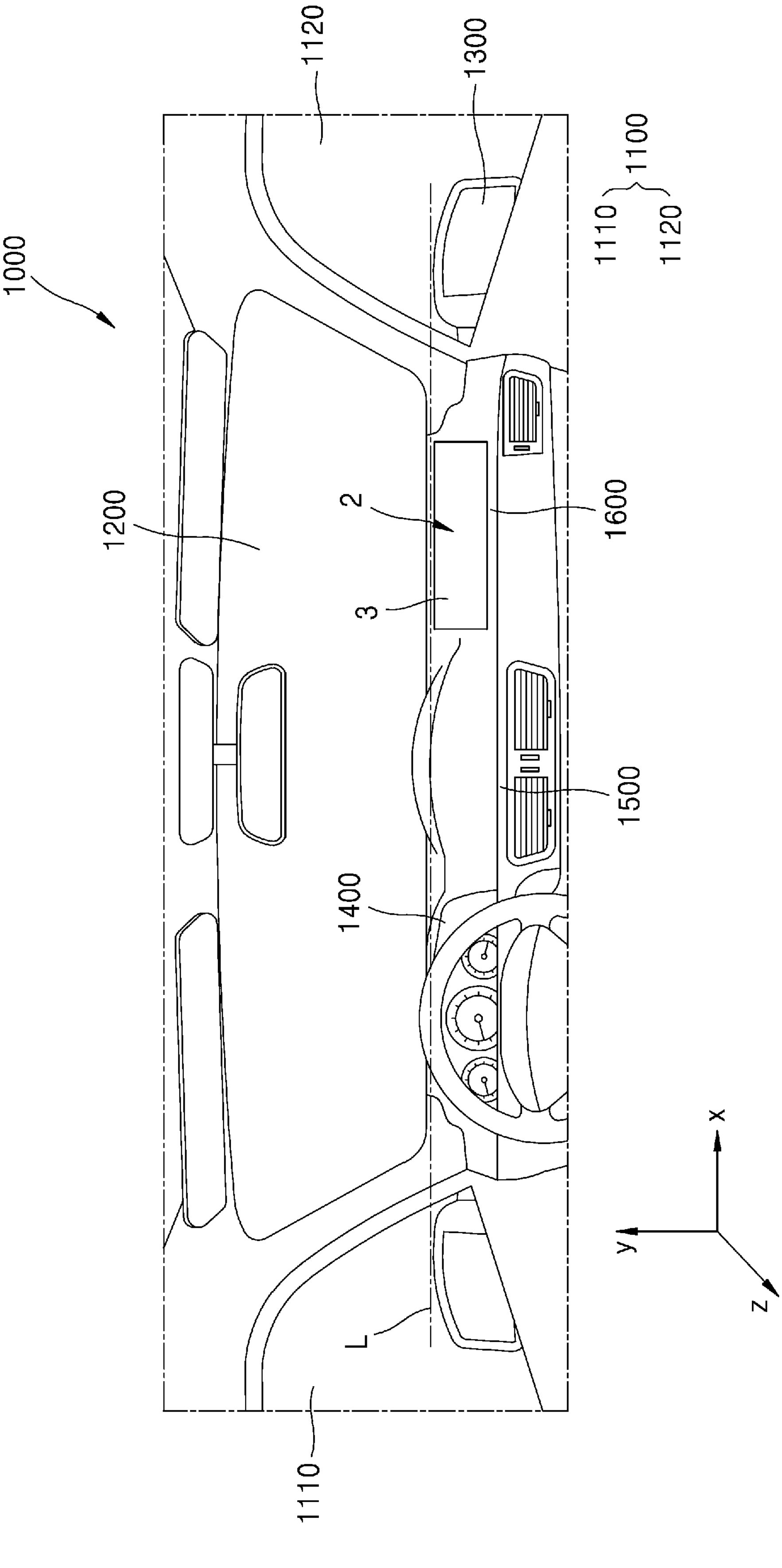
1000
1120
1300
1100
1110
1120
1200
2
3
1600
1500
1400
L
1110
x
y
z

Europäisches Patentamt
European Patent Office
Office européen des brevets

# EUROPEAN SEARCH REPORT

Application Number
EP 25 18 4686

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>A | US 2023/329086 A1 (JEON MINA [KR] ET AL) 12 October 2023 (2023-10-12)<br>* compounds 56,59 * | 1-14<br>15 | INV. H10K50/12 H10K85/30 |
| X<br>A | US 2023/002430 A1 (CHEN HSIAO-FAN [US] ET AL) 5 January 2023 (2023-01-05)<br>* paragraph [0178] * | 1-14<br>15 | ADD. H10K101/40 |
| T | WANG XIN ET AL: "Construction of stable luminescent donor-acceptor neutral radicals: a theoretical study", JOURNAL OF MATERIALS CHEMISTRY C, vol. 10, no. 48, 11 November 2022 (2022-11-11), pages 18343-18350, XP093305946, GB ISSN: 2050-7526, DOI: 10.1039/D2TC03712B<br>* Section 3.3. * | 1,8 | |
| T | ALBERT POATER ET AL: "Samb V ca: A Web Application for the Calculation of the Buried Volume of N-Heterocyclic Carbene Ligands", EUROPEAN JOURNAL OF INORGANIC CHEMISTRY, vol. 2009, no. 13, 15 April 2009 (2009-04-15), pages 1759-1766, XP055604204, DE ISSN: 1434-1948, DOI: 10.1002/ejic.200801160<br>* the whole document * | 1,8 | TECHNICAL FIELDS SEARCHED (IPC)<br>H10K |

The present search report has been drawn up for all claims

| Place of search | Date of completion of the search | Examiner |
|---|---|---|
| Munich | 19 August 2025 | Wolfbauer, Georg |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

2

EPO FORM 1503 03.82 (P04C01)

## ANNEX TO THE EUROPEAN SEARCH REPORT ON EUROPEAN PATENT APPLICATION NO.

EP 25 18 4686

This annex lists the patent family members relating to the patent documents cited in the above-mentioned European search report. The members are as contained in the European Patent Office EDP file on The European Patent Office is in no way liable for these particulars which are merely given for the purpose of information.

19-08-2025

| Patent document cited in search report | Publication date | Patent family member(s) | Publication date |
|---|---|---|---|
| US 2023329086 A1 | 12-10-2023 | CN 116891504 A | 17-10-2023 |
| | | KR 20230144704 A | 17-10-2023 |
| | | US 2023329086 A1 | 12-10-2023 |
| US 2023002430 A1 | 05-01-2023 | KR 20220157909 A | 29-11-2022 |
| | | US 2023002430 A1 | 05-01-2023 |

EPO FORM P0459

For more details about this annex : see Official Journal of the European Patent Office, No. 12/82